(19) Europäisches Patentamt

European Patent Office

Office européen des brevets

(11) **EP 1 450 341 A1**

(12) **EUROPEAN PATENT APPLICATION**
published in accordance with Art. 158(3) EPC

(43) Date of publication:
**25.08.2004 Bulletin 2004/35**

(21) Application number: **02767990.1**

(22) Date of filing: **20.09.2002**

(51) Int Cl.7: **G09G 3/30**, G09G 3/20, H03M 1/74

(86) International application number:
**PCT/JP2002/009668**

(87) International publication number:
**WO 2003/027998 (03.04.2003 Gazette 2003/14)**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **25.09.2001 JP 2001291598**
**30.10.2001 JP 2001332196**
**10.05.2002 JP 2002136157**

(71) Applicant: **MATSUSHITA ELECTRIC INDUSTRIAL CO., LTD.**
**Kadoma-shi, Osaka 571-8501 (JP)**

(72) Inventors:
• **YAMANO, Atsuhiro**
**Kawanishi-shi, Hyogo 666-0001 (JP)**
• **TAKAHARA, Hiroshi**
**Neyagawa-shi, Osaka 572-0807 (JP)**
• **TSUGE, Hitoshi**
**Kadoma-shi, Osaka 571-0074 (JP)**

(74) Representative:
**Dempster, Benjamin John Naftel et al**
**Withers & Rogers,**
**Goldings House,**
**2 Hays Lane**
**London SE1 2HW (GB)**

(54) **EL DISPLAY PANEL AND EL DISPLAY APPARATUS COMPRISING IT**

(57) In a source driver (14) provided in an electroluminescent (EL) display device of the present invention, the gate voltage of a first-stage current source formed by a transistor (631) is applied to the gate of a transistor (632a) which is a second-stage current source situated next to the transistor (631) and, as a result, a current flowing through the transistor (632a) is transferred to a transistor (632b) which is a second-stage current source. In addition, the gate voltage of the transistor (632b) is applied to the gate of a transistor (633a) which is a third-stage current source situated next to the transistor (632b) and, as a result, a current flowing through the transistor (633a) is transferred to a transistor (633b) which is a third-stage current source. The gate of the transistor (633b) is provided with a large number of current sources (634) corresponding to the number of bits required.

FIG.68

**Description**

Technical Field

The present invention relates to an EL display apparatus employing an organic or inorganic electroluminescence (EL) device and, more particularly, to an EL display apparatus capable of feeding an EL device with a desired current, a method of driving the same, and an electronic apparatus provided with such an EL display apparatus.

Background Art

In general, an active-matrix display apparatus has a multiplicity of pixels arranged in matrix and displays an image by controlling the intensity of light pixel by pixel in accordance with image signals given. When, for example, liquid crystal is used as an electro-optic substance, the transmittance of each pixel varies in accordance with the voltage applied to the pixel. The basic operation of an active-matrix image display apparatus employing an organic electroluminescence (EL) material as an electro-optic converting substance is the same as in the case where liquid crystal is used.

A liquid crystal display panel has pixels each functioning as a shutter and displays an image by turning on/off light from a back light with such a shutter, or a pixel. An organic EL display panel is a display panel of the self-luminescence type having a light-emitting device in each pixel. Such a self-luminescence type display panel has advantages over liquid crystal display panels, including higher image visibility, no need for a back light, and higher response speed.

The organic EL display panel controls the luminance of each light-emitting device (pixel) based on the amount of current. Thus, the organic EL display panel is largely different from the liquid crystal display panel in that its luminescent devices are of the current-driven type or the current-controlled type.

Like the liquid crystal display panel, the organic EL display panel can have any one of a simple-matrix configuration and an active-matrix configuration. Though the former configuration is simple in structure, it has a difficulty in realizing a large-scale and high-definition display panel. However, it is inexpensive. The latter configuration can realize a large-scale and high-definition display panel. However, it has problems of a technical difficulty in control and of a relatively high price. Presently, organic EL display panels of the active-matrix configuration are being developed intensively. Such an active-matrix EL panel controls electric current passing through the light-emitting device provided in each pixel by means of a thin film transistor (TFT) located inside the pixel.

An organic EL display panel of such an active-matrix configuration is disclosed in Japanese Patent Laid-Open Publication No. HEI 8-234683 for example.

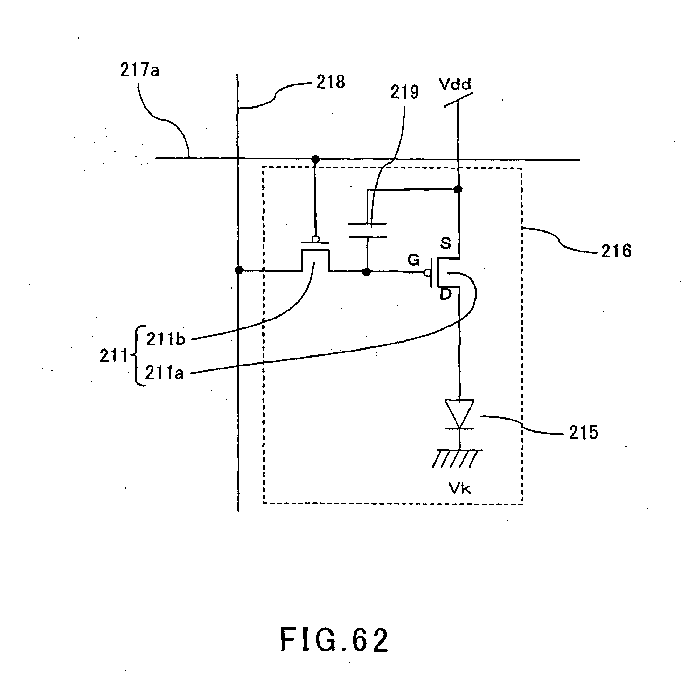

Figure 62 shows an equivalent circuit of one pixel portion of this display panel. Pixel 216 comprises an EL device 215 as a light-emitting device, a first transistor 211a, a second transistor 211b, and a storage capacitor 219. Here, the EL device 215 is an organic electroluminescence (EL) device.

In the present description, a transistor for feeding (controlling) current to an EL device is referred to as a driving transistor, while a transistor operating as a switch like the transistor 211b in Figure 62 referred to as a switching transistor.

EL device 215 has a rectification property in many cases and hence is called OLED (Organic Light-Emitting Diode) as the case may be. For this reason, the EL device 215 in Figure 62 is regarded as an OLED and represented by the symbol of a diode.

In the example shown in Figure 62, the source terminal (S) of p-channel transistor 211a is connected to Vdd (power source potential), while the cathode (negative electrode) of the EL device 215 connected to ground potential (Vk). On the other hand, the anode (positive electrode) is connected to the drain terminal (D) of the transistor 211b. The gate terminal of the p-channel transistor 211b is connected to a gate signal line 217a, the source terminal connected to a source signal line 218, and the drain terminal connected to the storage capacitor 219 and the gate terminal (G) of the transistor 211a.

In order to operate the pixel 216, first, the source signal line 218 is applied with an image signal indicative of luminance information with the gate signal line 217a turned into a selected state. Then, the transistor 211b becomes conducting and the storage capacitor 219 is charged or discharged, so that the gate potential of the transistor 211a becomes equal to the potential of the image signal. When the gate signal line 217a is turned into an unselected state, the transistor 211a is turned off, so that the transistor 211a is electrically disconnected from the source signal line 218. However, the gate potential of the transistor 211a is stably maintained by means of the storage capacitor 219. The current passing through the EL device 215 via the transistor 211a comes to assume a value corresponding to voltage Vgs across the gate and the source terminals of the transistor 11a, with the result that the EL device 215 keeps on emitting light at a luminance corresponding to the amount of current fed thereto through the transistor 211a.

As described above, according to the prior art configuration shown in Figure 62, one pixel comprises one selecting transistor (switching device) and one driving transistor. Another prior art configuration is disclosed in Japanese Patent Laid-Open Publication No. HEI 11-327637 for example. This publication describes an embodiment in which a pixel comprises a current mirror circuit.

Meanwhile, the organic EL display panel is usually manufactured using a low temperature polysilicon transistor array. Since organic EL devices emit light based on current, the organic EL display panel involves a problem that display irregularities occur if there are variations in transistor characteristics.

Further, a conventional EL display panel cannot sufficiently charge/discharge the parasitic capacitance which is present in the source signal line 18. For this reason there arises a problem that in some cases a desired current cannot be fed to pixel 16.

In addition, it is possible to achieve a reduction in display unevenness by employing a pixel configuration of the current program system. Here, execution of a current program requires the provision of a source driver of the current driven type. However, even in a source driver of the current driven type, variations occur to transistor elemental devices which constitute a current output stage. This creates variations in output current from each output terminal, thereby producing the problem that image display of better quality is not obtained.

Furthermore, human vision is characterized in that sensitivity to variation in brightness is low in a low gray scale region while on the other hand sensitivity to variation in brightness is high in a high gray scale region. If, in a source driver of the current driven type, display is carried out at a constant current value increment, this represents the problem that it is impossible to provide image display natural to human eyes.

Disclosure of Invention

Bearing in mind the above-described problems, the present invention was made. Accordingly, an object of the present invention is to provide an EL display device capable of realizing image display of better quality by suppressing variation in output current from each output terminal of a source driver.

In order to achieve the above-mentioned object, the present invention provides an electroluminescent (EL) display device. This EL display device comprises: a plurality of source signal lines; a plurality of EL elemental devices, each capable of the emission of light at a brightness corresponding to a current supplied via the source signal line; and a source driver which supplies a current corresponding to a gray scale of an image to the EL elemental device via the source signal line,
the source driver comprising:

reference signal generating means which generates reference signals,
a first current source which outputs a reference signal generated by the reference signal generating means in electric current form, and
a plurality of second current sources provided in association with the source signal lines, each of the plurality of second current sources being configured such that a reference signal outputted by the first current source is transferred in voltage form,

wherein a current according to the image gray scale is generated by the use of a reference signal held by each of the second current sources.

As a result of such arrangement, variation in output current from the source driver is suppressed, thereby realizing better image display.

Further, in the above-described EL display device of the present invention, it is preferable that a plurality of unit transistors, each of the unit transistors being so configured as to output the reference signal in electric current form when selected, are connected to each of the second current sources, that the source driver is so configured as to select one or more of the unit transistors according to the image gray scale, and that the EL display device is configured such that both a relational expression of $40 \leq K/(St)^{\frac{1}{2}}$ and a relational expression of $St \leq 300$, where K indicates the number of representable gray scales and St (square micrometers) indicates the size of the unit transistor, are satisfied.

As a result of such arrangement, even when there occurs variation in output current from the source driver, such output current variation is unsusceptible to being recognized in the image display.

In addition, in the above-described EL display device of the present invention, it is preferable that the plural second current sources are formed in a region the area of which does not exceed 2 square millimeters. As the result of this arrangement, variation in output current from the source driver is held as low as possible.

Furthermore, in the above-described EL display device of the present invention, it is preferable that the source driver is provided with a light shielding film for preventing the first and second current sources from being illuminated with rays of light emitted from the EL elemental device. It becomes possible to avoid the photoconductor phenomenon caused by rays of light emitted from the EL elemental device falling upon the first and second current sources.

Furthermore, the present invention provides an electroluminescent (EL) display device. This EL display device comprises: a plurality of source signal lines; a plurality of EL elemental devices, each capable of the emission of light at a brightness corresponding to a current supplied via the source signal line; and a source driver which supplies a current corresponding to a gray scale of an image to the EL elemental device via the source signal line,
the source driver comprising:

a first current output circuit, made up of a plurality of unit transistors each operable to output a first unit current, for outputting to the EL elemental device a desired current by the combination of the first unit currents, and
a second current output circuit, made up of a plurality of unit transistors each operable to output a second unit current greater than the first unit current, for outputting to the EL elemental device a desired current by the combination of the second unit currents,

wherein, when a gray scale to be displayed is lower than a predetermined gray scale, the first current output circuit is so operated as to output a corresponding current for the gray scale to be displayed, while, when a gray scale to be displayed is higher than the predetermined gray scale, the second current output circuit is so operated as to output a corresponding current for the gray scale to be displayed, and wherein the EL display device is configured such that the first current output circuit outputs a given current.

As a result of such arrangement, when a gray scale to be displayed is lower than a predetermined gray scale, display is carried out at increments of a lower current value, while, when a gray scale to be displayed is higher than a predetermined gray scale, display is carried out at increments of a higher current value. As the result of this, it becomes possible to provide the display characteristic that brightness variation is small in the low gray scale region whereas in the high gray scale region brightness variation is great, thereby making it possible to display an image natural to human eyes.

Further, in the above-described EL display device of the present invention, it is preferable that the magnitude of the second current is not less than four times nor more than eight times the magnitude of the first current.

In addition, in the above-described EL display device of the present invention, it is preferable that the source driver is provided with a light shielding film for preventing the first and second current output circuits from being illuminated with rays of light emitted from the EL elemental device.

Furthermore, electronic equipment in accordance with the present invention is provided with an EL display device and is so configured as to output an image signal to the EL display device.

In addition, the present invention provides an EL display device. This EL display device comprises:

a display region in which EL elemental devices are arranged in a matrix, and
a source driver which supplies in electric current form a video signal to the EL elemental device,

the source driver comprising:

reference current generating means which generates a reference current,
a first current source which is fed a reference current from the reference current generating means and which outputs a first current corresponding to the reference current,
a second current source which is fed a first current outputted from the first current source and which outputs a second current corresponding to the first current,
a third current source which is fed a second current outputted from the second current source and which outputs a third current corresponding to the second current, and
a plurality of unit current sources each of which is fed a third current outputted from the third current source, and outputs to the EL elemental device a unit current corresponding to the third current in response to input image data.

The present invention provides an EL display device. This EL display device comprises:

a display region in which EL elemental devices are arranged in a matrix, and
a source driver which supplies in electric current form a video signal to the EL elemental device,

wherein the source driver has a plurality of unit transistors,
wherein the unit transistor is so configured as to output, when selected, a unit current corresponding to the magnitude of an input video signal, and
wherein the EL display device is configured such that both a relational expression of $40 \leq K/(St)^{1/2}$ and a relational expression of $St \leq 300$, where K indicates the number of representable gray scales and St (square micrometers) indicates the size of the unit transistor, are satisfied.

In addition, the present invention provides an EL display device. This EL display device comprises:

a display region in which EL elemental devices are arranged in a matrix, and
a source driver which supplies in electric current form a video signal to the EL elemental device,

wherein the source driver has a transistor group made up of a first transistor and a plurality of second transistors in current-mirror connection with the first transistor, and
wherein the transistor group is formed in a region the area of which does not exceed 2 square millimeters.

Furthermore, in the above-described EL display device of the present invention, it is preferable that the first transistor is made up of a plurality of unit transistors, and that the plural unit transistors are formed in a region the area of which does not exceed 2 square millimeters.

In addition, the present invention provides an EL display device. This EL display device comprises:

a display region in which pixels each having a respective EL elemental device are arranged in a matrix, and
a transistor elemental device formed in the pixel,
a gate driver for the ON/OFF control of the transistor elemental device, and
a source driver for supplying a video signal to the transistor elemental device,

wherein the gate driver is formed by a P channel transistor,
wherein the transistor formed in the pixel is a P channel transistor, and
wherein the source driver is formed by a semiconductor chip.

Furthermore, the present invention provides an EL display device. This EL display device comprises:

a display region in which an EL elemental device, a drive transistor, a first switching elemental device which establishes a path between the drive transistor and the EL elemental device, and a second switching elemental device which establishes a path between the drive transistor and a source signal line,
a first gate driver for the ON/OFF control of the first switching elemental device,
a second gate driver for the ON/OFF control of the second switching elemental device, and
a source driver which applies a video signal to the transistor elemental device,

wherein the gate driver is formed by a P channel transistor,
wherein a transistor formed in a pixel and the switching elemental devices are P channel transistor elemental devices, and
wherein the source driver is formed by a semiconductor chip.

Furthermore, in the above-described EL display device of the present invention, it is preferable that the source driver outputs a video signal in electric current form.

Finally, in the above-described EL display device of the present invention, it is preferable that the gate driver performs shifting operations by four clock signals.

These objects as well as other objects, features and advantages of the present invention will become apparent to those skilled in the art from the following description with reference to the accompanying drawings.

Brief Description of Drawings

Figure 1 is a diagram illustrating a pixel configuration of an EL display panel according to the present invention.
Figure 2 is a diagram illustrating a pixel configuration of an EL display panel according to the present invention.
Figure 3 is an explanatory diagram illustrating an operation of an EL display panel according to the present invention.
Figure 4 is an explanatory chart illustrating an operation of an EL display panel according to the present invention.
Figure 5 is an explanatory view illustrating a method of driving an EL display apparatus according to the present invention.
Figure 6 is a diagram illustrating a configuration of an EL display apparatus according to the present invention.
Figure 7 is an explanatory view illustrating a method of manufacturing an EL display panel according to the present invention.
Figure 8 is a diagram illustrating a configuration of an EL display apparatus according to the present invention.
Figure 9 is a diagram illustrating a configuration of an EL display apparatus according to the present invention.
Figure 10 is a sectional view of an EL display panel according to the present invention.
Figure 11 is a sectional view of an EL display panel according to the present invention.
Figure 12 is an explanatory chart illustrating an EL display panel according to the present invention.
Figure 13 is an explanatory view illustrating a method of driving an EL display apparatus according to the present invention.
Figure 14 is an explanatory chart illustrating a method of driving an EL display apparatus according to the present invention.
Figure 15 is an explanatory chart illustrating a method of driving an EL display apparatus according to the present invention.
Figure 16 is an explanatory view illustrating a method of driving an EL display apparatus according to the present invention.
Figure 17 is an explanatory chart illustrating a method of driving an EL display apparatus according to the present invention.
Figure 18 is an explanatory chart illustrating a method of driving an EL display apparatus according to the present invention.
Figure 19 is an explanatory view illustrating a method of driving an EL display apparatus according to the present invention.
Figure 20 is an explanatory view illustrating a method of driving an EL display apparatus according to the present invention.
Figure 21 is an explanatory chart illustrating a method of driving an EL display apparatus according to the present invention.
Figure 22 is an explanatory view illustrating a method of driving an EL display apparatus according to the present invention.
Figure 23 is an explanatory chart illustrating a method of driving an EL display apparatus according to the present invention.

Figure 24 is an explanatory view illustrating a method of driving an EL display apparatus according to the present invention.

Figure 25 is an explanatory chart illustrating a method of driving an EL display apparatus according to the present invention.

Figure 26 is an explanatory diagram illustrating a method of driving an EL display apparatus according to the present invention.

Figure 27 is an explanatory view illustrating a method of driving an EL display apparatus according to the present invention.

Figure 28 is an explanatory diagram illustrating a method of driving an EL display apparatus according to the present invention.

Figure 29 is an explanatory view illustrating a method of driving an EL display apparatus according to the present invention.

Figure 30 is an explanatory view illustrating a method of driving an EL display apparatus according to the present invention.

Figure 31 is an explanatory chart illustrating a method of driving an EL display apparatus according to the present invention.

Figure 32 is an explanatory diagram illustrating a method of driving an EL display apparatus according to the present invention.

Figure 33 is an explanatory diagram illustrating a method of driving an EL display apparatus according to the present invention.

Figure 34 is a diagram illustrating a configuration of an EL display apparatus according to the present invention.

Figure 35 is an explanatory chart illustrating a method of driving an EL display apparatus according to the present invention.

Figure 36 is an explanatory chart illustrating a method of driving an EL display apparatus according to the present invention.

Figure 37 is a diagram illustrating a configuration of an EL display apparatus according to the present invention.

Figure 38 is a diagram illustrating a configuration of an EL display apparatus according to the present invention.

Figure 39 is an explanatory diagram illustrating a method of driving an EL display apparatus according to the present invention.

Figure 40 is a diagram illustrating a configuration of an EL display apparatus according to the present invention.

Figure 41 is a diagram illustrating a configuration of an EL display apparatus according to the present invention.

Figure 42 is a diagram illustrating a pixel configuration of an EL display panel according to the present invention.

Figure 43 is a diagram illustrating a pixel configuration of an EL display panel according to the present invention.

Figure 44 is an explanatory diagram illustrating a method of driving an EL display apparatus according to the present invention.

Figure 45 is an explanatory chart illustrating a method of driving an EL display apparatus according to the present invention.

Figure 46 is an explanatory chart illustrating a method of driving an EL display apparatus according to the present invention.

Figure 47 is a diagram illustrating a pixel configuration of an EL display panel according to the present invention.

Figure 48 is a diagram illustrating a configuration of an EL display apparatus according to the present invention.'

Figure 49 is an explanatory chart illustrating a method of driving an EL display apparatus according to the present invention.

Figure 50 is a diagram illustrating a pixel configuration of an EL display panel according to the present invention.

Figure 51 is a diagram illustrating a pixel of an EL display panel according to the present invention.

Figure 52 is an explanatory chart illustrating a method of driving an EL display apparatus according to the present invention.

Figure 53 is an explanatory diagram illustrating a method of driving an EL display apparatus according to the present invention.

Figure 54 is a diagram illustrating a pixel configuration of an EL display panel according to the present invention.

Figure 55 is an explanatory diagram illustrating a method of driving an EL display apparatus according to the present invention.

Figure 56 is an explanatory diagram illustrating a method of driving an EL display apparatus according to the present invention.

Figure 57 is an explanatory view illustrating a mobile phone according to the present invention.

Figure 58 is an explanatory view illustrating a view finder according to the present invention.

Figure 59 is an explanatory view illustrating a digital video camera according to the present invention.

Figure 60 is an explanatory view illustrating a digital still camera according to the present invention.

Figure 61 is an explanatory view illustrating a television set (monitor) according to the present invention.

Figure 62 is a diagram illustrating a pixel configuration of a conventional EL display panel.

Figure 63 is a functional block diagram of a driver circuit of the present invention;

Figure 64 is an explanatory diagram of a driver circuit of the present invention;

Figure 65 is an explanatory diagram of a driver circuit of the present invention;

Figure 66 is an explanatory diagram of a multi-stage type current mirror circuit of the voltage transfer system;

Figure 67 is an explanatory diagram of a multi-stage type current mirror circuit of the current transfer system;

Figure 68 is an explanatory diagram of a driver circuit in another exemplary embodiment of the present invention;

Figure 69 is an explanatory diagram of a driver circuit in still another exemplary embodiment of the present invention;

Figure 70 is an explanatory diagram of a driver circuit in a further exemplary embodiment of the present invention;

Figure 71 is an explanatory diagram of a driver circuit in another exemplary embodiment of the present invention;

Figure 72 is an explanatory diagram of a driver circuit of the present invention;

Figure 73 is an explanatory diagram of a driver circuit of the present invention;

Figure 74 is an explanatory diagram of a driver circuit of the present invention;

Figure 75 is an explanatory diagram of a driver circuit of the present invention;

Figure 76 is an explanatory diagram of a driver circuit of the present invention;

Figure 77 is a diagram serving to explain a method for controlling a driver circuit of the present invention;

Figure 78 is an explanatory diagram of a driver circuit of the present invention;

Figure 79 is an explanatory diagram of a driver circuit of the present invention;

Figure 80 is an explanatory diagram of a driver circuit of the present invention;

Figure 81 is an explanatory diagram of a driver circuit of the present invention;

Figure 82 is an explanatory diagram of a driver circuit of the present invention;

Figure 83 is an explanatory diagram of a driver circuit of the present invention;

Figure 84 is an explanatory diagram of a driver circuit of the present invention;

Figure 85 is an explanatory diagram of a driver circuit of the present invention;

Figure 86 is an explanatory diagram of a driver circuit of the present invention;

Figure 87 is an explanatory diagram of a driver circuit of the present invention;

Figure 88 is a diagram serving to explain a drive method of the present invention;

Figure 89 is an explanatory diagram of a driver circuit of the present invention;

Figure 90 is a diagram serving to explain a drive method of the present invention;

Figure 91 is a diagram showing a constructional arrangement of an EL display device of the present invention;

Figure 92 is a diagram showing a constructional arrangement of an EL display device of the present invention;

Figure 93 is an explanatory diagram of a driver circuit of the present invention;

Figure 94 is an explanatory diagram of a driver circuit of the present invention;

Figure 95 is a diagram showing a constructional arrangement of an EL display device of the present invention;

Figure 96 is a diagram showing a constructional arrangement of an EL display device of the present invention;

Figure 97 is a diagram showing a constructional arrangement of an EL display device of the present invention;

Figure 98 is a diagram showing a constructional arrangement of an EL display device of the present invention;

Figure 99 is a diagram showing a constructional arrangement of an EL display device of the present invention;

Figure 100 is a cross sectional view of an EL display device of the present invention;

Figure 101 is a cross sectional view of an EL display device of the present invention;

Figure 102 is a diagram showing a constructional arrangement of an EL display device of the present invention;

Figure 103 is a diagram showing a constructional arrangement of an EL display device of the present invention;

Figure 104 is a diagram showing a constructional arrangement of an EL display device of the present invention;

Figure 105 is a diagram showing a constructional arrangement of an EL display device of the present invention;

Figure 106 is a diagram showing a constructional arrangement of an EL display device of the present invention;

Figure 107 is a diagram showing a constructional arrangement of an EL display device of the present invention;

Figure 108 is a diagram showing a constructional arrangement of an EL display device of the present invention;

Figure 109 is a diagram showing a constructional arrangement of an EL display device of the present invention;

Figure 110 is an explanatory diagram of a source driver of the present invention;

Figure 111 is a block diagram of a gate driver of the present invention;

Figure 112 is a timing chart diagram of the Figure 111 gate driver;

Figure 113 is a block diagram depicting a part of a gate driver of the present invention;

Figure 114 is a timing chart diagram of the Figure 113 gate driver;

Figure 115 is a diagram serving to explain a method of driving an EL display device of the present invention;

Figure 116 is a diagram serving to explain a method of driving an EL display device of the present invention; and

Figure 117 is a diagram serving to explain a method of driving an EL display device of the present invention.

Best Mode for Carrying Out the Invention

Hereinafter, embodiments of the present invention will be described with reference to the drawings.

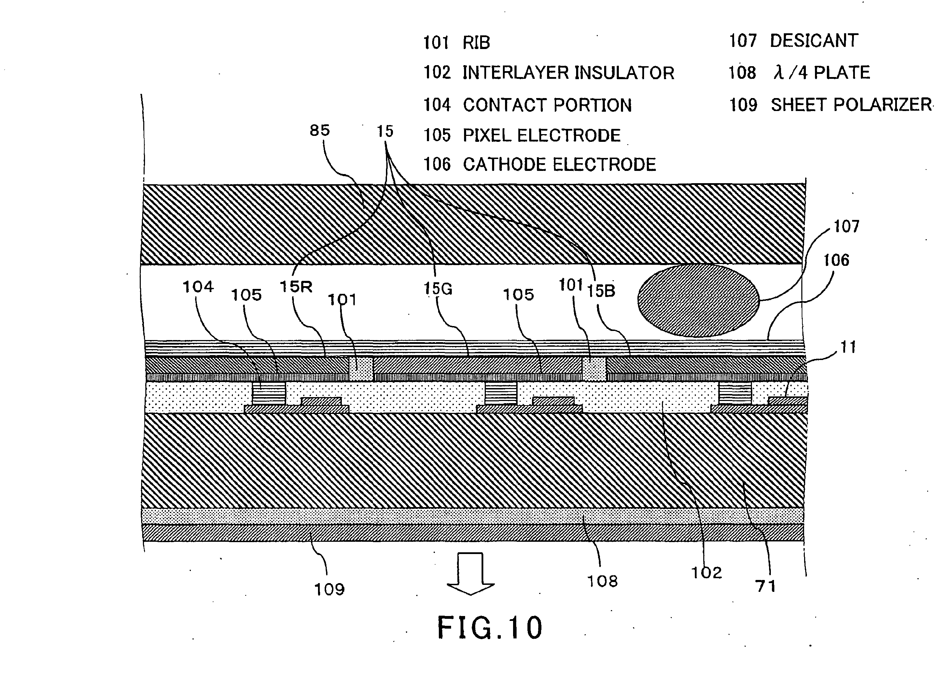

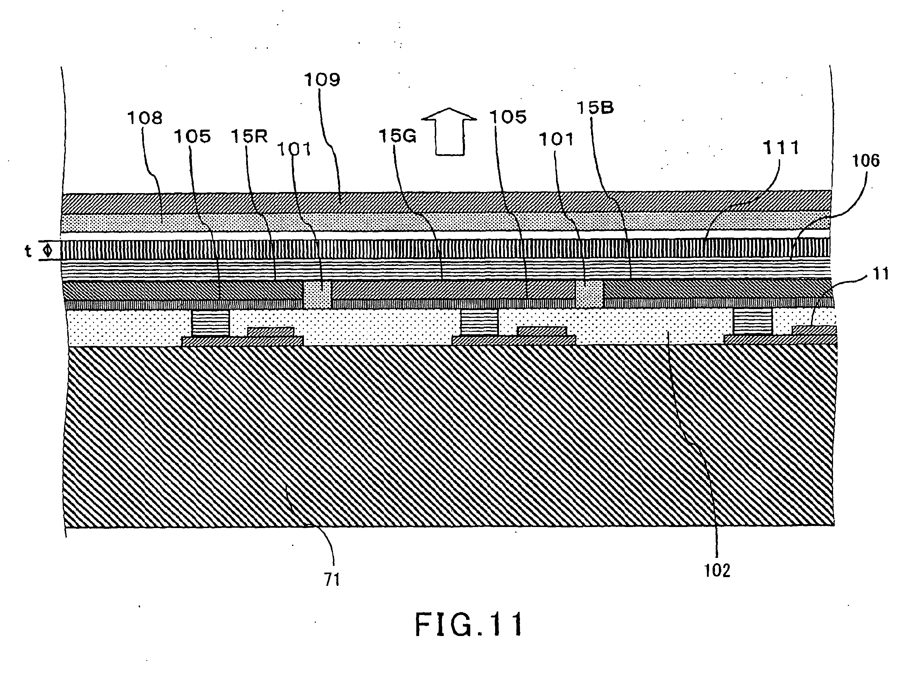

For easy understanding and/or illustration, each of the drawings in this description may have portions omitted and/or enlarged/reduced. For example, an encapsulating film 111 and the like are shown to be quite thick in the sectional view of a display panel at Figure 11. On the other hand, an encapsulating cover 85 is shown to be thin in Figure 10. There are omitted portions. For example, a display panel or the like according to the present invention needs to have a phase film such as a circularly polarizing plate for antireflection. However, such a phase film is omitted from the drawings used in this description. This holds true for other drawings. Like numerals, characters or the like designate parts having identical or similar forms, materials, functions or operations.

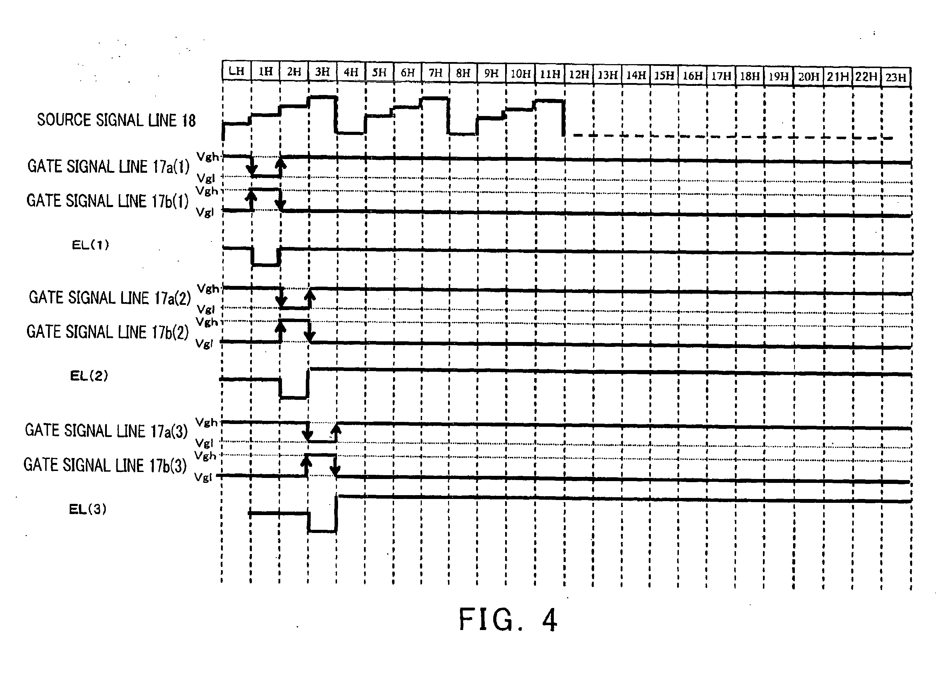

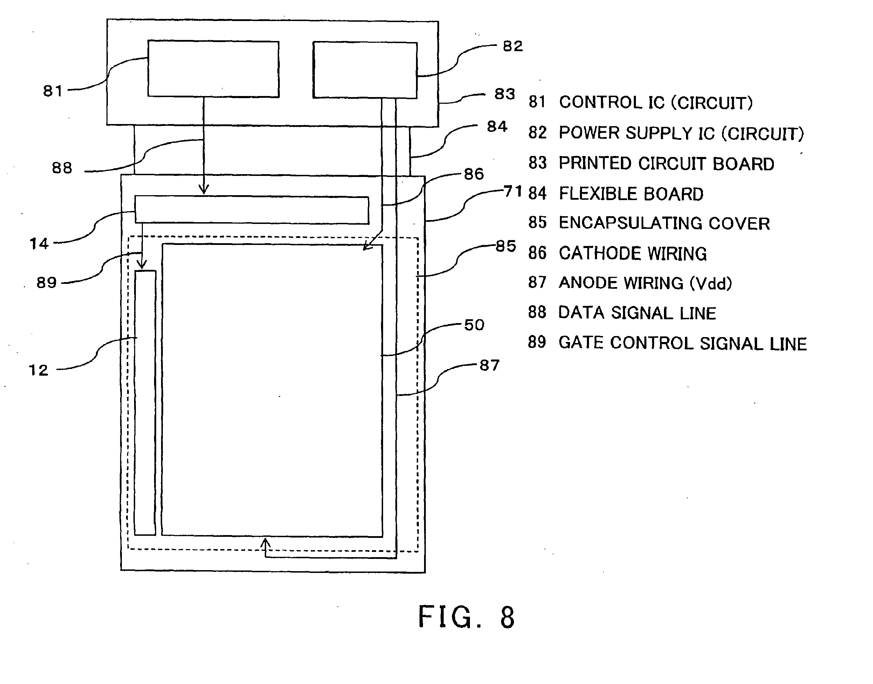

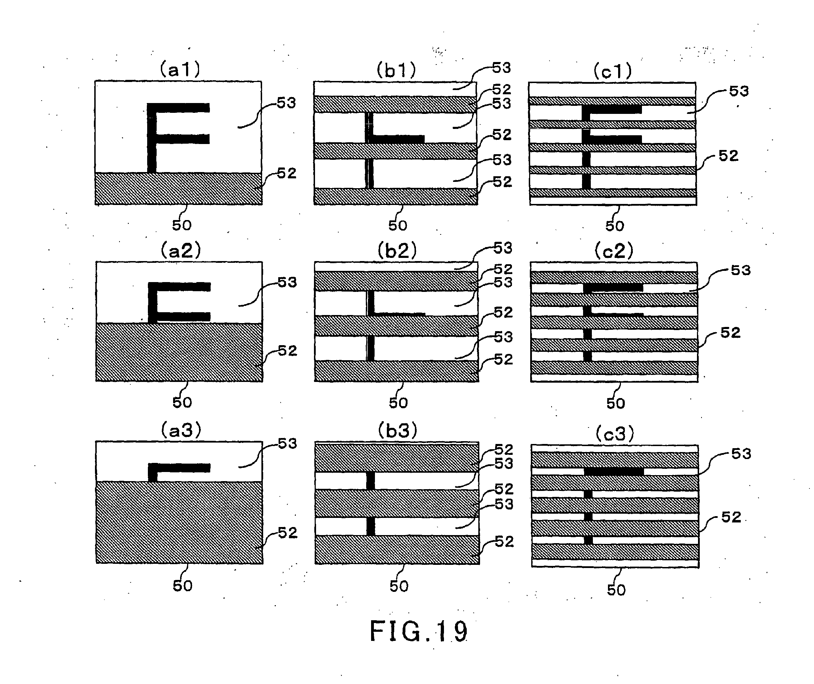

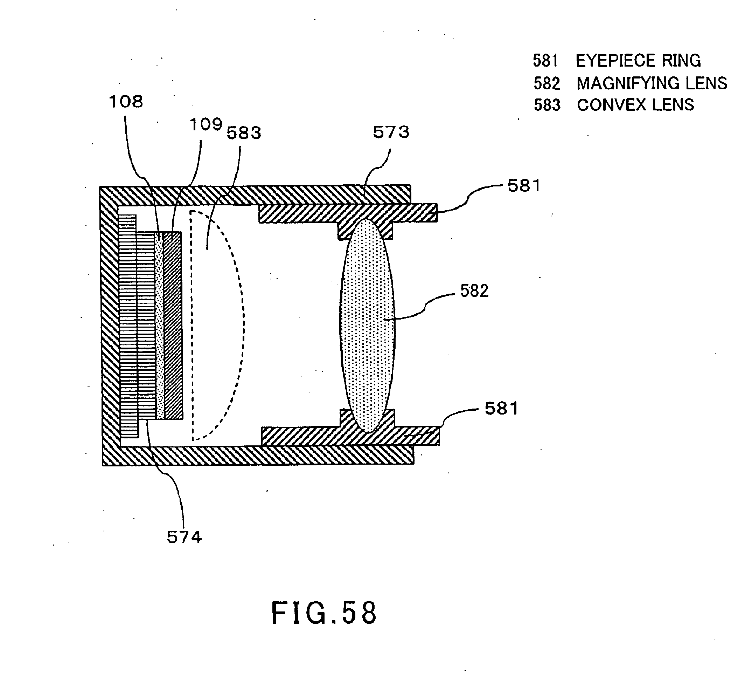

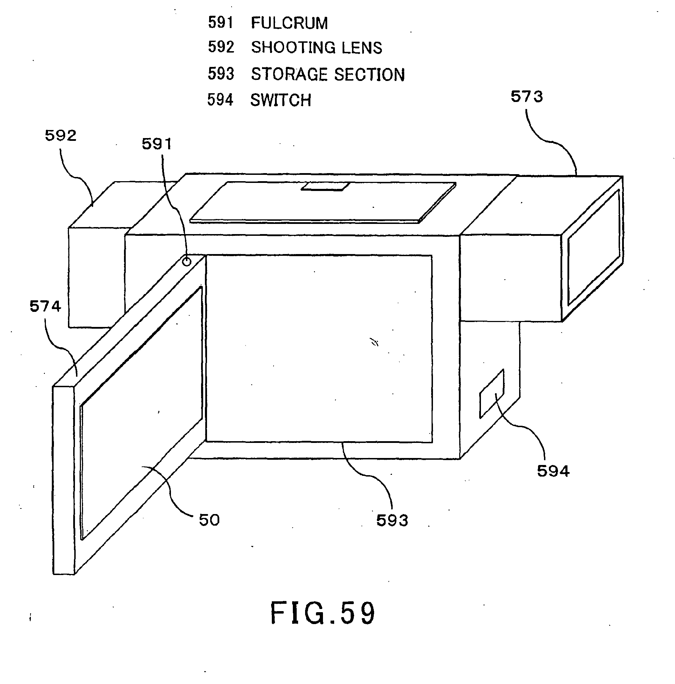

It is to be noted that the details to be described with reference to the drawings may be combined with other embodiments and the like. For example, a touch panel or the like may be added to a display panel shown in Figure 8 to form an information display apparatus illustrated in any one of Figs. 19 and 59 to 61. Alternatively, a magnifying lens 582 may be attached to the display panel to form a view finder (see Figure 58) for use in a video camera (see Figure 59 and the like). Any one of the driving methods to be described with reference to Figs. 4, 15, 18, 21 and 23 and like figures is applicable to any one of display apparatus or display panels according to the present invention.

While driving transistors 11 and switching transistors 11 will be described to be thin film transistors in this description, they are not limited to thin film transistors. Each of the transistors 11 may comprise a thin film diode (TFD), ring diode, or the like. Further, each transistor 11 is not limited to such a thin film device but may comprise a device formed on a silicon wafer. Of course, any one of FET, MOS-FET, MOS transistors and a bipolar transistor can serve the purpose. These are basically thin film transistors. It is needless to say that other devices such as a varistor, thyrister, ring diode, photodiode, phototransistor, and PLZT device can serve the purpose. That is, each of the switching devices 11 and driving devices 11 may comprise any one of the devices mentioned above.

As shown in Figure 10, an organic EL display panel includes at least one organic functional layer (EL layer) 15(15R, 15G and 15B) comprising an electron transport layer, a luminescent layer, hole transport layer and the like, and a metal electrode (reflective film) (cathode) 106, which are stacked on a glass plate 71 (array substrate) formed with a transparent electrode 105 as a pixel electrode. The organic functional layer (EL layer) 15 is caused to emit light by applying the anode consisting of the transparent electrode (pixel electrode) 105 and the cathode consisting of the metal electrode (reflective electrode) 106 with a positive voltage and a negative voltage, respectively; stated otherwise, by applying direct current across the transparent electrode 105 and the metal electrode 106.

A high current passes through wiring for feeding current to the anode or the cathode (cathode wiring 86 or anode wiring 87 in Figure 8). When the screen size of an EL display apparatus is 40 inches for example, a current of about 100 A passes therethrough. Therefore, such wiring needs to have a sufficiently low value of resistance. To solve this problem, the present invention firstly forms thin film wiring to the anode or the like (wiring for feeding EL devices with a luminescence-causing current). The thin film wiring is then thickened with an electrolytic plating technique or an electroless plating technique.

Examples of metals for use in plating include chromium, nickel, gold, copper, and aluminum, or alloys, amalgams or laminated structures thereof. As the need arises, the wiring is added with identical wiring or metal wiring comprising wiring and copper foil. Alternatively, the wiring is thickened to have decreased wiring resistance by screen printing over the wiring with copper paste or the like to stack the paste or the like thereon. The wiring may be reinforced by superposition of additional wiring thereon using a bonding technique. As needs dictate, a grand pattern may be formed over the wiring to form a capacitor therebetween.

To feed the anode or cathode wiring with a high current, a power wire for supply of a power having a low current and a high voltage is routed from current feeding means to a location in the vicinity of the anode wiring or the like and the power is converted into a power having a low voltage and a high current with a DCDC converter or the like before being fed to the anode wiring or the like. That is, a high-voltage and low-current wire is routed from the power source to a power-consuming target and the power fed therethrough is converted into a high-current and low-voltage power at a location short of reaching the power-consuming target. Examples of such converter means include a DCDC converter, and a transformer.

Preferable materials for the metal electrode 106 include lithium, silver, aluminum, magnesium, indium and copper, or their respective alloys or like materials having low work functions. Particularly preferable is an Al-Li alloy for example. On the other hand, the transparent electrode 105 may comprise a conductor material having a high work function, such as ITO, or gold or the like. If gold is used as the electrode material, the resulting electrode is translucent. ITO may be substituted with another material such as IZO. This holds true for other pixel electrodes 105.

In the vapor deposition of a thin film over the pixel electrode 105 or the like, it is convenient to form organic EL film 15 in an argon atmosphere. By forming a carbon film having a thickness not less than 20 nm and not more than 50 nm over ITO as the pixel electrode 105, an organic EL film can be formed which exhibits improved interface stability and satisfactory luminance and efficiency of luminescence. The process for forming the EL film 15 is not limited to vapor deposition. It is needless to say that the EL film 15 may be formed using an ink jet process.

A desiccant 107 is placed in the space defined between the encapsulating cover 85 and the array substrate 71. This is because the organic EL film 15 is easily affected by humidity. The desiccant 107 absorbs moisture permeating through sealant thereby preventing the organic EL film 15 from deteriorating.

Figure 10 shows an arrangement of encapsulation with cover 85 of glass. Encapsulation may be achieved using a film (which may be a thin film, i.e., encapsulating thin film) 111 as shown in Figure 11. An example of such an encapsulating film (encapsulating thin film) 111 is a film formed by vapor deposition of DLC (diamond-like carbon) on a film for use in electrolytic capacitors. This film has very poor water permeability (i.e. high moistureproofness) and hence is used as the encapsulating film 111. It is needless to say that an arrangement in which a DLC film or the like is vapor-deposited directly over the electrode 106 can serve the purpose. Alternatively, the encapsulating thin film may comprise a multi-layered film formed by stacking a resin thin film and a metal thin film on the other.

The thickness of the thin film is preferably established so that n• d is not more than the dominant wavelength $\lambda$ of light emitted from the EL device 15, wherein n represents the refractive index of the thin film (if plural thin films are stacked on each other, calculation is made with their respective refractive indexes totalized (n• d is calculated for each thin film), and d represents the thickness of the thin film (if plural thin films are stacked on each other, calculation is made with their respective refractive indexes totalized.) With this condition being satisfied, the efficiency in taking light out of EL device 15 is twice or more as high as that of the case where encapsulation is made with a glass substrate. An alloy, mixture or stack of aluminum and silver may be formed as the encapsulating thin film.

Such encapsulation with encapsulating film 111 and without cover 85 as described above is referred to as thin film encapsulation. In the thin film encapsulation to be applied to the case where light is taken out from the substrate 71 side, which is referred to as downward takeout (see Figure 10 in which the arrow indicates the light takeout direction), an aluminum film to be used as the cathode is formed over the EL film formed in advance. Subsequently, a resin layer to serve as a buffer layer is formed over the aluminum film. Examples of materials for the buffer layer include organic materials such as acrylic resin and epoxy resin. The thickness of the buffer layer is suitably not less than 1 $\mu$m and not more than 10 $\mu$m, more preferably not less than 2 $\mu$m and not more than 6 $\mu$m. Further, encapsulating film 74 is formed over the buffer film. Without the buffer layer, the structure of the EL film would collapse, causing streak-like defects to occur. As described above, the encapsulating film 111 comprises, for example, DLC (diamond-like carbon) or a layered structure for electrolytic capacitors (a multi-layered structure in which a dielectric thin film and an aluminum thin film are formed alternately by vapor deposition.)

In the thin film encapsulation to be applied to the case where light is taken out from the EL layer 15 side, which is referred to as upward takeout (see Figure 10 in which the arrow indicates the light takeout direction), an Ag-Mg film to be used as the cathode (or the anode) is formed to a thickness not less than 20 angstroms and not more than 300 angstroms over the EL film formed in advance. Subsequently, a transparent electrode comprising ITO or the like is formed over the AG-Mg film to lower the resistance, followed by the formation of a resin film as a buffer layer over the electrode film. Further, encapsulating film 111 is formed over the buffer film.

A half of the amount of light emitted from the organic EL layer 15 is reflected by reflective film 106, passes through the array substrate 71, and is then emitted from the panel. However, undesired reflection occurs due to the reflective film 106 reflecting extraneous light, causing the display contrast to lower. As the measures to avoid this inconvenience, a $\lambda$/4 plate 108 and a sheet polarizer (polarizing film) 109 are disposed at the array substrate 71. These are generally called a circularly polarizing plate (circularly polarizing sheet).

If the pixels comprise a reflective electrode, light generated from the EL layer 15 is emitted upward. It is therefore needless to say that the phase plate 108 and the sheet polarizer 109 are disposed on the light-emitting side in this case. Such reflective-type pixels can be obtained by forming pixel electrode 105 of aluminum, chromium, silver or the like. If the surface of the pixel electrode 105 is provided with projections (or projections and depressions), the interface with the organic EL layer 15 is enlarged, which increases the light-emitting area and improves the luminescence efficiency. It should be noted that when it is possible to form a reflective film to serve as cathode 106 (or anode 105) on a transparent electrode or reduce the reflectance to 30% or lower, the circularly polarizing plate is unnecessary. This is because undesired reflection of extraneous light is reduced to a large extent. Further, such an arrangement reduces interference of light and hence is desirable.

Preferably, each transistor 11 employs a LDD (lightly doped drain) structure. Though the organic EL device (which is variously abbreviated as OEL, PEL, PLED, OLED or the like) 15 is exemplified as the EL device in this description, it is needless to say that an inorganic EL device is applicable to the present invention without limitation to the organic EL device.

The active-matrix configuration used for the organic EL display panel has to satisfy the following two conditions:

(1) the active-matrix configuration is capable of selecting a specified pixel and giving the pixel required information; and
(2) the active-matrix configuration is capable of passing a current through each EL device throughout a one-frame period.

To satisfy these two conditions, the pixel configuration of the conventional organic EL device shown in Figure 62 uses first transistor 211b as a switching transistor for pixel selection and second transistor 211a as a driving transistor for feeding EL device (EL film) 215 with current.

In causing this configuration to realize grayscale display, the driving transistor 211a needs to be applied a voltage corresponding to a level of gray as a gate voltage. Accordingly, fluctuations of on-current in the driving transistor 211a are directly reflected in image display

The on-current in a transistor formed of single crystal is extremely invariant, whereas a low-temperature polycrystalline transistor, which is formed by the low temperature polysilicon technology which enables the formation of a transistor on an inexpensive glass substrate at 450°C or lower, has a threshold voltage varying in the range from ±0.2 V to ±0.5 V For this reason, the on-current passing through the driving transistor 211a fluctuates with variations in threshold voltage, resulting in display irregularities. Such irregularities occur due not only to variations in threshold voltage but also to variations in the mobility, gate insulator thickness or the like of the transistor. Also, the characteristics of the transistor 211 vary as the transistor 211 deteriorates.

This phenomenon is possible to occur not only with the low temperature polysilicon technology but also with other technology including the high temperature polysilicon technology using a processing temperature of 450°C or higher and the technology of forming a transistor using a semiconductor film resulting from solid phase (CGS) growth. As well, the phenomenon occurs with organic transistors and amorphous silicon transistors. Therefore, the present invention to be described below is directed to configurations or methods capable of taking measures depending on those technologies. In this description, however, transistors of the type formed by the low temperature polysilicon technology are described mainly.

With the method of gray scale display by writing with voltage as shown in Figure 62, device characteristics need to be controlled precisely for providing an invariant display. With the low temperature polysilicon transistor or the like presently available, however, the requirement of controlling variations in device characteristics to within predetermined ranges cannot be satisfied.

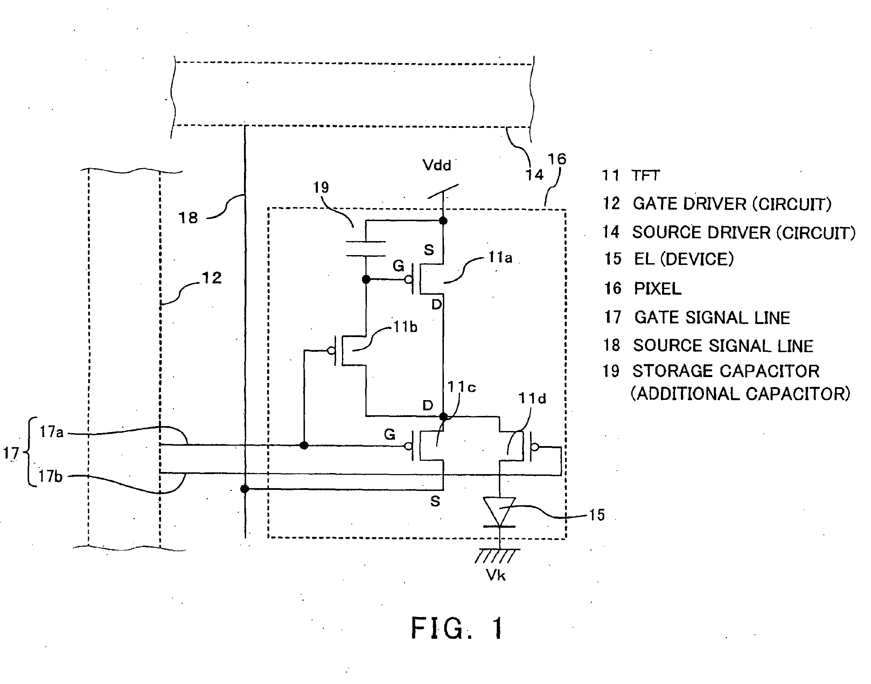

In the pixel structure of the EL display apparatus according to the present invention, a unit pixel comprises four transistors 11 and an EL device, as specifically shown in Figure 1. The pixel electrode is formed as overlapping the source signal lines. More specifically, source signal lines 18 are insulated by the formation of an insulating film or a planarizing film comprising an acrylic material over the source signal lines 18, and then pixel electrode 105 is formed on the insulating film. Such a structure that a pixel electrode overlaps at least a part of source signal lines is called a high aperture (HA) structure. This structure can be expected to reduce useless interference light and ensure favorable luminescence.

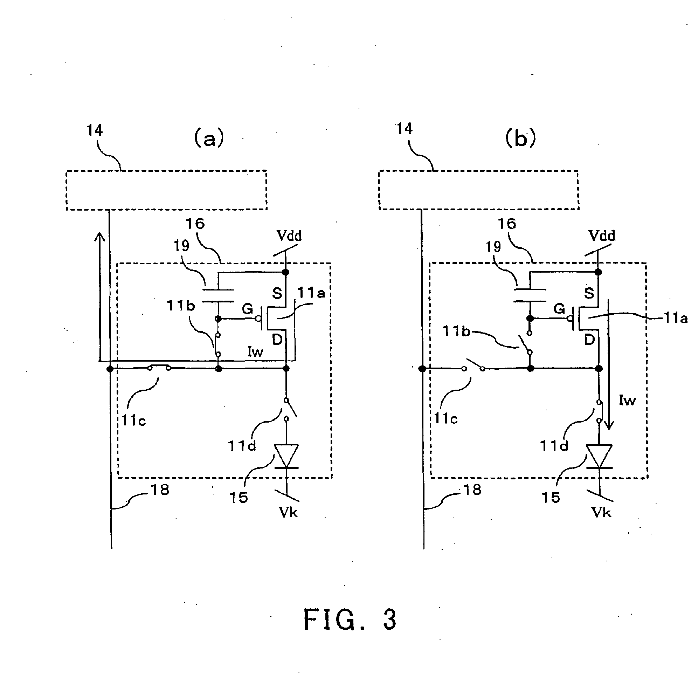

When gate signal line (first scanning line) 17a is rendered active (applied with on-voltage) by outputting of a gate signal thereto, the source driver 14 feeds EL device 15 with a current having a value required by EL device 15 through driving transistor 11a and switching transistor 11c associated with the EL device 15. By rendering gate signal line 17a active (applying the gate signal line with on-voltage) in a manner to shortcircuit the gate and the drain of the transistor 11a, the transistor 11b is opened and, at the same time, the gate voltage (or the drain voltage) of the transistor 11a is stored in capacitor (storage capacitor or additional capacitor) 19 connected between the gate and the source of the transistor 11a (see Figure 3(a).)

The capacitor 19 intermediate the source (S) and the gate (G) of the transistor 11a preferably has a capacitance of 0.2 pF or more. A structure having capacitor 19 formed separately is exemplified as another structure. That is, the structure has a storage capacitor comprising a capacitor electrode layer, a gate insulator and gate metal. Such a separately-formed capacitor is preferable from the viewpoints of preventing a decrease in luminance due to leakage from the transistor 11c and stabilizing the display operation.

The capacitor (storage capacitor) 19 preferably has a capacitance not less than 0.2 pF and not more than 2 pF, particularly preferably not less than 0.4 pF and not more than 1.2 pF. The capacitance of the capacitor 19 is determined in view of a pixel size. Assuming that Cs (pF) is the capacitance required for one pixel and Sp (square µm) is the area occupied by one pixel (not the effective aperture ratio), Cs and Sp preferably satisfy $500/S \leqq Cs \leqq 20000/S$, more preferably $1000/Sp \leqq Cs \leqq 10000/Sp$. Since the capacitance of the gate of the transistor is small enough, Q used here is the capacitance of the storage capacitor (capacitor) 19 alone.

Preferably, the capacitor 19 is formed substantially in a non-display region located intermediate adjacent pixels. Generally, in the formation of full color organic EL devices 15, misalignment of a mask causes misregistration of organic EL layers to occur since the EL layers are formed using a vapor deposition process with a metal mask. Such misregistration might cause organic EL layers 15 (15R, 15G and 15B) for respective colors to overlap each other. For this reason, adjacent pixels for respective colors have to be spaced 10 µ or more by the non-display region. This region does not contribute to luminescence. Therefore, the formation of storage capacitor 19 in this region is also effective means for improving the effective aperture ratio.

Subsequently, gate signal line 17a is rendered inactive (applied with off-current) and gate signal line 17b rendered active, so that the current path is switched to the path including EL device 15 and transistor 11d connected to the first transistor 11a and the EL device 15, thereby causing the current stored in the aforementioned manner to pass through the EL device 15 (see Figure 3(b).)

This circuit has four transistors 11 in one pixel, the transistor 11a having its gate connected to the source of the transistor 11b. The gates of the respective transistors 11b and 11c are connected to gate signal line 17a. The drain of the transistor 11b is connected to the drain of the transistor 11c as well as the source of the transistor 11d. The source of the transistor 11c is connected to source signal line 18. The gate of the transistor 11d is connected to gate signal line 17b, while the drain of the transistor 11d connected to the anode of the EL device 15.

All the transistors shown in Figure 1 are p-channel transistors. The p-channel transistor is preferable because it has a high breakdown voltage and is hard to deteriorate, though the p-channel transistor exhibits slightly lower mobility than the n-channel transistor. However, the present invention does not limit the transistors used in the EL device configuration to p-channel transistors. It is possible to form the EL device configuration using the n-channel transistor exclusively The EL device configuration may be formed using the n-channel transistor and the p-channel transistor both.

In Figure 1, it is preferable that the transistors 11c and 11b have the same polarity and are of the p-channel type while the transistors 11a and 11d are of the n-channel type. Generally, the p-channel transistor is characterized in the features including higher reliability and less occurrence of kink current than the n-channel transistor. Therefore, use is very effective of the p-channel transistor as the transistor 11a associated with EL device 15 which is designed to obtain a desired intensity of luminescence by current control.

Most preferably, all the transistors forming a pixel as well as incorporated gate driver 12 are of the p-channel type. By thus forming the array with exclusive use of p-channel transistors, the number of masks to be used is reduced to five, which can make the cost lower and the yield higher.

For easy understanding of the present invention, description will be made of the EL device configuration according to the present invention with reference to Figure 3. The EL device configuration of the present invention is controlled with two timings. The first timing is timing for storing a required current value. When transistors 11b and 11c are turned on at this timing, the equivalent circuit of the EL device configuration assumes the state shown in Figure 3(a). Here, a predetermined current Iw is written through a signal line. By so doing, transistor 11a is turned into a state where the gate and the drain are connected to each other and current Iw passes through the transistor 11a and transistor 11c. Accordingly, the voltage across the gate- source of transistor 11a assumes a value such as to cause current Iw to pass.

The second timing is timing for closing transistors 11b and 11c and opening transistor 11d. At this time, the equivalent circuit of the EL device configuration assumes the state shown in Figure 3(b). The voltage across the source-gate of transistor 11a is held as it is. In this case transistor 11a operates within a saturation region at all times and, hence, the value of current assumes Iw constantly.

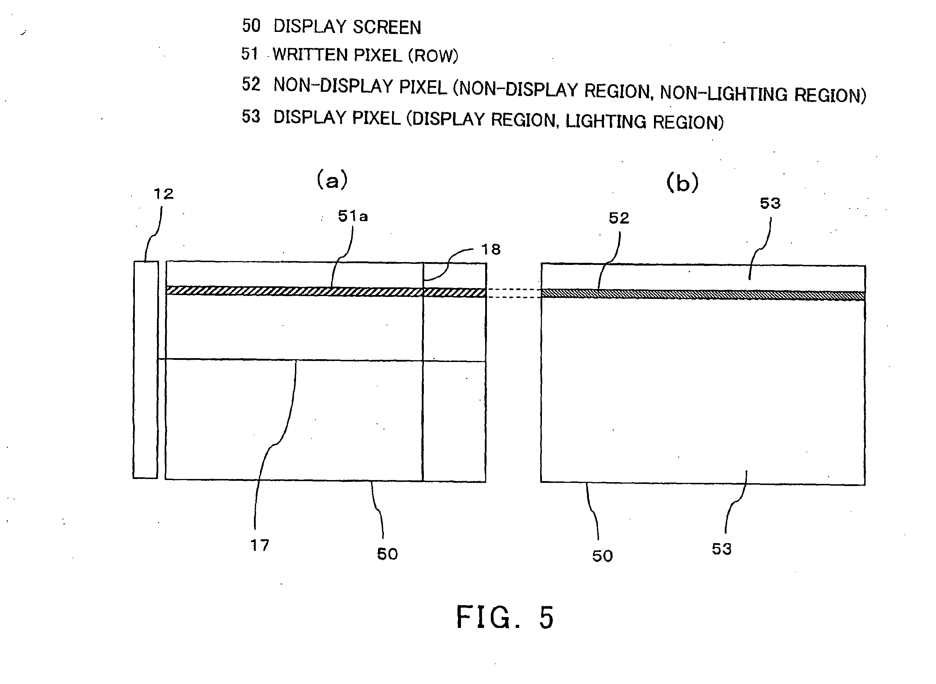

These operations cause the display apparatus to be driven as shown in Figure 5. Reference character 51a in Figure 5(a) designates a pixel (row) of display screen 50 programmed with current at a certain time point (written pixel (row).) This pixel (row) 51a is a non-lighting (non-display) pixel row as shown in Figure 5(b). Other pixels (rows) are display pixels (rows) 53. (That is, current is passing through EL devices 15 of the display pixels (rows) 53 and the EL devices 15 are emitting light.)

In the case of the pixel configuration shown in Figure 1, programming current Iw passes through source signal line 18 at the time of current-based programming. The current Iw passes through transistor 11a to make voltage setting (programming) of the capacitor 19 so that a voltage such as to cause the current Iw to pass is held. At this time transistor 11d is open (in off-state).

In a period for allowing current to pass through EL device 15, transistors 11c and 11b are turned off while transistor 11d turned on, as shown in Figure 3(b). Specifically, off-voltage (Vgh) is applied to gate signal line 17a to turn transistors 11b and 11c off. On the other hand, on-voltage (Vgl) is applied to gate signal line 17d to turn transistor 11d on.

The chart of such timing is shown in Figure 4. In Figure 4 and the like, a parenthesized additional numeral (for example, (1)) indicates a row number given to a pixel row. Specifically, gate signal line 17a(1) indicates the gate signal line 17a of pixel row (1). *H ("*" represents any character or numeral indicative of the number of a horizontal scanning line), which appears in the uppermost section of Figure 4, represents a horizontal scanning period. Specifically, 1H represents the first horizontal scanning period. These matters are for easy description and do not limit the number and the period of a one -H period, the sequence of pixel rows, and the like.

As seen from Figure 4, in each pixel row selected (the period for which the pixel row is in the selected state is 1H), gate signal line 17b is applied with off-voltage, while gate signal line 17a applied with on-voltage. In this period current does not pass through EL devices 15; that is, the EL devices 15 are in the non-lighting state. In each pixel row unselected, on the other hand, gate signal line 17a is applied with off-voltage, while gate signal line 17b applied with on-voltage. In this period current passes through EL devices 15; that is, the EL devices 15 are in the lighting state.

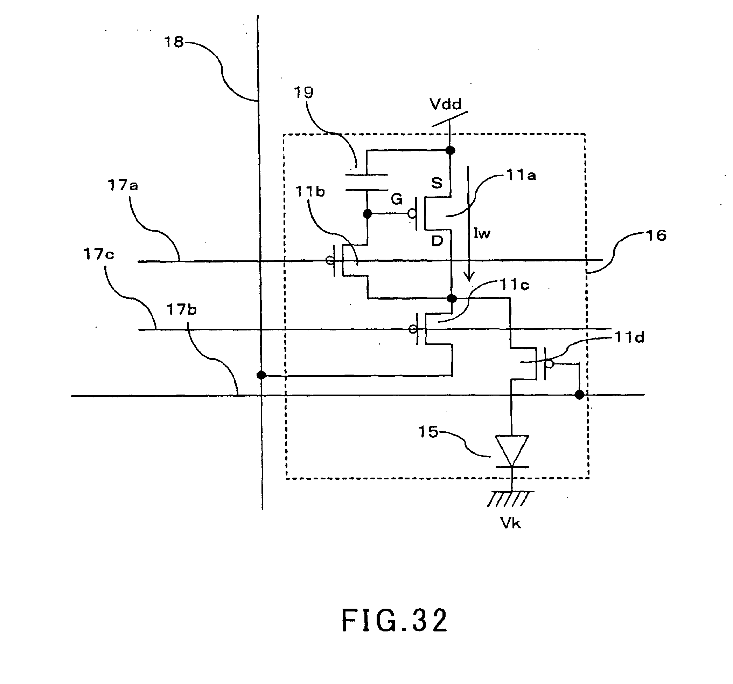

The gate of transistor 11b and that of transistor 11c are connected to the same gate signal line 17a. However, they may be connected to different gate signal lines (the gate signal lines 17a and 17c in Figure 32). In this case, the number of gate signal lines associated with one pixel is three. (The configuration shown in Figure 1 has two gate signal lines for one pixel.) By individually controlling the on-off timing for the gate of transistor 11b and that for the gate of transistor 11c, fluctuations in the value of current passing through EL devices 15 due to variations in the characteristics of transistor 11a can further be reduced.

If gate signal lines 17a and 17b formed into a common line and transistors 11c and 11d are rendered different from each other in conductivity type (i.e., n-channel type and p-channel type), it is possible to simplify the driving circuit and improve the effective aperture ratio of pixels.

With such a configuration, the writing path from a relevant signal line becomes off at the operation timing according to present invention. If the path allowing current to pass therethrough is branched when a predetermined value of current is to be written, the value of current is not exactly stored in the capacitor located intermediate the source (S) and the gate (G) of transistor 11a. Where transistors 11c and 11d are rendered different in conductivity type from each other, an operation becomes possible such that transistor 11d is necessarily turned on after transistor 11c has been turned off at timing at which a scanning line is switched to another if each other's threshold value is controlled.

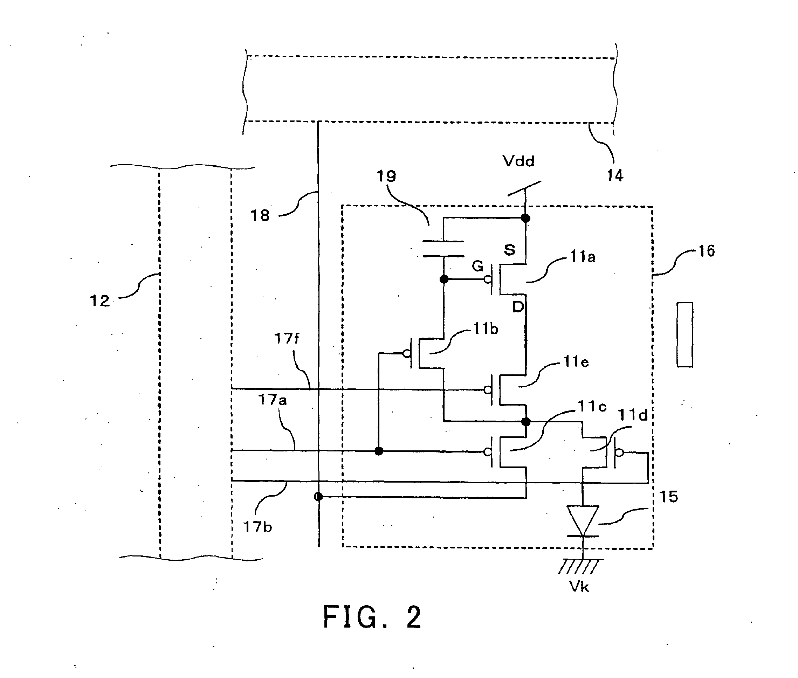

Since the transistors require that each other's threshold value be controlled accurately in this case, sufficient care is necessary in the manufacturing process. Though the above-described circuit is feasible with at least four transistors, a configuration having more than four transistors in which transistor 11e is provided as cascade-connected as shown in Figure 2 operates based on the same operating principle described above. Such a configuration with additional transistor 11e can cause a current as exact as programmed through transistor 11c to pass through EL device 15.

Variations in the characteristics of transistor 11a are correlated with the size of the transistor 11a. For reduction of such variations in characteristics, the channel length of the first transistor 11a is preferably not less than 5 μm and not more than 100 μm, more preferably not less than 10 μm and not more than 50 μm. This is because when the channel length L is made longer, the grain boundary contained in the channel increases, which is presumed to relax the electric field and hence lower the kink effect.

It is preferable that each of the transistors 11 forming a pixel comprises a polysilicon transistor formed through the laser recrystallization method (laser annealing) and the channels of all the transistors extend in the same direction with respect to the laser irradiation direction. Further, it is preferable that the laser scans the same portion twice or more to form a semiconductor film.

An object of the present invention is to propose a circuit configuration which prevents variations in transistor characteristics from affecting image display. To attain this object, four or more transistors are necessary. In determining a circuit constant from the characteristics of these transistors, it is difficult to determine a suitable circuit constant unless the four transistors are made uniform in characteristics. A transistor having a channel formed to extend in a horizontal direction with respect to the longitudinal axis of laser irradiation is different in such transistor characteristics as threshold value and mobility from a transistor having a channel formed to extend in a vertical direction with respect to the longitudinal axis of laser irradiation. The extent of variations in one case is the same as that in the other. The transistor having the channel extending in the horizontal direction and the transistor having the channel extending in the vertical direction are different from each other in a mean value of mobility and a mean value of threshold. Thus, it is desirable that the channel directions of all the transistors forming a pixel be the same.

Assuming that the capacitance of storage capacitor 19 is Cs and the value of off current applied to the second transistor 11b is Ioff, Cs and Ioff preferably satisfy the formula: $3 < Cs/Ioff < 24$.

More preferably, they satisfy the formula: $6 < Cs/Ioff < 18$.

The variation in the value of current passing through EL devices can be reduced to 2% or less by adjusting off current of transistor 11b to 5 pA or lower. This is because charge stored between the gate and the source (opposite ends of the capacitor) cannot be maintained for a one-field period when voltage is not written. Therefore, with increasing storage capacitance of the capacitor 19, allowable off-current increases. The variation in the value of current passing through adjacent pixels can be reduced to 2% or less by satisfying the aforementioned formula.

It is preferable that each of the transistors forming the active-matrix configuration comprises a p-channel polysilicon thin film transistor and transistor 11b has a multi-gated structure having at least dual gate. Since transistor 11b acts as a switch intermediate the source and the drain of transistor 11a, the highest possible on/off ratio is required of transistor 11b. By employing such a multi-gated structure having at least dual gate for the gate structure of transistor 11b, a high on/off ratio characteristic can be realized.

It is a general practice to form a semiconductor film constituting transistors 11 of pixels 16 through low temperature polysilicon technology with laser annealing. Variations in laser annealing conditions result in variations in the characteristics of transistors 11. However, if there is uniformity in the characteristics of respective transistors 11 in one pixel, a configuration adapted for current-based programming as shown in Figure 1 or the like is capable of operating so that a predetermined current may pass through EL device 15. This feature is an advantage which a voltage-based programming configuration does not have. The laser for use here is preferably an excimer laser.

In the present invention, the process used to form the semiconductor film is not limited to the laser annealing process but may be a thermal annealing process or a process based on solid phase (CGS) growth. It is needless to say that the present invention can use not only the low temperature polysilicon technology but also the high temperature polysilicon technology.

In order to solve the problem described above, annealing is performed in a manner that a laser irradiation spot (laser irradiation range) 72 extending parallel with source signal line 18 is irradiated with laser light. Further, the laser irradiation spot 72 is moved so as to coincide with one pixel column. Of course, there is no limitation to one pixel column. One pixel unit 16 comprising R,G and B may be irradiated with laser light (in this case three pixel columns are irradiated). It is possible to irradiate plural pixels at a time. It is needless to say that the laser irradiation range may be moved in an overlapping fashion. (Usually, moving laser irradiation range overlaps the preceding laser irradiation spot.)

Three pixels for R, G and B are formed to constitute a square shape. Accordingly, each of the pixels for R, G and B is vertically elongated. Thus, annealing with vertically elongated laser irradiation spot 72 makes it possible to avoid the occurrence of variations in the characteristics of transistors 11 in one pixel. Further, the transistors 11 connected to one source signal line 18 can be rendered uniform in characteristics (mobility, Vt, S value and the like.) (That is, the transistors 11 connected to one source line 18 can be made substantially to agree to each other in characteristics, though there may be a case where the transistors 11 connected to one source signal line 18 are different in characteristics from those connected to an adjacent signal line 18.)

Generally, the length of laser irradiation spot 72 is a fixed value, for example 10 inches. Since laser irradiation spot 72 moves, the panel needs to be positioned so that one laser irradiation spot 72 can move within a range allowing laser irradiation spot 72 to move therein. (That is, the panel needs to be positioned so as to prevent laser irradiation spots 72 from overlapping each other in a central portion of display region 50 of the panel.)

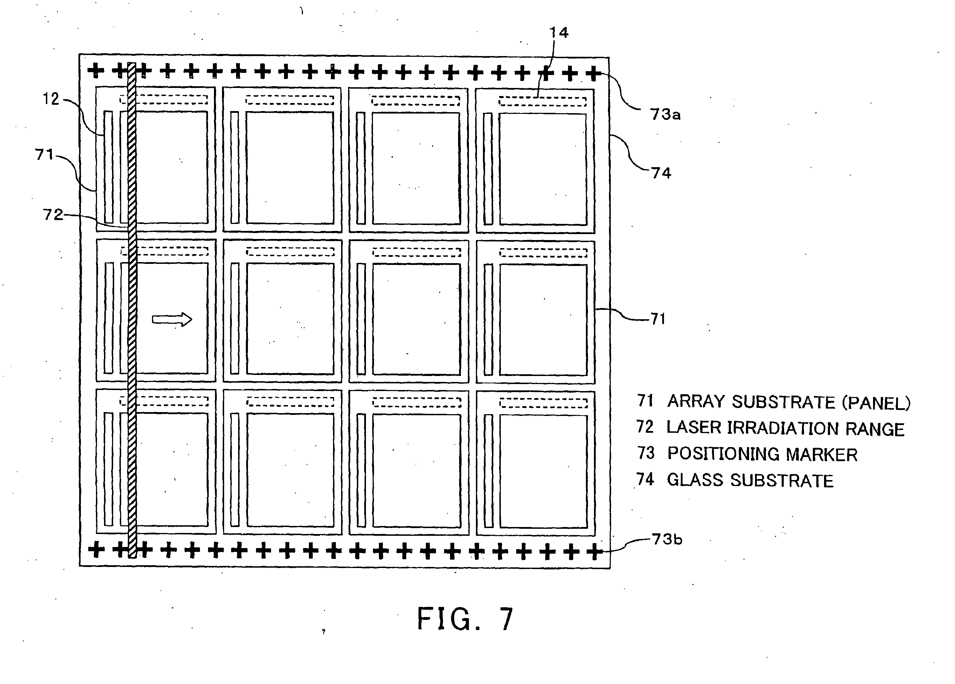

In the arrangement shown in Figure 7, three panels are formed as arranged vertically within a range corresponding to the length of laser irradiation spot 72. An annealing apparatus for irradiation of laser irradiation spot 72 recognizes positioning markers 73a and 73b provided on glass substrate 74 (automatic positioning based on pattern recognition) and moves laser irradiation spot 72. The positioning markers 73 are recognized by means of a pattern recognition device. The annealing apparatus recognizes the positioning markers 73 to find the position of a pixel column. (That is, the apparatus makes laser irradiation range 72 parallel with source signal line 18.) Sequential annealing is performed through irradiation of laser irradiation spot 72 positioned coinciding with the position of each pixel column.

Use of the laser annealing method (of the type adapted for irradiation of a linear laser spot extending parallel with source signal line 18) described with reference to Figure 7 is preferable particularly in manufacturing an organic EL display panel of the current-based programming type. This is because transistors 11 arranged parallel with a source signal line are uniform in characteristics. (That is, the characteristics of one pixel transistor are approximate to those of a vertically adjacent pixel transistor.) For this reason fluctuations in the voltage level of a source signal line which occur in current-based driving are small and, hence, insufficient writing with current is not likely to occur.

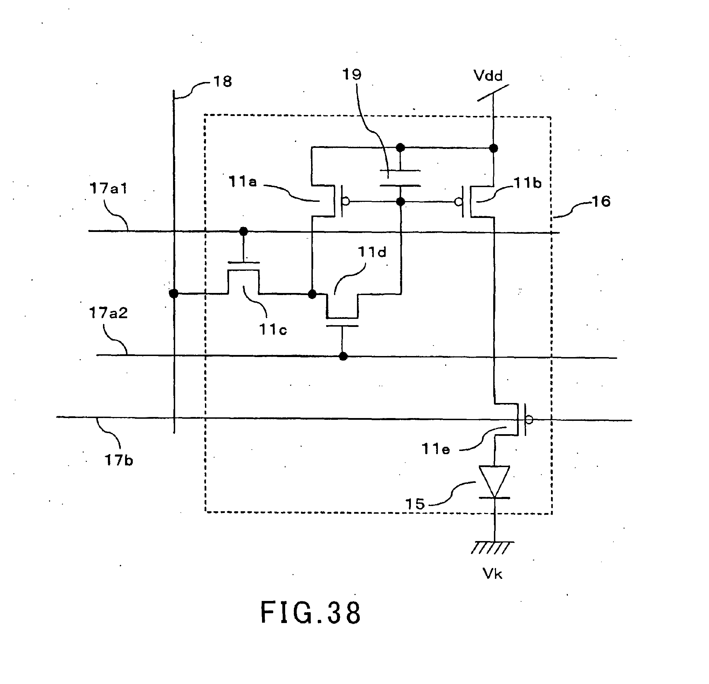

In the case of white raster display for example, a current to be passed through transistor 11a of one pixel is substantially equal to a current to be passed through transistor 11a of an adjacent pixel and, therefore, the amplitude of a current outputted from source driver 14 varies little. If transistors 11a in Figure 1 are uniform in characteristics and the values of currents for programming pixels of a pixel column are equal to each other, fluctuations in the potential of source signal line 18 do not occur. Accordingly if the transistors 11a connected to one source signal line 18 are substantially uniform in characteristics, fluctuations in the potential of the source signal line 18 are small. This also holds true for other pixel configurations of the current-based programming type as shown in Figure 38 and the like. (This means that use of the manufacturing method illustrated in Figure 7 is preferable.)

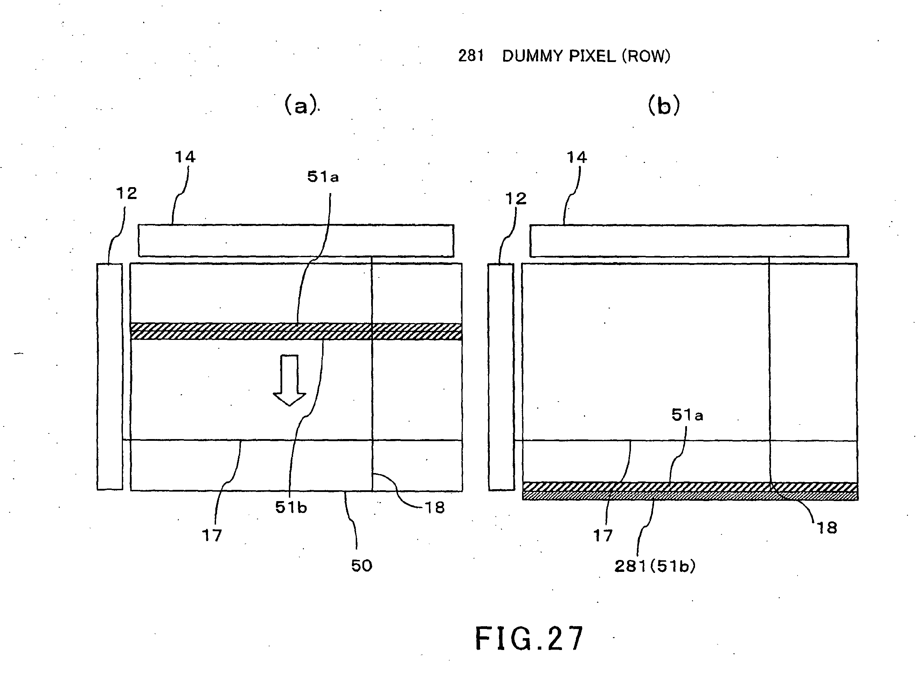

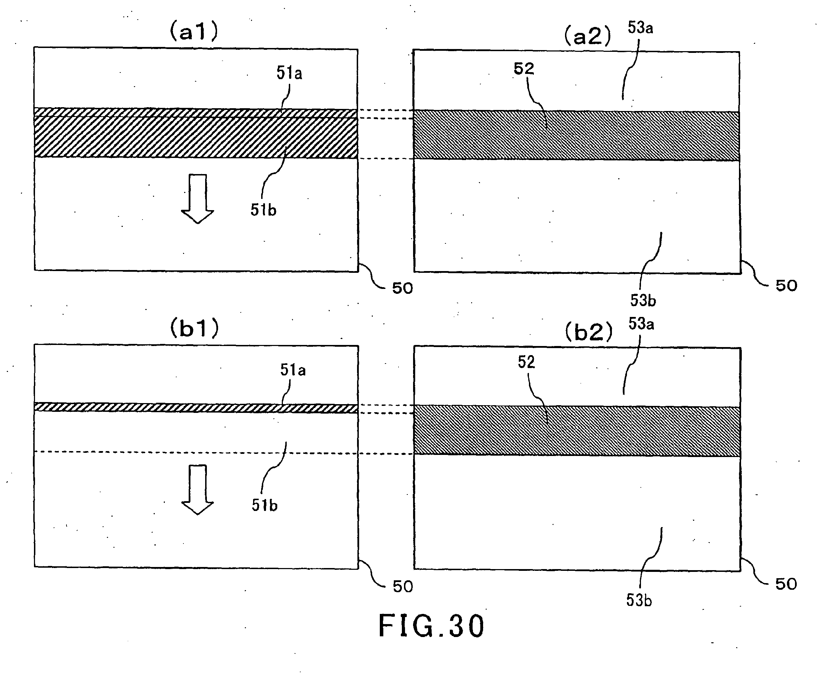

Uniform image display can also be realized by a configuration of the type adapted for writing to plural pixel rows at a time to be described with reference to Figure 27 or 30 or the like. This is mainly because display irregularities due to variations in transistor characteristics are not likely to occur. Since the configuration shown in Figure 27 or the like selects plural pixel rows at a time, driver circuit 14 can accommodate variations in the characteristics of transistors arranged vertically if the transistors of adjacent pixel rows are uniform.

Though the source driver 14 is formed as comprising an IC chip as shown in Figure 7, the formation of source driver 14 is not limited thereto. It is needless to say that source driver 14 may be formed together with pixels 16 in the same process.

In the present invention, particularly, the threshold voltage Vth2 of transistor 11b is established so as not to be lower than the threshold voltage Vth1 of transistor 11a associated with transistor 11b in one pixel. For example, the gate length L2 of transistor 11b is made longer than the gate length L1 of transistor 11a so that Vth2 may not become lower than Vth1 even when the process parameters of these thin film transistors vary. By so doing, faint leakage current can be inhibited to occur.

The above-described features are also applicable to the current mirror pixel configuration shown in Figure 38. The configuration shown in Figure 38 comprises driving transistor 11a allowing signal current to pass therethrough, driving transistor 11b for controlling driving current to be passed through a light-emitting device comprising EL device 15 or the like, take-in transistor 11c for connecting or disconnecting the pixel circuit to or from a data line (data) by control over gate signal line 17a1, switching transistor 11d for shortcircuiting the gate and the drain of transistor 11a during a writing period by control over gate signal line 17a2, storage capacitor 19 for holding a voltage across the gate and the source of transistor 11a even after completion of writing of the voltage, and EL device 15 as a light-emitting device.

Though transistors 11c and 11d are n-channel transistors while other transistors are p-channel transistors in Figure 38, this feature is a mere example and the configuration need not necessarily have this feature. Though the storage capacitor 19 has one terminal connected to the gate of transistor 11a and the other terminal connected to Vdd (power supply potential), the storage capacitor 19 may be connected to any fixed potential instead of Vdd. The cathode (negative electrode) of EL device 15 is connected to the ground potential.

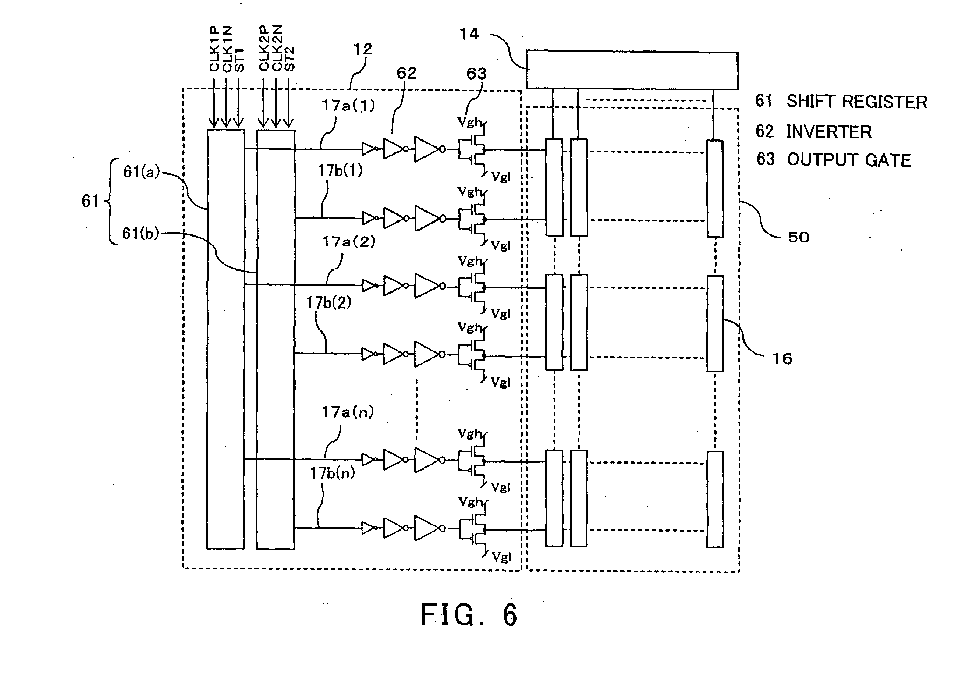

Description will be made of an EL display panel and an EL display apparatus according to the present invention. Figure 6 is an explanatory diagram mainly illustrating the circuit of the EL display apparatus. Pixels 16 are arranged or formed in a matrix pattern. Each pixel 16 is connected to source driver 14 adapted to output a current for current-based programming of each pixel 16. The source driver 14 has an outputting section formed with current mirror circuits corresponding to the number of bits of an image signal as gray scale data, as will be described later. For example, if there are 64 gray-levels, each source signal line is formed with 63 current mirror circuits. The source driver 14 is configured to be capable of applying a desired current to source signal line 18 by selecting a current mirror circuits count.

The minimum output current of one current mirror circuit is set to be not more than 10 nA and not less than 50 nA. It is particularly preferable to set the minimum output current of one current mirror circuit to be not more than 15 nA and not less than 35 nA. This is because such setting can ensure correct functioning of the transistors forming the current mirror circuits in the source driver 14.

The source driver 14 incorporates a precharge or discharge circuit for forcibly charging or discharging source signal line 18. The precharge or discharge circuit for forcibly charging or discharging source signal line 18 is preferably configured to be capable of setting output voltage (current) values for respective of R, G and B independently. This is because EL devices 15 for R, G and B have different threshold values.

Organic EL devices are known to have high temperature dependence. In order to control variations in luminance intensity due to such temperature dependence, the current mirror circuits are provided with a nonlinear device, such as thermistor or posister, for varying the output current. A reference current is generated in an analog fashion by adjusting variations due to the temperature dependence by means of the thermistor or the like.

In the present invention, source driver 14 comprises a semiconductor chip and is connected to terminals of source signal lines 18 on substrate 71 by the Chip On Glass (COG) technology. Metal wires of chromium, aluminum, silver or the like are used for wiring of signal lines including source signal lines 18. This is because such a wire offers a low resistance with a small wiring width. In the case where the pixels are of the reflection type, it is preferable that such wiring is made of the same material as the reflective film of the pixels and formed at the same time with the formation of the reflective film. By so doing, the process can be simplified.

The technology for use in mounting source driver 14 is not limited to the COG technology. It is possible that the source driver 14 is mounted by the Chip On Film (COF) technology and connected to signal lines of the display panel. A drive IC may comprise three chips, with a power supply IC 82 being formed separately.

On the other hand, the gate driver 12 is formed by the low temperature polysilicon technology. This means that the gate driver 12 is formed along with the transistors of the pixels by the same process. This is because the gate driver 12 has a simple internal structure and a low working frequency as compared to the source driver 14. Therefore, the gate driver 12 can be formed easily even by the low temperature polysilicon technology, which leads to the frame made narrower. Of course, it is needless to say that the gate driver 12 may comprise a silicon chip and may be mounted on the substrate 71 by utilizing the COG technology. The gate driver, switching devices including a pixel transistor, and like components may be formed by the high temperature polysilicon technology, or they may be formed using an organic material (organic transistor).

The gate driver 12 incorporates a shift register circuit 61a for gate signal line 17a, and a shift register circuit 61b for gate signal line 17b. Each shift register 61 is controlled using clock signals of positive and negative phases (CLKxP and CLKxN) and start pulse (STx). Preferably, there are additionally used an enable signal (ENABL) for controlling outputting/non-outputting from gate signal lines and an up-down (UPDOWN) signal for reversing the shifting direction up and down. It is also preferable to provide an output terminal or the like for checking whether the start pulse has been shifted by the shift register and outputted therefrom. The timing for shifting by the shift register is controlled using a control signal from control IC 81. The gate driver 12 further incorporates a level shifting circuit for shifting an extraneous data level, and an inspection circuit.

Since the shift register circuit 61 has a low buffer capacity, the shift register circuit 61 cannot directly drive gate signal lines 17. For this reason, at least two inverter circuits 62 are formed between the output of the shift register 61 and an associated output gate 63 adapted to drive gate signal line 17.

Similarly, in the case where the source driver 14 is formed directly on the substrate 71 by such polysilicon technology as the low temperature polysilicon technology, plural inverter circuits are formed between an analog switch gate such as a transfer gate for driving source signal line 18 and a shift register of the source driver 14. The source driver and the gate driver share the following feature (i.e., the feature related to an inverter circuit provided between the output of a shift register and an outputting section (including an output gate or a transfer gate)) adapted to drive signal lines.

Though an output of the source driver 14 is shown to connect directly to source signal line 18 in Figure 6 for example, actually the output of the shift register of the source driver is connected to multiple inverter circuits, the outputs of which are connected to analog switch gates such as transfer gates.

Each inverter circuit 62 comprises a p-channel MOS transistor and an n-channel MOS transistor. As described above, an output terminal of shift register 61 of the gate driver 12 is connected to multiple inverter circuits 62 and the output of the final inverter circuit is connected to associated output gate circuit 63. Each inverter circuit 62 may comprise transistors of p-channel type only. In this case, inverter circuit 62 may serve as a mere gate circuit but not as an inverter.

Figure 8 is a diagram illustrating an arrangement for supply of signals and voltage in the display apparatus or the configuration of the display apparatus according to the present invention. Signals from control IC 81 are fed to source driver 14a (power supply wiring, data wiring or the like) through flexible board 84.

In Figure 8, control signals for gate driver 12 are generated at control IC 81, level-shifted at source driver 14 and then applied to gate driver 12. Since the driving voltage of source driver 14 ranges from 4 to 8 (V), a control signal having an amplitude of 3.3 (V) can be converted into a signal having an amplitude of 5 (V), which can be received by gate driver 12.

Source driver 14 is preferably provided therein with image memory. The image memory may store image data previously subjected to an error diffusion process or a dither process. Such an error diffusion process or dither process can convert 260,000-color display data into, for example, 4096-color display data, thereby contributing to a reduction in the capacity of the image memory. The error diffusion process or the like can be achieved with error diffusion controller 81. Image data may be subjected to the dither process and then further subjected to the error diffusion process. The matter described above holds true for a reverse error diffusion process.

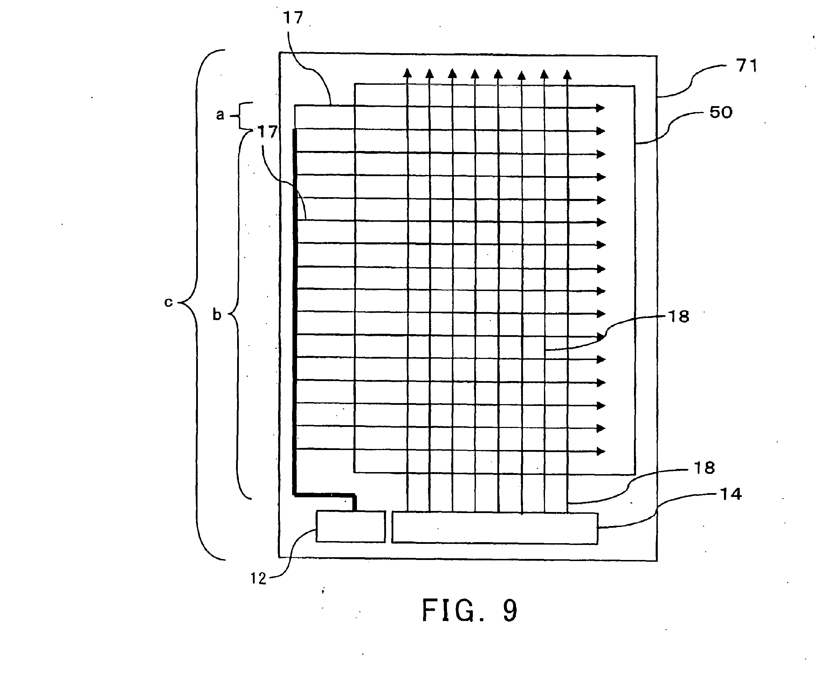

Though the component 14 in Figure 8 or the like is referred to as the source driver, the component 14 may incorporate not only a mere driver circuit but also a power supply circuit, buffer circuit (including such a circuit as a shift register), data converter circuit, latch circuit, command decoder, shift circuit, address translator circuit, image memory or the like. It is needless to say that a three-side-free arrangement (structure) and a driving method, which will be described with reference to Figure 9 and the like, are applicable to the configuration described with reference to Figure 8.

For the display panel to be used in an information display apparatus such as a mobile phone, it is preferable that source driver (circuit) 14 and gate driver (circuit) 12 are mounted (formed) on one side of the display panel. (It should be noted that an arrangement such that driver ICs (circuits) are mounted (formed) on one side of a panel is referred to as a three-side-free arrangement (structure). It has been a conventional practice to mount gate driver 12 and source driver 14 on X-side and Y-side, respectively, of a display region.) The three-side-free arrangement allows the center line of screen 50 to coincide with the center line of the display apparatus easily and makes the mounting of driver ICs easy. The gate driver may be formed in a three-side-free arrangement by the high temperature or low temperature polysilicon technology. (That is, at least one of source driver 14 and gate driver 12 shown in Figure 9 is formed directly on substrate 71 by the polysilicon technology.)

The term "three-side-fiee arrangement" is meant to include not only an arrangement having ICs mounted or formed directly on substrate 71 but also an arrangement in which a film attached with source driver (circuit) 14, gate driver (circuit) 12 and the like (by TCP or TAB technology) is bonded to one side (or essentially one side) of substrate 71. That is, the term "three-side-free arrangement" is meant to include any arrangement or disposition having two sides on which any IC is not mounted or fitted as well as all arrangements similar thereto.

When gate driver 12 is disposed beside source driver 14 as shown in Figure 9, gate signal lines 17 need to be arranged along side C.

The portion indicated by thick solid line in Figure 9 and the like is a portion in which gate signal lines are formed side by side. Accordingly, the portion designated by reference character b (lower portion in the figure) is formed with parallel gate signal lines 17 in the number shown, while the portion designated by reference character a (an upper portion in the figure) is formed with one gate signal line 17.

The pitch at which gate signal lines 17 are formed on C side is not less than 5 μm and not more than 12 μm. If the pitch is less than 5 μm, noise occurs at an adjacent gate signal line by the influence of parasitic capacitance. According to an experiment, the influence of parasitic capacitance becomes significant when the pitch is 7 μm or less. When the pitch further decreases to a value less than 5 μm, image noise such as beat noise occurs vigorously on the display screen. Particularly, noise occurs differently between the right-hand side and the left-hand side of the screen and it is difficult to reduce such image noise as beat noise. On the other hand, if the pitch exceeds 12 μm, the frame width D of the display panel becomes so large that the display panel cannot be put to practical use.

The aforementioned image noise can be reduced by providing a ground pattern (which is a conductive pattern set to have a fixed voltage or a stabilized potential as a whole) as a layer underlying or overlying the portion formed with gate signal lines 17. Alternatively, a separately-formed shielding plate or foil (which is a conductive pattern set to have a fixed voltage or a stabilized potential as a whole) should be placed over gate signal lines 17.

Though the gate signal lines 17 formed on side C in Figure 9 may comprise an ITO electrode each, each of them preferably comprise a stack of ITO film and metal thin film so as to have decreased resistance. Alternatively, each gate signal line preferably comprises a metal film. In stacking metal thin film on ITO, a titanium film is formed over ITO and then a thin film of aluminum or of alloy comprising aluminum and molybdenum is formed over the titanium film. Alternatively, a chromium film is formed over ITO. In the case where each gate signal line comprises metal film, the metal film comprises an aluminum thin film or a chromium thin film. The matters described above hold true for other embodiments of the present invention.

There is no limitation to the arrangement shown in Figure 9 or the like in which gate signal lines 19 are disposed (or formed) on one side of display region 50. Gate signal lines 19 may be disposed (or formed) on opposite sides of display region 50. For example, it is possible that gate signal lines 17a are disposed (or formed) on the right-hand side of display region 50 while gate signal lines 17b disposed (or formed) on the left-hand side of display region 50. The matter thus described hold true for other embodiments.

Source driver 14 and gate driver 12 may be formed into a single chip. With such a single chip, it is sufficient to mount a single IC chip on the display panel. Accordingly, the mounting cost can be reduced. In addition, different voltages to be used in the single chip driver IC can be generated at a time.

There is no limitation to the above-described feature that source driver 14 and gate driver 12 are each formed from a semiconductor wafer such as silicon and then mounted on the display panel. It is needless to say that they may be formed directly on display panel 82 by the low temperature polysilicon technology or the high temperature polysilicon technology.

In the configuration shown in Figure 1 or the like, EL device 15 is connected to Vdd potential through transistor 11a. Such a configuration, however, involves a problem of different driving voltages to be applied to organic EL devices for developing respective colors. For example, when a current of 0.01 (A) is allowed to pass per unit $cm^2$, the terminal voltage of EL device for blue (B) assumes 5 (V) while that of each of EL devices green (G) and red (R) assumes 9 (V). That is, G and R are different from B in terminal voltage. Therefore, B is different from G and R in the source-drain voltage (SD voltage) of transistor 11a to be held. For this reason, the transistors associated with respective color EL devices have different off-leak currents due to different source-drain voltages (SD voltages). When such off-leak currents occur with a difference in off-leak characteristic between EL devices for respective colors, a complicated display state results where flicker occurs with the colors being out of balance and the gamma characteristic deviates in accordance with the correlation with the color of emitted light.

To deal with this problem, an arrangement is employed such that the potential at the cathode of at least one of R, G and B devices is made different from that at the cathode of each of the other devices. Alternatively, another arrangement may be employed such that the Vdd potential of at least one of R, G and B devices is made different from that of each of the other devices.

It is needless to say that terminal voltages of EL devices for R, G and B are preferably made as equal to each other as possible. Materials and structures needs to be selected so that the terminal voltages of R, G and B devices assume respective values not higher than 10 (V) on condition that the devices each exhibits a white peak luminance and the color temperatures of the respective devices are in the range not lower than 7000 K and not higher than 12,000 K. Further, the difference between the maximum terminal voltage and the minimum terminal voltage of the EL devices for R, G and B need be not more than 2.5 (V), preferably not more than 1.5 (V). While the foregoing embodiment uses the colors of R, G and B, there is no limitation to these colors. This will be described later.

While the pixels are adapted to develop the three primary colors, namely R, G and B, they may be adapted to develop three colors, namely cyan, yellow and magenta. It is possible to use two colors, namely B and yellow. Of course, it is possible to use a monochromatic color. It is possible to use six colors, namely R, G, B, cyan, yellow and magenta. It is also possible to use five colors, namely R, G and B, cyan and magenta. These colors offer widened color reproducible ranges of natural colors and hence are capable of realizing favorable display. Another possible combination of colors includes four colors, namely R, G, B and white. Yet another possible combination of colors includes seven colors, namely R, G, B, cyan, yellow, magenta, black and white. It is possible that white light emitting pixels are formed (or made) throughout display region 50 and R, G and B color filters are provided on the pixels to realize a three-primary-color display. In this case it is sufficient to stack light-emitting materials for respective colors on EL layers. Alternatively, each pixel is dividedly painted with B and yellow for example. As described above, the El display apparatus according to the present invention is not limited to color display based on the R, G and B three primary colors.

Three major methods can be used in causing an organic EL display panel to realize color display, and the color conversion method is one of them. According to this method, it is sufficient to form a single luminescent layer for blue and the other colors, namely green and red, required for full color display are produced by color conversion from blue light. Accordingly, there is no need to provide layers painted into R, G and B separately. This method has an advantage that there is no need to provide a set of organic EL materials for respective of R, G and B. The color conversion method is free of a decrease in production yield, which is essential to the separately painting method. Either method is applicable to the EL display panel and the like according to the present invention.

In addition to the pixels for the three primary colors, white-light-emitting pixels may be formed. Such a white-light-emitting pixel can be realized by stacking light-emitting structures for R, G and B on each other. A set of pixels comprises pixels for the R, G and B three primary colors and a white-light-emitting pixel 16W. The formation of such a white-light-emitting pixel makes it easy to develop a white light peak luminance. Thus, brilliant image display can be realized.

In forming a set of pixels for the R, G and B three primary colors or like colors, the pixels for the respective colors are preferably made to have respective pixel electrodes having different areas. Of course, the pixel electrodes may have equal areas if the emission efficiencies of the respective colors are well-balanced and the color purities of the respective colors are also well-balanced. If one or plural colors are ill-balanced, it is preferable to adjust the light-emitting surface areas of the respective pixel electrodes. The light-emitting surface areas of the pixel electrodes for the respective colors should be determined based on their current densities. Specifically, on condition that white balance is adjusted in a state where the color temperatures are within the range not lower than 7000 K (Kelvin) and not higher than 12,000 K, the difference in current density between the pixel electrodes for the respective colors is adjusted to within $\pm 30\%$, preferably $\pm 15\%$. If the current density of the pixel electrode for one color is 100 A/m$^2$ for example, the current density of the pixel electrode for any one of the three primary colors is made to assume a value not less than 70 A/m$^2$ and not more than 130 A/m$^2$, more preferably not less than 85 A/m$^2$ and not more than 115 A/m$^2$.

Organic EL device 15 is a self-luminescent device. When light of luminescence becomes incident on a transistor serving as a switching device, a photoconductor phenomenon occurs. The photoconductor phenomenon is a phenomenon that leakage at a switching device, such as a transistor, in an off-state (off-leak) increases due to optical excitation.

To deal with this problem, the present invention forms a light-shielding film underlying gate driver 12 (source driver 14 in some cases) and pixel transistors 11. The light-shielding film comprises a metal thin film such as chromium and has a thickness not less than 50 nm and not more than 150 nm. If the film thickness is too small, the film has a poor light-shielding effect. On the other hand, if the film thickness is too large, unevenness occurs, which makes the patterning of overlying transistors 11a difficult.

A planarization film having a thickness not less than 20 nm and not more than 100 nm, which comprises an inorganic material, is formed over the light-shielding film. One electrode of storage capacitor 19 may be formed using the layer of this light-shielding film. In this case the planarization film is preferably made as thin as possible so that the storage capacitor has a larger capacitance. Alternatively, it is possible that the light-shielding film is formed from aluminum and a silicon oxide film is formed over the surface of the light-shielding film by utilizing the anodic oxidation technique for use as a dielectric film of storage capacitor 19. On the planarization film are formed pixel electrodes of a high aperture (HA) structure.

The driver circuit 12 and the like should inhibit penetration of light not only from the reverse side but also from the obverse side. This is because malfunction of such a circuit is caused by the influence of the photoconductor phenomenon. For this reason, in the present invention, when the cathode comprises a metal film, the drivers 12 and the like are formed with such a cathode electrode covering the surface thereof to serve as the light-shielding film.

However, the formation of such a cathode over the drivers 12 possibly causes a malfunction of the drivers due to an electric field produced from the cathode or an electric contact between the cathode and the driver circuit. To deal with this problem, the present invention forms at least one organic EL film layer, preferably a plurality of organic EL film layers over the driver circuits 12 and the like at the same time with the formation of the organic EL film over pixel electrodes.

Since such an organic EL film is basically an insulator, the formation of the organic EL film over the drivers isolates the drivers from the cathode, thus overcoming the aforementioned problem.

When shortcircuiting occurs between terminals of one or more transistors 11 or between a signal line and a transistor 11, EL device 15 associated therewith lights constantly and such a pixel may become a luminescent spot. Since this luminescent spot is visually prominent, the luminescent spot needs to be turned into a black spot (or turned into the non-lighting state.) The pixel 16 constituting such a luminescent spot is detected and then the capacitor 19 of the pixel 16 is irradiated with laser light so that the terminals thereof are shortcircuited. By so doing, the capacitor 19 becomes incapable of holding charge and, hence, the transistor 11a cannot allow current to pass therethrough any more.

It is desirable that the cathode film situated in a region to be irradiated with laser light be removed in advance in order to prevent a terminal electrode of the capacitor 19 from shortcircuiting with the cathode film.

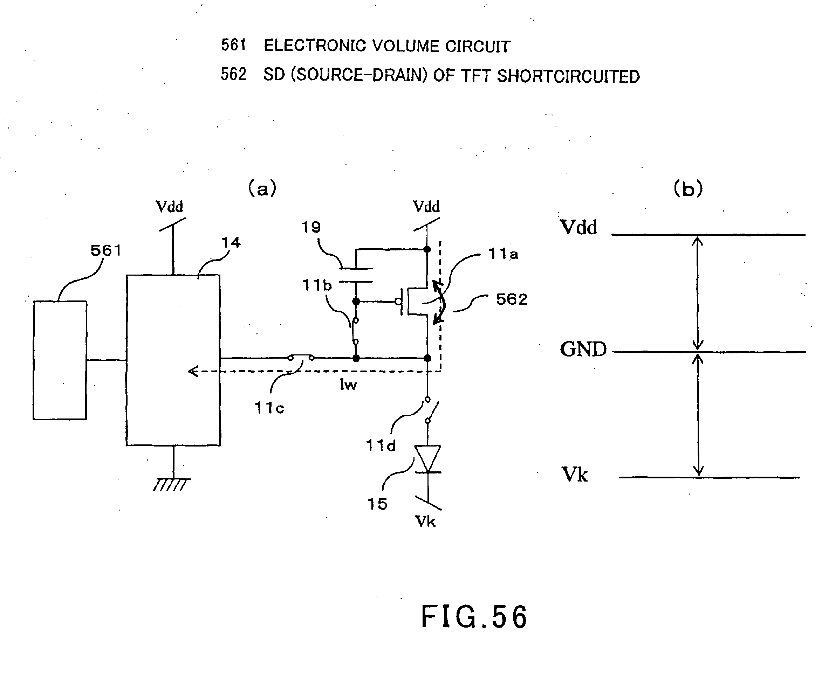

A defect of transistor 11 of pixel 16 affects the driver circuit 14 or the like. For example, when a source-drain (SD) shortcircuit 562 occurs at driving transistor 11a as shown in Figure 56, the source driver 14 is applied with Vdd voltage of the panel. For this reason, the supply voltage of the source driver 14 is preferably set equal to or higher than the supply voltage Vdd of the panel. It is preferable to employ an arrangement capable of controlling the reference current to be used in the source driver 14 by means of an electron volume 561.

When SD shorcircuit 562 occurs at transistor 11a, an excessive current passes through EL device 15. This causes the EL device 15 to light constantly (to become a luminescent spot). Such a luminescent spot is visually prominent as a defect. In Figure 56 for example, when a source-drain (SD) shortcircuit occurs at transistor 11a, current from the Vdd voltage keeps on passing through the EL device 15 (while the transistor 11d is on.) Accordingly, the EL device 15 becomes a luminescent spot.

Further, such a SD shorcircuit at the transistor 11a causes the Vdd voltage to be applied to source signal line 14, hence, to the source driver 14 while the transistor 11c is on. If the supply voltage of the source driver 14 is lower than Vdd, the source driver 14 might be broken down due to a voltage exceeding the withstand voltage. For this reason, the supply voltage of the source driver 14 is preferably set equal to or higher than the Vdd voltage (which is the higher voltage applied to the panel.)

The SD shortcircuit or a like defect at transistor 11a may result in the breakdown of the source driver of the panel as well as a spot defect. A luminescent spot, which is visually prominent, makes the panel faulty. For this reason, it is necessary to turn such a luminescent spot into a black defect by cutting off the wiring interconnecting transistor 11a and EL device 15. Optical means such as laser light may be used to cut off the wiring.

Though wiring is cut off in the above embodiment, the means for changing a luminescent spot into a black display spot is not limited thereto. As can be understood from Figure 1 for example, a modification may be made so that the supply voltage Vdd for transistor 11a is constantly applied to the gate (G) terminal of the transistor 11a. For example, if the opposite terminals of the capacitor 19 are shortcircuited, the Vdd voltage is applied to the gate (G) terminal of transistor 11a. Accordingly, the transistor 11a is kept in complete off state and hence does not allow current to pass through the EL device 15 any more. This can be easily realized through laser irradiation of capacitor 19, which can shortcircuit the capacitor electrodes.

Further, since the Vdd wiring actually underlies the pixel electrode, the display condition of the pixel can be controlled (or modified) through irradiation of the Vdd wiring and the pixel electrode with laser light.

Additionally, turning a luminescent spot into a black defect can also be realized by making open the channel between the source and the drain of the transistor 11a. Briefly, the transistor 11a is irradiated with laser light to make the channel thereof open. Similarly, the channel of the transistor 11d may be opened. When the channel of the transistor 11b is opened, the associated pixel 16 cannot be selected and hence becomes a black display.

In order to turn pixel 16 into a black display, the EL device 15 may be deteriorated. For example, laser light is applied to the EL layer 15 to deteriorate the EL layer physically or chemically, thereby making the EL layer 15 incapable of luminescence (constant black display.) Irradiation with laser light can heat the EL layer 15 thereby deteriorating it easily. Use of an excimer laser can cause a chemical change of the EL layer 15 to take place easily.

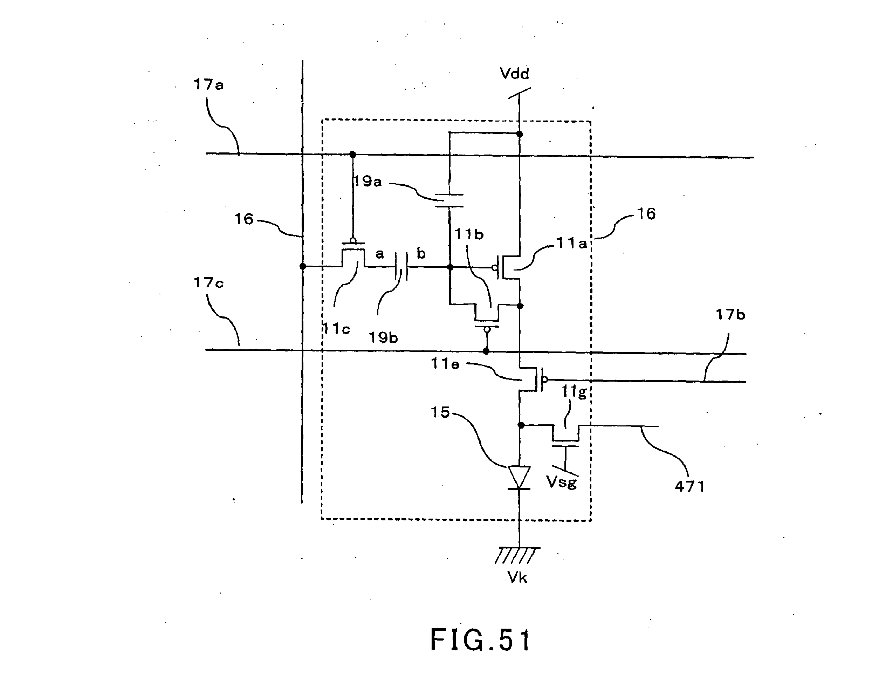

While the pixel configuration shown in Figure 1 is exemplified in the above-described embodiment, the present invention is not limited thereto. It is needless to say that the art of making wiring or electrodes open or shortcircuited by the use of laser light is applicable to other current-driven pixel configurations such as a current mirror circuit configuration and voltage-driven pixel configurations as shown in Figure 62 or 51 or the like.

A method of driving the pixel configuration shown in Figure 1 will be described below. As shown in Figure 1, gate signal line 17a assumes a conducting state during a row selecting period, while gate signal line 17b assumes a conducting state during an unselecting period. (Here, application of a low-level voltage causes gate signal line 17 to assume the conducting state since the transistors 11 in Figure 1 are p-channel transistors.)

Parasitic capacitance (not shown) is present in source signal line 18. Such parasitic capacitance is produced due to a capacitance at each of the intersections of source signal line 18 and gate signal lines 17, a channel capacitance at each of transistors 11b and 11c, or the like.

Time t required for the value of current at source signal line 18 to vary is found from the equation: $t = C \cdot V/I$, where C represents the value of parasitic capacitance, V represents a voltage applied to source signal line 18 and I represents a current passing through source signal line 18. Accordingly, the time t required for the value of current to vary can be shortened to nearly 1/10 by increasing current to a 10-fold value. The equation also indicates that even when the parasitic capacitance in source signal line 18 increases to a 10-fold value, the value of current can be varied to a predetermined value. Therefore, increasing the value of current is effective in writing a predetermined current value within a short horizontal scanning period.

In order to charge/discharge the parasitic capacitance of source signal line 18, a current having value I satisfying the formula: $I > (C \cdot V)/t$ should be passed through source signal line 18.

If the input current is increased 10 times, the output current is also increased 10 times. In this case the luminance of the EL device is also raised 10 times, which means that a predetermined luminance cannot be obtained. In this respect, the present invention realizes the predetermined luminance by providing settings such that the conducting period of transistor 17d in Figure 1 is set to 1/10 of the conventional conducting period and the light-emitting period of EL device 15 set to 1/10 of the conventional light-emitting period.

That is, in order to program transistor 11a of pixel 16 with a predetermined current value after sufficient charge/discharge of the parasitic capacitance of source signal line 18, source driver 14 needs to output a relatively high current. However, when such a high current is passed through source signal line 18, the pixel is programmed with the value of this current undesirably, with the result that the EL device 15 is fed with a higher current than the predetermined current. For example, if programming is made with a 10-fold current, naturally a 10-fold current passes through EL device 15, thus causing the EL device 15 to emit light at a 10-fold luminance. To obtain the predetermined luminance of emission, the time period for which the EL device 15 is fed with the current should be shortened to 1/10. Such a driving method is capable of sufficiently charging/discharging the parasitic capacitance of source signal line 18 and obtaining the predetermined luminance of emission.

The above-described feature that a 10-fold current value is written to transistor 11a of a pixel (more exactly, the terminal voltage of capacitor 19 is set to a predetermined value) and the on-time of EL device 15 is shortened to 1/10, is an mere example. In some cases it is possible that a 10-fold current value is written to transistor 11a of a pixel and the on-time of EL device 15 is shortened to 1/5. Alternatively, as the case may be, it is possible that a 10-fold current value is written to transistor 11a of a pixel and the on-time of EL device 15 is shortened to 1/2.

The present invention is characterized by a driving method in which a current to be written to a pixel is set to have a value different from the predetermined value while EL device 15 is fed with a current intermittently. For easy explanation, the driving method is herein described as having a feature that a current N times as high as the predetermined current is written to transistor 11 of a pixel while the on-time of EL device 15 is set 1/N times the predetermined time period. However, the present invention is not limited to this feature. It is needless to say that it is possible that an N1-fold current is written to transistor 11 of a pixel while the on-time of EL device 15 is 1/N2 times as large as the predetermined time period, (where N1 and N2 are different from each other.)

The "predetermined current", as used herein, means a current required to realize a gray scale display corresponding to an image signal. The predetermined current has a current value varying depending on the specifications of the EL display apparatus. For example, the current value ranges from about 0.25 µA to about 0.75 µA when a luminance of 150 nt is to be realized. Therefore, if N = 4, a current value of from about 1 µA to about 3 µA is to be written to transistor 11. Similarly, if N = 8, the current value to be written ranges from about 2 µA to about 6 µA. If N = 2, the current value to be written ranges from about 0.5 pA to about 1.5 µA.

The intervals at which the intermittent passage of current is performed are not limited to equal intervals. For example, random intervals are possible (provided the display period or the non-display period, as a whole, has a predetermined value (fixed ratio).) The intervals may differ depending on R, G and B. That is, each of R, G and B display periods or non-display periods should be adjusted to a predetermined value (fixed ratio) so as to optimize the white balance.

For easy explanation, the on-time is described to be 1/N of 1F (one field or one frame period), 1F being used as a reference. However, a time period required for selection of one pixel row and programming with a current value (which is usually one horizontal scanning period) should be taken into account. In addition, errors may occur depending on the scanning conditions. Thus, the above description is merely provided for convenience in making the explanation easy and there is no limitation thereto.

For example, it is possible that pixel 16 is programmed with a 10-fold current (N = 10) and EL device is caused to light for a 1/5 period. In this case EL device 15 lights at a two-fold luminance (10/5 = 2). Alternatively, it is possible that pixel 16 is programmed with a two-fold current (N = 2) and EL device 15 is caused to light for a 1/4 period. In this case EL device 15 lights at a 0.5-fold luminance (2/4 = 0.5). That is, according to the present invention, a pixel is programmed with an N-fold current (N is not equal to 1) and a display which is not in a constant lighting state (i.e. 1/1, which does not means intermittent driving) is realized. In a wider sense, the present invention provides a driving method which includes cutting off feeding of current to EL device 15 at least once in a one-frame (or one-field) period. The present invention also provides a driving method which includes programming pixel 16 with a current higher than the predetermined value while performing intermittent display necessarily.

Organic (or inorganic) EL display apparatus involve a problem essential to their display method which is basically different from the display method applied to such display apparatus as a CRT adapted to display an image as an aggregate of line displays provided by means of an electron gun. Since such an EL display apparatus is configured to hold a current (or a voltage) written to a pixel for a one-F (one-field or one-frame) period. This configuration gives rise to a problem of a blurred outline of an image if it is displayed in a motion picture display state.

According to the present invention, EL device 15 is fed with a current for only a 1F/N period of a one-frame period and is not fed with a current for the rest of the frame period (1F(N-1)/N). Consideration is given to the case where one spot of the screen driven according to this driving method is observed. In this display state, a display based on image data and a black display (nonlighting state) alternate with each other on a 1F basis. That is, such a display based on image data appears at time intervals (intermittent display). When a display based on motion picture data is realized by such intermittent display driving, the image has no blurred outline, which means that a display of high quality is realized. Thus, the intermittent display method can realize a motion picture display close to that realized by a CRT. Further, since the main clock used in the circuit is a conventional one in spite of intermittent display, no increase occurs in the power consumption of the circuit.

In the case of a liquid crystal display panel, image data (voltage) based on which light modulation is performed is held in the liquid crystal layer. Therefore, data applied to the liquid crystal layer needs to be rewritten in order to insert a black display. For this reason, it is required that the value of the clock for operating source driver 14 be made higher while source signal line 18 applied with image data and black display data alternately. Accordingly, the value of the main clock of the circuit needs to be raised in order to realize insertion of black (intermittent display of a black display or the like.) In addition, image memory for extending the time axis is also needed.

In a pixel configuration of the EL display panel of the present invention as shown in Figure 1, 2 or 38 or the like, image data is held in the capacitor 19. A current corresponding to the terminal voltage of this capacitor 19 is passed through EL device 15. Thus, image data is not held in a light modulation layer as in the liquid crystal display panel.

According to the present invention, the current to be passed through EL device 15 is controlled by merely turning on/off switching transistor 11d or 11e or the like. That is, even when the current Iw passing through EL device 15 is cut off, image data is held as it is in the capacitor 19. Therefore, when the switching device 11d or the like is turned off at the next timing to feed EL device 15 with a current, this current has a current value equal to that of the current passed just before. The present invention does not need to raise the main clock of the circuit even when insertion of black (intermittent display of a black display or the like) is to be made. Nor does the present invention need to extend the time axis and, hence, image memory therefor is not needed either. Organic EL device 15 requires a shortened time for the device 15 to emit light from the time when it is fed with current and hence is responsive at a high speed. For this reason, the present invention is suitable for motion picture display and is capable of solving the motion picture display problem which is essential to display panels of the conventional data holding type (liquid crystal display panel, EL display panel, and the like) by intermittent display.

In the case of a large-sized display apparatus having an increased source capacitance, the source current should be increased 10 times or more. Generally, when the source current value is increased N times, it is sufficient to set the conducting period for gate signal line 17b (transistor 11d) to 1F/N. By so doing, the present invention is applicable to television sets, monitoring display apparatus, and the like.

The driving method according to the present invention will be described more specifically with reference to the drawings. The parasitic capacitance of source signal line 18 is produced due to the coupling capacitance between adjacent source signal lines 18, the capacitance of the buffer output of source driver IC (circuit), the capacitance at a crossing point between gate signal line 17 and source signal line 18, and the like. Such a parasitic capacitance is usually 10 pF or more. In the case of voltage-based driving, driver IC 14 applies a voltage to source signal line 18 with a low impedance and, hence, some increase in the parasitic capacitance does not raise any driving problem.

However; in the case of current-based driving, image display of a black level, in particular, requires programming of capacitor 19 of a pixel with a faint current of 20 nA or lower. For this reason, when the parasitic capacitance takes place as having a value more than a predetermined value, the parasitic capacitance cannot be charged/discharged within the time required for one pixel row to be programmed. (The time required is usually a 1H period or shorter but is not limited thereto since two pixel rows may be programmed at a time.) If charge/discharge is impossible within a 1H period, writing to a pixel is insufficient and, hence, display with a desired resolution cannot be realized.

In the case of the pixel configuration shown in Figure 1, a programming current Iw passes through source signal line 18 during current-based programming as shown in Figure 3(a). The current Iw is passed through transistor 11a to set (program) a voltage of capacitor 19 so that the voltage for causing the current Iw to pass is held. At this time transistor 11d is in an open state (off-state).

In turn, transistors 11c and 11b are turned off and transistor 11d operates in the period for feeding EL device 15 with a current as shown in Figure 3(b). Specifically, off-voltage (Vgh) is applied to gate signal line 17a to turn transistors 11b and 11c off. On the other hand, on-voltage (Vgl) is applied to gate signal line 17b to turn transistor 11d off.

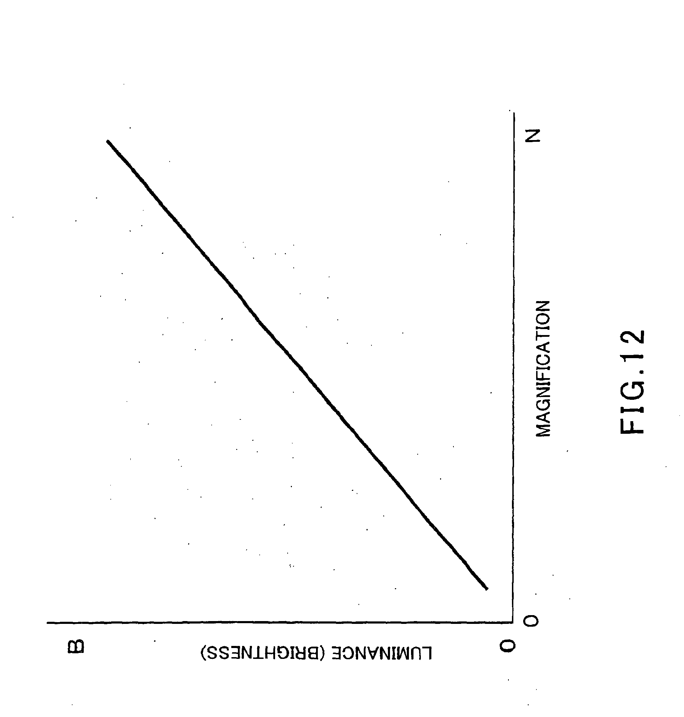

Now, assuming that the current Iw is 10 times as high as a current (of a predetermined value) to be passed conventionally, a current passing through EL device 15 in Figure 3(b) is also 10 times as high as the predetermined value. Accordingly, EL device 15 emits light at a luminance 10 times as high as a predetermined value. That is, the display luminance B of the display panel becomes higher with increasing magnification N, as shown in Figure 12. Therefore, the luminance and the magnification are proportional to each other. With 1/N driving, on the other hand, the luminance and the magnification are inverse proportion to each other.

If transistor 11d is caused to assume on-state for only 1/N of the time period for which transistor 11 assumes on-state conventionally and to assume off-state for the rest ((N-1)/N) of the time period, the mean luminance throughout 1F becomes a predetermined luminance. This display state is close to a display state of a screen scanned with an electron gun in a CRT. The difference therebetween resides in that the region displaying an image or the lighting region is 1/N of the whole screen (which is equal to 1.) (The lighting region in the CRT corresponds to one pixel row (one pixel in a strict sense).)

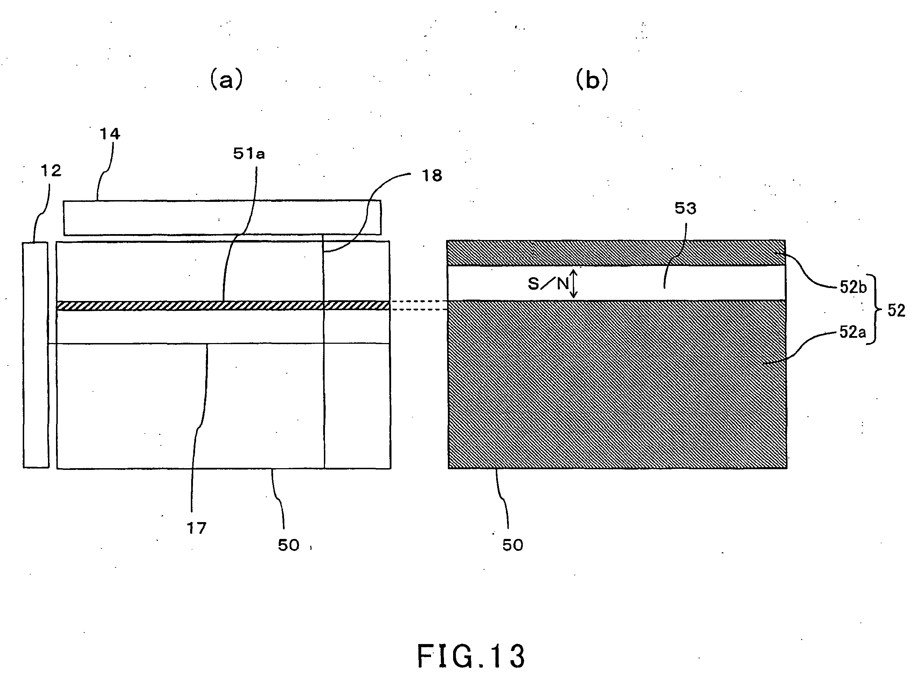

In the present invention, 1F/N image display region 53 shifts from the upper side to the lower side of screen 50, as shown in Figure 13(b). EL device 15 is fed with current for only a 1F/N period and is not fed with current for the rest (1F·(N-1)/N) of the period. Therefore, each pixel displays intermittently. However, the image is seen to be retained at human eyes through afterimage and, hence, the whole screen is seen to display uniformly.

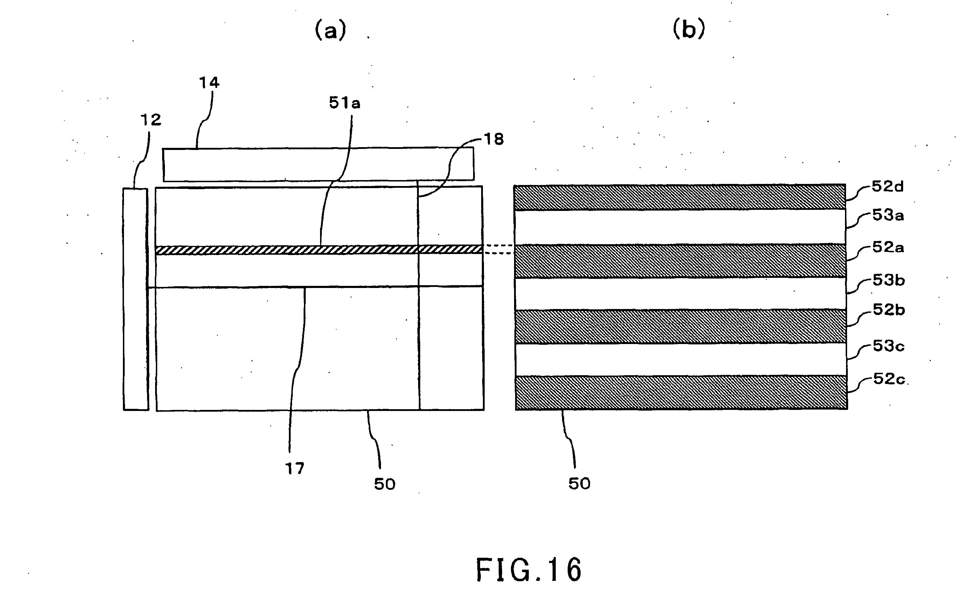

It should be noted that written pixel row 51a forms a non-lighting display 52a, as shown in Figure 13. However, this occurs in the pixel configurations shown in Figs. 1 and 2. Such a written pixel row 51a may assume a lighting state in the current mirror pixel configuration shown in Figure 38 or the like. In the present description, however, the pixel configuration shown in Figure 1 is mainly exemplified for easy explanation. The method illustrated in Figure 13 or 16 or the like, which includes programming with a current higher than the predetermined driving current Iw and intermittent driving, will be referred to as an N-fold pulse driving method.

In this display state, a display based on image data and a black display (non-lighting state) alternate with each on a 1F basis. That is, such a display based on image data appears at time intervals (intermittent display). Since liquid crystal display panels (and EL display panels other than the EL display panels of the present invention) are configured to hold data at pixels for a 1F period, an image on a motion picture display cannot keep up with image data changing, resulting in blurred motion picture (blurred image outline). According to the present invention, however, an image is displayed intermittently and, hence, satisfactory display state with no blurred outline can be realized. Thus, the intermittent display method can realize a motion picture display close to that realized by a CRT.

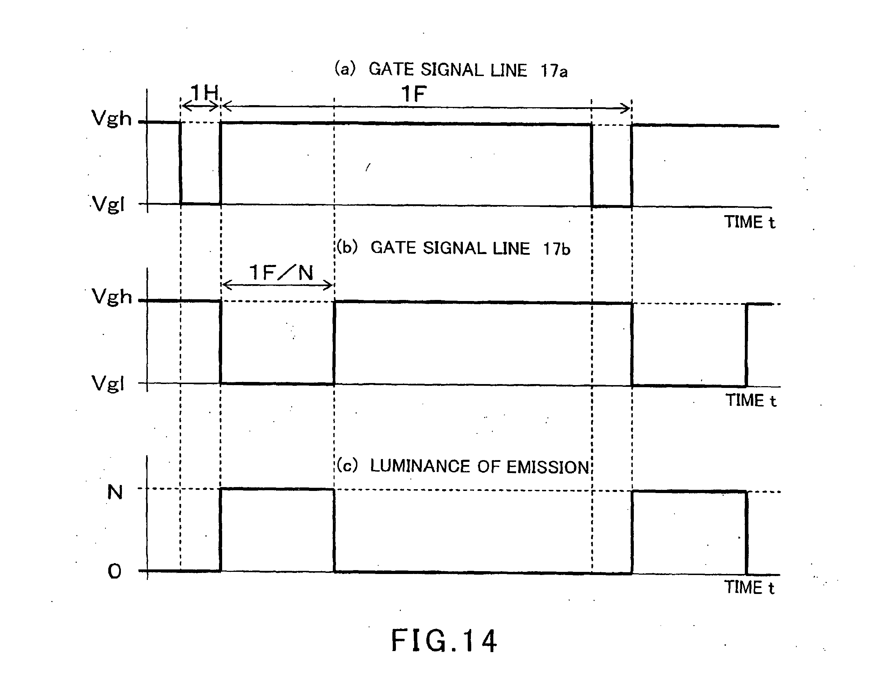

The timing chart of such intermittent display is shown in Figure 14. The pixel configuration shown in Figure 1 is exemplified in the present invention unless otherwise particularly specified. As seen from Figure 14, in each selected pixel row (selecting period is 1H), gate signal line 17b is under application of off-voltage (Vgh) (see Figure 14(b)) while gate signal line 17a is being applied with on-voltage (Vgl) (see Figure 14(a).) During this period, EL device 15 is not fed with current (in a non-lighting state). In an unselected pixel row, on the other hand, gate signal line 17a is under application of off-voltage (Vgh) and gate signal line 17b is under application of on-voltage (Vgl). During this period, EL device 15 is fed with current (in a lighting state). In the lighting state, EL device lights at a luminance N times as high as a predetermined value (N·B) for a time period of 1F/N. Thus, a means display luminance of the display panel throughout a 1F period can be found from the equation: (N·B)×(1/N) = B (predetermined luminance).

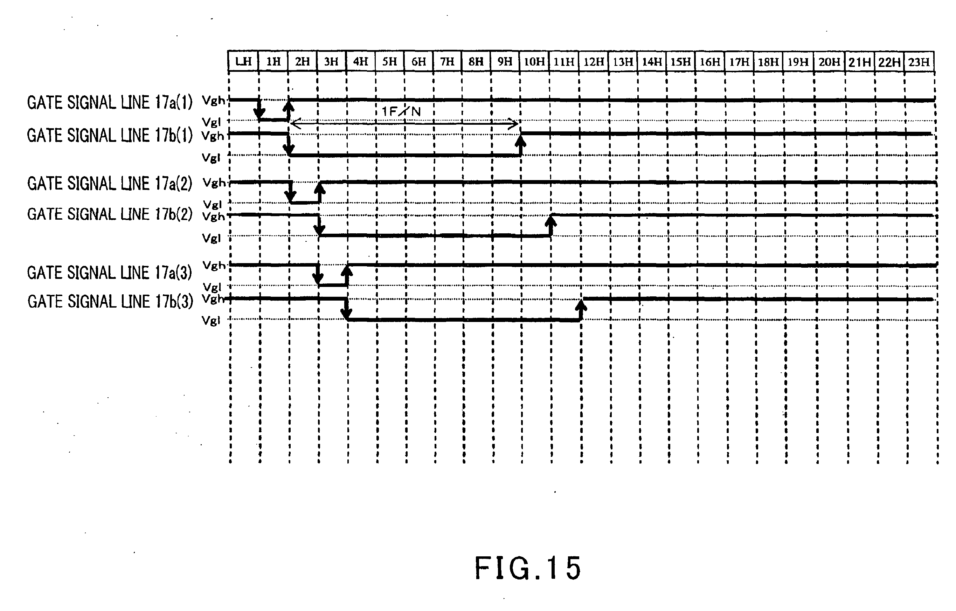

Figure 15 illustrates an embodiment in which the operation illustrated in Figure 14 is applied to pixel rows. Specifically, voltage waveforms to be applied to respective gate signal lines 17 are shown. Each voltage waveform comprises off voltage Vgh (H level) and on-votlage Vgl (L level). Additional numerals such as (1) and (2) indicate the row numbers of selected pixel rows.

In Figure 15, when gate signal line 17a(1) is selected (at voltage Vgl), a programming current is passed through source signal line 18 from transistor 11a of the selected pixel row toward source driver 14. This programming current is N times as high as a predetermined value. (Description is made with N = 10 for easy explanation. Since the predetermined value is the value of a data current causing an image to be displayed, the predetermined value is not a fixed value unless white raster display is given.) Accordingly, capacitor 19 is programmed so that a 10-fold current will pass through transistor 11a. When pixel row (1) is in the selected state, gate signal line 17b(1) of the pixel configuration of Figure 1 is under application of off-voltage (Vgl), thus preventing current from passing through EL device 15.

After lapse of 1H, gate signal line 17a(2) is selected (at voltage Vgl) and a programming current is passed through source signal line 18 from transistor 11a of the selected pixel row toward source driver 14. This programming current is N times as high as a predetermined value. (Description is made with N = 10 for easy explanation.) Accordingly, capacitor 19 is programmed so that a 10-fold current will pass through transistor 11a. When pixel row (2) is in the selected state, gate signal line 17b(2) of the pixel configuration of Figure 1 is under application of off-voltage (Vgl), thus preventing current from passing through EL device 15. On the other hand, the preceding pixel row (1) assumes a lighting state because gate signal line 17a(1) and gate signal line 17b(1) of pixel row (1) are applied with off-voltage (Vgh) and on-voltage (Vgl), respectively.

After lapse of another 1H, gate signal line 17a(3) is selected and gate signal line 17b(3) is applied with off-voltage (Vgh) to prevent current from passing through EL device 15 of pixel row (3). On the other hand, the preceding pixel rows (1) and (2) assume the lighting state because gate signal lines 17a(1) and 17a(2) thereof are applied with off-voltage (Vgl) and gate signal lines 17b(1) and 17b(2) thereof are applied with on-voltage (Vgl).

The above-described operation is synchronized with a 1H synchronizing signal. With the driving method of Figure 15, however, a 10-fold current passes through El device 15 and, accordingly, display screen 50 displays an image at a luminance having about a 10-fold value. Of course, it is needless to say that the programming current should be decreased to 1/10 in order to realize a display at the predetermined luminance. With such a 1/10 current, however, insufficient writing occurs due to parasitic capacitance and the like. The basic concept of the present invention is that programming is made with a high current to avoid such insufficient writing while black display 52 is inserted to obtain the predetermined luminance.

An important feature of the driving method of the present invention resides in that a current higher than the predetermined current is caused to pass through EL device 15 thereby sufficiently charging/discharging the parasitic capacitance of source signal line 18. Therefore, EL device 15 need not necessarily be fed with a current N times as high as the predetermined current. For example, a configuration may be employed such that a current path is formed in parallel with EL device 15 (specifically, a dummy EL device is formed which has been subjected to such processing as to prevent the dummy EL device from emitting light, for example, formation of a light-shielding film thereover) and a current is dividedly fed to the dummy EL device and EL device 15. When the signal current is 0.2 μA for example, the programming current adjusted to 2.2 μA is passed through transistor 11a. Of this current, the signal current of 0.2 μA is fed to EL device 15 while the remaining current of 2.0 μA fed to the dummy EL device. Such a driving method is exemplified. That is, dummy pixel row 281 shown in Figure 27 is made constantly selected. The dummy pixel row is made to fail to emit light or formed with a light-shielding film to prevent emission of light from being recognized visually.

With such an arrangement, programming can be made so that a current N times as high as the predetermined current will pass through driving transistor 11a by increasing the current to pass through source signal line 18 N times, while at the same time a current sufficiently lower than the N-fold current can be passed through EL device 15. The above-described method does not need to provide non-lighting region 52 shown in Figure 5 and hence can allow the whole display region 50 to be used as image display region 53.

Figure 13(a) illustrates a written state of display screen 50. Reference character 51a used in Figure 13(a) designates a written pixel row. Source driver 14 feeds the programming current to each source signal line 18. In Figure 3 or the like, writing is made to a single pixel row in a 1H period. However, there is no particular limitation to 1H but it is possible to employ a 0.5H period or a 2H period. Though the programming current is written to source signal line 18 according to the above description, the present invention is not limited to such a current-based programming method but may employ a voltage-based programming method (illustrated in Figure 62 or the like) in which source signal line 18 is written with a voltage.

In Figure 13(a), when gate signal line 17a is selected, transistor 11a is programmed with a current passing through source signal line 18. At that time, gate signal line 17b is applied with off-voltage and, as a result, EL device 15 is not fed with a current. This is because when transistor 11d is in on-state, a capacitance component of EL device 15 is seen from source signal line 18 and capacitor 19 cannot sufficiently accurately be programmed with current because of the influence of the capacitance. Accordingly, in the configuration of Figure 1 for example, a pixel row written with current forms non-lighting region 52, as shown in 13(b).

If programming is made with an N-fold current (here, N = 10 as described earlier), the luminance of the screen is increased 10 times. Therefore, non-lighting region 52 should cover 90% of display region 50. Specifically, if an image display region has 220 horizontal scanning lines (S = 220) in Quarter Common Intermediate Format (QCIF), 22 lines should form display region 53, with the rest (220-22 = 198) forming non-display region 52. Generally speaking, if the number of horizontal scanning lines (the number of pixel rows) is S, an S/N region is used as display region 53 which is caused to emit light at an N-fold luminance. This display region 53 is scanned vertically of the screen. Thus, the remaining S(N-1)/N region is used as non-lighting region 52. This non-lighting region forms a black display (luminescenceless region.) Such a luminescenceless region 52 is realized by turning transistor 11d off. Though the display region 53 has been described to light at an N-fold luminance, it is needless to say that the value of N can be controlled by brightness adjustment or gamma adjustment, as a matter of course.

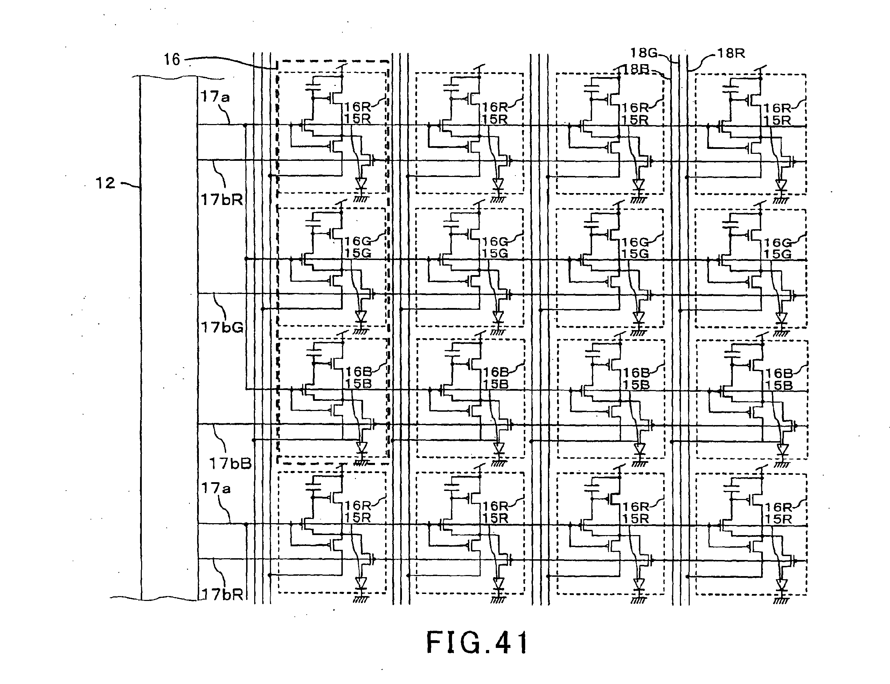

In the above-described embodiment, non-lighting region 52 should cover 90% of display region 50 because if programming is made with an N-fold current, the luminance of the screen is increased 10 times. However, this feature is not limited to an arrangement where R, G and B pixels form non-lighting regions 52 in the same manner. For example, the proportion of non-display region 52 may be varied depending on R, G and B; for example, R pixel provides non-lighting region 52 covering 1/8 of display region 50, G pixel provides non-lighting region 52 covering 1/6 of display region 50, and B pixel provides non-lighting region 52 covering 1/10 of display region 50. Alternatively, it is possible to employ an arrangement such as to adjust non-lighting region 52 (or lighting region 53) in individual R, G and B pixels. To realize these arrangements, gate signal lines 17b for respective of R, G and B need to be provided. By making individual adjustment of R, G and B possible, it becomes possible to control white balance as well as to ease color balance adjustment at each gray level (see Figure 41.)

As shown in Figure 13(b), pixel rows including written pixel row 51a form non-lighting region 52, while an S/N region (which is 1F/N in terms of time) in a screen portion above written pixel row 51a forms lighting region 53. (In the case of scanning upwardly from the lower side of the screen, lighting region 53 is situated on the opposite side.) In this image display state, band-like display region 53 shifts downwardly from the upper side of the screen.

In the display shown in Figure 13, one display region 53 shifts downwardly from the upper side of the screen. If the frame rate is low, shifting of display region 53 is visually recognized. This is likely particularly when the viewer blinks his or her eyes or moves his or her face up and down.

To solve this problem, display region 53 should be split into plural sections as shown in Figure 16. If the total sum of the areas of the sections is equal to the area of an S(N-1)/N region, the brightness of this display is equal to that of the display shown in Figure 13. Display region 53 need not necessarily be split equally. Similarly, sections of non-display region 52 split need not necessarily be uniform.

By thus splitting display region 53 into plural sections, the screen provides a display with reduced flitter. Thus, favorable image display free of flicker can be realized. Display region 53 may be split into smaller sections. However, with finer splitting, the motion picture display performance lowers.

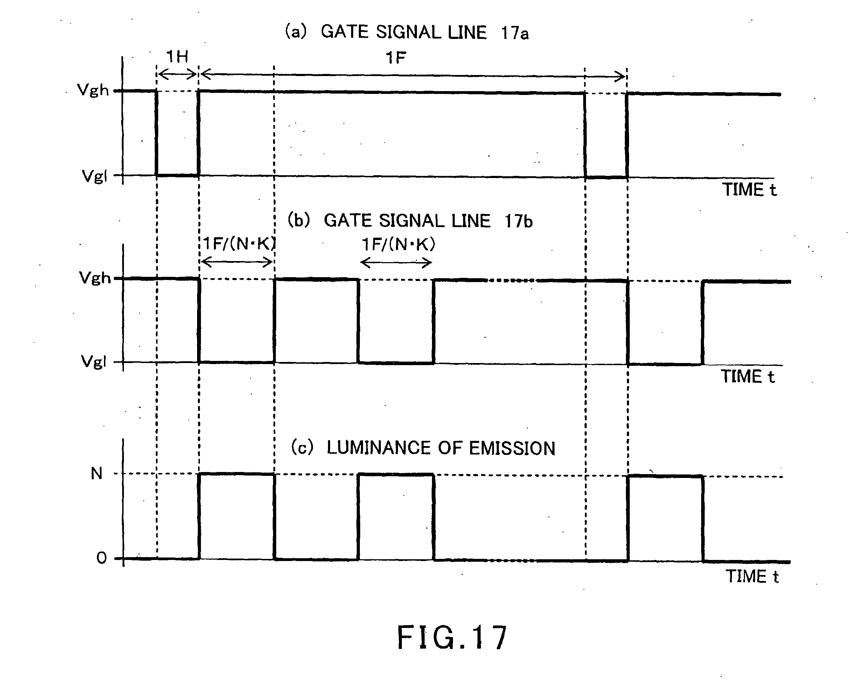

Figure 17 shows a voltage waveform applied to each gate signal line 17 and the luminance of the EL device emitting light. As can be clearly seen from Figure 17, the (1F/N) period for which gate signal line 17b is applied with Vgl is divided into plural subperiods (the number of subperiods is K) That is, gate signal line 17b is applied with Vgl for a 1F/(K/N) period K times. Such a control can inhibit the occurrence of flicker and realize image display with a low frame rate. It is also preferable to employ such an arrangement as to allow the number of such image divisions to be varied. For example, an arrangement is possible such as to detect a change resulting from depressing of a brightness adjuster switch or turning of a brightness adjuster volume and then vary the value of K. Another possible arrangement allows the user to adjust the luminance. Yet another possible arrangement allows the user to vary the number of K depending on the details of or data on an image to be displayed manually or is capable of varying the number of K automatically

While description has been made of the feature that the (1F/N) period for which gate signal line 17b is applied with Vgl is divided into plural subperiods (the number of subperiods is K) and gate signal line 17b is applied with Vgl for a 1F/(K/N) period K times, there is no limitation to this feature. Gate signal line 17b may be applied with Vgl for the 1F/(K/N) period L times (L ≠ K). Thus, the present invention has the feature that an image is displayed by controlling the period (time) for which EL device 15 is fed with current. Therefore, the art of repeating the 1F/(K/N) period L times (L ≠ K) is included in the technical concept of the present invention. The luminance of image 50 can be varied digitally by varying the value of L. For example, the difference between L = 2 and L =3 corresponds to a 50 % change in luminance (contrast). In splitting display region 53, the period for which gate signal line 17b is applied with Vgl is not necessarily constant.

The above-described embodiment is an embodiment in which display screen 50 is turned on/off (into lighting state/non-lighting state) by cutting of the current to be passed through EL device or passing the current through EL device. That is, the embodiment is configured to pass generally equal current through transistor 11a plural times by the charge held in capacitor 19. However, the present invention is not limited thereto. The present invention may employ such a configuration as to turn display screen 50 on/off (into lighting state/non-lighting state) by charging/discharging capacitor 19.

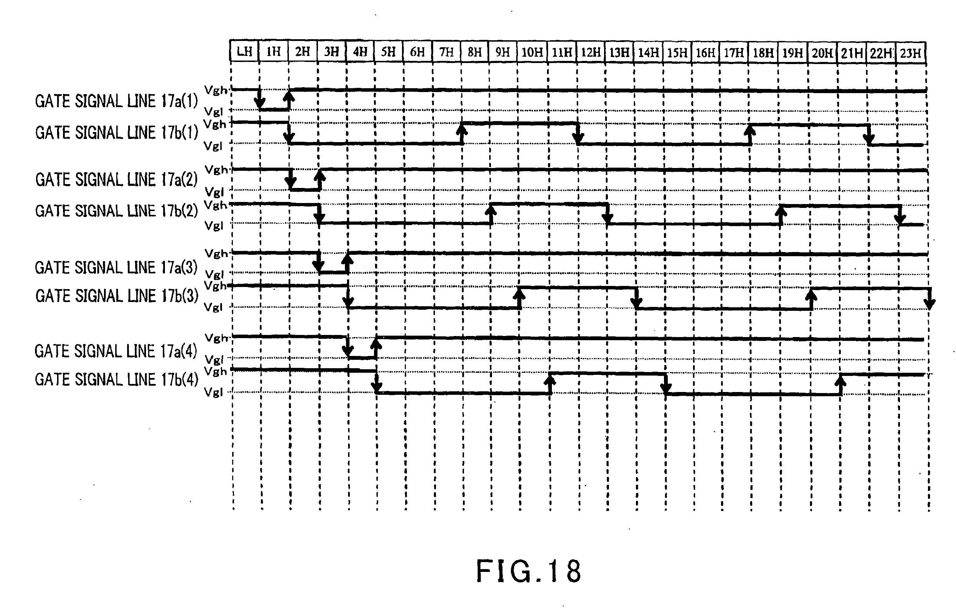

Figure 18 shows a voltage waveform applied to each gate signal line 17 for realizing the image display state shown in Figure 16. The difference between Figure 18 and Figure 15 resides in the operation of gate signal line 17b. Gate signal line 17b is turned on/off (with Vgl or Vgh) plural times, the number of times corresponding to the number of split sections of the screen. Since other features are the same as the corresponding features of Figure 15, description thereof will be omitted.

Since the EL display apparatus assumes a completely non-lighting state to provide a black display, a drop in contrast, which is essential to intermittent display performed by a liquid crystal display panel, does not occur. With the configuration shown in Figure 1, intermittent display can be realized by merely on-off controlling transistor 11d. With each of the configurations shown in Figs. 38 and 51, intermittent display can be realized by merely on-off controlling transistor 11e. This is because capacitor 19 stores image data. (The number of gray levels is infinite since such stored image data is an analog value.) Specifically, each pixel 16 stores image data for a 1F period. Whether or not EL device 15 is to be fed with a current corresponding to image data stored in each pixel 16 is controlled by control over transistors 11d and 11e. Thus, the above-described driving method is applicable not only to the current-driven configuration but also to the voltage-driven configuration. Stated otherwise, the driving method can realize intermittent driving of a configuration where each pixel is adapted to store a current to be passed through EL device 15 by turning on/off the driving transistor 11 on the current path between EL devices 15.

It is critical to maintain the terminal voltage of capacitor 19. This is because when the terminal voltage of capacitor 19 varies (i.e., capacitor 19 is charged/discharged) during a one-field (frame) period, the luminance of the screen varies, which results in flitter (flicker or the like) when the frame rate is lowered. It is required that the current to be passed through EL device 15 during a one-frame (field) period should not lower to 65% or less. The value of 65% means that assuming the first current written to pixel 16 and passed through EL device 15 is 100%, the current to be passed through EL device 15 just before writing to the pixel 16 in the next frame (or field) is set to 65% or more.

In the configuration shown in Figure 1, the number of transistors 11 forming one pixel is not varied irrespective of whether or not intermittent display is realized. That is, satisfactory current-based programming is realized by eliminating the influence of the parasitic capacitance of source signal line 18 without changing the pixel configuration. In addition, picture motion display close to that provided by a CRT can be realized.

Since the clock for operating gate driver 12 is sufficiently slow as compared to the clock for operating source driver 14, the main clock of the circuit does not rise. Further, the value of N can be varied easily

It is possible that the image displaying direction (image writing direction) at the first field (frame) is the direction from the upper side to the lower side of the screen while the image displaying direction at the second field (frame) is the direction from the lower side to the upper side of the screen. That is, the downwardly displaying direction and the upwardly displaying direction may alternate with each other repeatedly.

It is also possible that the image displaying direction at the first field (frame) is the direction from the upper side to the lower side of the screen and after the whole screen has been temporarily turned into a black display (into a non-display state), the image displaying direction is switched to the direction from the lower side to the upper side of the screen at the subsequent second field (frame). The whole screen may present a black display once.

Though the aforementioned driving method has been described to perform the writing to the screen in the direction from the upper side to the lower side of the screen or from the lower side to the upper side of the screen, there is no limitation to this feature. It is possible that the direction of writing to the screen from the upper side to the lower side or from the lower side to the upper side is fixed whereas non-display region 52 shifts in the direction from the upper side to the lower side of the screen at a first field (frame) while shifting in the direction from the lower side to the upper side of the screen at a subsequent second field. It is also possible that one frame is divided into three fields, the first, second and third ones of which are allocated to R, B and G, respectively, and, hence, three fields constitute one frame. It is also possible that R, G and B are switched one to another on a one horizontal scanning period (1H) basis. The above-described matters hold true for other embodiments of the present invention.

Non-display region 52 need not necessarily assume a completely non-lighting state. There arises no practical problem even when faint luminescence or faint image display occurs. Such faint luminescence or faint image display should be construed as a region having a lower display luminance than image display region 53. The "non-display region 52" is meant to include even the case where one or two of R,G and B image display pixels are in the non-display state.

Basically speaking, with the luminance (brightness) of display region 53 being maintained to a predetermined value, the luminance of screen 50 rises with increasing area of display region 53. For example, with display region 53 having a luminance of 100 (nt), an increase in the proportion of display region 53 relative to the whole screen 50 from 10% to 20% raises the screen luminance twice. Thus, the display luminance of the screen can vary with varying area of display region 53 in the whole screen 50.

The area of display region 53 can be set as desired by controlling data pulse (ST2) to be fed to shift register 61. Further, the display state shown in Figure 16 and the display state shown in Figure 13 can be switched to each other by varying the data pulse input timing and the data pulse input cycle. An increase in the number of data pulses per 1F period causes screen 50 to become brighter, whereas a decrease in the number of data pulses causes screen 50 to become darker. Continuous application of data pulses results in the display state shown in Figure 13, while intermittent inputting of data pulses results in the display state shown in Figure 16.

Figure 19(a) illustrates a method of brightness adjustment applicable to the case where display region 53 is continuous as shown in Figure 13. The screen 50 at Figure 19(a1) has the highest display luminance. The display luminance of the screen 50 at Figure (a2) is next to the highest, whereas that of the screen 50 at Figure (a3) is the lowest. The change in state from Figure 19 (a1) to Figure 19(a3) and vice versa can be easily realized by control over the shifter register 61 of gate driver 12 and the like as described above. At that time, the voltage Vdd in Figure 1 need not be varied. That is, the luminance of display screen 50 can be varied without varying the supply voltage. The gamma characteristic of the screen does not vary at all with the change in state from Figure 19(a1) to Figure 19(a3). Thus, the contrast and the gray scale characteristic of a displayed image are maintained irrespective of the luminance of screen 50. This is an effect characteristic of the present invention. With the conventional screen luminance adjustment, the gray scale performance is low when the luminance of screen 50 is low. Specifically, though a 64-level gray scale display can be realized at a high luminance display, the number of displayable gray levels is decreased to a half or less at a low luminance display in most cases. In contrast, the driving method of the present invention is capable of realizing the maximum 64-level gray scale display without dependence on the display luminance of the screen.

Figure 19(b) illustrates a method of brightness adjustment applicable to the case where display region 53 is dispersed as shown in Figure 16. The screen 50 at Figure 19(b1) has the highest display luminance. The display luminance of the screen 50 at Figure (b2) is next to the highest, whereas that of the screen 50 at Figure (b3) is the lowest. The change in state from Figure 19 (b1) to Figure 19(b3) and vice versa can be easily realized by control over the shifter register 61 of gate driver 12 and the like as described above. If display region 53 is dispersed as shown in Figure 19(b), flicker does not occur even at a low frame rate.

In order to further lessen the occurrence of flicker at a low frame rate, display region 53 should be dispersed more finely as shown in Figure 19(c). In this case, however, the motion picture display performance lowers. Therefore, the driving method illustrated in Figure 19(a) is suitable for motion picture display. The driving method illustrated in Figure 19(c) is suitable for the case where a stationary image is displayed with low power consumption demanded. Switching from the Figure 19(a) method to the Figure 19(c) method can be easily realized by control over shift register 61.

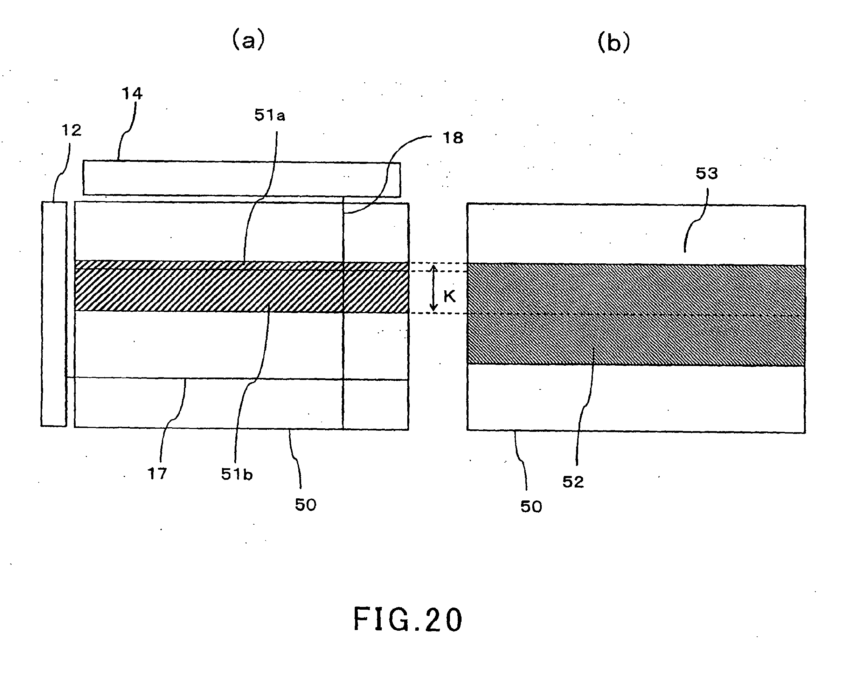

Figure 20 is an explanatory view illustrating another embodiment for increasing the current to be fed to source signal line 18. This embodiment is a method of significantly improving insufficient writing with current, which basically comprises selecting plural pixel rows at a time and charging/discharging the parasitic capacitance of source signal line 18 and the like with a current which is the sum of currents required by the plural pixel rows. Since plural pixel rows are selected at a time, the current for driving one pixel can be decreased. Hence, the current to be fed to EL device 15 can be decreased. Here, for easy explanation, the case of N = 10 (in which a 10-fold current is passed through source signal line 18) will be described as an example.

As shown in Figure 20, K pixel rows are selected according to the present invention. Source signal line 18 is applied with a current N times as high as a predetermined current from source driver 14. Each pixel is programmed with a current N/K times as high as the current to be passed through the EL device 15. The time period for which the EL device 15 is fed with the current is set to K/N of a one-frame (field) period. Such a driving method makes it possible to charge/discharge the parasitic capacitance of source signal line 18 sufficiently as well as to obtain satisfactory resolution and a predetermined luminance of emission.

Specifically, EL device 15 is fed with current for K/N of a one-frame (field) period and is not fed with current for the rest (1F(N-1)K/N) of the one-frame period. In this display state, a display based on image data and a black display (non-lighting state) alternate with each other repeatedly 1F by 1F. That is, such a display based on image data appears at time intervals (intermittent display). Thus, a motion picture display of high quality with no blurred outline can be realized. Further, since source signal line 18 is driven with an N-fold current, the parasitic capacitance does not affect the display and, hence, the driving method of the present invention is applicable to high-resolution display panels.

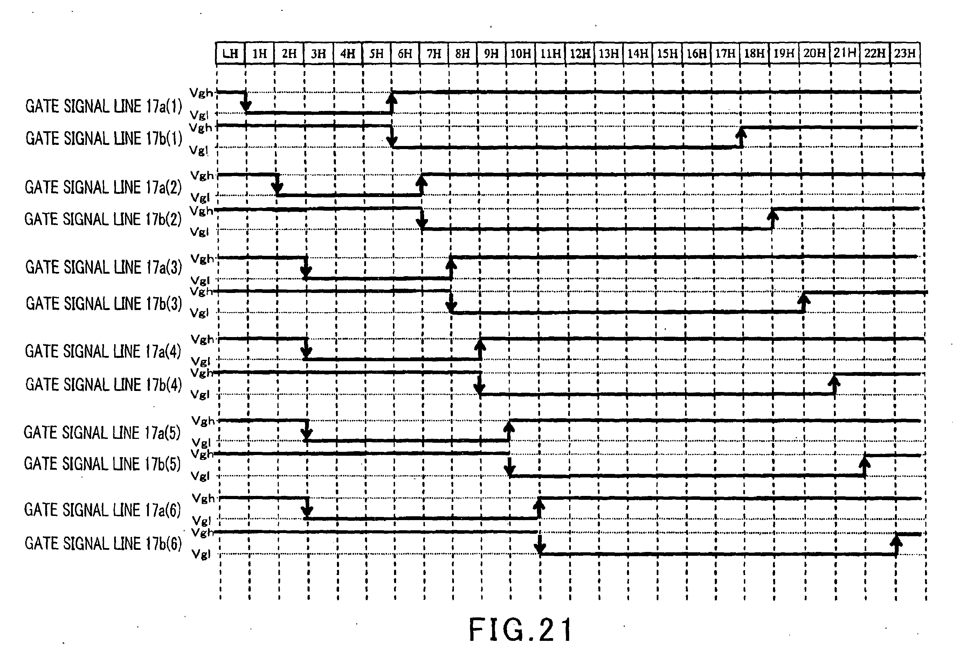

Figure 21 is an explanatory diagram of driving voltage waveforms used for realizing the driving method illustrated in Figure 20. In this figure, a signal waveform comprises off-voltage Vgh (H level) and on-voltage Vgl (L level). The numeral added to each signal line, such as (1), (2) or (3), indicates the row number of each pixel row. It should be noted that a QCIF display panel has 220 rows while a VGA panel has 480 rows.

In Figure 21, when gate signal line 17a(1) is selected (at voltage Vgl), a programming current is passed through source signal line 18 from transistor 11a of the selected pixel row toward source driver 14. For easy explanation, description will be made of the case where pixel row 51a to be written is the first pixel row.

The programming current to be passed through source signal line 18 is N times as high as a predetermined value. (Description is made with N = 10 for easy explanation. Since the predetermined value is the value of a data current causing an image to be displayed, the predetermined value is not a fixed value unless a white raster display is provided.) Further, description will be made of the case where five pixel rows are to be selected at a time (K = 5.) Accordingly, the capacitor 19 of one pixel is programmed so that, ideally, a 2-fold current (N/K = 10/5 = 2) will pass through transistor 11a.

When the written pixel row is the first pixel row (1), gate signal lines 17a(1) to 17a(5) are in the selected state. That is, the switching transistors 11b and 11c of each of pixels rows (1) to (5) are in on-state. Also, gate signal line 17b is in reversed phase with gate signal line 17a. Accordingly, the switching transistor 11d of each of the pixel rows (1) to (5) is in off-state, thus preventing current from passing through EL devices 15 of the associated pixel row. That is, these EL devices are in the non-lighting state 52.

Ideally, the transistors 11a of five pixels each pass a current of Iw×2 through source signal line 18. (That is, a current of Iw×2×N = Iw×2×5 = Iw×10 is passed through source signal line 18. Therefore, assuming that the current to be passed through source signal line 18 in the case where the N-fold pulse driving method of the present invention is not employed is the predetermined current Iw, a current 10 times as high as Iw is to be passed through source signal line 18.)

The operation (driving method) described above causes the capacitor 19 of each pixel 16 to be programmed with a 2-fold current. Here, description is made on the assumption that transistors 11a are uniform in characteristics (Vt and S value) for easy understanding.

Since the number of pixel rows selected at a time is five (K = 5), five driving transistors 11a operate. That is, a 2-fold (10/5 = 2) current passes through transistor 11a per pixel. Source signal line 18 is fed with a current as the sum of programming currents for the five transistors 11a. For example, assuming that the current to be conventionally passed through pixel row 51a to be written is Iw, a current of Iw×10 is to be passed through source signal line 18 according to the present invention. Pixel rows 51b to be written with image data after writing to pixel row (1) are now used as auxiliary pixel rows for increasing the amount of current to be fed to source signal line 18. However, there arises no problem because the pixel rows 51b will be written with correct image data thereafter.

Therefore, the four pixel rows 51b provide the same display as the pixel row 51a during a 1H period. For this reason, at least the written pixel row 51a and the pixel rows 51b selected for increasing the current are made to assume the non-lighting state 52. However, such pixel rows in a current mirror pixel configuration as shown in Figure 38 or other pixel configurations adapted for voltage-based programming may be made to assume the lighting state.

After lapse of 1H, gate signal line 17a(1) assumes the unselected state while gate signal line 17b is applied with on-voltage (Vgl). At the same time, gate signal line 17a(6) is selected (applied with Vgl voltage) and transistor 11a of the selected pixel row (6) passes the programming current through source signal line 18 toward source driver 14. Such an operation allows pixel row (1) to hold regular image data.

After lapse of another 1H, gate signal line 17a (2) assumes the unselected state while gate signal line 17b is applied with on-voltage (Vgl). At the same time, gate signal line 17a(7) is selected (applied with Vgl voltage) and transistor 11a of the selected pixel row (7) passes the programming current through source signal line 18 toward source driver 14. Such an operation allows pixel row (2) to hold regular image data. By performing the above-described operation with scanning shifting pixel row by pixel row, one screen is wholly rewritten.

With the driving method of Figure 20, each pixel is programmed with a 2-fold current (voltage) and, hence, ideally the EL device 15 of each pixel emits light at a 2-fold luminance. Therefore, the luminance of the display screen is twice as high as the predetermined value. In order for the display screen to display at the predetermined luminance, a region including written pixel row 51 and occupying 1/2 of display region 50 should be used as non-display region 52.

As in the case of Figure 13, when one display region 53 shifts downwardly from the upper side of the screen as shown in Figure 20, the shifting of display region 53 is visually recognized if the frame rate is low. This is likely particularly when the viewer blinks his or her eyes or moves his or her face up and down.

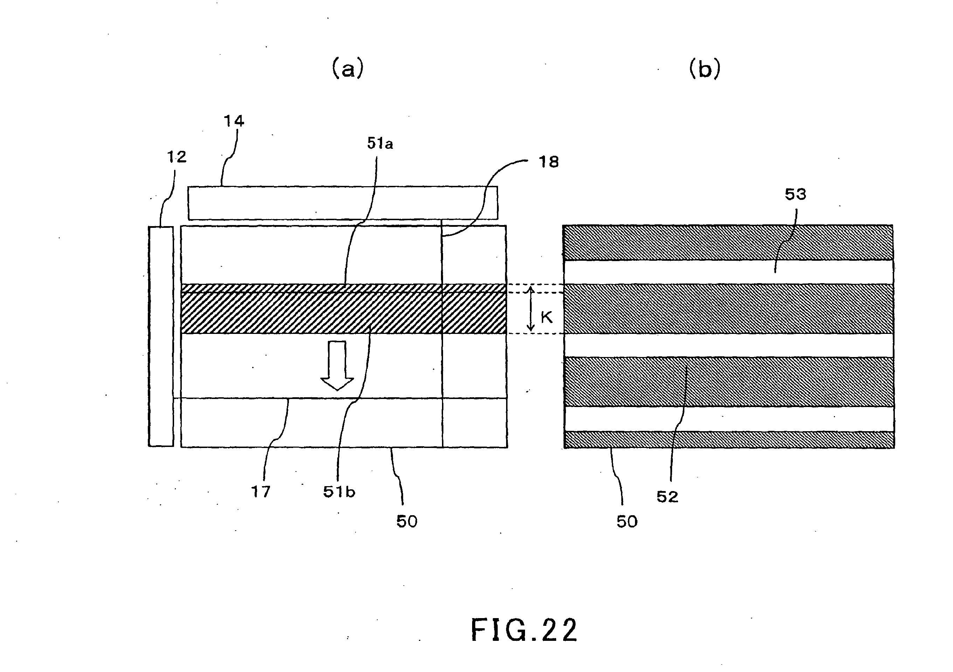

To solve this problem, display region 53 should be split into plural sections as shown in Figure 22. If the total sum of the areas of these sections is equal to the area of an S(N-1)/N region, the brightness of this display is equal to that of the display provided without splitting of display region 53.

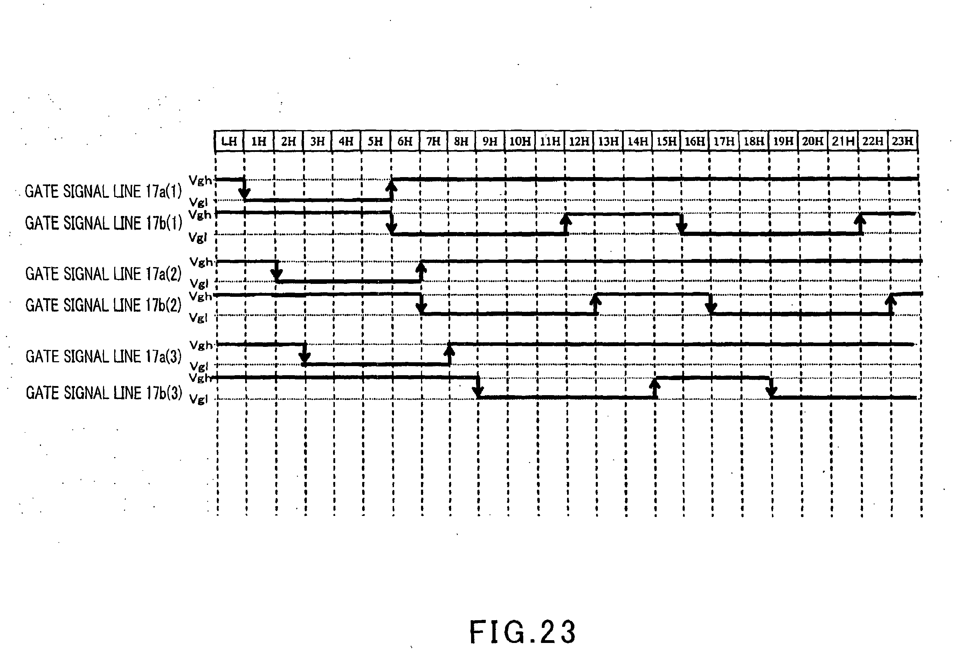

Figure 23 shows a voltage waveform applied to each gate signal line 17. The difference between Figure 21 and Figure 23 resides in the operation of gate signal line 17b. Gate signal line 17b is turned on/off (with Vgl and Vgh) plural times, the number of times corresponding to the number of split sections of the screen. Since other features are substantially the same as or analogous to the corresponding features of Figure 21, description thereof will be omitted.

By thus splitting display region 53 into plural sections; the screen provides a display with reduced flitter. Thus, satisfactory image display free of flicker can be realized. Display region 53 may be split into smaller sections. With finer splitting, flicker can be more reduced. Since the responsiveness of EL device 15 is particularly high, the display luminance will not lower even if EL device 15 is turned on/off at a time interval shorter than 5 μsec.

In the driving method of the present invention, EL device 15 can be on-off controlled by turning on/off the signal to be applied to gate signal line 17b. For this reason, such control can be achieved with a clock having a low frequency on the KHz order. Further, image memory or the like is not needed for inserting a black display (i.e., non-display region 52). Therefore, the driving circuit or method of the present invention can be implemented with reduced cost.

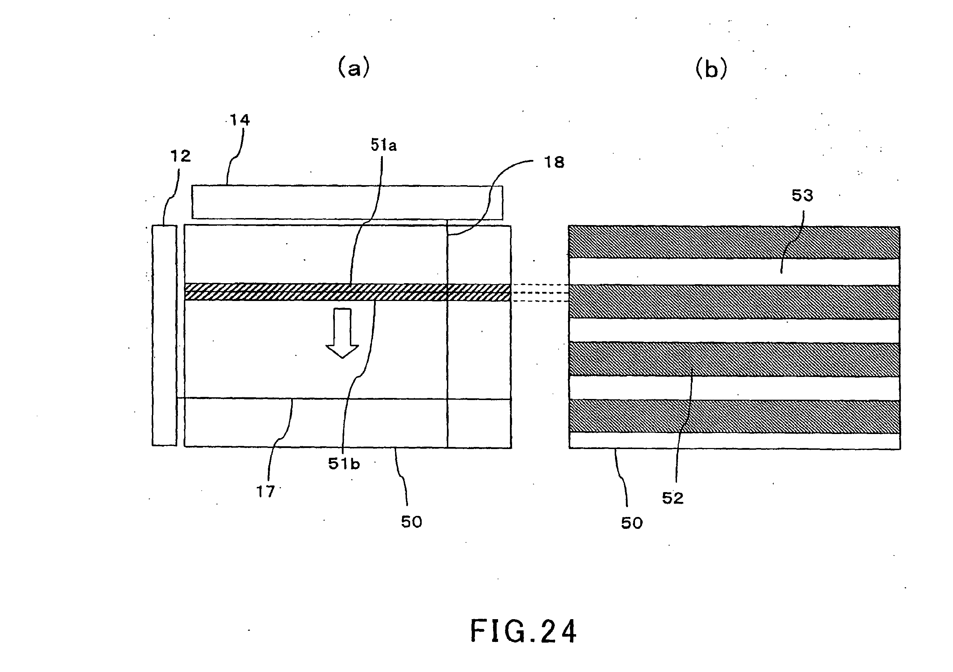

Figure 24 illustrates the case where the number of pixel rows to be selected at a time is two. According to the results of study made by the inventors et al., the method including selection of two pixel rows at a time realized practical display uniformity when applied to display panels formed by the low temperature polysilicon technology. Presumably, this is because driving transistors 11a of adjacent pixels were very uniform in their characteristics. Good results were obtained by performing striped laser irradiation parallel with source signal line 18 in laser annealing.

This is because portions of a semiconductor film in a region annealed at the same time are uniform in characteristics. Stated otherwise, this is because a semiconductor film is formed uniformly in a striped region irradiated with laser light and transistors formed using this semiconductor film are substantially uniform in Vt and mobility. Thus, pixels arranged along source signal line 18 (i.e., a pixel column extending vertically of the screen) are made substantially uniform in characteristics by irradiation with striped laser shot in parallel with the source signal line 18 forming direction and shifting the irradiating position. Therefore, when plural pixel rows are turned on at a time so as to be programmed with current, the plural pixel rows selected at a time are programmed with a substantially equal current having a value which is the quotient obtained by dividing the programming current by the number of the selected pixel rows. Thus, it is possible to realize current-based programming with a current value close to a target value, hence, realize a uniform display. For this reason, the laser shot direction and the driving method illustrated in Figure 24 or the like provide a synergetic effect.

As described above, transistors 11a of vertically arranged pixels are made substantially uniform in characteristics by making the direction of laser shot substantially coincident with the direction in which source signal line 18 is formed, thus resulting in satisfactory current-based programming. (In this case, transistors 11a of horizontally arranged pixels need not necessarily be uniform in characteristics.) The operation thus described is performed, while the position of pixel rows to be selected is shifted one pixel row by one pixel row or plural pixel rows by plural pixel rows in synchronism with 1H (one-horizontal period). Though the laser shot direction described is made parallel with source signal line 18 according to the above description, the present invention is not limited to the laser shot direction parallel with source signal line 18. This is because irradiation with laser shot in an oblique direction with respect to source signal line 18 allows transistors 11a of vertically arranged pixels along one source signal line 18 to be made substantially uniform in characteristics. Therefore, the "irradiation with laser shot parallel with source signal line" is meant to form any adjacent pixels to be arranged along the wiring direction of source signal line 18 (in the vertical direction) in a manner to locate them within one laser irradiation region. The "source signal line 18" generally means wiring for transmission of programming currents or voltages serving as image signals.

According to the above-described embodiment of the present invention, the position of pixel rows to be written is shifted 1H by 1H. However, the present invention is not limited to this feature. It is possible to shift the position 2H by 2H or on the basis of more pixel rows. Alternatively, shifting may be performed based on any unit time. The shifting time interval may be varied with varying position on the screen. For example, it is possible that the shifting time interval is shortened at a central portion of the screen and prolonged at upper and lower portions of the screen. Also, the shifting time interval may be varied frame by frame. The present invention is not limited to selection of plural pixel rows arranged adjacent to each other. For example, it is possible to select pixel rows located across one intervening pixel row. Specifically, a driving method may be employed such that the first and third pixel rows are selected in the first horizontal scanning period, the second and fourth pixel rows selected in the second horizontal scanning period, the third and fifth pixel rows selected in the third horizontal scanning period, and the fourth and sixth pixel rows selected in the fourth horizontal scanning period. Of course, the technical scope of the present invention includes a driving method such as to select the first, third and fifth pixel rows in the first horizontal scanning period. It is, of course, possible to select pixel row positions across plural intervening pixel rows.

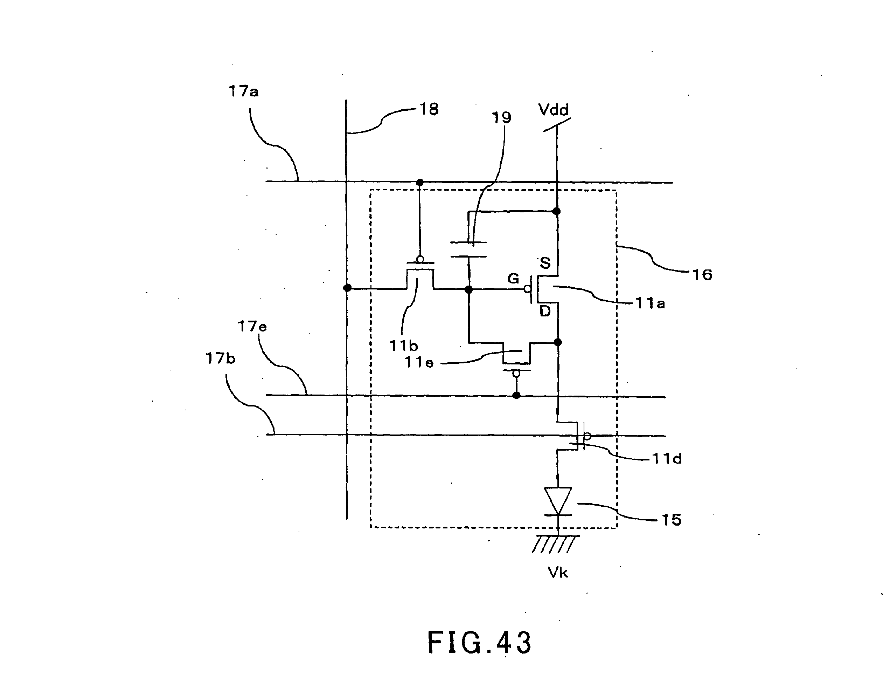

It is needless to say that the combination of the feature of the laser shot direction setting and the feature of the simultaneous selection of plural pixel rows is applicable not only to the pixel configurations shown in Figs. 1, 2 and 32 but also to other current-driven pixel configurations as shown in Figs. 38, 42 and 50 including the current mirror pixel configuration shown in Figure 38. The combination is also applicable to voltage-driven pixel configurations as shown in Figs. 43, 51, 54 and 62. This is because if the transistors of pixels arranged adjacent to each other vertically are uniform in characteristics, satisfactory voltage-based programming can be realized with a voltage applied to a common source signal line 18.

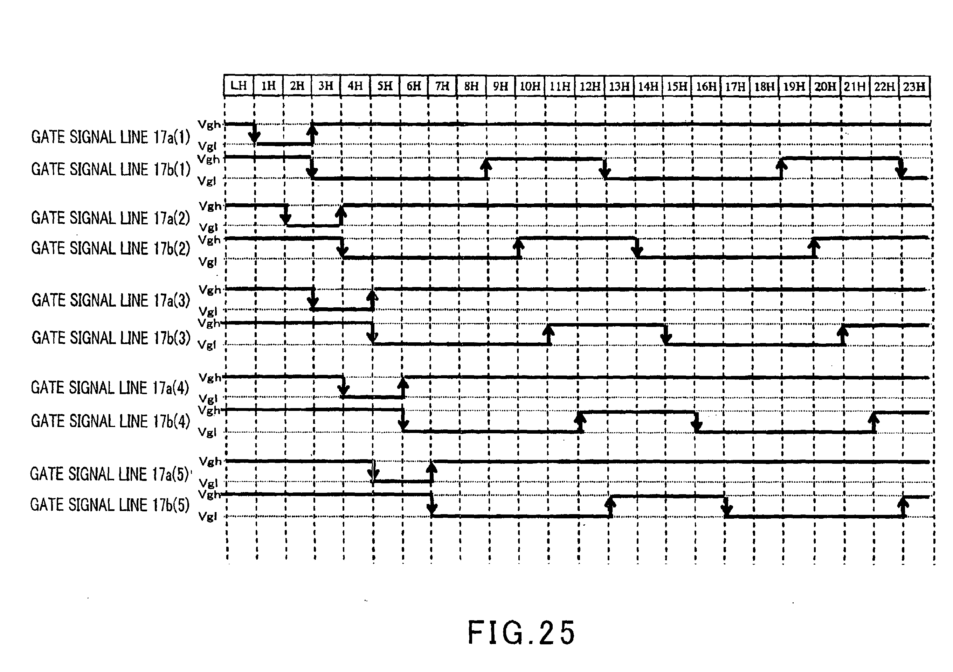

When the first pixel row is written in the configuration shown Figure 24, gate signal lines 17a(1) and 17a(2) are selected (see Figure 25.) That is, the switching transistors 11b and transistors 11c of pixel rows (1) and (2) are in on-state. Each gate signal line 17b is in reversed phase with each gate signal line 17a. Accordingly, the switching transistors 11d of at least the pixel rows (1) and (2) are in off-state, thus preventing current from passing through EL devices 15 of the associated pixel rows. That is, these pixel rows are in the non-lighting state 52. It should be noted that in the arrangement shown in Figure 24, display region 53 is split into five sections in order to reduce the occurrence of flicker.

Ideally, the transistors 11a of two pixels (pixel rows) each pass a current of Iw×5 (N = 10) through source signal line 18. (That is, since K = 2, a current of Iw×K×5 = Iw×10 is passed through source signal line 18.) Therefore, the capacitor 19 of each pixel 16 is programmed with a 5-fold current.

Since the number of pixel rows selected at a time is two (K = 2), two driving transistors 11a operate. That is, a 5-fold (10/2 = 5) current passes through each transistor 11a. Source signal line 18 is fed with a current as the sum of programming currents for the two transistors 11a.

For example, pixel row 51a to be written is fed with current Id, which is to be conventionally fed to pixel row 51a, while source signal line 18 is fed with a current of Iw×10. However, there arises no problem because the pixel row 51b will be written with regular image data thereafter. The pixel row 51b provides the same display as the pixel row 51a during a 1H period. For this reason, at least the written pixel row 51a and the pixel row 51b selected for increasing the current are made to assume the non-lighting state 52.

After lapse of 1H, gate signal line 17a(1) assumes the unselected state while gate signal line 17b is applied with on-voltage (Vgl). At the same time, gate signal line 17a(3) is selected (applied with Vgl voltage) and the transistor 11a of the selected pixel row (3) passes the programming current through source signal line 18 toward source driver 14. Such an operation allows pixel row (1) to hold regular image data.

After lapse of another 1H, gate signal line 17a (2) assumes the unselected state while gate signal line 17b is applied with on-voltage (Vgl). At the same time, gate signal line 17a(4) is selected (applied with Vgl voltage) and the transistor 11a of the selected pixel row (4) passes the programming current through source signal line 18 toward source driver 14. Such an operation allows pixel row (2) to hold regular image data. By performing the above-described operation with scanning shifting pixel row by pixel row, one screen is wholly rewritten. (Of course, scanning may be shifted plural pixel rows by plural pixel rows. For example, a pseudo-interlaced driving method will shift scanning two rows by two rows. In terms of image display, there will be some cases where the same image is written to plural pixel rows.)

Similarly to the case of Figure 16, the driving method illustrated in Figure 24 programs each pixel with a 5-fold current (voltage) and, hence, ideally the EL device 15 of each pixel emits light at a 5-fold luminance. Therefore, the luminance of display region 53 is 5 times as high as the predetermined value. In order for the display region 53 to display at the predetermined luminance, a region including written pixel rows 51 and occupying 1/5 of display screen 50 should be used as non-display region 52.

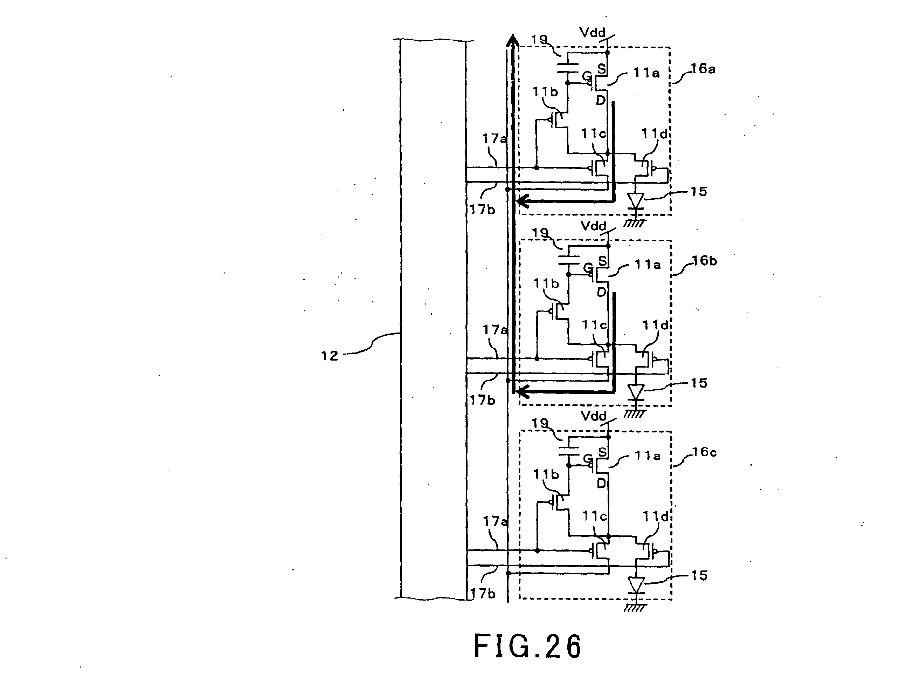

As shown in Figure 27, two pixel rows to be written 51 (51a and 51b) are selected and such selection is made sequentially from the upper side to the lower side of screen 50. (See Figure 26 also. In Figure 26, pixel rows 16a and 16b are selected.) When selection is made down to the lower side of the screen, pixel row 51b to be written disappears, though pixel row 51a to be written is present. That is, only one pixel row is left for selection. For this reason, the current applied to source signal line 18 is wholly written to pixel row 51a. Accordingly, pixel row 51 to be written now is undesirably programmed with a current twice as high as the current with which the preceding pixel rows 51a have been priorly programmed.

In order to solve this problem, the present invention uses a dummy pixel row 281 formed (located) on the lower side of screen 50, as shown in Figure 27 (b). Therefore, when selection of pixel rows to be written reaches the lower side of screen 50, the final pixel row on screen 50 and the dummy pixel row 281 are selected. For this reason, the final pixel row shown in Figure 27 (b) is written with the regular current. Though the dummy pixel row 281 is shown to locate adjacent to the upper or lower edge of display region 50, there is no limitation to this arrangement. The dummy pixel row 281 may be formed at a location spaced apart from display region 50. The dummy pixel row 281 need not be formed with switching transistor 11d, EL device 15 and the like shown in Figure 1. The absence of these components enables the dummy pixel row 281 to be reduced in size.

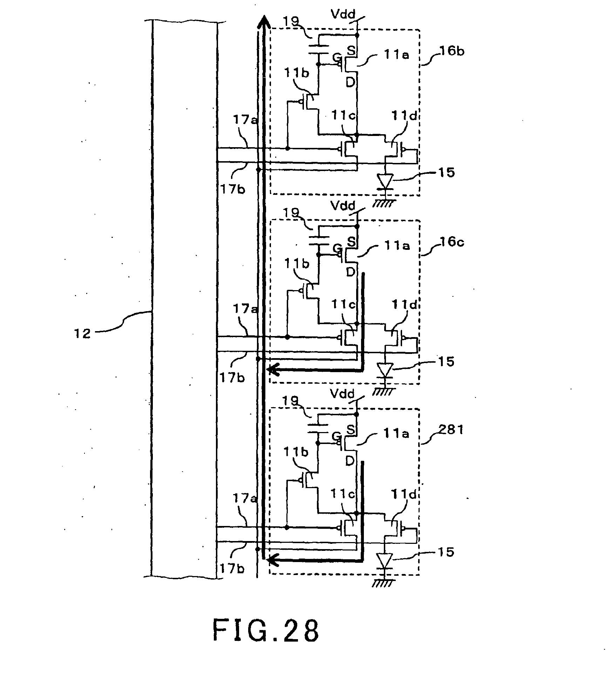

Figure 28 illustrates the state shown in Figure 27(b). As apparent from Figure 28, when selection of pixel rows reaches pixel 16c on the lower side of screen 50, the final pixel row 281 on screen 50 is selected. The dummy pixel row 281 is located outside display region 50. That is, the dummy pixel row 281 is configured to fail to light or not to be allowed to light, or not to be seen as a display even when it lights. This can be made by, for example, elimination of the contact hole between the pixel electrode and transistor 11 or failure to form EL film at the dummy pixel row.

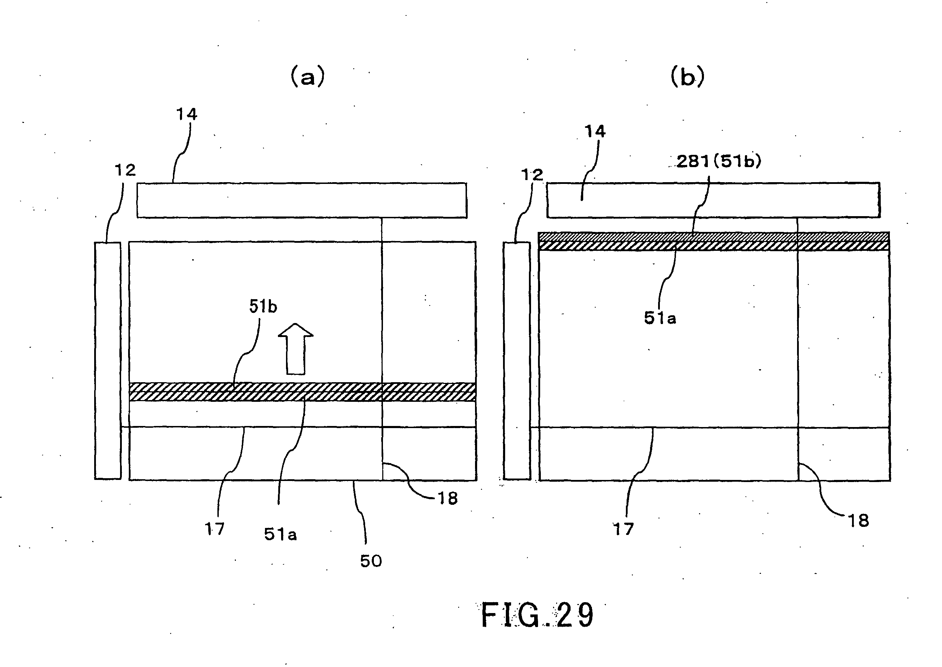

Though the dummy pixel (row) 281 is provided (formed or located) on the lower side of screen 50 in the arrangement shown in Figure 27, there is no limitation to this arrangement. For example, in the case where scanning is performed from the lower side to the upper side of screen 50 (reverse scanning) as shown in Figure 29(a), dummy pixel row 281 should be formed also on the upper side of screen 50, as shown in Figure 29(b). That is, the upper side and the lower side of screen 50 are formed (provided) with respective dummy pixel rows 281. Such an arrangement can accommodate to vertical reversal of scanning over the screen.

The above-described embodiment is configured to select two pixel rows at a time. However, the present invention is not limited to this configuration but may employ a configuration for selection of, for example, five pixel rows at a time (see Figure 23.) That is, where five pixel rows are driven at a time, four dummy pixel rows 281 should be formed. The dummy pixel row configuration or the dummy pixel row driving method according to the present invention is of the type using at least one dummy pixel row. Of course, it is preferable to combine the dummy pixel row driving method with the N-fold pulse driving method.

With the driving method in which plural pixel rows are selected at a time, it becomes more difficult to accommodate variations in the characteristics of transistors 11a as the number of pixel rows to be selected at a time increases. However, with increasing number of pixel rows to be selected, the programming current for each pixel becomes higher and, hence, a higher current is to be passed through EL device 15. If the current passing through EL device 15 is high, EL device 15 is easy to deteriorate.

The method illustrated in Figure 30 is capable of solving this problem. The basic concept of the method illustrated in Figure 30 according to the present invention is a combination of a method such as to select plural pixel rows at a time in a 1/2H period (1/2 of a horizontal scanning period), similarly to the methods described in relation to Figs. 22 and 29, and a method such as to select one pixel row in the subsequent 1/2H period (1/2 of a horizontal scanning period), similarly to the methods described in relation to Figs. 5 and 13. Such a combination accommodates variations in the characteristics of transistors 11a and hence is capable of making the responsiveness high and the in-plane uniformity satisfactory.

For easy explanation, description will be made of such a combined method including selecting five pixel rows at a time in a first period and then selecting one pixel row in a second period. In the first period (the first 1/2H), five pixel rows are selected at a time as shown in Figure 30(a1). Since this operation has already been described with reference to Figure 22, description thereof will be omitted. The current to be passed through source signal line 18 is, for example, 25 times as high as the predetermined value. Accordingly, the transistor 11a of each pixel (in the case of the pixel configuration shown in Figure 1) is to be programmed with a 5-fold current (25/5 pixel rows = 5.) Since source signal line 18 is to be fed with a 25-fold current, the parasitic capacitance occurring in source signal line 18 and the like can be charged/discharged in a very short time. Therefore, the potential of source signal line 18 becomes a target potential in a short time and the capacitor 19 of each pixel 16 is programmed to have such a terminal voltage as to pass the five-fold current. The period for which the 25-fold current is applied is the first 1/2H (1/2 of one horizontal scanning period.)

As a matter of course, since five pixel rows are to be written with the same image data, the transistors 11d of these five pixel rows are made to assume off-state so that the five pixel rows do not display. Thus, the resulting display state is as shown in Figure 30(a2).

In the latter 1/2H period, one pixel row is selected and current-based (voltage-based) programming is performed. This state is illustrated in Figure 30(b1). The pixel row 51a written is programmed with a current (voltage) so that a 5-fold current will pass as in the first period. The current to be passed through each pixel in the case of Figure 30(a1) and that in the case of Figure 30(b1) are equalized to each other because a variation in the terminal voltage of capacitor 19 is reduced to allow a current of a target value to pass more promptly.

Specifically, in the operation illustrated in Figure 30(a1), plural pixels are fed with a current so that the terminal voltage of each capacitor 19 can rapidly reach a value causing an approximate current to pass. At this first step, programming is made at plural transistors 11a and, hence, errors in regard to a target value occur due to variations in the characteristics of the transistors. At the subsequent second step, only the pixel row to be written with data and hold the data is selected so that programming is completed with a current having the predetermined target value varied from the approximate target value.

Since the operation of scanning non-lighting region 52 as well as pixel row 51a to be written downwardly of the screen is the same as in the case of Figure 13 or the like, description thereof will be omitted.

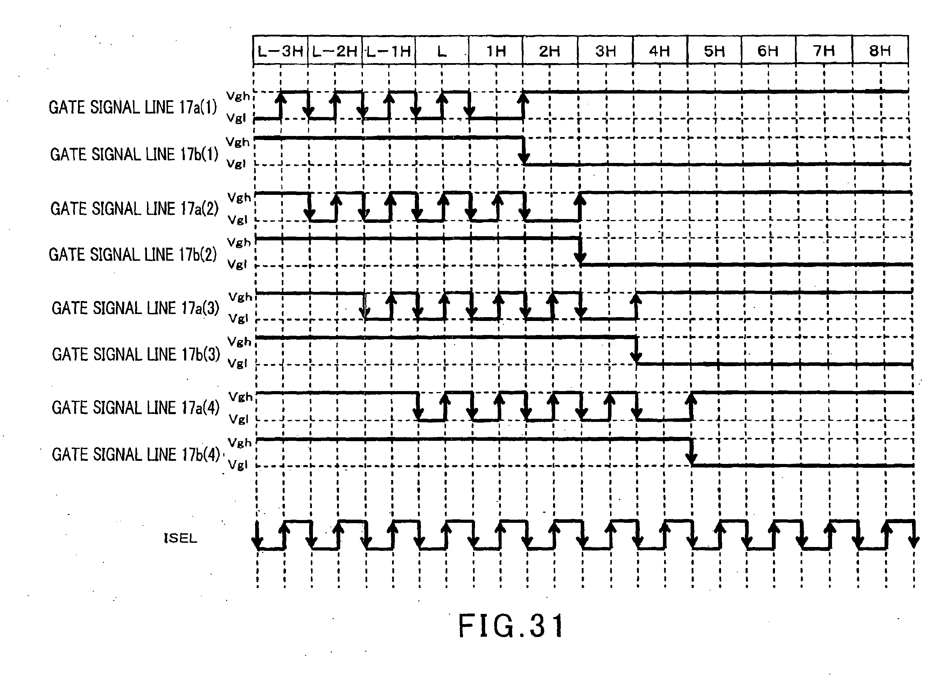

Figure 31 shows driving waveforms for realizing the driving method illustrated in Figure 30. As can be seen from Figure 31, a 1H period (one horizontal scanning period) comprises two phases. Switching between these two phases is made using ISEL signal, which is shown in Figure 31.

Reference is first made to such ISEL signal. The driver circuit 14 for carrying out the method illustrated in Figure 30 has first and second current output circuits. These first and second current output circuits each comprise a DA circuit for DA conversion of 8-bit gray scale data, an operational amplifier, and the like. In the embodiment of Figure 30, the first current output circuit is configured to output a 25-fold current, while the second current output circuit configured to output a 5-fold current. Outputs of the respective first and second current output circuits are applied to source signal line 18 by control over a switching circuit formed (located) in a current output section with the ISEL signal. Each source signal line is provided with the first and second current output circuits.

When the ISEL signal assumes an L level, the first current output circuit adapted to output a 25-fold current is selected so that source driver 14 absorbs the current from source signal line 18 (more exactly, the first current output circuit formed in source driver 14 absorbs the current.) The magnitude of the current to be outputted from each of the first and second current output circuits can be adjusted to a 25-fold value, 5-fold value or the like easily, because each current output circuit can be formed using plural resistors and an analog switch.

When the pixel row to be written is the first pixel row (see the column of 1H in Figure 30) as shown in Figure 30, gate signal lines 17a(1) to 17a(5) are in the selected state (in the case of the pixel configuration shown in Figure 1.) That is, the switching transistors 11b and transistors 11c of pixels rows (1) to (5) are in on-state. Since the ISEL is assuming the L level, the first current output circuit for outputting a 25-fold current is selected and connected to source signal line 18. Further, gate signal line 17b is under application of off- voltage (Vgh). Accordingly, the switching transistors 11d of the pixel rows (1) to (5) are in off-state, thus preventing current from passing through the EL devices 15 of the respective pixel rows. That is, these EL devices are in the non-lighting state 52.

Ideally, the transistors 11a of five pixels each pass a current of Iw×2 through source signal line 18. Then, the capacitor 19 of each pixel 16 is programmed with a 5-fold current. Here, description is made on the assumption that transistors 11a are uniform in characteristics (Vt and S value) for easy understanding.

Since the number of pixel rows selected at a time is five (K = 5), five driving transistors 11a operate. That is, a 5-fold (25/5 = 5) current passes through transistor 11a per pixel. Source signal line 18 is fed with a current as the sum of programming currents for the five transistors 11a. For example, assuming that the current to be passed through pixel row 51a to be written is Iw according to the conventional driving method, a current of Iw×25 is passed through source signal line 18. Pixel rows 51b to be written with image data after writing to pixel row (1) are now used as auxiliary pixel rows for increasing the amount of current to be fed to source signal line 18. However, there arises no problem because the pixel rows 51b will be written with regular image data thereafter.

Therefore, the pixel rows 51b each provide the same display as the pixel row 51a during a 1H period. For this reason, at least the written pixel row 51a and the pixel rows 51b selected for increasing the current are made to assume the non-lighting state 52.

In the subsequent 1/2H period (1/2 of the horizontal scanning period), only pixel row 51a to be written is selected. That is, only the first pixel row is selected. As apparent from Figure 31, only gate signal line 17a(1) is applied with on-voltage (Vgl) while gate signal lines 17a (2) to 17a(5) applied with off-voltage (Vgh). Therefore, the transistor 11a of pixel row (1) is in an operating state (the state feeding current to source signal line 18), while the switching transistors 11b and transistors 11c of the pixel rows (2) to (5) are in off-state, or in the unselected state. Since the ISEL signal is assuming an H level, the current output circuit B for outputting a 5-fold current is selected and connected to source signal line 18. The state of gate signal line 17b is not changed from the state assumed in the first 1/2H period and hence is under application of off voltage (Vgh). Accordingly, the switching transistors 11d of the pixel rows (1) to (5) are in off-state, thus preventing current from passing through the EL devices 15 of the respective pixel rows. That is, these pixel rows are in the non-lighting state 52.

The above-described operation causes the transistor 11a of the pixel row (1) to pass a current of Iw×5 through source signal line 18. Then, the capacitor 19 of each pixel row (1) is programmed with the 5-fold current.

In the next horizontal scanning period, the pixel row to be written is shifted by one pixel row. That is, the pixel row to be written is changed to pixel row (2). In the first 1/2H period, when the pixel row to be written is the second pixel row as shown in Figure 31, gate signal lines 17a(2) to 17a(6) are in the selected state. That is, the switching transistors 11b and transistors 11c of pixels rows (2) to (6) are in on-state. Since the ISEL is assuming the L level, the first current output circuit for outputting a 25-fold current is selected and connected to source signal line 18. Further, gate signal line 17b is under application of off-voltage (Vgh). Accordingly, the switching transistors 11d of the pixel rows (2) to (6) are in off-state, thus preventing current from passing through the EL devices 15 of the respective pixel rows. That is, these pixel rows are in the non-lighting state 52. On the other hand, since the gate signal line 17b(1) of the pixel row (1) is under application of voltage Vgl, the transistor 11d of the pixel row (1) is in on-state and the EL device 15 of the pixel row (1) is in the lighting state.

Since the number of pixel rows selected at a time is five (K = 5), five driving transistors 11a operate. That is, a 5-fold (25/5 = 5) current passes through transistor 11a per pixel. Source signal line 18 is fed with a current as the sum of programming currents for the five transistors 11a.

In the subsequent 1/2H period (1/2 of the horizontal scanning period), only pixel row 51a to be written is selected. That is, only the second pixel row is selected. As apparent from Figure 31, only gate signal line 17a(2) is applied with on-voltage (Vgl) while gate signal lines 17a (3) to 17a(6) applied with off-voltage (Vgh). Therefore, the transistors 11a of the pixel rows (1) and (2) is in the operating state (the state where the pixel row (1) passes current through EL device 15 while the pixel row (2) feeds current to source signal line 18), while the switching transistors 11b and transistors 11c of the pixel rows (3) to (6) are in off-state, or in the unselected state. Since the ISEL signal is assuming the H level, the second current output circuit for outputting the 5-fold current is selected. The state of gate signal line 17b is not changed from the state assumed in the first 1/2H period and hence is under application of off-votage (Vgh). Accordingly, the switching transistors 11d of the pixel rows (2) to (6) are in off-state, thus preventing current from passing through the EL devices 15 of the respective pixel rows. That is, these pixel rows are in the non-lighting state 52.

The above-described operation causes the transistor 11a of the pixel row (2) to pass a current of Iw×5 through source signal line 18. Then, the capacitor 19 of the pixel row (2) is programmed with the 5-fold current. Display over one whole screen can be made by sequentially performing the above-described operations.

According to the driving method described in relation to Figure 30, G pixel rows (G is 2 or more) are selected in the first period and each of the pixel rows is programmed so that an N-fold current will pass therethrough. In the second period subsequent to the first period, B pixel rows (B is not less than 1 and less than G) are selected and each of the pixel rows is programmed so that the N-fold current will pass therethrough.

However, another way is possible. G pixel rows (G is 2 or more) are selected in the first period and programming is made so that the total sum of currents to pass through the respective pixel rows assumes the N-fold value. In the second period subsequent to the first period, B pixel rows (B is not less than 1 and less than G) are selected and programming is made so that the total sum of currents to pass through the respective pixel rows assumes the N-fold value. (When one pixel row is selected, programming is made so that the current to pass therethrough assumes the N-fold value.) For example, five pixel rows are selected at a time in Figure 30(a1) and a 2-fold current is passed through the transistor 11a of each pixel. By so doing, source signal line 18 is fed with a 10-fold (5×2) current. In the subsequent second period, one pixel row is selected in Figure 30(b1). The 10-fold current is passed through transistor 11a of this pixel row.

In the foregoing description related to Figure 31, the period for selecting plural pixel rows at a time is set to 1/2H and the period for selecting one pixel row set to 1/2H. However, the present invention is not limited thereto. It is possible that the period for selecting plural pixel rows at a time is set to 1/4H and the period for selecting one pixel row set to 3/4H. Further, the sum of the period for selecting plural pixel rows at a time and the period for selecting one pixel row is set to 1H. However, the present invention is not limited thereto. For example, the sum of these periods may be set to a 2H period or a 1.5H period.

In the method of Figure 30, it is possible that the period for selecting five pixel rows at a time is set to 1/2H and two pixel rows are selected at a time in the subsequent second period. In this case also, image display without no practical trouble can be realized.

In the foregoing description related to Figure 30, two stages are provided consisting of the first period for selecting five pixel rows at a time, which is set to 1/2H, and the second period for selecting one pixel row, which is set to 1/2H. However, the present invention is not limited thereto. For example, three stages may be provided consisting of the first period for selecting five pixel rows at a time, the second period for selecting two of the five pixel rows, and the third period for selecting one pixel row. That is, it is possible to write image data to a pixel row at plural stages.

The above-described N-fold pulse driving method according to the present invention applies the same waveform to gate signal lines 17b of respective pixel rows while shifting the scanning at 1H intervals. Such a manner of scanning makes it possible to shift a pixel row to light to another sequentially with the lighting duration of each EL device 15 set to 1F/N. Such application of the same waveform to gate signal lines 17b of respective pixel rows and shifting of the scanning, can be easily realized. This is because it is sufficient to control data ST1 and data ST2 to be applied to shift register circuits 61a and 61b, respectively, shown in Figure 6. Assuming that Vgl is outputted to gate signal line 17b when inputted ST2 assumes L level while Vgh is outputted to gate signal line 17b when inputted ST2 assumes H level, ST2 to be applied to shift register 17b is inputted at L level for a 1F/N period and at H level for the rest of the period. ST2 thus inputted should be shifted with clock CLK2 synchronizing to 1H.

The on-off cycle of EL device 15 needs to be set to 0.5 msec or longer. If this cycle is too short, complete black display is not realized due to human eyes having the afterimage property and, hence, the image displayed is seen to blur as if the resolution is lowered. Such a display state is the same as the display state of a display panel of the data holding type. On the other hand, if the on-off cycle is set to 100 msec or longer, the resulting display is seen to blink. For this reason, the on-off cycle of EL device 15 has to be not less than 0.5 μsec and not more than 100 msec, more preferably not less than 2 msec and not more than 30 msec, much more preferably not less than 3 msec and not more than 20 msec.

As described earlier, satisfactory motion picture display can be realized when the number by which black display screen 152 is divided (split) is one. However, flitter is likely seen on the screen. Therefore, it is preferable to split an inserted black display portion into plural blocks. However, too much increase in the number of such blocks results in a blurred motion picture. The number of blocks resulting from splitting has to be not less than 1 and not more than 8, preferably not less than 1 and not more than 5.

It is preferable to employ an arrangement capable of varying the number of split blocks of a black display depending on whether a stationary image or a motion picture image is to be displayed. When N = 4, a black display occupies 75% of the screen and an image display occupies 25% of the screen. In this case, when the number of split blocks is one, the black display portion occupying 75% is scanned vertically of the screen so as to be viewed as a black band occupying 75%. When the number of split blocks is 3, scanning is made so that a black display occupying 25% of the screen is split into three black display blocks each occupying 25/3% of the screen. The number of split blocks is increased for stationary image display, whereas it is decreased for motion picture display. Switching may be made either automatically in accordance with images inputted (through detection of a motion picture image or the like) or by a manual operation by the user. Alternatively, it is possible to employ an arrangement capable of switching in accordance with input receptacles corresponding to types of video images to be displayed by the display apparatus.

In a mobile phone for example, the number of split blocks is 10 or more when the screen is in a wallpaper display state or in an input screen state. (In an extreme case, on/off may be made 1H by 1H. In NTSC motion picture display, the number of split blocks is not less than 1 and not more than 5. It is preferable to employ an arrangement capable of changing the number of split blocks in multiple stages, the number of which is 3 or more. For example, the number of blocks is changed stepwise like 0, 2, 4, 8.

The proportion of a black display relative to the whole display screen which is assumed to be 1 is preferably not less than 0.2 and not more than 0.9 (i.e., not less than 1.2 and not more than 9 in the units of N), particularly preferably not less than 0.25 and not more than 0.6 (i.e., not less than 1.25 and not more than 6 in the units of N.) If it is less than 0.20, the effect of improving motion picture display is low. If it is more than 0.9, the display portion exhibits an increased luminance and, hence, the vertical shifting of the display portion is easy to recognize visually.

The number of frames per second is preferably not less than 10 and not more than 100 (i.e., not less than 10 Hz and not more than 100 Hz), more preferably not less than 12 and not more than 65 (i.e., not less than 12Hz and not more than 65 Hz.) If the number of frames is too small, screen flitter becomes conspicuous, while if it is too large, writing from the driver circuit 14 or the like becomes difficult, which results in a degraded resolution.

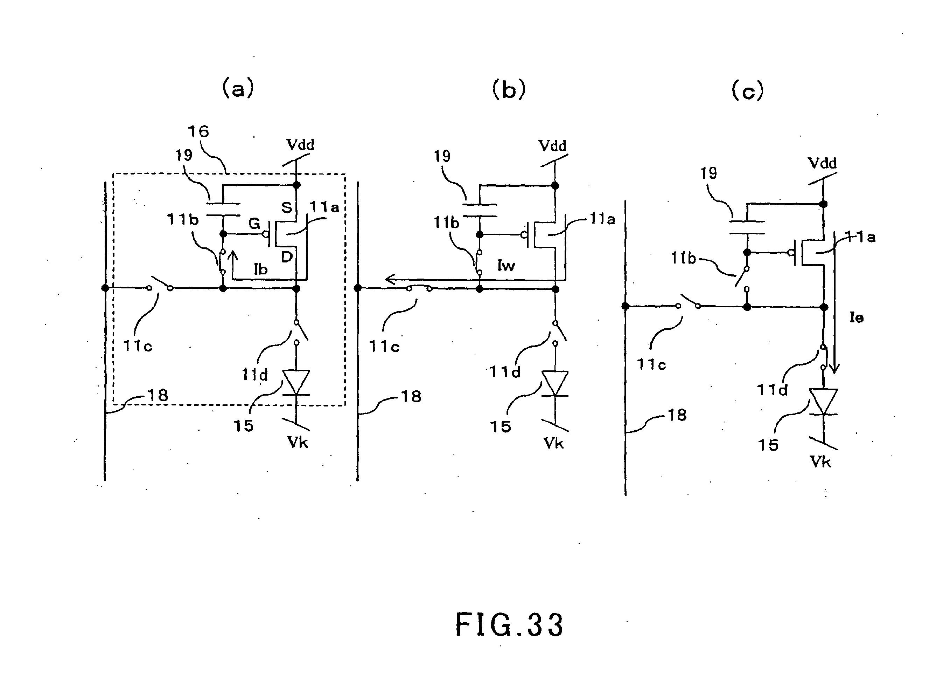

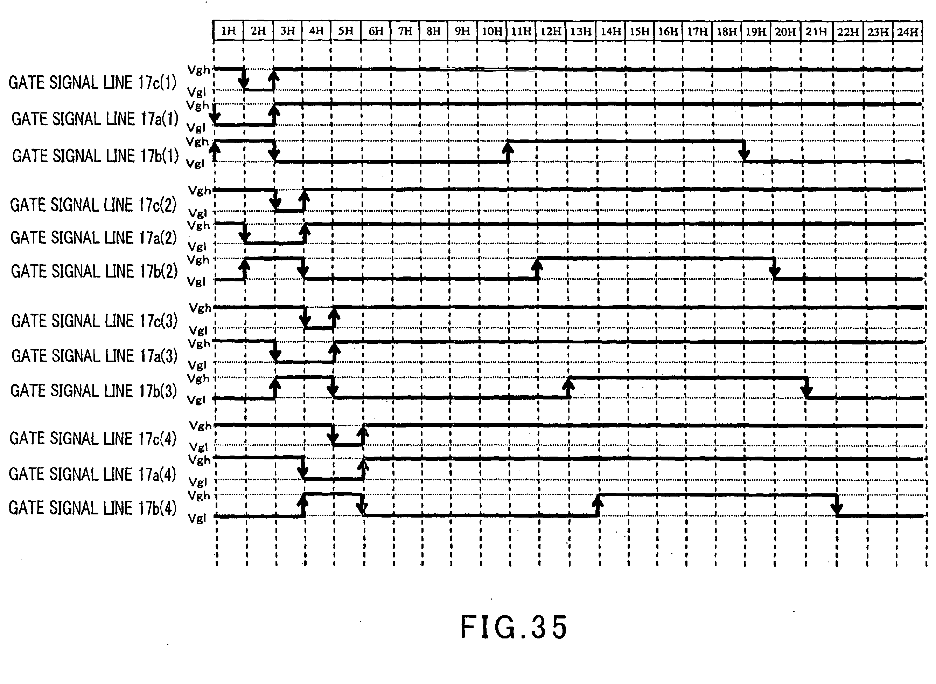

Anyway, the present invention is capable of varying the brightness of an image by control over gate signal line 17. It is needless to say that the brightness of an image may be varied with varying current (voltage) to be applied to source signal line 18. Also, it is needless to say that the control over gate signal line 17 described earlier (with reference to Figure 33 or 35 or the like) may be combined with the art of varying the current (voltage) to be applied to source signal line 18.

It is needless to say that the above-described matters are applicable to the current-based programming pixel configurations shown in Figure 38 and the like and the voltage-based programming pixel configurations shown in Figs. 43, 51 and 54 and the like. It is sufficient for the transistor 11d in each of Figs. 38, 43 and 51 to be on-off controlled. By thus turning on/off the wiring for feeding EL device 15 with current, the N-fold pulse driving method according to the present invention can be realized easily.

Application of Vgl to gate signal line 17b for a 1F/N period may start at any time point in a 1F period (which is not limited and may be any unit period.) This is because the purpose of such application is to obtain a predetermined mean luminance by making EL device 15 assume on-state for a predetermined period of a unit time. However, EL device 15 had better be caused to emit light by application of Vgl to gate signal line 17b immediately after lapse of a current-based programming period (1H). This is because EL device 15 becomes less susceptible to the influence from the current holding characteristic of capacitor 19 in Figure 1.

It is also preferable to employ an arrangement capable of varying the number by which an image is to be split. For example, when the user depresses a brightness adjustor switch or turns a brightness adjustor volume, the value of K is varied depending on this change detected. Alternatively, it is possible to employ an arrangement such as to vary the number either manually or automatically in accordance with the particulars of or data on an image to be displayed.

Such an arrangement for varying the value ofK (i.e., the number by which image display portion 53 is to be split) can be realized easily. This is because it is sufficient to provide an arrangement capable of controlling or varying the timing at which data is applied to ST in Figure 6 (i.e., the timing at which ST is made to assume L level in a 1F period.)

While description in relation to Figure 16 and the like has been made of the feature that a (1F/N) period for which gate signal line 17b is applied with Vgl is divided into plural subperiods (the number of subperiods is K) and gate signal line 17b is applied with Vgl for a 1F/(K/N) period K times, there is no limitation to this feature. Gate signal line 17b may be applied with Vgl for a 1F/(K/N) period L times (L≠K). That is, the present invention has the feature that image 50 is displayed by controlling the period (time) for which EL device 15 is fed with current. Therefore, the art of repeating the 1F/(K/N) period L times (L ≠ K) is included in the technical concept of the present invention. The luminance of image 50 can be varied digitally with a variation in the value of L. For example, the difference between the case of L = 2 and the case of L =3 corresponds to a 50 % change in luminance (contrast). It is needless to say that these controls are applicable to other embodiments of the present invention. (Of course, they are applicable to embodiments of the present invention to be described hereinafter.) Such controls are included in the scope of the N-fold pulse driving method according to the present invention.

The foregoing embodiments are each configured to cause the display of screen 50 to be turned on/off by controlling transistor 11d serving as a switching device located (or formed) between EL device 15 and driving transistor 11a. This driving method solves the problem of insufficient writing with current in a black display state of a current-based programming configuration, thereby realizing a satisfactory resolution or black display. That is, the current-based programming is highly advantageous in that a satisfactory black display can be realized. The driving method to be described next is a method capable of realizing a satisfactory black display by resetting driving transistor 11a. Hereinafter, this embodiment will be described with reference to Figure 32.

The pixel configuration shown in Figure 32 is basically the same as that shown is Figure 1. In the pixel configuration shown in Figure 32, current Iw as programmed is passed through EL device 15 to cause EL device 15 to emit light. That is, driving transistor 11a becomes capable of holding the ability to pass the current when programmed. The driving method applied to the Figure 32 configuration is a method which utilizes the ability to pass current to reset (or turn off) transistor 11a. Hereinafter, this type of driving will be referred to as "reset driving".

In order to realize the reset driving with the pixel configuration of Figure 1, an arrangement capable of on-off controlling transistors 11b and 11c independently of each other is needed. Specifically, such an arrangement is capable of controlling gate signal line 17a (gate signal line WR) for on-off controlling transistor 11b and signal line 17c (gate signal line EL) for on-off controlling transistor 11c, independently of each other. Controls over gate signal lines 17a and 17c can be achieved using two independent shift registers 61 as shown in Figure 6.

The driving voltage for gate signal line WR and that for gate signal line EL preferably are made different from each other. The amplitude of the driving voltage for gate signal line WR (the difference between on-voltage and off-voltage) is made smaller than that of the driving voltage for gate signal line EL. Basically, if the amplitude of the driving voltage for a gate signal line is large, a punch-through voltage across the gate signal line and the pixel becomes high, which causes unclear black to occur. The amplitude of the driving voltage for a gate signal line WR can be adjusted by controlling the potential of source signal line 18 not to be applied (or to be applied in the selected state) to pixel 16. Since fluctuations in the potential of source signal line 18 are small, the amplitude of the driving voltage for gate signal line WR can be decreased. On the other hand, gate signal line EL is required to on-off control the EL device. Therefore, the amplitude of the driving voltage for gate signal line EL is large. As a measure to deal with this inconvenience, the output voltages of the respective shift registers 61a and 61b are made different from each other. In the case where each pixel comprises p-channel transistors, the off-voltages Vgh of the respective shift registers 61a and 61b are substantially equalized to each other, while the on-voltage Vgl of shift register 61a is made lower than that of shift register 61b.

Hereinafter, the reset driving method will be described with reference to Figure 33. Figure 33 is an explanatory diagram illustrating the principle of the reset driving method. First, as shown in Figure 33(a), transistors 11c and 11d are turned off, while transistor 11b turned on. Then, the drain terminal (D) and the gate terminal (G) of driving transistor 11a are shortcircuited, thus allowing current Ib to pass therethrough. Generally, transistor 11a has been programmed with current in the immediately preceding field (frame) and hence has the ability to pass current. When transistors 11d and 11b assume off-state and on-state, respectively, with transistor 11a in that condition, driving current Ib is passed to the gate terminal (G) of transistor 11a, so that the potential at the gate terminal (G) and that at the drain terminal (D) are equalized to each other, thus resetting transistor 11a (to a state not allowing current to pass therethrough).

The reset state (the state not allowing current to pass) of transistor 11a is equivalent to an offset voltage holding state of a voltage offset canceller configuration, which will be described later with reference to Figure 51 and the like. That is, in the state shown in Figure 33(a), an offset voltage is held across the terminals of capacitor 19. This offset voltage has a voltage value which varies with variations in the characteristics of transistor 11a. Therefore, when the operation illustrated in Figure 33(a) is performed, transistor 11a does not pass current to capacitor 19 of each pixel 19. (That is, a black display current (substantially equal to zero) is held.)

It is preferable to perform an operation of turning transistors 11b and 11c off and transistor 11d on to pass the driving current through driving transistor 11a prior to the operation illustrated in Figure 33(a). Preferably, this operation is completed in a very short time. This is because current might pass through EL device 15 to cause it to light thereby causing the display contrast to lower. The time period for this operation is preferably not less than 0.1% and not more than 10% of a 1H period (one horizontal scanning period), more preferably not less than 0.2% and not more than 2% of a 1H period. Stated otherwise, the time period is preferably not less than 0.2 μsec and not more than 5 μsec. The aforementioned operation (the operation to be performed before the operation of Figure 33(a)) may be performed on all the pixels 16 present in the whole screen collectively. The operations described above can cause the drain terminal (D) voltage of driving transistor 11a to lower thereby allowing current Ib to pass smoothly in the state shown in Figure 33(a). The above-described matters are applicable to other reset driving methods of the present invention.

As the state shown in Figure 33(a) continues for a longer time, the terminal voltage of capacitor 19 tends to become lower due to passage of current Ib. Therefore, the time period for which the state shown in Figure 33(a) continues needs to be fixed. According to the experiment and study conducted by the inventors et al, the time period for which the state shown in Figure 33(a) continues is preferably not less than 1H and not more than 5H. Preferably, this period is varied depending on R, G and B pixels. This is because these different color pixels employ different EL materials, which are different in threshold voltage and the like from each other. The optimum periods for the respective R, G and B pixels are established depending on the respective EL materials. Though this period is set not less than 1H and not more than 5H in this embodiment, it is needless to say that the period may be set to 5H or more in a driving method based mainly on insertion of a black display (writing of a black display to the screen.) It should be noted that the black display state of each pixel becomes better as this period becomes longer.

After the state shown in Figure 33(a) continued for the time period not less than 1H and not more than 5H, the pixel configuration is turned into the state shown in Figure 33(b). In the state shown in Figure 33(b), transistors 11c and 11b are in on-state, while transistor 11d in off-state. As described earlier, the state shown in Figure 33(b) is a state where current-based programming is being performed. That is, source driver 14 outputs (or absorbs) programming current Iw to driving transistor 11a. Driving transistor 11a is programmed to have such a gate terminal (G) potential as to cause current Iw to pass. (The potential thus set is held in capacitor 19.)

If the programming current Iw is 0 (A), transistor 11a is kept in the state shown in Figure 33(a) which does not allow current to pass, thus realizing a satisfactory black display. In the case of current-based programming for a white display by the state shown in Figure 33 (b), perfect current-based programming can be achieved from the offset voltage providing a black display even when there are variations in the characteristics of driving transistors of pixels. Therefore, the times required for respective driving transistors to be programmed with a target value are equalized to each other for each gray level. For this reason, there occurs no gray scale error due to variations in the characteristics of transistors 11a and, hence, satisfactory image display can be realized.

After the current-based programming in the state shown in Figure 33(b), transistors 11b and 11c are turned off and transistor 11d turned on to cause driving transistor 11a to pass programming current Iw (=Ie) through EL device 15, thereby causing EL device 15 to emit light. Description of the details of the state shown in Figure 33(c) will be omitted since similar description has bee made earlier with reference to Figure 1 and the like.

The driving method (reset driving) illustrated in Figure 33 comprises: a first operation in which driving transistor 11a and EL device 15 are disconnected from each other (or turned into a state preventing current from passing therebetween), while the drain terminal (D) and the gate terminal (G) of driving transistor 11a (alternatively, the source terminal (S) and the gate terminal (G) of driving transistor 11a; in more general term, two terminals of driving transistor 11a including the gate terminal (G)) are shortcircuited; and a second operation in which driving transistor 11a is programmed with current (voltage) after the first operation. It is at least required that the second operation be performed after the first operation. For the reset driving to be effected, it is necessary to provide an arrangement capable of controlling transistors 11b and 11c independently of each other as shown in Figure 32.

The image display state changes as follows (provided instantaneous changes can be observed.) First, a pixel row to be programmed with current is turned into a reset state (i.e., black display state). After lapse of 1H, current-based programming is performed. (At this time, image display is still in the black display state because transistor 11d is in off-state.) Subsequently, each EL device 15 is fed with current, so that the pixel row emits light at a predetermined luminance (with a current as programmed). Specifically, it should be seen that the pixel row displaying black moves downwardly of the screen and the image displayed is rewritten at a position that the pixel row has just passed. Though the current-based programming is performed 1H after the resetting according to the above description, the period between the programming and the resetting may be about 5H or less. This is because a relatively long time is required for the resetting operation shown in Figure 33(a) to be completed. If this period is set to 5H, five pixel rows will display black. (If the pixel row programmed with current is taken into account, six pixel rows will display black.)

There is no limitation to the feature that resetting is made pixel row by pixel row, but a set of plural pixel rows may be reset at a time; that is, resetting may made plural pixel rows by plural pixel rows. Alternatively, it is possible to perform resetting plural pixel rows by plural pixel rows while performing overlapped scanning. For example, if four pixel rows are to be reset at a time, an exemplary manner of driving is as follows: pixel rows (1) to (4) are reset in the first horizontal scanning period (one unit); subsequently, pixel rows (3) to (6) reset in the second horizontal scanning period; subsequently, pixel rows (5) to (8) reset in the third horizontal scanning period; and then, pixel rows (7) to (10) reset in the fourth horizontal scanning period. Of course, the driving operations shown in Figs. 33(b) and 33(c) are performed in synchronism with the driving operation shown in Figure 33(a).

It is needless to say that the driving operations shown in Figs. 33(b) and 33(c) may be performed after all of the pixels present in one screen have been reset either at a time or in a scanned fashion. It is also needless to say that interlaced driving (scanning every other pixel row or every other set of plural pixel rows) may be effected to reset every other pixel row or every other set of plural pixel rows. Random resetting is also possible. The reset driving according to the present invention described above is a method adapted to operate pixel rows. (That is, control is made vertically of the screen.) The concept of the reset driving is not limited to the control in the direction in which pixel rows are arranged. It is needless to say that the reset driving may be performed in the direction in which pixel columns are arranged for example.

The reset driving method illustrated in Figure 33 can realize better image display if combined with the N-fold pulse driving method or a like method according to the present invention or with the interlaced driving method. The method illustrated in Figure 22, in particular, can easily realize an intermittent N/K-fold pulse driving method. (This is a driving method including providing plural lighting regions on one screen. This driving method can be easily practiced if gate signal line 17b is controlled so as to turn transistor 11d on/off. This feature has been described earlier.) Therefore, satisfactory image display free of flicker can be realized. This is an excellent characteristic of the method illustrated in Figure 22 or its variations. It is also needless to say that the reset driving method can realize much better image display if combined with other driving methods including, for example, the reverse bias driving method, precharge driving method and punch-through voltage driving method to be described later. Thus, it is needless to say that the reset driving method can be implemented in combination with other embodiments herein described.

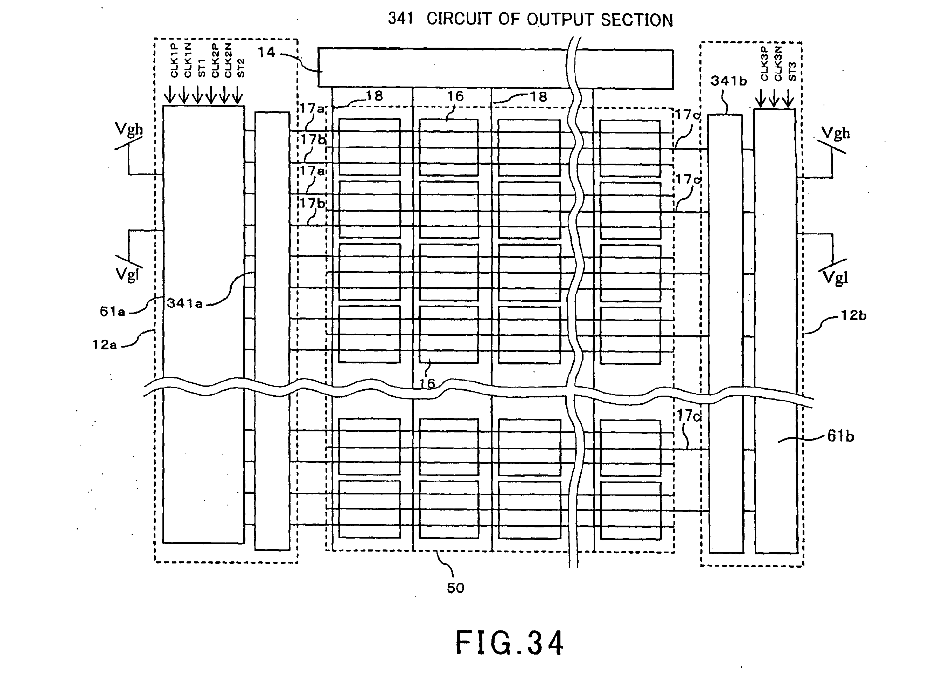

Figure 34 is a diagram showing the configuration of a display apparatus for realizing the reset driving. Gate driver 12a controls gate signal lines 17a and 17b of Figure 32. Application of on-voltage and off voltage to gate signal line 17a allows transistor 11b to be on-off controlled. Application of on-voltage and off-voltage to gate signal line 17b allows transistor 11d to be on-off controlled. Gate driver 12b controls gate signal line 17c of Figure 32. Application of on-voltage and off-voltage to gate signal line 17c allows transistor 11c to be on-off controlled.

Thus, gate signal lines 17a and 17c are operated by gate drivers 12a and 12b, respectively. For this reason, it is possible to freely control the timing at which transistor 11b is turned on to reset driving transistor 11a and the timing at which transistor 11c is turned on to program driving transistor 11a with current. Reference character 341a in Figure 34 designates the circuit of an output section. Since other features and the like are identical with or similar to the features described earlier, description thereof will be omitted.

Figure 35 is a timing chart of the reset driving. When transistor 11a is reset by applying on-voltage to gate signal line 17a to turn transistor 11b on, transistor 11d is turned off by application of off voltage to gate signal line 17b. Thus, the configuration assumes the state shown in Figure 32(a). During this period, current Ib is passed.

According to the timing chart of Figure 35, reset time is set to 2H (during which gate signal line is under application of on-voltage and hence transistor 11b is in on-state.) However, there is no limitation to this feature, but the reset time may be 2H or more. In the case where resetting can be made very rapidly, the rest time may be less than 1H. The reset time can be varied to any desired H period easily by varying the pulse period of DATA (ST) to be inputted to gate driver 12. For example, if DATA to be inputted to ST terminal assumes H level for a 2H period, the reset time outputted from each gate signal line 17a is a 2H period. Similarly, if DATA to be inputted to ST terminal assumes H level for a 5H period, the reset time outputted from each gate signal line 17a is a 5H period.

After the reset state for a 1H period, gate signal line 17c(1) of pixel row (1) is applied with on-voltage. When transistor 11c is turned on, driving transistor 11a is written with the programming current applied to source signal line 18 via transistor 11c.

After the current-based programming, gate signal line 17c of pixel row (1) is applied with off voltage to turn transistor 11c off, thereby disconnecting each pixel from source signal line 18. At the same time, gate signal line 17a is also applied with off-voltage to release driving transistor 11a from the reset state. (In this period, the expression "current-based programmed state" is more proper than the expression "reset state".) Further, gate signal line 17b is applied with on-voltage to turn transistor 11d on, thereby causing the current programmed at driving transistor 11a to be passed through EL device 15. Since the operation on pixel row (2) and the succeeding pixel rows is the same as that on pixel row (1) and since that operation is obvious from Figure 35, description thereof will be omitted.

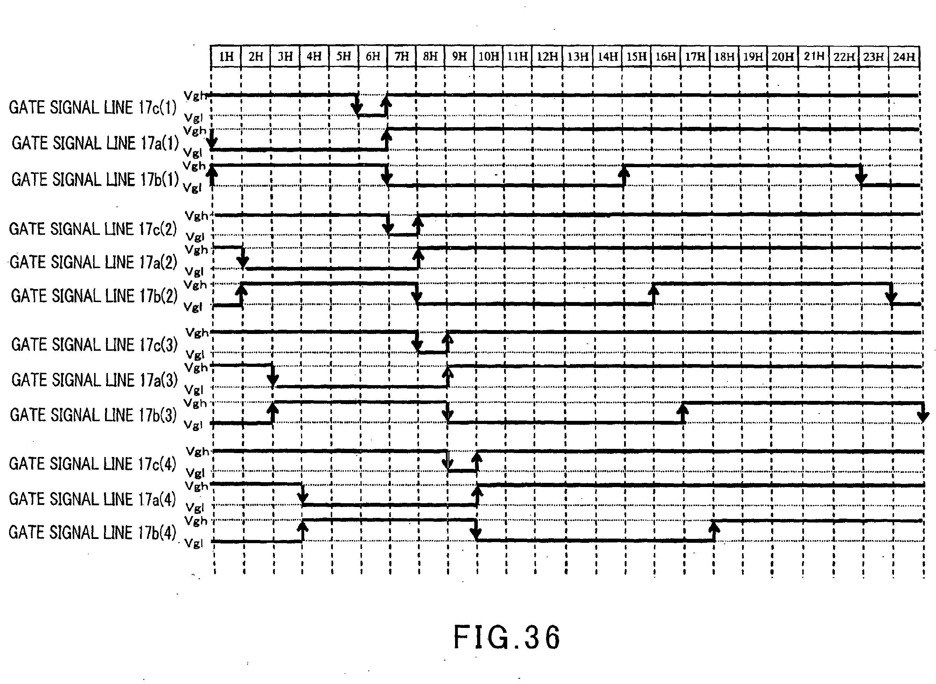

In Figure 35, the reset period is a 1H period. Figure 36 illustrates an embodiment having a reset period of 5H. The reset period can be varied to any desired H period easily by varying the pulse period of DATA (ST) to be inputted to gate driver 12. Figure 36 is directed to the embodiment having settings such that DATA to be inputted to ST1 terminal of gate driver 12a assumes H level for a 5H period and the reset period outputted from each gate signal line 17a is a 5H period. As the reset period becomes longer, more perfect resetting is achieved, thus realizing better black display. However, the display luminance is lowered by a degree corresponding to the proportion of the reset period.

In the embodiment of Figure 36, the reset period is set to 5H and the reset state is continuous. However, there is no limitation to such a continuous reset state. For example, it is possible to turn on/off the signal outputted from each gate signal line 17a on a 1H basis. Such an on-off operation can be easily realized by operating an enabling circuit (not shown) formed in the output section of the shift register or controlling the DATA (ST) pulse to be inputted to gate driver 12.

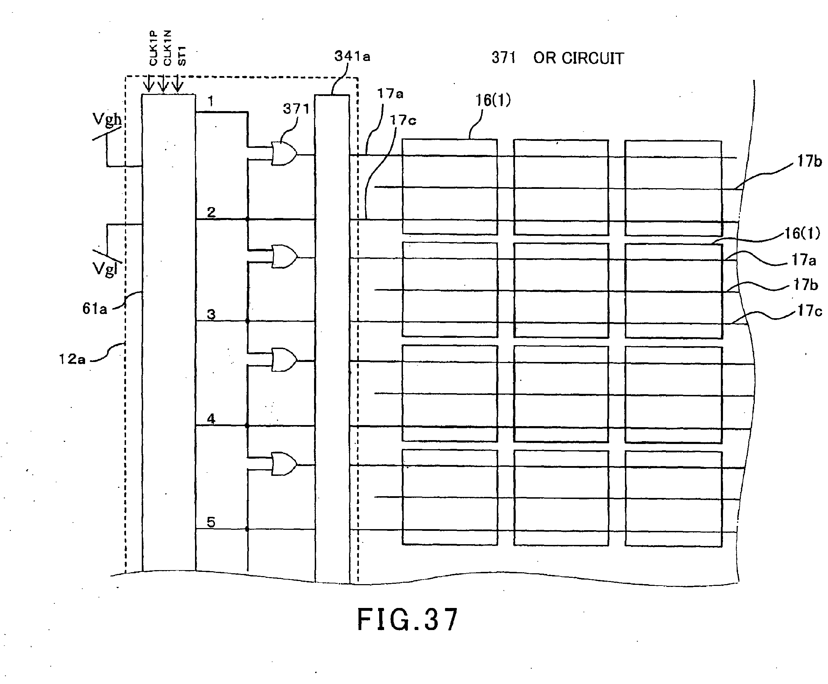

The circuit configuration shown in Figure 34 requires at least two shift register circuits (one for controlling gate signal line 17a and the other for controlling gate signal line 17b.) For this reason, there arises a problem of gate driver 12a having an increased circuit scale. Figure 37 shows an embodiment wherein gate driver 12a has a single shift register. The timing chart of output signals in the operation of the circuit of Figure 37 is as shown in Figure 35. Attention should be given to Figs. 35 and 37 which use different signs to designate each of gate signal lines 17 extending from gate drivers 12a and 12b.

As can be clearly understood from the configuration of Figure 37 which additionally includes OR circuit 371, OR is taken from the output of the current stage and the output of the preceding stage of shift register circuit 61a and outputted to each gate signal 17a. That is, gate signal line 17a outputs on-voltage for a 2H period. On the other hand, the output of shift register 61a, as it is, is outputted to gate signal line 17c. Therefore, gate signal line 17c is under application of on-voltage for a 1H period.

For example, when an H level signal is outputted to the second stage of shift register circuit 61a, on-voltage is outputted to gate signal line 17c of pixel 16 (1), thus making pixel 16(1) programmed with current (or voltage). At the same time, on-voltage is also outputted to gate signal line 17a of pixel 16(2) to turn on transistor 11b of pixel 16(2), thus resetting driving transistor 11a of pixel 16(2).

Similarly, when an H level signal is outputted to the third stage of shift register circuit 61a, on-voltage is outputted to gate signal line 17c of pixel 16(2), thus making pixel 16(2) programmed with current (or voltage). At the same time, on-voltage is also outputted to gate signal line 17a of pixel 16(3) to turn on transistor 11b of pixel 16(3), thus resetting driving transistor 11a of pixel 16(3). That is, gate signal line 17a continues to output on-voltage for a 2H period, while gate signal line 17c continues to be applied with on-voltage for a 1H period.

Transistors 11b and 11c assume on-state (see Figure 33(b)) at the same time when each pixel is programmed (see Figure 33(b)). For this reason, if transistor 11c is turned into off-state prior to transistor 11b in switching the pixel to an unprogrammed state, transistor 11a assumes the reset state shown in Figure 33(b) undesirably. To avoid this inconvenience, transistor 11c needs to be turned off after the turning-off of transistor 11b. Accordingly, it is required that control be performed so that gate signal line 17a can be applied with on-voltage prior to the application of on-voltage to gate signal line 17c.

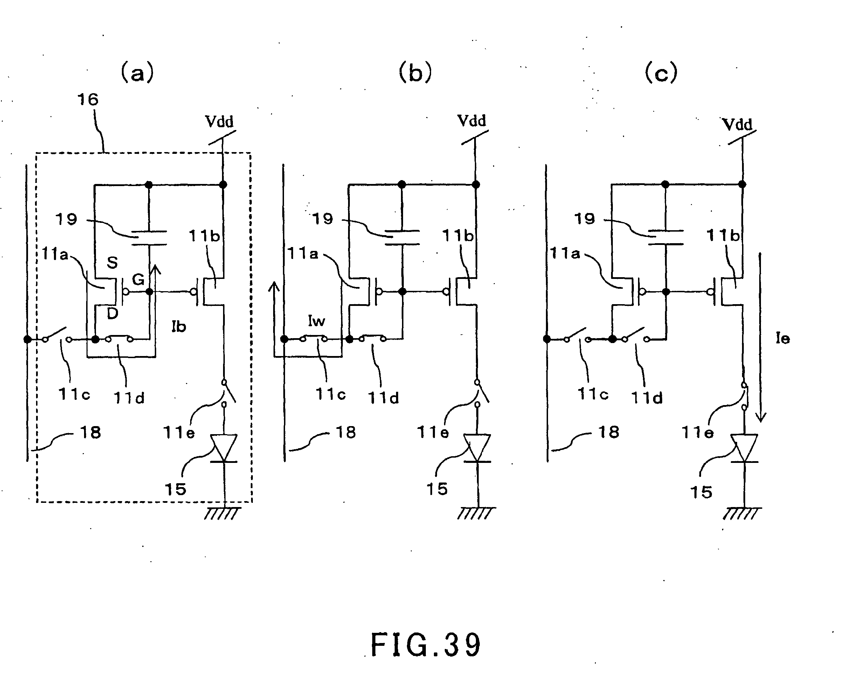

The foregoing embodiment is applied to the pixel configuration shown in Figure 32 (basically Figure 1). However, the present invention is not limited thereto. For example, this embodiment is applicable to a current mirror pixel configuration as shown in Figure 38. With the pixel configuration of Figure 38, the N-fold pulse driving method as illustrated in Figure 13 or 15 or the like can be practiced by on-off control over transistor 11e. Figure 39 is an explanatory diagram illustrating an embodiment based on the current mirror pixel configuration shown in Figure 38. Hereinafter, a reset driving method applied to the current mirror pixel configuration will be described with reference to Figure 39.

As shown in Figure 39(a), transistors 11c and 11e are turned off, while transistor 11d turned on. Then, the drain terminal (D) and the gate terminal (G) of current-based programming transistor 11b are short-circuited, thus allowing current Ib to pass therethrough. Generally, transistor 11b has been programmed with current in an immediately preceding field (frame) and hence has the ability to pass current. (This is natural because the gate potential is held by capacitor 19 for a 1F period to perform image display. However, current is not passed in the case of perfect black display.) When transistors 11e and 11d assume off-state and on-state, respectively, with transistor 11b in that condition, driving current Ib is passed toward the gate terminal (G) of transistor 11a. (That is, gate terminal (G) and drain terminal (D) become shortcircuited.) Accordingly, the potential at the gate terminal (G) and that at the drain terminal (D) are equalized to each other, thus resetting transistor 11a (to a state not allowing current to pass). Since the gate terminal (G) of driving transistor 11b and that of current-based programming transistor 11a are common, driving transistor 11b is also reset.

Each of the reset states (the state not allowing current to pass) of respective transistors 11a and 11b is equivalent to an offset voltage holding state of the voltage offset canceller configuration, which will be described later with reference to Figure 51 and the like. That is, in the state shown in Figure 39(a), an offset voltage is held across the terminals of capacitor 19. (The offset voltage is an initiating voltage causing current to start passing. Application of a voltage having an absolute value equal to or larger than the absolute value of the offset voltage causes current to pass through transistor 11.) This offset voltage has a voltage value which is variable in accordance with the characteristics of transistors 11a and 11b. Therefore, when the operation illustrated in Figure 39(a) is performed, transistors 11a and 11b do not pass current to capacitor 19 of each pixel. (That is, a black display current (substantially equal to zero) state is kept; stated otherwise, resetting to the initiating voltage causing current to start passing is made.)

As in the case of Figure 33(a), as the reset state shown in Figure 39(a) continues for a longer time, the terminal voltage of capacitor 19 tends to become lower due to passage of current Ib. Therefore, the time period for which the state shown in Figure 39(a) continues needs to be fixed. According to the experiment and study conducted by the inventors et al., the time period for which the state shown in Figure 33(a) continues is preferably not less than 1H and not more than 10H (10 horizontal scanning periods), more preferably not less than 1H and not more than 5H. Specifically, the time period is preferably not less than 20 μsec and not more

than 2 msec. This holds true for the driving method illustrated in Figure 33.

As in the case of Figure 33(a), when the operation is performed so that the reset state shown in Figure 39(a) synchronizes to the current-based programmed state shown in Figure 39(a), the time period required for the current-based programmed state shown in Figure 39(b) to be reached from the reset state shown in Figure 39(a) has a fixed value (constant value) and, therefore, there arises no problem. That is, the time period from the reset state shown in Figure 33(a) or 39(a) to the current-based programmed state shown in Figure 33(b) or 39(b) is preferably not less than 1H and not more than 10H (10 horizontal scanning periods), more preferably not less than 1H and not more than 5H. Specifically, the time period is preferably not less than 20 μsec and not more than 2 msec. If this time period is too short, driving transistor 11 is not completely reset, while if it is too long, driving transistor 11 assumes complete off-state, which in turn results in the current-based programming taking a longer time. In addition, the luminance of screen 50 is lowered.

Subsequently to the state shown in Figure 39 (a), the pixel configuration is turned into the state shown in Figure 39(b) where transistors 11c and 11b are in on-state, while transistor 11d in off-state. The state shown in Figure 39(b) is a state where current-based programming is being performed. That is, source driver 14 outputs (or absorbs) programming current Iw and passes the programming current Iw to driving transistor 11a. Capacitor 19 is programmed with the gate terminal (G) potential of driving transistor 11b so that current Iw will pass through driving transistor 11a.

If the programming current Iw is 0 (A) (black display), transistor 11b is kept in the state shown in Figure 33(a) which does not allow current to pass, thus realizing a favorable black display. In the case of current-based programming for white display by the state shown in Figure 39(b), perfect current-based programming can be achieved from the offset voltage providing a black display (the initiating voltage causing the current set in accordance with the characteristics of driving transistors to start passing) even when there are variations in the characteristics of driving transistors of respective pixels. Therefore, the times required for respective driving transistors to be programmed with a current of a target value are equalized to each other for each gray level. For this reason, there occurs no gray scale error due to variations in the characteristics of transistors 11a or 11b and, hence, satisfactory image display can be realized.

After the current-based programming in the state shown in Figure 39(b), transistors 11b and 11c are turned off and transistor 11e turned on to cause driving transistor 11b to pass programming current Iw (= Ie) through EL device 15, thereby causing EL device 15 to emit light. Description of the details of the state shown in Figure 39(c) will be omitted since similar description has bee made earlier.

The driving method (reset driving) illustrated in Figure 33 or 39 comprises: a first operation in which driving transistor 11a or 11b and EL device 15 are disconnected from each other (or turned into a state preventing current from passing therebetween by transistor 11e or 11d), while the drain terminal (D) and the gate terminal (G) of the driving transistor (alternatively, the source terminal (S) and the gate terminal (G) of the driving transistor, more generally, two terminals of the driving transistor including gate terminal (G)) are shortcircuited; and a second operation in which the driving transistor is programmed with current (or voltage) after the first operation. It is at least required that the second operation be performed after the first operation. The operation of disconnecting driving transistor 11a or 11b and EL device 15 from each other is not necessarily indispensable. Even if the first operation of shortcircuiting the drain terminal (D) and the gate terminal (G) of the driving transistor is performed without disconnecting driving transistor 11a or 11b and EL device 15 from each other, it is possible that variations in the reset state are not so serious in some cases. Whether driving transistor 11a or 11b is to be disconnected from EL device 15 or not is decided based on examination of the transistor characteristics of the array manufactured.

The current mirror pixel configuration shown in Figure 39 is a driving method including resetting the current-based programming transistor 11a, which results in the resetting of the driving transistor 11b.

With the current mirror pixel configuration of Figure 39, the operation of disconnecting driving transistor 11b and EL device 15 from each other need not necessarily be performed in the reset state. Thus, the driving method comprises: a first operation in which the drain terminal (D) and the gate terminal (G) of the current-based programming transistor (alternatively, the source terminal (S) and the gate terminal (G) of the current-based programming transistor, more generally, two terminals of the current-based programming transistor or the driving transistor including gate terminal (G)) are shortcircuited; and a second operation in which the current-based programming transistor is programmed with current (or voltage) after the first operation. It is at least required that the second operation be performed after the first operation.

The image display state changes as follows (provided instantaneous changes can be observed.) First, a pixel row to be programmed with current is turned into a reset state (i.e., black display state). After lapse of 1H, current-based programming is performed. Specifically, it should be seen that the pixel row displaying black moves downwardly of the screen and the image displayed is rewritten at a position that the pixel row has just passed.

Though the foregoing description of the embodiment is directed mainly to the current-based programming pixel configuration, the reset driving according to the present invention is applicable to voltage-based programming pixel configurations. Figure 43 is an explanatory diagram illustrating a pixel configuration (panel configuration) according to the present invention for practicing a reset driving method with a voltage-based programming pixel configuration.

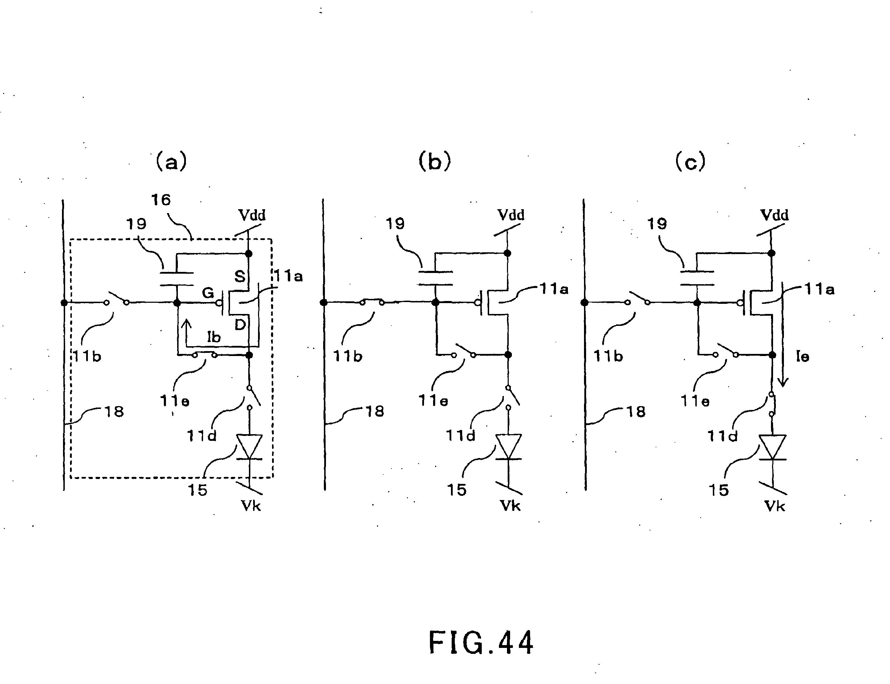

In the pixel configuration shown in Figure 43, there is formed transistor 11e for causing driving transistor 11a to be reset. When gate signal line 17e is applied with on-voltgage to turn transistor 11e on, which causes the gate terminal (G) and the drain terminal (D) of driving transistor 11a to become shortcircuited. The pixel configuration is also formed with transistor 11d for cutting off the current path between EL device 15 and driving transistor 11d. Hereinafter, the reset driving method applied to the voltage-based programming. pixel configuration will be described with reference to Figure 44.

As shown in Figure 44(a), transistors 11b and 11c are turned off, while transistor 11e turned on. Then, the drain terminal (D) and the gate terminal (G) of driving transistor 11a become shortcircuited, thus allowing current Ib to pass as shown. Accordingly, the potential at the gate terminal (G) and that at the drain terminal (D) of driving transistor 11a are equalized to each other, thus resetting transistor 11a (to a state not allowing current to pass therethrough.) Before the resetting of transistor 11a, current has been made passing through transistor 11a by initially turning transistors 11d and 11e on and off, respectively, in synchronism with an HD synchronizing signal, as described with reference to Figure 33 or 39. Thereafter, the operation illustrated in Figure 44 is performed.

Each of the reset states (the state not allowing current to pass) of respective transistors 11a and 11b is equivalent to the offset voltage holding state of the voltage offset canceller configuration described in relation to Figure 41 or the like. That is, in the state shown in Figure 44(a), an offset voltage (reset voltage) is held across the terminals of capacitor 19. This offset voltage has a voltage value which is variable in accordance with the characteristics of transistor 11a. Therefore, when the operation illustrated in Figure 44(a) is performed, transistor 11a does not pass current to capacitor 19 of each pixel. (That is, a black display current (substantially equal to zero) state is kept; stated otherwise, resetting to the initiating voltage causing current to start passing is made.)

As in the current-based programming pixel configuration, as the reset state shown in Figure 44(a) of the voltage-based programming pixel configuration continues for a longer time, the terminal voltage of capacitor 19 tends to become lower due to passage of current Ib. Therefore, the time period for which the state shown in Figure 44(a) continues needs to be fixed. This time period is preferably not less than 0.2H and not more than 5H (five horizontal scanning periods), more preferably not less than 0.5H and not more than 4H. Specifically, the time period is preferably not less than 2 μsec

and not more than 400 μsec.

It is preferable that gate signal line 17e and the gate signal line 17a of an antecedent pixel row form a common line. That is, gate signal line 17e is formed as shortcircuited to gate signal line 17 a of the antecedent pixel row. This configuration is referred to as "antecedent gate control method". The antecedent gate control method uses a waveform applied to the gate signal line of a pixel row having been selected at least 1H before the selection of a pixel row concerned. Therefore, the antecedent pixel row is not limited to the immediately preceding pixel row. For example, transistor 11a of a pixel row concerned may be reset by using the signal waveform applied to the gate signal of the pixel row next to the immediately preceding pixel row.

More specifically, the antecedent gate control method is as follows. It is assumed that: a pixel row concerned is the (N)th pixel row having gate signal lines 17e (N) and 17a(N); a pixel row selected 1H before is the (N-1)th pixel row having gate signal lines 17e(N-1) and 17a(N-1); and a pixel row to be selected 1H after the selection of the pixel row concerned is the (N+1)th pixel row having gate signal lines 17e(N+1) and 17a(N+1).

In the (N-1)th H period; when gate signal line 17a(N-1) of the (N-1)th pixel row is applied with on-voltage, gate signal line 17e(N) of the (N)th pixel row is also applied with on-voltage. This is because gate signal line 17e(N) is formed as shortcircuited to gate signal line 17a (N-1) of the antecedent pixel row. Accordingly, transistor 11b(N-1) of each pixel of the (N-1)th pixel row is turned on to write the voltage of source signal line 18 to the gate terminal (G) of driving transistor 11a(N-1). At the same time, transistor 11e(N) of the (N)th pixel row is turned on to shortcircuit the gate terminal (G) and the drain terminal (D) of driving transistor 11a(N), thereby resetting driving transistor 11a(N).

In the (N)th period following the (N-1)th H period, when gate signal line 17a(N) of the (N)th pixel row is applied with on-voltage, gate signal line 17e(N+1) of the (N+1)th pixel row is also applied with on-voltage. Accordingly, transistor 11b(N) of each pixel of the (N)th pixel row is turned on to write the voltage applied to source signal line 18 to the gate terminal (G) of driving transistor 11a(N). At the same time, transistor 11e(N+1) of each pixel of the (N+1)th pixel row is turned on to shortcircuit the gate terminal (G) and the drain terminal (D) of driving transistor 11a(N+1), thereby resetting driving transistor 11a(N+1).

A similar operation proceeds for the following pixel rows. In the (N+1)th H period following the (N)th H period, when gate signal line 17a(N+1) of the (N+1)th pixel row is applied with on-voltage, gate signal line 17e (N+2) of the (N+2)th pixel row is also applied with on-voltage. Accordingly, transistor 11b(N+1) of each pixel of the (N+1)th pixel row is turned on to write the voltage applied to source signal line 18 to the gate terminal (G) of driving transistor 11a(N+1). At the same time, transistor 11e(N+2) of each pixel of the (N+2)th pixel row is turned on to shortcircuit the gate terminal (G) and the drain terminal (D) of driving transistor 11a(N+2), thereby resetting driving transistor 11a(N+2).

With the antecedent gate control method according to the present invention, driving transistor 11a is reset for a 1H period, followed by voltage-based programming.

As in the case of Figure 33(a), when the operation is performed so that the reset state shown in Figure 44(a) synchronizes to the current-based programmed state shown in Figure 44(a), the time period required for the current-based programming state shown in Figure 44(b) to be reached has a fixed value (constant value) and, therefore, there arises no problem. If this time period is too short, driving transistor 11a is not completely reset, while if it is too long, driving transistor 11a assumes complete off state, which in turn results in the current-based programming taking a longer time. Further, the luminance of screen 12 is lowered.

Subsequently to the state shown in Figure 44 (a), the pixel configuration is turned into the state shown in Figure 44(b) where transistors 11b is in on-state, while transistors 11e and 11d in off-state. The state shown in Figure 44(b) is a state where current-based programming is being performed. That is, source driver 14 outputs the programming current, which is then written to the gate terminal (G) of driving transistor 11a (i.e., capacitor 19 is programmed with the potential of the gate terminal (G) of driving transistor 11a.) In the case of voltage-based programming, transistor 11d need not necessarily be turned off at the time of voltage-based programming. Transistor 11e will not be needed if the combination with the N-fold pulse driving method as shown in Figs. 13 or 15 or the like is unnecessary or if the intermittent N/K pulse driving method does not need to be practiced. (The intermittent NK-fold pulse driving method is a driving method including providing plural lighting regions on one screen. This driving method can be easily practiced if transistor 11e is caused to turn on/off.) Since this feature has been described earlier, description thereof will be omitted.

In the case where a white display is provided by voltage-based programming using the configuration shown in Figure43 or the driving method illustrated in Figure 44, perfect voltage-based programming can be achieved from the offset voltage providing a black display (the initiating voltage causing the current set in accordance with the characteristics of driving transistors to pass) even when there are variations in the characteristics of driving transistors of respective pixels. Therefore, the times required for respective driving transistors to be programmed with a target value are equalized to each other for each gray level. For this reason, there occurs no gray scale error due to variations in the characteristics of transistors 11a and, hence, satisfactory image display can be realized.

After the voltage-based programming illustrated in Figure 44(b), transistors 11b is turned off and transistor 11d turned on to cause driving transistor 11a to pass the programming current through EL device 15, thereby causing EL device 15 to emit light.

Thus, the reset driving method based on the voltage-based programming illustrated in Figure 43 comprises: a first operation in which transistor 11d is turned on and transistor 11e turned off in synchronism with an HD synchronizing signal to pass current to transistor 11a; a second operation in which driving transistor 11a and EL device 15 are disconnected from each other, while the drain terminal (D) and the gate terminal (G) of the driving transistor 11a (alternatively, the source terminal (S) and the gate terminal (G) of the driving transistor 11a, more generally, two terminals of the driving transistor including gate terminal (G)) are shortcircuited; and a third operation in which the driving transistor 11a is programmed with voltage after the second operation.

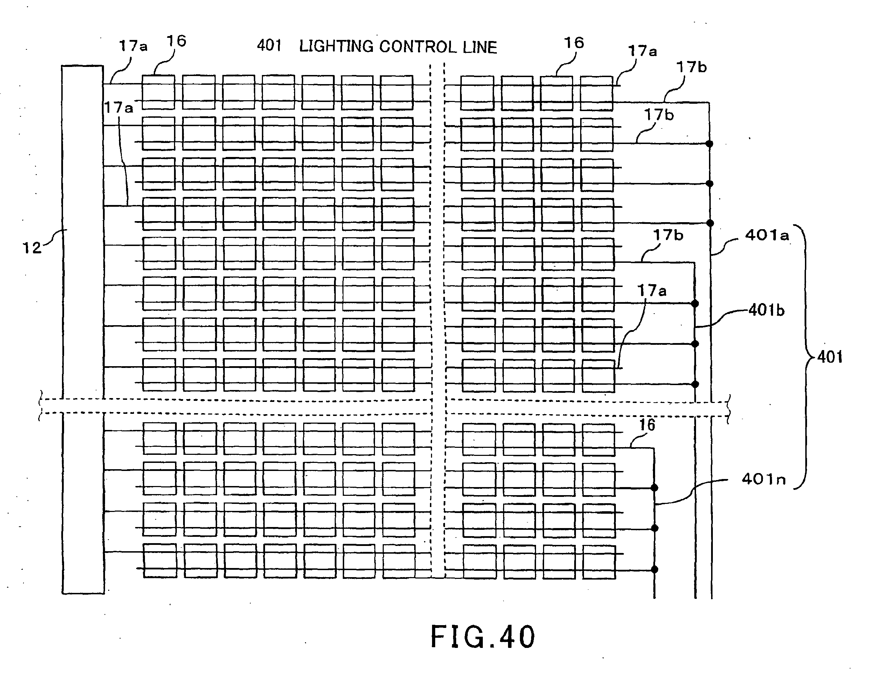

In the embodiment described above, transistor 11d is on-off controlled to control the current to be passed from driving transistor 11a (in the case of the pixel configuration shown in Figure 1) to EL device 15. In order for transistor 11d to be on-off controlled, gate signal lines 17b need to be scanned. Such scanning requires shift register 61 (gate circuit 12). Since shift register 61 is large in size, use of shift register 61 for control over gate signal lines 17b will prevent the frame from being narrowed. The method to be described with reference to Figure 40 solves this problem.

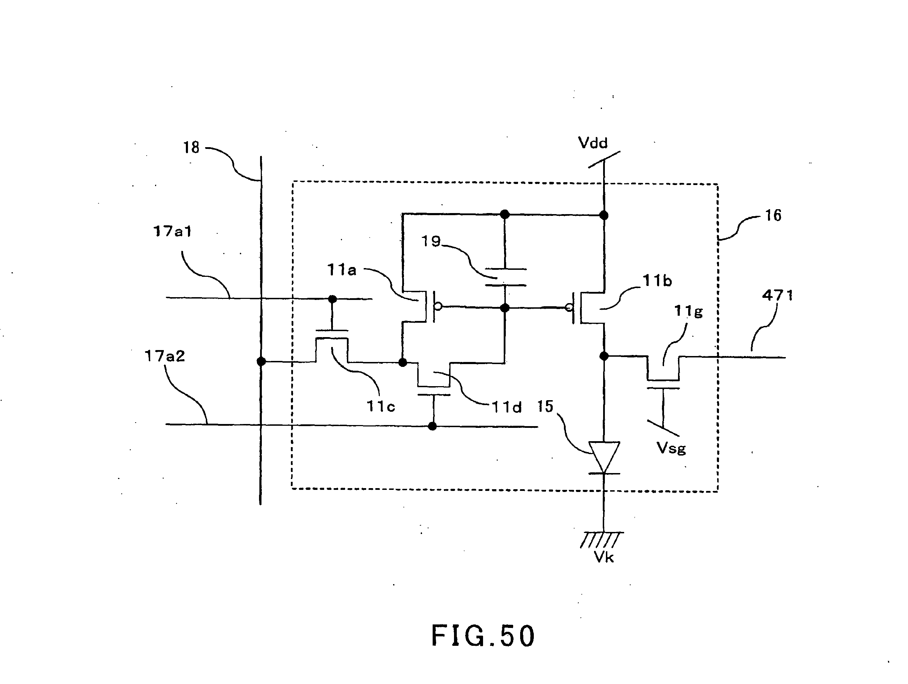

Though the present invention is described by reference mainly to examples of current-based programming pixel configuration as shown in Figure 1 and the like, the present invention is not limited to these examples. It is needless to say that the present invention is applicable even to other current-based programming pixel configurations (including a current mirror pixel configuration) as described with reference to Figure 38 and the like. It is also needless to say that the technical concept of on-off control on a block-by-block basis is applicable to voltage-based programming pixel configurations as shown in Figure 41 and the like. Since the present invention is directed to a method of intermittently passing current through EL device 15, it is needless to say that the present invention can be combined with a method of application of reverse bias voltage to be described with reference to Figure 50 or the like. Thus, the present invention can be practiced in combination with other embodiments.

Figure 40 illustrates an embodiment of a block driving method. For easy explanation, it is assumed that gate driver 12 is formed directly on substrate 71 or gate driver 12 in a silicon chip form is mounted on substrate 71. Further, source driver 14 and source signal lines are omitted from the figure to avoid complicated drawing.

In Figure 40, gate signal line 17a is connected to gate driver 12. On the other hand, gate signal line 17b associated with each pixel is connected to lighting control line 401. In Figure 40, four gate signal lines 17b are connected to one lighting control line 401.

Though four gate signal lines 17b form one block in the configuration, there is no limitation thereto but it is needless to say that one block may consist of more than four gate signal lines 17b. Generally, display region 50 is preferably divided into 5 or more, more preferably 10 or more, much more preferably 20 or more. If the number by which display region 50 is divided is too small, flicker is likely to become conspicuous. On the other hand, if the number is too large, the number of lighting control lines 401 becomes large, which makes it difficult to layout such control lines 401.

Since a QCIF display panel has 220 vertical scanning lines, these lines need to be divided into blocks by at least 5 (i.e., 220/5 = 44), preferably 10 or more (220/10 = 11). There are some cases where two blocks are sufficient because less flicker occurs in display region 50 which is divided into two blocks, one consisting of odd number rows, the other consisting of even number rows.

In the embodiment shown in Figure 40, lighting control lines 401a, 401b, 401c, 401d, ..., 401n are sequentially applied with on-voltage (Vgl) or off-voltage (Vgh) to turn EL devices 15 on/off block by block.

In the embodiment shown in Figure 40, gate signal line 17b and lighting control line 401 do not cross each other. Therefore, the embodiment is free from such a failure that gate signal line 17b and lighting control line 401 become shortcircuited. Further, since there is no capacitive coupling between gate signal line 17b and lighting control line 401, a very small capacitance is added when the gate signal line 17d side is viewed from lighting control line 401. Therefore, lighting control line 401 can be driven easily.

Gate driver 12 is connected to gate signal line 17a. When gate signal line 17a is applied with on-voltage, the pixel row associated therewith is selected and transistors 11b and 11c of each of the selected pixels are turned on to program capacitor 19 of each pixel with the current (voltage) applied to source signal line 18. On the other hand, gate signal line 17b is connected to the gate terminal (G) of transistor 11d of each pixel. Accordingly, when lighting control line 401 is applied with on-voltage (Vgl), a current path is formed between driving transistor 11a and EL device 15, whereas when it is applied with off-voltage (Vgh), the anode terminal of EL device 15 is opened.

It is preferable that the control timing at which on-voltage and off-voltage are applied to lighting control line 401 and the timing at which gate driver 12 outputs pixel row selecting voltage (Vgl) to gate signal line 17a synchronize to one horizontal scanning clock (1H). However, there is not limitation thereto.

The signal to be applied to lighting control line 401 merely on-off controls the current to be passed to EL device 15. That signal need not synchronize to image data to be outputted from source driver 14. This is because the signal to be applied to lighting control line 401 functions to control the current programmed at capacitor 19 of each pixel 16. Therefore, this signal need not necessarily synchronize to the pixel row selecting signal. Even if they synchronize to each other, the clock is not limited to 1H but may be 1/2H or 1/4H.

In the case of the current mirror pixel configuration shown in Figure 38, transistor 11e can be on-off controlled if gate signal line 17b is connected to lighting control line 401. Thus, the block driving can be realized.

The pixel configuration shown in Figure 32 can realize the block driving if gate signal line 17a is connected to lighting control signal 401 and the reset driving is performed. In this case, the block driving method according to the present invention is a driving method in which plural pixel rows are turned into the non-lighting state (or the black display state) at a time using one control line.

The embodiment described above has an arrangement where one pixel row selecting gate signal line is provided (formed) for each pixel row. The present invention is not limited to this arrangement but may have such an arrangement that one selecting gate signal line is provided (formed) for each set of plural pixel rows.

Figure 41 illustrates an embodiment of that arrangement. For easy explanation, the pixel configuration shown in Figure 1 will be mainly exemplified. In Figure 41, gate signal line 17a is designed to select three pixels (16R, 16G and 16B) at a time. The signs "R", "G" and "B" are meant to relate to red pixel, green pixel and blue pixel, respectively.

Accordingly, selection of gate signal line 17a causes pixels 16R, 16G and 16B to be selected and written with data at a time. Pixel 16R writes data from source signal line 18R to capacitor 19R, pixel 16G writes data from source signal line 18G to capacitor 19G, and pixel 16B writes data from source signal line 18B to capacitor 19B.

Transistor 11d of pixel 16R is connected to gate signal line 17bR. Similarly, transistor 11d of pixel 16G is connected to gate signal line 17bG, while transistor 11d of pixel 16B is connected to gate signal line 17bB. Accordingly, EL device 15R of pixel 16R, EL device 15G of pixel 16G and EL device 15B of pixel 16B can be on-off controlled independently of each other. That is, EL device 15R, EL device 15G and EL device 15B can be individually controlled as to their lighting time and lighting cycle by individual control over gate signal lines 17bR, 17bG and 17bB.

In realizing this operation, it is suitable that the configuration shown in Figure 6 is.formed (provided) with the four shift register circuits: shift register circuit 61 for scanning gate signal line 17a, shift register circuit 61 for scanning gate signal line 17bR, shift register circuit 61 for scanning gate signal line 17bG, and shift register circuit 61 for scanning gate signal line 17bB.

In spite of the foregoing description of the feature that a current N times as high as the predetermined current is passed through source signal line 18 to feed EL device 15 with the current N times as high as the predetermined current for a 1/N period, this feature cannot be realized practically. This is because actually the signal pulse applied to gate signal line 17 punches through capacitor 19 thereby making it impossible to set a desired voltage value (or current value) at capacitor 19. Generally, a voltage value (or current value) lower than a desired voltage value (or current value) is set at capacitor 19. For example, even when driving is performed so as to set a 10-fold current value, a current having about 5-fold value at most can be set at capacitor 19. Even when N = 10, EL device 15 is actually fed with a current equal to the current that is fed thereto when N = 5. Thus, the present invention is directed to a driving method including setting an N-fold current value so that EL device can be fed with a current that is proportional to or corresponding to the N-fold value, or a driving method including application of a current in a pulse form having a value higher than a desired value to EL device 15.

The present invention is also directed to the driving method including: programming driving transistor 11a (in the case of Figure 1) with a current (or a voltage) having a value higher than a desired value (i.e., a current such as to cause EL device 15 to exhibit a luminance higher than a desired luminance when the current, as it is, is continuously passed through EL device 15); and intermittently feeding the current to EL device 15 to cause EL device to emit light at the desired luminance.

It should be noted that a circuit compensating for the punch-through voltage reaching capacitor 19 is incorporated in source driver 14. This feature will be described later.

It is preferable that switching transistors 11b and 11c of Figure 1 each comprise an n-channel transistor. This is because the punch-through voltage reaching capacitor 19 can be lowered by such an arrangement. Further, since off-leakage at capacitor 19 is reduced, this arrangement is applicable to a low frame rate not higher than 10 Hz.

In some pixel configurations, the punch-through voltage may act to increase the current to be fed to EL device 15. In such cases, white peak current increases thereby to make the contrast of image display higher. Thus, it is possible to realize satisfactory image display.

Conversely, such a method is effective as to improve black display by using a p-channel transistor for each of switching transistors 11b and 11c to allow punch through to occur. In this case, voltage Vgh is used to turn p-channel transistor 11b off. For this reason, the terminal voltage of capacitor 19 slightly shifts toward the Vdd side. Thus, the gate terminal (G) voltage of transistor 11a rises, thus leading to a more satisfactory black display. Further, since the value of current for realizing a first-level gray scale display can be increased (i.e., a given base current can be passed until gray level 1 is reached), the occurrence of insufficient writing with current in current-based programming can be reduced.

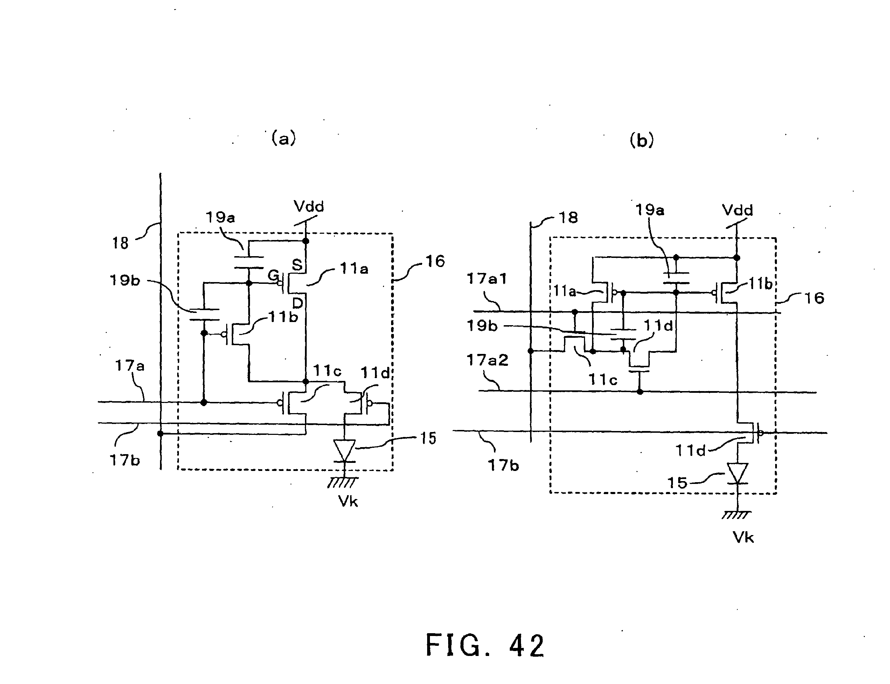

Other effective arrangements include an arrangement in which capacitor 19b is intentionally formed between gate signal line 17a and the gate terminal (G) of transistor 11a to increase punch-through voltage (see Figure 42(a).) This capacitor 19b preferably has a capacitance not less than 1/50 and mot more than 1/10 as large as the capacitance of the regularly-provided capacitor 19a. More preferably, this value is set not less than 1/40 and mot more than 1/15 as large as the capacitance of the regularly-provided capacitor 19a or not less than 1 and not more than 10 times as large as the capacitance of the source-gate (SG) (or source-drain (SD) or gate-drain (GD)) of transistor 11b. Much more preferably, the value of the capacitance is set not less than 2 and not more than 6 times as high as the capacitance of SG. The capacitor 19b may be formed or located between one terminal of capacitor 19a (or gate terminal (G) of transistor 11a) and the source terminal (S) of transistor 11d. The aforementioned value of capacitance holds true for this case.

The capacitance (Cb (pF)) of capacitor 19b for generating punch-through voltage has a relationship with the capacitance (Ca (pF)) of capacitor 19a for storing charge, gate terminal (G) voltage Vw of transistor 11a at which white peak current is passed (or at which a white raster display having the highest luminance of image display is provided), and gate terminal (G) voltage Vb at which a current for providing a black display (which current assumes a value of substantially 0 for a black display in image display) is passed. Preferably, the relationship satisfies the condition:

$$Ca/(200Cb) \leqq |Vw\text{-}Vb| \leqq Ca/(8Cb)$$

wherein |Vw-Vb| is the absolute value of the difference between a terminal voltage of the driving transistor providing a white display and a terminal voltage of the driving transistor providing a black display (that is, a varying amplitude of voltage.)

More preferably, the relationship satisfies the condition:

$$Ca/(100Cb) \leqq |Vw\text{-}Vb| \leqq Ca/(10Cb).$$

Transistor 11b should comprise a p-channel transistor which is at least double-gated, more preferably triple-gated or more, much more preferably quadruple-gated or more. It is preferable to form or locate capacitors in parallel, each of the capacitors having a capacitance not less than 1 and not more than 10 times as large as the capacitance of the source-gate SG (or gate-drain (GD)) of transistor 11b (in on-state.)

The feature described above is effective for not only the pixel configuration shown in Figure 1 but also other pixel configurations. For example, in the case of a current mirror pixel configuration as shown in Figure 42(b), a capacitor for causing punch through is located or formed between gate signal line 17a or 17b and the gate terminal (G) of transistor 11a. In this case, the n-channel of switching transistor 11c is double-gated or more. Alternatively, switching transistors 11c and 11d each comprise a p-channel transistor which is triple-gated or more.

In the case of the voltage-based programming configuration shown in Figure 41, a capacitor 19c for causing punch through is formed or located between gate signal line 17c and the gate terminal (G) of driving transistor 11a. Further, switching transistor 11c is triple-gated or more. The capacitor 19c for causing punch through may be located between the drain terminal (D) of transistor 11c (on the capacitor 19b side) and gate signal line 17a. Alternatively, the capacitor 19c for causing punch through may be located between the gate terminal (G) of transistor 11a and gate signal line 17a. Yet alternatively, the capacitor 19c for causing punch through may be located between the drain terminal (D) of transistor 11c (on the capacitor 19b side) and gate signal line 17c.

A satisfactory black display can be realized by an arrangement which satisfies the condition:

$$0.05 \text{ (V)} \leqq (Vgh\text{-}Vgl) \times (Cc/Ca) \leqq 0.8 \text{ (V)}$$

wherein Ca is the capacitance of capacitor 19a for storing charge, Cc is the source-gate capacitance of switching transistor 11c or 11d (Cc is the sum of the source-gate capacitance and the capacitance of a capacitor for causing punch through if the capacitor is present), Vgh is the high-voltage signal to be applied to a gate signal line, and Vgl is the low-voltage signal to be applied to the gate signal line.

Preferably, the condition: $0.1 \text{ (V)} \leqq (Vgh\text{-}Vgl) \times (Cc/Ca) \leqq 0.5 \text{ (V)}$ is satisfied.

The feature described above is also effective for the pixel configurations shown in Figure 43 and the like. In the case of the voltage-based programming pixel configuration shown in Figure 43, a capacitor 19b for causing punch through is formed or located between the gate terminal (G) of transistor 11a and gate signal line 17a.

The capacitor 19b for causing punch through is formed of source wiring and gate wiring. However, since the capacitor 19b is formed by superposition of gate signal line 17 and widened source signal line of transistor 11 on each other, the capacitor cannot be separated distinctively from the transistor in some practical cases.

An arrangement in which switching transistors 11b and 11c (in the case of the configuration shown in Figure 1) are each formed to have a larger size than necessary as if capacitor 19b for causing punch through is apparently formed thereby, is also included in the scope of the present invention. In many cases, switching transistors 11b and 11c are each formed to have a channel width W/channel length ratio of 6/6 μm. The capacitor 19b for causing punch through can also be formed by increasing the ratio of W to L. For example, the W:L ratio is set not less than 2:1 and not more than 20:1, more preferably not less than 3:1 and not more than 10:1.

Preferably, the capacitor 19b for causing punch through has a magnitude (capacitance) varying depending on R, G and B modulated by pixels. This is because EL devices 15 for R, G and B are different from each other in driving current and in cut-off voltage. For this reason, the gate terminals (G) of respective driving transistors 11a associated with these EL devices 15 are programmed with different voltages (currents). For example, when the capacitor 11bR of R pixel has a capacitance of 0.02 pF, the capacitors 11bG and 11bB of pixels for other colors (G pixel and B pixel) are each set to have a capacitance of 0.025 pF. When the capacitor 11bR of R pixel has a capacitance of 0.02 pF, the capacitor 11bG of G pixel and the capacitor 11bB of B pixel are set to have a capacitance of 0.03 pF and a capacitance of 0.025 pF, respectively. In this way, the offset driving current can be adjusted for each of R, G and B by varying the capacitance of capacitor 11b depending on R, G and B pixels. Thus, it is possible to optimize the black display level of each of R, G and B pixels.

While it has been described that the capacitance of the capacitor 19b for generating punch-through voltage is varied, the punch-through voltage is generated due to the relativity between the capacitance of capacitor 19a for storing charge and that of capacitor 19b for generating punch-through voltage. Therefore, there is no limitation to the feature that the capacitance of capacitor 19b is varied depending on R, G and B pixels. The capacitance of storage capacitor 19a may be varied. For example, when the capacitor 11aR of R pixel has a capacitance of 1.0 pF, the capacitor 11aG of G pixel and the capacitor 11aB of B pixel are set to have a capacitance of 1.2 pF and a capacitance of 0.9 pF, respectively. In this case, the capacitors 19b of the respective R, G and B pixels are set to have capacitances of equal value. Thus, according to the present invention, at least one of R, G and B pixels is made different from the others in the capacitance ratio between storage capacitor 19a and capacitor 19b for generating punch-through voltage. It is to be noted that both the capacitance of storage capacitor 19a and that of capacitor 19b for generating punch-through voltage may be varied depending on R, G and B pixels.

It is also possible to vary the capacitance of capacitor 19b for generating punch-through voltage as the screen extends laterally. Since the gate signal rises rapidly at each pixel 16 located close to gate driver 12 (because the through rate is high), the punch-through voltage becomes high. At the pixel located (formed) at the end of each gate signal line 17, on the other hand, the signal waveform becomes dulled (due to the capacitance of gate signal line 17.) This is because the punch-through voltage becomes low due to the gate signal rising slow (because of a low through rate.) For this reason, the capacitance of capacitor 19b for generating punch-through voltage is made low at each pixel close to the connection side of gate driver 12. On the other hand, the capacitance of capacitor 19b is made high at the end of each gate signal line 17. For example, a variation of about 10% in the capacitance of capacitor is provided between the right-hand extremity and the left-hand extremity of the screen.

The punch-through voltage to be generated is determined from the capacitance ratio between storage capacitor 19a and capacitor 19b for generating punch-through voltage. Therefore, there is no limitation to the aforementioned feature that the capacitance of capacitor 19b for generating punch-through voltage is varied as the screen extends laterally. It is possible that the capacitance of storage capacitor 19a is varied depending on the lateral position of capacitor 19a on the screen with the capacitance of capacitor 19b for generating punch-through voltage being fixed in the lateral direction of the screen. It is needless to say that both the capacitance of capacitor 19b for generating punch-through voltage and that of storage capacitor 19a may be varied as the screen extends laterally.

The N-fold pulse driving method according to the present invention has a problem that the current to be applied to EL device 15 becomes N times as high as in the prior art though this phenomenon is instantaneous. In some cases, such a high current shortens the lifetime of EL device 15. Application of reverse bias voltage Vm to EL device 15 is effective in solving the problem.

In EL device 15, electrons are injected into the electron transport layer through the cathode, while at the same time positive holes injected into the positive hole transport layer through the anode. The electrons and positive holes thus injected travel to the opposite poles. At that time, they are trapped in the organic layer and carriers are accumulated due to an energy level difference at the interface with the luminescent layer.

It is known that when space-charge is accumulated in the organic layer, molecules are oxidized or reduced to produce unstable radical anionic molecules and radical cationic molecules, which deteriorate the film quality thereby lowering the luminance and causing a rise in driving voltage during constant-current driving. An example of means to prevent this phenomenon is a modification of the device structure for reverse voltage to be applied.

When reverse bias voltage is applied, reverse current is applied, which causes the electrons and positive holes injected to be withdrawn toward the cathode and the anode, respectively. Thus, the generation of space-charge in the organic layer is cancelled, whereby electrochemical deterioration of molecules can be inhibited, which ensures the EL device having a prolonged lifetime.

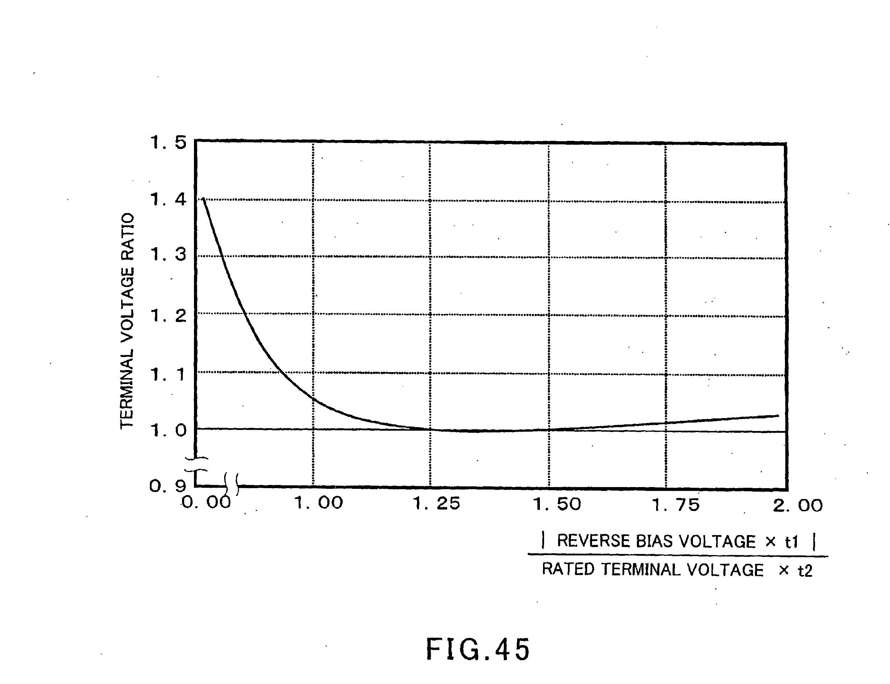

Figure 45 plots a variation in reverse bias voltage Vm with varying terminal voltage of EL device 15. The "terminal voltage", as used here, is a voltage generated when EL device 15 is fed with a rated current. The variation shown in Figure 45, which resulted from the case where the current passed through EL device 15 had a current density of 100 A/m$^2$, had a tendency having little difference from that of the case where the current passed through EL device 15 had a current density of from 50 to 100 A/m$^2$. Therefore, the reverse bias voltage application method is estimated to be effective over a wide range of current density.

The ordinate represents the ratio of the terminal voltage of EL device 15 resulting 2,500 hours after the starting of application of current to the initial terminal voltage of EL device 15. Assuming, for example, that the terminal voltage resulting at the time 0 hour after the starting of application of a current having a current density of 100 A/m$^2$ is 8 (V) while the terminal voltage resulting at the time 2,500 hours after the starting of application of the current having a current density of 100 A/m$^2$ is 10 (V), the terminal voltage ratio is 10/8 = 1.25.

The abscissa represents the ratio of rated terminal voltage V0 to the product of reverse bias voltage Vm by time t1 for which reverse bias voltage was applied in one cycle. For example, if the time for application of reverse bias voltage Vm of 60 Hz (60Hz has no particular meaning) is 1/2 (a half), t1 is equal to 0.5. Assuming that the terminal voltage resulting at the time 0 hour after the starting of application of a current having a current density of 100 A/m$^2$ is 8 (V) while reverse bias voltage is 8 (V), it follows that | reverse bias voltage $\times$ t1|/(rated terminal voltage $\times$ t2) = |-8(V) $\times$ 0.5 |/(8(V) $\times$ 0.5) = 1.0.

According to Figure 45, when |reverse bias voltage $\times$ t1|/(rated terminal voltage t2) is 1.0 or more, the terminal voltage ratio does not vary (that is, the terminal voltage does not vary from the initial terminal voltage.) Application of reverse bias voltage works effectively. However, when | reverse bias voltage $\times$ t1|/(rated terminal voltage $\times$ t2) is 1.75 or more, the terminal voltage ratio tends to rise. Accordingly, the magnitude of reverse bias voltage Vm and the application time ratio t1 (or t2, or the ratio between t1 and t2) should be determined so that |reverse bias voltage $\times$ t1 |/(rated terminal voltage $\times$ t2) may assume 1.0 or more. Preferably, the magnitude of reverse bias voltage Vm, the application time ratio t1 and the like are determined so that |reverse bias voltage $\times$ t1|/(rated terminal voltage $\times$ t2) may assume 1.75 or less.

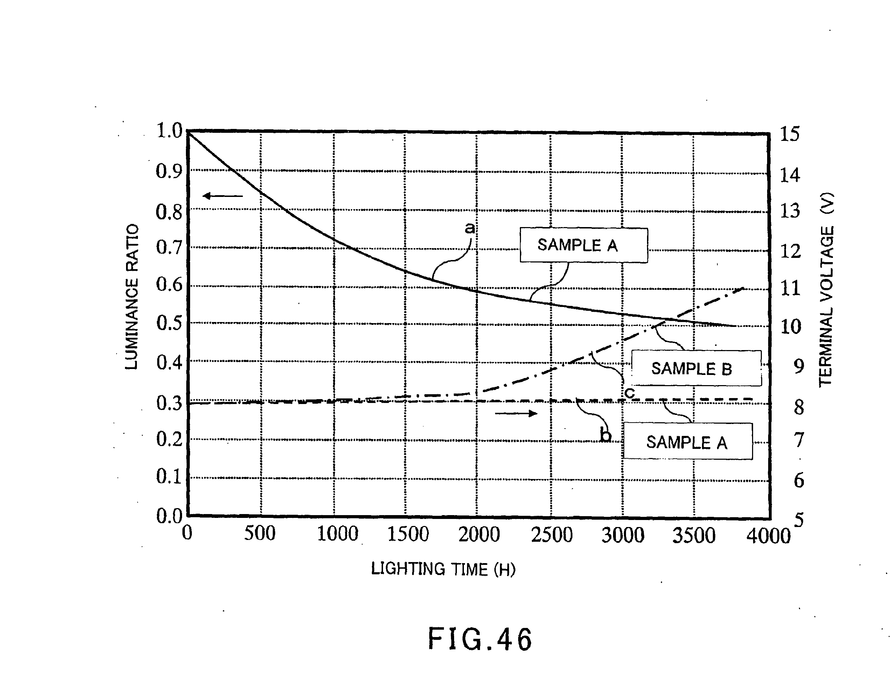

Such a bias driving method requires alternate application of reverse bias voltage and rated current. In the case of Figure 46, in order to equalize the mean luminance of sample A and that of sample B per unit time, a current that instantaneously becomes higher than in the case where there is no application of reverse bias voltage Vm, has to be passed in the case where there is application of reverse bias voltage Vm. For this reason, the terminal voltage of EL device 15 also becomes higher in the case where there is application of reverse bias voltage Vm (sample A of Figure 46.)

However, even in the driving method including application of reverse bias voltage, the rated terminal voltage V0 of Figure 45 is such a terminal voltage as to satisfy the mean luminance (that is, such a terminal voltage as to cause EL device 15 to light.) (According to the specific example mentioned herein, the rated terminal voltage V0 is a terminal voltage resulting when a current having a current density of 200 A/m$^2$ is applied. Since the duty ratio is 1/2, the mean luminance throughout one cycle is a luminance at a current density of 200 A/m$^2$.

The matter described above lies on the assumption that EL device 15 is caused to provide a white raster display (i.e., EL device 15 is fed with a maximum current.) When the EL display apparatus displays a picture image, it performs gray scale display since the picture image is a natural image. Therefore, a white peak current is not constantly passed through EL device 15. (The white peak current is a current passing at a maximum white display. In the case of the specific example mentioned herein, the white peak current is a current having a mean current density of 100 A/m$^2$.)

In the case of picture image display, in general, the current to be applied to (passed through) each EL device 15 is about 0.2 times as high as the white peak current. (The white peak current is a current passing under application of the rated terminal voltage. According to the specific example mentioned herein, the white peak current is a current having a current density of 100 A/m$^2$.)

Accordingly, when a picture image is displayed with the embodiment shown in Figure 45, any value on the abscissa needs to be multiplied by 0.2. Thus, the magnitude of reverse bias voltage Vm and the application time ratio t1 (or t2, or the ratio between t1 and t2) should be determined so that I reverse bias voltage $\times$ t1 |/(rated terminal voltage $\times$ t2) may assume 0.2 or more. Preferably, the magnitude of reverse bias voltage Vm, the application time ratio t1 and the like are determined so that | reverse bias voltage $\times$ t1 |/(rated terminal voltage $\times$ t2) may assume 0.35 (= 1.75$\times$0.2) or less.

That is, a value of 1.0 on the abscissa (|reverse bias voltage $\times$ t1|/(rated terminal voltage x t2) in Figure 45 needs to be changed to 0.2. Accordingly, when the display panel displays a picture image (this state of use seems to be usual because a white raster display seems not to be performed usually), reverse bias voltage Vm should be applied for predetermined time t1 so that | reverse bias voltage $\times$ t1|/(rated terminal voltage $\times$ t2) may assume 0.2 or more. Even when the value of | reverse bias voltage $\times$ t1 |/(rated terminal voltage $\times$ t2) increases, the increase in the terminal voltage ratio is not very large, as seen from Figure 45. In view of the case where white raster display is performed, the upper limit value of |reverse bias voltage $\times$ t1|/(rated terminal

voltage $\times$ t2) should be adjusted to 1.75 or less.

Hereinafter, the reverse bias method according to the present invention will be described with reference to the relevant drawings. The method of the present invention is based on application of reverse bias voltage Vm (or current) during a time period in which current is not passed through EL device 15. However, there is no limitation thereto. For example, it is possible to apply reverse bias voltage Vm forcibly while current is passing through EL device 15. This case will result in the current fed to EL device 15 stopped, hence, EL device 15 turned into the non-lighting state (black display state.) Though the method of the present invention will be described focusing mainly on the feature that a current-based programming pixel configuration is applied with reverse bias voltage, there is no limitation to this feature.

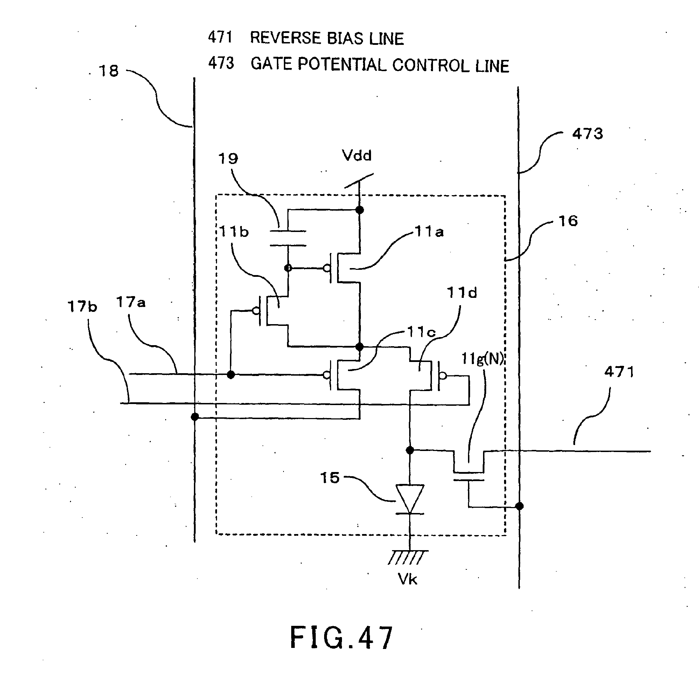

In a pixel configuration adapted for reverse bias driving, transistor 11g is an n-channel transistor as shown in Figure 47. Of course, transistor 11g may be a p-channel transistor.

In Figure 47, when gate potential control line 473 is applied with a voltage higher than the voltage applied to reverse bias line 471, transistor 11g(N) is turned on to apply reverse bias voltage Vm to the anode of EL device 15.

In the pixel configuration of Figure 47 or the like, gate potential control line 473 may be operated with its potential always fixed. For example, when voltage Vk in Figure 47 is 0 (V), the potential of gate potential control line 473 is fixed to 0 (V) or more (preferably 2 (V) or more). This potential is indicated at Vsg. With gate potential control line 473 in this state, when the potential of reverse bias line 471 is adjusted to reverse bias voltage Vm (0 (V) or lower, preferably a voltage lower than Vk by 5 (V) or more), transistor 11g(N) is turned on to apply reverse bias voltage Vm to the anode of EL device 15. When the voltage of reverse bias line 471 is made higher than the voltage of gate potential control line 473 (that is, the gate terminal (G) voltage of transistor 11g), transistor 11g is turned off to stop application of reverse bias voltage Vm to EL device 15. Of course, it is needless to say that reverse bias line 471 may assume a high-impedance state (open state or the like) at that time.

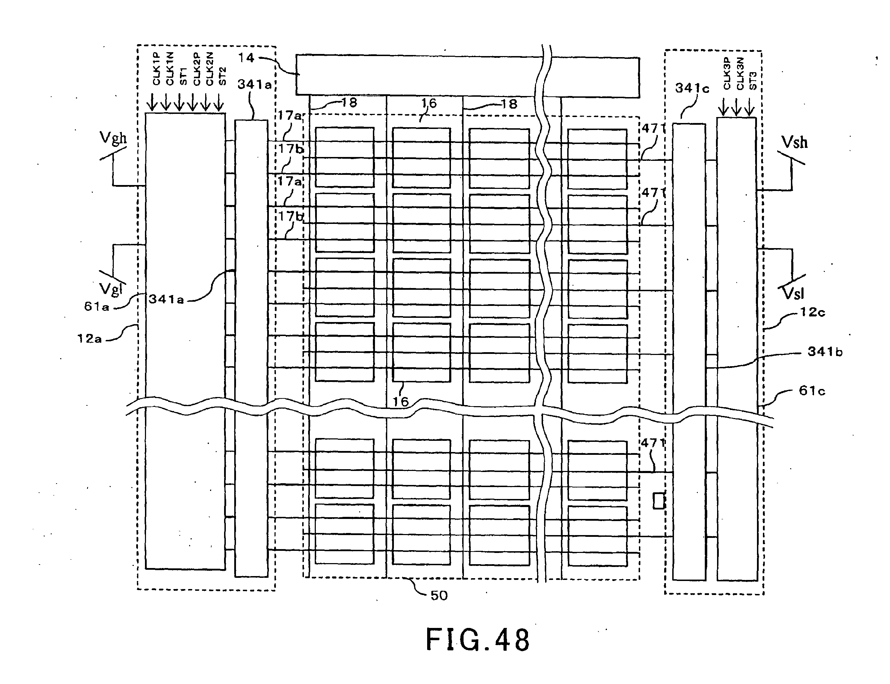

As shown in Figure 48, gate driver 12c for controlling reverse bias line 471 may be formed or disposed separately. Like gate driver 12a, gate driver 12c operates shiftingly in sequence, so that the position to be applied with reverse bias voltage is shifted synchronously with this shifting operation.

The driving method described above is capable of applying reverse bias voltage Vm to EL device 15 by merely varying the potential of reverse bias line 471 with the gate terminal (G) voltage of transistor 11g fixed. Thus, application of reverse bias voltage Vm can be controlled easily. Further, the driving method can lower the voltage to be applied across the gate terminal (G) and the source terminal (S) of transistor 11g. This holds true for the case where transistor 11g is a p-channel transistor.

Application of reverse bias voltage Vm is performed when EL device 15 is not fed with current. Therefore, it is sufficient for transistor 11g to be turned on while transistor 11d is off. That is, gate potential control line 473 should be applied with voltage in a manner reverse of the on-off logic of transistor 11d. For example, it is sufficient for gate signal line 17b to be connected to the gate terminals (G) of respective transistors 11d and 11g. Since transistor 11d is of the p-channel type while transistor 11g is of the n-channel type, their respective on-off operations are opposite to each other.

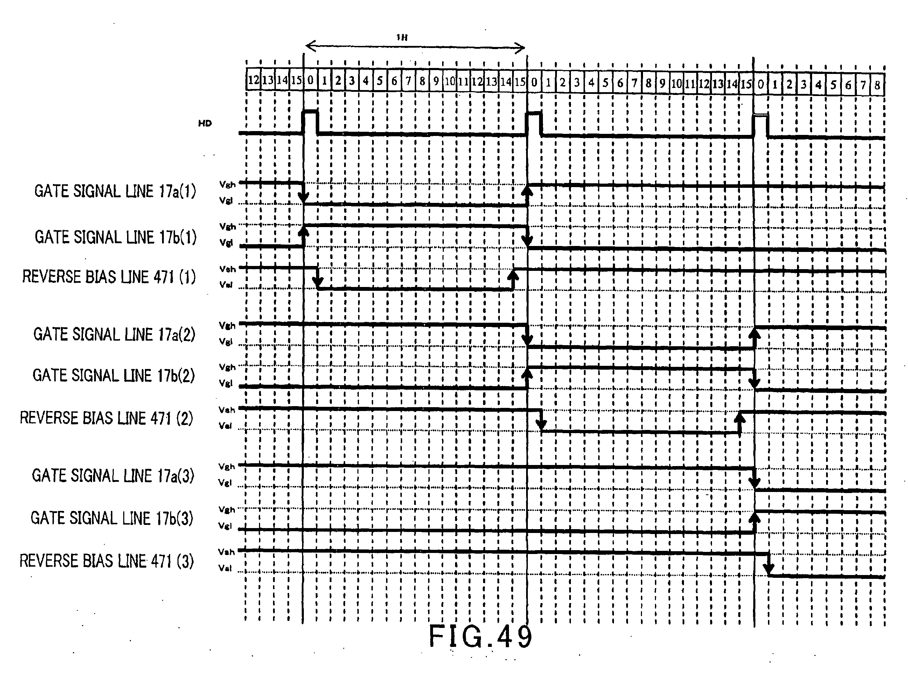

Figure 49 is a timing chart of the reverse bias driving method. In the chart, an additional number such as (1) or (2) indicates the number of a pixel row. For easy explanation, it is assumed that the first pixel row is indicated at (1) and the second pixel row indicated at (2). However, there is no limitation thereto but it may be considered that (1) indicates the Nth pixel row and (2) indicates the (N+1)th pixel row. This holds true for other embodiments unless otherwise specified. Though the embodiment illustrated in Figure 49 and the like will be described by reference to the pixel configuration shown in Figure 1 for example, there is no limitation thereto. For example, the driving method is applicable to the pixel configurations shown in Figs. 41, 38 and the like.

When gate signal line 17a(1) of the first pixel row is under application of on-voltage (Vgl), gate signal line 17b(1) of the first pixel row is under application of off-voltage (Vgh). That is, transistor 11d is off and EL device 15 is not fed with current.

Reverse bias line 471(1) is applied with voltage Vsl (which causes transistor 11g to turn on.) Accordingly, transistor 11g is turned on to apply reverse bias voltage to EL device 15. After lapse of a predetermined time period (a time period of 1/200 or more of 1H, or 0.5 μsec) from application of off-voltage (Vgh) to gate signal line 17b, reverse bias voltage is applied. The predetermined time period (a time period of 1/200 or more of 1H, or 0.5 μsec) before application of on-voltage (Vgl) to gate signal line 17b, application of reverse bias voltage is stopped. This operation is to avoid the transistors 11d and 11g turning on at the same time.

In the next horizontal scanning period (1H), off-voltage (Vgh) is applied to gate signal line 17a to select the second pixel row. That is, on-voltage is applied to gate signal line 17b(2). On the other hand, on-voltage (Vgl) is applied to gate signal line 17b to turn transistor 11d on. Accordingly, transistor 11a passes current through EL device 15 to cause EL device 15 to emit light. At the same time, off-voltage (Vsh) is applied to reverse bias line 471(1) so that EL device 15 of the first pixel row (1) will not be applied with reverse bias voltage. On the other hand, reverse bias line 471(2) of the second pixel row is applied with voltage Vsl (reverse bias voltage).

An image displayed over one screen is rewritten by repeating the sequential operations described above. The embodiment described above has the feature that application of reverse bias voltage is performed during the period in which each pixel is programmed. However, the present invention is not limited to the circuit configuration shown in Figure 48. It is apparent that plural pixel rows can be consecutively applied with reverse bias voltage. It is also apparent that the reverse bias driving method can be combined with block driving (see Figure 40), N-fold pulse driving, reset driving, dummy pixel driving, or a like driving method.

There is no limitation to the feature that application of reverse bias voltage is performed during image display. Such an arrangement is possible that reverse bias voltage is applied for a predetermined time period after the powering-off of the EL display apparatus.

Though the embodiment described above is applied to the pixel configuration shown in Figure 1, it is needless to say that the embodiment is applicable to configurations adapted for application of reverse bias voltage as shown in Figs. 38 and 41. For example, the embodiment is applicable to the current-based programming pixel configuration shown in Figure 50.

Figure 50 illustrates a current mirror pixel configuration. Transistor 11c is a pixel selecting device. When on-voltage is applied to gate signal line 17a1, transistor 11c is turned on. Transistor 11d is a switching device having a resetting function and a function of shortcircuiting the drain terminal (D)-gate terminal (G) of driving transistor 11a. Transistor 11d is turned on when gate signal line 17a2 is applied with on-voltage.

Transistor 11d is turned on 1H (one horizontal scanning period, i.e, one pixel row), preferably 3H, before the selection of the associated pixel. If it is 3H, transistor 11d is turned on 3H before to shortcircuit the gate terminal (G) and the drain terminal (D) of transistor 11a, thus turning transistor 11a off. Accordingly, transistor 11b is turned into a state not allowing current to pass therethough, so that EL device 15 assumes the non-lighting state.

When EL device 15 is in the non-lighting state, transistor 11g is turned on to apply reverse bias voltage to EL device 15. Therefore, EL device 15 is under application of reverse bias voltage for a time period for which transistor 11d is on. For this reason, transistors 11d and 11g are turned on at the same time in terms of logic.

The gate terminal (G) voltage of transistor 11g is fixed by application of voltage Vsg. When reverse bias line 471 is applied with a reverse bias voltage that is sufficiently lower than Vsg, transistor 11g is turned on.

Thereafter, when the horizontal scanning period in which an image signal is applied (written) to the pixel of concern comes, on-voltage is applied to gate signal line 17a1 to turn transistor 11c on. Accordingly, the image signal voltage outputted from source driver 14 to source signal line 18 is applied to capacitor 19 (with transistor 11d being kept in the on-state.)

When transistor 11d is turned on, a black display is provided. As the on-time of transistor 11d grows longer in a one-field (one frame) period, the proportion of the black display period becomes higher. Therefore, in order to adjust the means luminance throughout one field (on frame) to a desired value notwithstanding the black display period included, the display luminance during a display period needs to be raised. That is, it is required that EL device 15 be fed with a higher current in the display period. This operation is the N-fold pulse driving according to the present invention. Therefore, an operation characteristic of the present invention is to combine the N-fold pulse driving operation and the driving operation of turning transistor 11d on to provide a black display. Also, application of reverse bias voltage to EL device 15 in the non-lighting state is a feature characteristic of the present invention.

The embodiment described above is of the type which includes application of reverse bias voltage to a pixel assuming the non-lighting state in image display. The method of application of reverse bias voltage is not limited to this type. If application of reverse bias voltage is performed when an image is not displayed, it is not necessary to provide reverse bias transistor 11g for every pixel. The "non-lighting state", as used here, means a state where reverse bias voltage is applied before and after use of the display panel.

In the pixel configuration of Figure 1, for example, pixel 16 is selected (by turning transistors 11b and 11c on), while source driver (circuit) 14 outputs voltage V0 (for example, voltage GND) as low as the source driver can output and applies voltage V0 to the drain terminal (D) of driving transistor 11a. With transistor 11a in this state, turning transistor 11d on causes the anode of EL device 15 to be applied with voltage V0. At the same time, the cathode Vk of EL device 15 is applied with voltage Vm which is lower than voltage V0 by a value from 5 to 15 (V), whereby reverse bias voltage is applied to EL device 15. Transistor 11a is also turned into off-state when applied with a voltage lower than voltage V0 by a value from 0 to 5 (V) as voltage Vdd. By thus causing source driver 14 to output voltage and controlling gate signal line 17, it is possible to apply reverse bias voltage to EL device 15.

The N-fold pulse driving method is capable of passing a predetermined current (a current programmed by the voltage held at capacitor 19) through EL device 15 again even after a black display has been provided once within a one-field (one-frame) period. With the configuration of Figure 50, however, once transistor 11d is turned on, capacitor 19 discharges (the meaning of which includes "reduce") electric charge held thereat and, hence, it is not possible to feed EL device 15 with the predetermined current (the current programmed.) Nevertheless, the circuit of Figure 50 has a characteristic advantage that it can operate easily.

The embodiment described above is applied to the current-based programming pixel configuration. However, the present invention is not limited to this embodiment but may be applied to other current-based pixel configurations as shown in Figs. 38 and 50. The present invention is also applicable to voltage-based programming pixel configurations as shown in Figs. 51, 54 and 62.

Figure 51 shows a voltage-based programming pixel configuration which is simplest in a general sense. Transistor 11b is a selective switching device, while transistor 11a a driving transistor for feeding current to El device 15. In this configuration, transistor (switching device) 11g for application of reverse bias voltage is located (formed) on the anode side of EL device 15.

In the pixel configuration of Figure 51, the current to be passed through EL device 15 is fed to source signal line 18 and then fed to the gate terminal (G) of transistor 11a upon selection of transistor 11b.

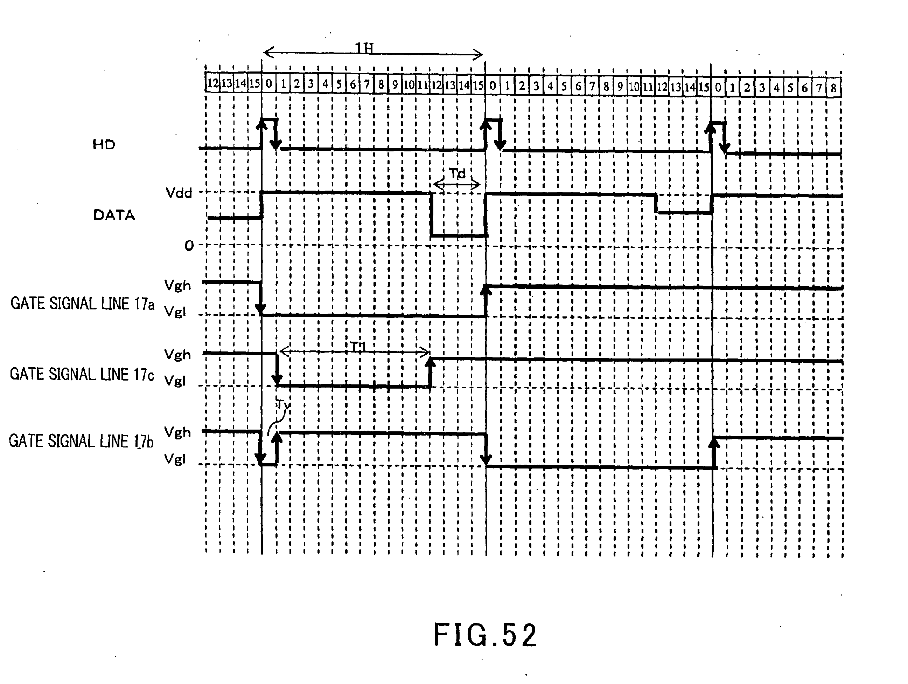

The basic operation of the configuration shown in Figure 51 will be described with reference to Figure 52 for explanation of this configuration. The pixel shown in Figure 51 is of the configuration called "voltage offset canceller" and performs a four-step operation comprising an initializing operation, a resetting operation, a programming operation, and light-emitting operation.

Following a horizontal synchronizing signal (HD), the initializing operation is performed. On-voltage is applied to gate signal line 17b to turn transistor 11g on. Also, on-voltage is applied to gate signal line 17a to turn transistor 11c on. At that time, source signal line 18 is applied with voltage Vdd. Accordingly, terminal a of capacitor 19b is applied with voltage Vdd. In this state, driving transistor 11a assumes on-state to pass a feeble current through EL device 15. This current causes the drain terminal (D) voltage of driving transistor 11a to have an absolute value larger than at least the operating point of transistor 11a.

Subsequently, the resetting operation is performed. Off-voltage is applied to gate signal line 17b to turn transistor 11e off. On the other hand, on-voltage is applied to gate signal line 17c for a time period T1 to turn transistor 11b on. This time period T1 is a resetting period. Also, gate signal line 17a is continuously applied with on-votlage for a 1H period. The time period T1 is preferably not less than 20% and not more than 90% of a 1H period. Stated otherwise, the time period T1 is preferably not less than 20 μsec and not more than 160 μsec. The ratio of the capacitance of capacitor 19b (Cb) to that of capacitor 19a (Ca), i.e., Cb:Ca, is preferably not less than 6:1 and not more than 1:2.

In the resetting period, transistor 11b is turned on to shortcircuit the gate terminal (G) and the drain terminal (D) of driving transistor 11a. Accordingly, the gate terminal (G) voltage and the drain terminal (D) voltage of driving transistor 11a become equal to each other, thus rendering transistor 11a into an offset state (i.e., reset state: a state not allowing current to pass therethrough). The reset state is a state where the gate terminal (G) voltage of transistor 11a assumes a value close to the initiating voltage at which current starts passing. This gate voltage for keeping the reset state is held at terminal b of capacitor 19b. Accordingly, capacitor 19 holds offset voltage (resetting voltage).

In the subsequent programming operation, off-voltage is applied to gate signal line 17c to turn transistor 11b off. On the other hand, source signal line 18 is applied with DATA voltage for a time period Td. Accordingly, the gate terminal (G) of driving transistor 11a is applied with a voltage as the sum of DATA voltage and offset voltage (resetting voltage.) For this reason, driving transistor 11a becomes able to pass the current programmed.

After the programming period, off-voltage is applied to gate signal line 17a to render transistor 11c into off-state thereby disconnecting driving transistor 11a from source signal line 18. Also, gate signal line 17c is applied with off voltage to render transistor 11b into off-state which is kept for a 1F period. On the other hand, gate signal line 17b is applied with on-voltage and off-voltage periodically. When combined with the N-fold driving method as shown in Figure 13 or 15 or the like or with the interlaced driving method, this driving method can realize better image display.

According to the driving method illustrated in Figure 52, capacitor 19 in the reset state holds the initiating voltage for causing current to start passing through transistor 11a (offset voltage or resetting voltage). For this reason, when the gate terminal (G) of transistor 11a is under application of the resetting voltage, the pixel is in the darkest black display state. However, unclear black (a drop in contrast) occurs due to the coupling between source signal line 18 and pixel 16, punch-through voltage reaching to capacitor 19 or punch through at transistors. Therefore, the driving method illustrated in Figure 52 cannot raise the display contrast.

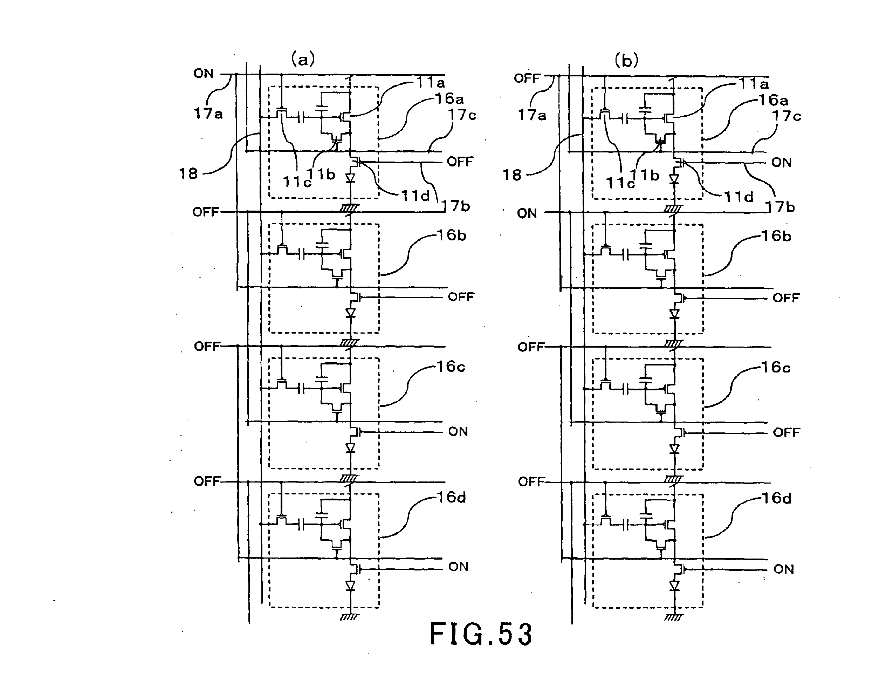

Transistor 11a needs to be turned off in order to apply reverse bias voltage Vm to EL device 15. Shortcircuiting the Vdd terminal and the gate terminal (G) of transistor 11a is sufficient to turn transistor 11a off. This feature will be described later with reference to Figure 53.

Alternatively, voltage Vdd or a voltage for causing transistor 11a to turn off may be applied to source signal line 18 to turn transistor 11b on, thereby applying such a voltage to the gate terminal (G) of transistor 11a. This voltage turns transistor 11a off (or into a state allowing little current to pass therethrough (i.e., a substantially off-state in which transistor 11a has a high impedance).) Thereafter, transistor 11g is turned on to apply reverse bias voltage to EL device 15. The application of reverse bias voltage Vm may be performed on all the pixels at a time. Specifically, source signal lines 18 are each applied with the voltage for causing transistor 11a to turn substantially off thereby turning on transistors 11b of all (plural) pixel rows. Accordingly, transistors 11a are turned off. Subsequently, transistors 11g are turned on to apply reverse bias voltage to EL devices 15. Thereafter, the pixel rows are sequentially applied with image signal, whereby the display apparatus displays an image.

The following description is directed to a reset driving method applied to the pixel configuration shown in Figure 51. Figure 53 illustrates an embodiment of the reset driving method. As shown in Figure 53, gate signal line 17a connected to the gate terminal (G) of transistor 11c of pixel 16a is also connected to the gate terminal (G) of resetting transistor 11b of pixel 16b of the succeeding row. Similarly, gate signal line 17a connected to the gate terminal (G) of transistor 11c of pixel 16b is also connected to the gate terminal (G) of resetting transistor 11b of pixel 16c of the succeeding row.

Accordingly, when on-voltage is applied to gate signal line 17a connected to the gate terminal (G) of transistor 11c of pixel 16a, pixel 16a is programmed with voltage, while at the same time the resetting transistor 11b of pixel 16a of the succeeding row is turned on to reset driving transistor 11a of pixel 16b. Similarly, when on-voltage is applied to gate signal line 17a connected to the gate terminal (G) of transistor 11c of pixel 16b, pixel 16b is programmed with current, while at the same time the resetting transistor 11b of pixel 16c of the succeeding row is turned on to reset driving transistor 11a of pixel 16c. In this way, reset driving based on the antecedent gate control method can be realized easily. Further, the number of gate signal lines routed from each pixel can be decreased.

More specific description follows. It is assumed that gate signal lines 17 are applied with respective voltages as shown in Figure 53(a); that is, gate signal line 17a of pixel 16a is applied with on-voltage, while gate signal lines 17a of other pixels 16 applied with off-voltage. It is also assumed that gate signal lines 17b of pixels 16a and 16b are applied with off-voltage, while gate signal lines 17b of pixels 16c and 16d applied with on-voltage.

Under these conditions, pixel 16a is in a state programmed with voltage and in the non-lighting state; pixel 16b is in a reset state and in the non-lighting state; pixel 16c is in a state holding the programming current and in the lighting state; and pixel 16d is in a state holding the programming current and in the lighting state.

After lapse of 1H, data in shift register circuit 61 of control gate driver 12 shifts by one bit, so that the state shown in Figure 53(b) results. Specifically, the state shown in Figure 53(b) is such that: pixel 16a is in a state holding the programming current and in the lighting state; pixel 16b is in a state programmed with current and in the non-lighting state; pixel 16c is in a reset state and in the non-lighting state; and pixel 16d is in a state holding the programming current and in the lighting state.

As can be understood from the above description, the voltage applied to gate signal line 17a of each pixel of a row of concern resets driving transistor 11a of each pixel of the succeeding row thereby rendering the pixel of the succeeding row ready for voltage-based programming in the next horizontal period. Thus, voltage-based programming is performed on pixel rows sequentially

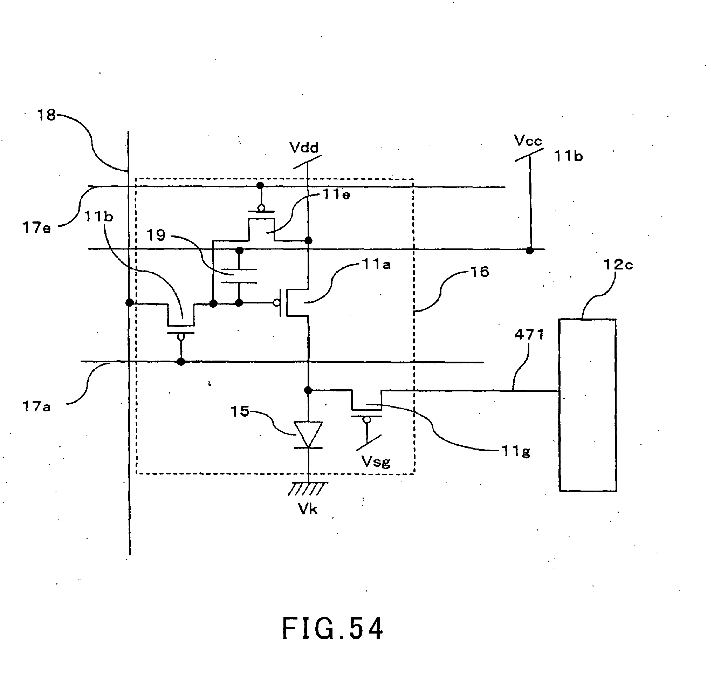

The antecedent gate control method can be implemented even with the voltage-based programming pixel configuration shown in Figure 43. Figure 54 shows an embodiment in which the pixel configuration of Figure 43 has connections adapted for the antecedent gate control method.

As shown in Figure 54, gate signal line 17a connected to the gate terminal (G) of transistor 11b of pixel 16a is also connected to the gate terminal (G) of resetting transistor 11e of pixel 16b of the succeeding row. Similarly, gate signal line 17a connected to the gate terminal (G) of transistor 11b of pixel 16b is also connected to the gate terminal (G) of resetting transistor 11e of pixel 16c of the succeeding row.

Accordingly, when on-voltage is applied to gate signal line 17a connected to the gate terminal (G) of transistor 11b of pixel 16a, pixel 16a becomes programmed with voltage, while at the same time resetting transistor 11e of pixel 16b of the succeeding row is turned on to reset driving transistor 11a of pixel 16b. Similarly, when on-voltage is applied to gate signal line 17a connected to the gate terminal (G) of transistor 11b of pixel 16b, pixel 16b becomes programmed with current, while at the same time resetting transistor 11e of pixel 16c of the succeeding row is turned on to reset driving transistor 11a of pixel 16c. In this way, reset driving based on the antecedent gate control method can be realized easily.

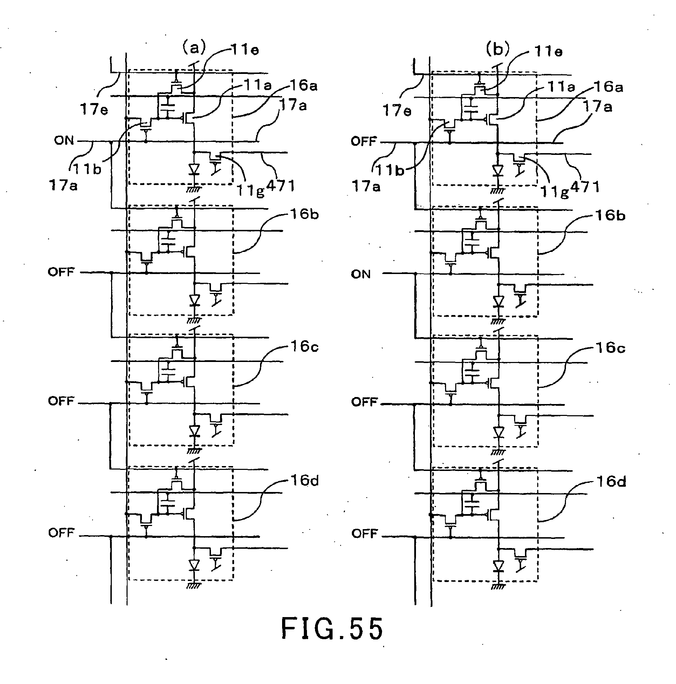

More specific description follows. It is assumed that gate signal lines 17 are applied with respective voltages as shown in Figure 55(a); that is, gate signal line 17a of pixel 16a is applied with on-voltage, while gate signal lines 17a of other pixels 16 applied with off-voltage. It is also assumed that all the reverse bias transistors 11g are off.

Under these conditions, pixel 16a is in a state programmed with voltage; pixel 16b is in a reset state; pixel 16c is in a state holding the programming current; and pixel 16d is in a state holding the programming current.

After lapse of 1H, data in shift register circuit 61 of control gate driver 12 shifts by one bit, so that the state shown in Figure 55(b) results. Specifically, the state shown in Figure 55(b) is such that: pixel 16a is in a state holding the programming current; pixel 16b is in a state programmed with current; pixel 16c is in a reset state; and pixel 16d is in a state holding the programming current.

As can be understood from the above description, the voltage applied to gate signal line 17a of each pixel of a row of concern resets driving transistor 11a of each pixel of the succeeding row thereby rendering the pixel of the succeeding row ready for voltage-based programming in the next horizontal period. Thus, voltage-based programming is performed on pixel rows sequentially.

When perfect black display is performed with a current-based driving method, the current programmed at the driving transistor 11 of each pixel is 0. That is, no current is passed from source driver 14. With no current, it is impossible to charge/discharge the parasitic capacitance produced in source signal line 18 as well as to vary the potential of source signal line 18. Accordingly, the gate potential of the driving transistor does not vary and, hence, capacitor 19 keeps on holding the potential as built one frame (field) (1F) before. For example, if a white display is given one frame before, the white display is maintained in the next frame even when a perfect black display is desired in the next frame. In order to solve this problem, the present invention has an arrangement such as to write source signal line 18 with a black-level voltage in the beginning of a one-horizontal scanning period (1H) and then output the programming current to source signal line 18. Assuming, for example, that picture image data has a gray level of from 0th to 7th which is close to the black level, a voltage corresponding to the black level is written for a predetermined time period in the beginning of a one-horizontal period. In this way, it becomes possible to reduce the burden on current-based driving and compensate for insufficient writing. Here, it is assumed that a 64-level gray scale display has the 0th level corresponding to a perfect black display and the 63rd level corresponding to a perfect white display.

The level at which precharge is to be performed has to be limited to within a black display range. Specifically, image data to be written is judged as to whether it has a level within the black display range (low luminance range, that is, the range in which the writing current is low (feeble) in the current-based driving method) and then the black range level is selected for precharge (selective precharge.) If precharge is performed for all levels of gray scale data, a drop in luminance (which means that a target luminance is not reached) occurs in the white display range. In addition, vertical streaks appear in the image displayed.

Preferably, selective precharge is performed within a 1/8 range from level 0 of gray scale data. (For example, if the gray scale data has 64 levels, precharge is performed for image data having a level ranging from the 0th to the 7th before the writing of the image data.) More preferably, selective precharge is performed within a 1/16 range from level 0 of gray scale data. (For example, if the gray scale data has 64 levels, precharge is performed for image data having a level ranging from the 0th to the third before the writing of the image data.)

In raising the contrast with a black display in particular, a method including detection of level 0 only for precharge is also effective. This method provides a very good black display. The problem essential to this method is that the screen is observed to have unclear black when the whole screen is of level 1 or 2. Thus, the selective precharge is performed within a 1/8 range from level 0 of gray scale data and within a fixed range.

It is also effective to vary the precharge voltage and the gray scale level range depending on R, G and B. This is because EL devices 15 for R, G and B are different from each other in luminescence initiating voltage and luminance of emission. For example, in the case of R, the selective precharge is performed within a 1/8 range from level 0 of gray scale data. (For example, if the gray scale data has 64 levels, precharge is performed for image data having a level ranging from the 0th to the 7th before the writing of the image data.) In the case of the other colors (G and B), control is made so that the selective precharge will be performed within a 1/16 range from level 0 of gray scale data. (For example, if the gray scale data has 64 levels, precharge is performed for image data having a level ranging from the 0th to the third before the writing of the image data.) Also, if the prechrage voltage for R is 7 (V), a voltage of 7.5 (V) is written to source signal line 18 as the precharge voltage for the other colors (G and B). The optimum precharge voltage often varies depending on production lots of EL display panel. Therefore, it is preferable to employ an arrangement capable of adjusting the precharge voltage by means of an external volume or the like. Such an adjustment circuit can be realized easily by the use of an electronic volume circuit.

Hereinafter, the source driver (circuit) 14 of the current driven type according to the present invention will be described. The source driver of the present invention serves to realize the aforementioned drive methods and drive circuits of the present invention. In addition, a drive method, a drive circuit, and a display device of the present invention are used in combination with each other. In the following description, it is described as an IC chip; however, this should not in any way be deemed restrictive. Needless to say, it may be fabricated on a display panel by means of a low-temperature polysilicon technique or other technique.

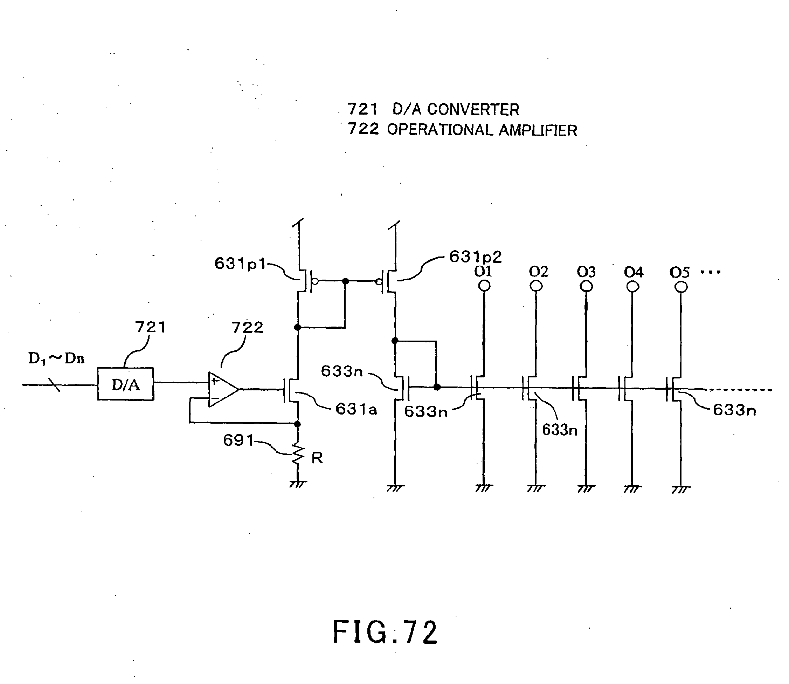

Referring first to Figure 72, there is illustrated an example of a driver circuit of the current driven type according to the present invention. In Figure 72, reference numeral 721 denotes a D/A converter. The D/A converter 721 is fed an n-bit data signal, and outputs, based on the input data, an analog signal. This analog signal is put into an operational amplifier 722. The operational amplifier 722 gives its output to an N channel transistor 631a, and a current flowing in the transistor 631a flows to a resistor 691. The terminal voltage of the resistor R becomes a minus (-) input of the operational amplifier 722, and this minus (-) terminal's voltage and the plus (+) terminal's voltage of the operational amplifier 722 are at the same level. Accordingly, the output voltage of the D/A converter 721 becomes the terminal voltage of the resistor 691.

Now, if the resistance value of the resistor 691 is 1 MΩ and, in addition, if the output of the D/A converter 721 is 1 (V), then a current of 1 (V)/1 MΩ = 1 (μA) flows through the resistor 691. This becomes a constant current circuit. Therefore, according to the data signal value, the analog output of the D/A converter 721 varies and, based on the value of the analog output, a given current flows in the resistor 691.

Transistors 631p1 and 631p2 form a current mirror circuit. These transistors 631p are transistors of the P channel type. On the other hand, N channel type transistors 633n are transistors forming a current mirror circuit. The same current flows also through the source-drain (SD) of the drive transistor 631a, and a current of the same value flows also through the current mirror circuit made up of the transistors 631p1 and 631p2, and a current of the same value flows also through the current mirror circuit made up of the transistors 633n. As a result, output terminals O1, O2, O3, O4, O5, and so on serve as constant current output terminals through which currents of the same value flows (when the current multiplying ratios are the same).

However, even for the case of ICs fabricated from the same mask on the basis of the same process, elemental devices such as transistors and capacitors which are formed on a semiconductor chip differ from each other in electrical characteristics, and even for the case of identical ICs, there are variations in output current between constant current output terminals. If, as described, there are variations in output current value between each constant current output terminal, this causes the light emitting elemental devices to vary in the amount of light emission, thereby creating display unevenness in the display panel. Accordingly, when activating an light emitting elemental device such as an organic EL display panel by the use of the driver IC14, it is required to hold variation in output current value between each constant current output terminal as low as possible.

Consequently, the driver IC (circuit)14 of the current driven type, provided with circuitry and a layout configuration capable of holding variation in output current value between each constant current output terminal as small as possible, is required.

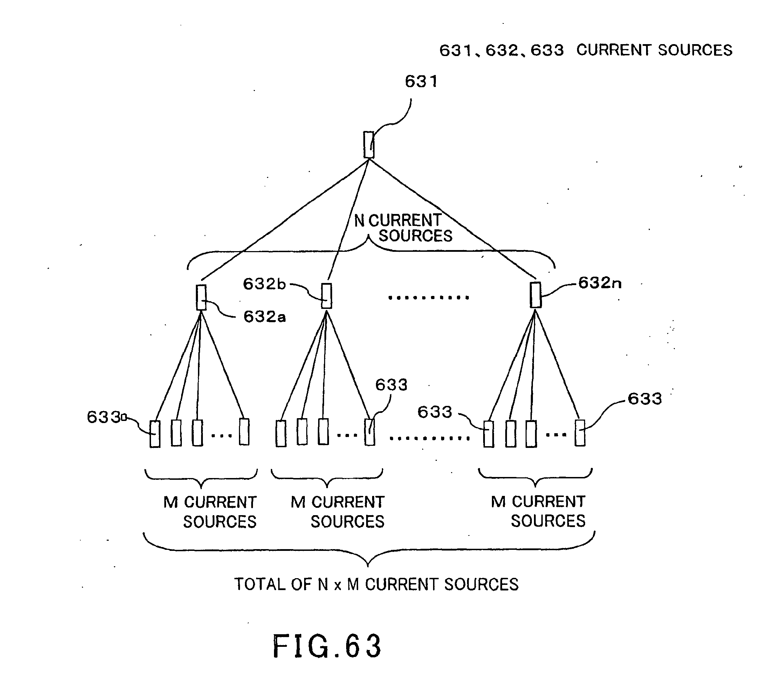

Referring to Figure 63, there is shown a constructional arrangement of the source driver (circuit)14 of the current driven type according to the present invention. Figure 63 shows, by way of example, a multistage type current mirror circuit made up of a current source of three stages, i.e., current sources (631, 632, 633).

Referring still to Figure 63, the current value of a first-stage current source 631 is copied to N second-stage current sources 632, where the number N is any integer, by a current mirror circuit. Further, the current value of each of the second-stage current sources 632 is copied to M third-stage current sources 633, where the number M is any integer, by a current mirror circuit. By virtue of such arrangement, resultingly the current value of the first-stage current source 631 is copied to the N x M third-stage current sources 633.

For example, when a source signal line 18 of the QCIF type display panel is activated by a single driver IC14, there are 176 outputs (because the source signal line requires 176 outputs for each of the colors R, G, and B). In this case, the number N is 16 and the number M is 11. Therefore, 16 x 11 = 176, thereby making it possible to deal with the requirement (i.e., 176 outputs). The arrangement that either one of the numbers N and M is 8 or 16, or a multiple thereof facilitates layout design of a driver IC's current source.

In the source driver of the current driven type (shown in Figure 72), the current value of the first-stage current source 631 is copied directly to the N x M third-stage current sources by a current mirror circuit. If there is a difference in transistor characteristics between the first-stage current source 631 and the third-stage current source, this directly gives rise to a variation in current value, and such current value variation appears as display unevenness in the display panel. The source driver 14, since it is shaped like a long narrow strip (about 2 mm in width and about 20 mm in length), undergoes a wide variation in transistor characteristic in the middle and at both ends, and it is considered that such problems are significant.

On the contrary to the above, in the source driver (circuit) 14 of the current driven type formed of the multi-stage current mirror circuit shown in Figure 63, as describe above, the current value of the first-stage current source 631 is not copied directly to the N x M third-stage current sources 633 by a current mirror circuit. Because of the intermediate provision of the second-stage current sources 632, it becomes possible to absorb variation in transistor characteristics.

Particularly, the present invention is characterized in that the first-current mirror circuit (the current source 631) and the second-stage current mirror circuit (the current source 632) are arranged closely to each other. If a 2-stage current mirror circuit configuration (i. e., the first- and third-stage current sources 631 and 632) is employed, this increases the number of third-stage current sources 633 that are brought into connection with the first-stage current source 631, thereby making it impossible to array the first- and second-stage current sources 631 and 633 closely to each other.

The source driver 14 of the present invention is designed so that the current of the first-stage current mirror circuit (the current source 631) is copied to the second-stage current mirror circuit (the current source 632) and, then, the current of the second-stage current mirror circuit (the current source 632) is copied to the third-stage current mirror circuit (the current source 632). In this configuration, the number of second-stage current mirror circuits (the current sources 632) that are brought into connection with the first-stage current mirror circuit (the current source 631) is less in comparison with the configuration of Figure 72. This therefore makes it possible to array the first-stage current mirror circuit (the current source 631) and the second-stage current mirror circuits (the current sources 632) closely to each other.

If transistors making up a current mirror circuit are arrayed closely to each other, this, of course, reduces transistor variation, thereby reducing variation in current value to be copied. In addition, the number of third-stage current mirror circuits (the current sources 633) that are brought into connection with the second-stage current mirror circuits (the current sources 632) is also diminished. This therefore makes it possible to dispose the second-stage current mirror circuits (the current sources 632) and the third-stage current mirror circuits (the current sources 633) closely to each other.

Stated another way, as a whole, it is possible to provide a dense layout of transistors at current receiving parts of the first to third stage current mirror circuits (the current sources 631, 632,633). Therefore, since transistors making up a current mirror circuit can be closely compacted together, this reduces transistor variation, thereby considerably reducing variation in current signal from the output terminals and achieving a high degree of accuracy.

In the present exemplary embodiment, for purposes of simplification, the description has been made in terms of the 3-stage current mirror circuit as a multi-stage current mirror circuit. Needless to say, as the number of current mirror circuit stages increases, variation in current flowing through the source driver 14 of the current driven type display panel is reduced. Accordingly, the number of current mirror circuit stages is not limited to three. The number of current mirror circuit stages may be three or more.

The term "current source" (the current sources 631, 632, 633) and the term "current mirror circuit", used in the present invention specification, are equivalent in meaning. That is to say, the current source is a basic constructional concept of the present invention. The current source is implemented practically by a current mirror circuit. Accordingly, the current source is not limited to a current mirror circuit. For example, the current mirror circuit may be made up of a combination of the operational amplifier 722, the transistor 631, and the resistor R, as shown in Figure 72.

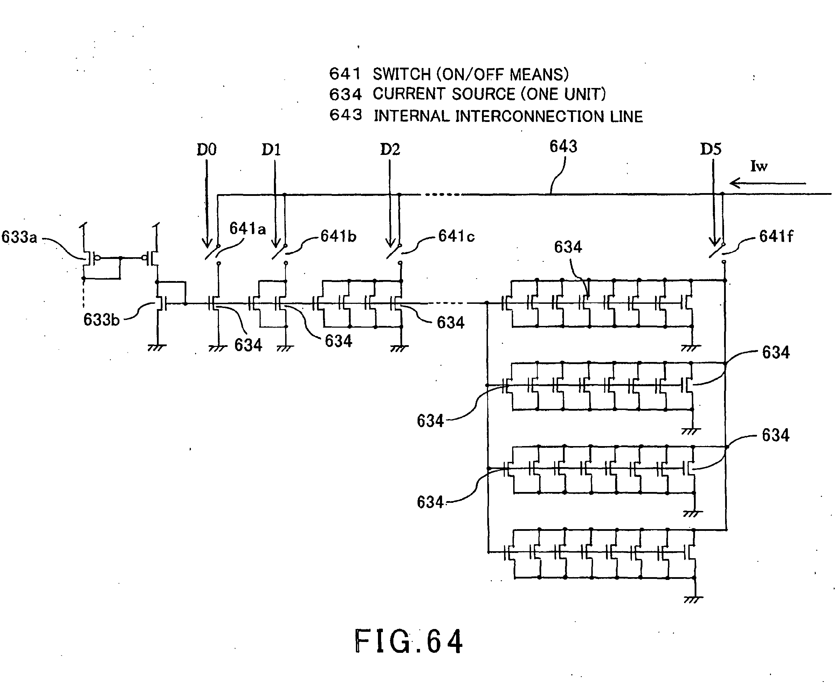

Referring to Figure 64, there is shown, in more specific manner, a constructional arrangement of the source driver (circuit) 14. Figure 64 shows a section of the third current source 633, i.e., a section which is brought into connection with a single source signal line 18. The final-stage current mirror circuit configuration is made up a plurality of current mirror circuits of the same size (the current sources 634 (one unit)), and the current mirror circuit count is bit-weighted according to the image data bit.

Additionally, the transistors making up the source driver (circuit) 14 are not limited to transistors of the MOS type. They may be of the bipolar type. In addition, other than the silicon semiconductor, GaAs semiconductor may be used. Furthermore, germanium semiconductor may be available. In addition, one, directly formed in a substrate by means of polysilicon technology such as low-temperature polysilicon technology or by means of amorphous silicon technology, may be used.

Referring to Figure 64, there is shown a 6-bit digital input case as an exemplary embodiment of the present invention. In other words, it is possible to display 64 gray scales because two to the sixth power ($2^6$) = 64. Placement of such a source driver 14 on an array substrate makes it possible to display about 260000 colors (64 x 64 x 64) because each of the colors R (red), G (green), and B (blue) is 64 gray scales.

In Figure 64, D0 indicates an LSB input and D5 indicates an MSB input. When the D0 input terminal is at HIGH level (at a positive logic level), the switch 641a (which is an ON/OFF means and which may be formed of a single transistor or implemented by an analog switch comprising a combination of a P channel transistor and an N channel transistor) turns on, upon which a current flows in the direction of a current source (one unit) 634 constituting a current mirror circuit. This current flows through an internal interconnection line 643 in the inside of the IC 14. Since the internal interconnection line 643 is connected to the source signal line 18 by way of a terminal electrode of the IC 14, the current flowing through the internal interconnection line 643 becomes a program current for the pixel 16.

When the D1 input terminal is at HIGH level (at a positive logic level), the switch 641b turns on, upon which a current flows in the direction of two current sources (one unit) 634 constituting a current mirror circuit. This current flows through the internal interconnection line 643 in the inside of the IC 14. Since the internal interconnection line 643 is connected to the source signal line 18 through the terminal electrode of the IC 14, the current flowing through the internal interconnection line 643 becomes a program current for the pixel 16.

The same is applied to the other switches 641. When the D2 input terminal is at HIGH level (at a positive logic level), the switch 641c turns on, upon which a current flows in the direction of four current sources (one unit) 634 constituting a current mirror circuit. When the D5 input terminal is at HIGH level (at a positive logic level), the switch 641f turns on, upon which a current flows in the direction of 32 current sources (one unit) 634 constituting a current mirror circuit.

As described above, in response to the data (D0 to D5) externally applied, a current flows toward a corresponding current source (one unit). Accordingly, it is configured such that a current flows toward zero to 63 current sources (one unit) in response to the data. For purposes of providing an easy understanding of the present invention, the number of current sources is 63 (the 6-bit case); however, this arrangement should not in any way be deemed restrictive. For the 8-bit case, it suffices if 255 unit current sources 634 are formed (or arranged). On the other hand, for the 4-bit case, it suffices if 15 unit current sources 634 are formed (or arranged). The transistors 634 constituting a unit current source have the same channel width (W) and the same channel length (L). By such a configuration formed by identical transistors, it becomes possible to construct an output stage which undergoes a less variation.

In addition, the aforesaid arrangement, in which all the current sources 634 supply respective flows of currents of the same level, should not in any way be deemed restrictive. For example, each current source 634 may be assigned a respective weight. For example, it may be arranged such that a current output circuit is composed of a mixture of a current source 634 (one unit), a current source 634 (assigned a twofold weight), and a current source 634 (assigned a fourfold weight).

However, when the current sources 634 are configured by weighting, each weighed current source 634 becomes out of the weighting ratio, thereby producing the possibility that there occur variations. Accordingly, even when the current sources are weighed, it is preferable that each current source is configured by forming a plurality of transistors each of which becomes a current source of one unit.

The size of a transistor making up the unit current source 634 is required to be greater than a certain level. As the transistor size decreases, the variation in output current increases. Here, by "the size of the transistor 634" is meant a size found by multiplication of L (the channel length) times W (the channel width). For example, if W = 3 $\mu$m and L = 4 $\mu$m, then the size of the transistor 634 constituting a single unit current source is: W x L = 12 square $\mu$m. As the transistor size decreases, the variation becomes wider, the possible reason for which is the influence of the crystal interface state of a silicon wafer. Therefore, if a single transistor is so formed as to extend over a plurality of crystal interfaces, this reduces variation in transistor output current.

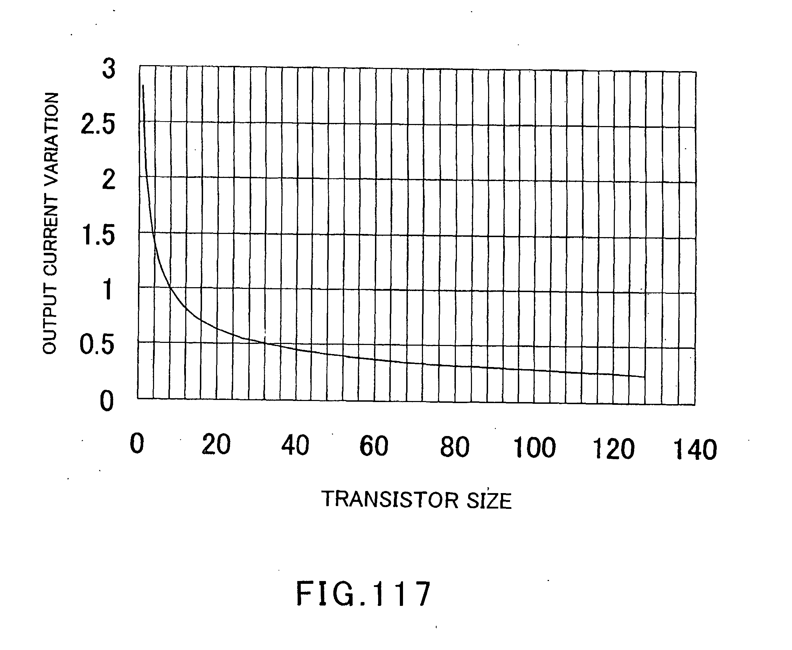

Referring now to Figure 117, there is shown a transistor size versus transistor output current variation relationship. In the Figure 117 graph, the horizontal axis indicates the transistor size (square $\mu$m). On the other hand, the vertical axis indicates the output current variation ($\sigma$) by %. The output current variation (%) was found as follows. A group composed of 63 unit current sources 634 was formed, in other words 63 unit transistors were formed. A plurality of such groups were formed on a wafer. Then, variations in output current were measured. The horizontal axis of the graph provides a representation by the size of a transistor constituting a single unit current source. However, the number of transistors arrayed in parallel is 63, and the actual area is 63 times greater than that. In the present invention, consideration, in which the size of the unit current source 634 was used as a unit, was made. Therefore, Figure 117 shows that the variation in output current thereat is 0.5 %, when 63 unit transistors (30 square $\mu$m) are

formed.

For the 64-gray-scale display, 100/64 = 1.5 %. Accordingly, it is required that the output current variation be within 1.5 %. As can be seen from Figure 117, in order for the output current variation to be within 1.5 %, it is required that the unit transistor has a size of not less than 2 square μm. For the 64-gray-scale display, 63 unit transistors of 2 square μm are operated. On the other hand, there are limits to the transistor size because the IC chip size increases and there are limits to the crosswise width per one output. In view of this, the upper limit of the size of the unit current source 634 is 300 square μm. Accordingly, for the 64-gray-scale display, it is required that the current source 634 has a size of not less than 2 nor more than 300 square μm.

For the 128-gray-scale display, 100/128 = 1 %. Accordingly, it is required that the output current variation be within 1 %. As can be seen from Figure 117, in order for the output current variation to be within 1 %, it is required that the unit transistor has a size of not less than 8 square μm. Accordingly, in the case of the 128-gray-scale display, it is required that the current source 634 has a size of not less than 8 nor more than 300 square μm.

Figure 117 is the variation data of 1σ. If 3σ serves as a reference, then (100/64)/3 = 0.5 % for the case of the 64-gray-scale display. Therefore, it is required that the variation in output current be within 0.5 %. As can be seen from Figure 117, in order for the output current variation to be within 0.5 %, it is required that the unit transistor has a size of not less than 30 square μm. On the other hand, there are limits to the transistor size. If 3σ is a reference, then it is required that the unit current source 634 has a size of not less than 30 nor more than 300 square μm for the 64-gray-scale display. Even when there occurs some variation, such variation will, in fact, not be recognized when the image is being displayed. For the 64-gray-scale display, the transistor size of not less than 15 nor more than 300 square μm (2σ level) is sufficient for practical use.

Generally, both a relation of $40 \leq K/(St)^{1/2}$ and a relation of $St \leq 300$ should be satisfied, where K is the number of gray scales and St is the size of the unit transistor 634 (square μm).

It is more preferable that a relation of $120 \leq K/(St)^{1/2}$ and a relation of $St \leq 300$ are satisfied.

The foregoing example is a case where 63 transistors are formed for the 64-gray-scale display. When constituting 64 gray scales with 127 unit transistors 634, the size of the unit transistor 634 is a size which a sum of two unit transistors 634. For example, if the size of the unit transistor 634 is 10 square μm and 127 unit transistors are formed for the 64-gray-scale display, then a column of 10 x 2 = 20 of Figure 117 should be referred to as a unit transistor size. Likewise, if the size of the unit transistor 634 is 10 square μm and 255 unit transistors are formed for the 64-gray-scale display, then a column of 10 x 4 = 40 of Figure 117 should be referred to as a unit transistor size.

The configuration of Figure 64 is a third-stage current mirror section depicted in Figure 63. Accordingly, the first-stage current source 631 is formed separately from the second-stage current source 632, and these current sources are arranged densely (closely or adjacently). Furthermore, the second-stage current source 632 and the current mirror circuit transistor 633a making up a third-stage current source are arranged densely (closely or adjacently).

In addition, particularly, the current sources (one unit) 634 are arranged densely and a minute current flows therethrough. Consequently, when the current source 634 (the other current sources 631, 632, 633 should also be considered) is illuminated with rays of light (luminescent light) emitted from the EL display panel or the like, this gives rise to an operational malfunction caused by the photoconductor phenomenon. In order to deal with this problem, a light shielding film is formed on an underside surface of the chip. Furthermore, a light shielding film is formed at a mounting area on the substrate and, in addition, at an area where a chip current source is formed (formation of a metal thin film or a light absorbing film made of organic or inorganic material on a surface of the panel substrate). If the light shielding film is formed by routing, under the IC chip, anode and cathode interconnection lines for the supply of current to the EL elemental device 15, this both facilitates formation of the light shielding film and cuts down costs. The use of this construction is not limited to the IC chip. The construction is applied to the source driver 14 by the use of low-temperature polysilicon technology, high-temperature polysilicon technology, CGS (semiconductor film formation by solid-phase growth) technology, or amorphous silicon technology. Stated another way, the light shielding film is formed on an underside surface of the source driver 14.

A current flowing in the second-stage current mirror circuit 632 is copied to the transistor 633a which constitutes a third-stage current mirror circuit and, when the current mirror current multiplying ratio is 1, this current flows through the transistor 633b. The current is copied to the final-stage transistor 634.

A section corresponding to D0, since it is formed by a single transistor 634, is at the value of a current flowing through the transistor 633 which is a final-stage current source. A section corresponding to D1, since it is formed by two transistors 634, is at a current value two times that of the final-stage current source. D2, since it is formed by four transistors 634, is at a current value four times that of the final-stage current source. Likewise, a section corresponding to D5, since it is formed by 32 transistors 634, is at a current value 32 times that of the final-stage current source. Accordingly, a program current Iw is outputted to the source signal line through the switches controlled by the image data of six bits D0, D1, D2, ..., D5 (current withdrawal). Therefore, in response to the ON/OFF of the 6-bit image data D0, D1, D2, ..., D5, currents at values one times, two times, four times, ..., 32 times that of the final-stage current source 633 are added together for outputting to the output line. Stated another way, by the 6-bit image data D0, D1, D2, ..., D5, current values from zero to 63 times that of the final-stage current source 633 are outputted from the output line. A current is drawn in from the source signal line 18.

The above-described integral multiple configuration of the final-stage current sources 633 makes it possible to control the value of current with a higher degree of accuracy in comparison with the conventional W/L proportional distribution, in other words any variation in output between each terminal will no longer occur.

However, this configuration is for the case where the drive TFT 11a which constitutes the pixel 16 is formed by a P channel transistor and, in addition, the current source (one unit) section 634 which constitutes the source driver 14 is formed by an N channel transistor. In other cases (for example in the case where the driver TFT 11a which constitutes the pixel 16 is formed by an N channel transistor), it is needless to say that it is possible to employ a configuration in which the program current Iw becomes a discharge current.

As described in the foregoing description, currents at values from zero to 63 times that of the final-stage current source 633 are outputted, for the current mirror multiplying ratio of the final-stage current source 633 = 1. When the current mirror multiplying ratio is 2, currents at values from zero to 126 times that of the final-stage current source 633 are outputted. When the current mirror multiplying ratio is 0.5, currents at values from zero to 31.5 times that of the final-stage current source 633 are outputted. As has been described above, in accordance with the present invention, the value of the output current can be changed easily by making a change in current mirror multiplying ratio of the final-stage current source 633 or by making a change in current mirror multiplying ratio of a current source (631, 632 et cetera) at a stage preceding to the final stage. In addition, with respect to this, it is preferable to make a change in current mirror multiplying ratio by color (R, G, and B). For example, only with respect to the color R, the current mirror multiplying ratio of any one of the current sources may be varied against the other color (against the current source circuit in association with the other color). Particularly, for the case of the EL display panel, the efficiency of luminescence differs from one color to another (R, G, and B, or cyan, yellow, and magenta). Accordingly, better white balance can be obtained by making a change in current mirror multiplying ratio for each color.

The arrangement that the current mirror multiplying ratio of the current source is varied against a different color (against the current source circuit associated with a different color) is not limited to a fixed one. It includes a variable one. Such a variable one is realized by forming a plurality of transistors constituting a current mirror circuit and by changing the number of transistors by which a current flows in response to an external signal. Such arrangement makes it possible to achieve optimal white balance control while observing the state of luminescence of each color of the EL display panel fabricated. Especially, the present invention provides a configuration in which current sources (current mirror circuits) are coupled in a multi-stage fashion. Accordingly, by making a change in current mirror multiplying ratio between the first-stage current source 631 and the second-stage current source 632, output currents from many outputs can be varied easily with a less number of connections (current mirror circuits et cetera). Of course, it is needless to say that, when compared to the case where there is made a change in current mirror multiplying ratio between the second-stage current source 632 and the third-stage current source 633, output currents from many outputs can be varied easily with a much less number of connections (current mirror circuits et cetera).

It should be noted that the concept of making a change in current mirror multiplying ratio is to make variation (adjustment) in current multiplying ratio. Therefore, the concept is not limited to current mirror circuits. For example, the concept is realized in a current output operational amplifier circuit, a current output D/A circuit or the like.

Needless to say, the arrangements as describe above are applicable to other exemplary embodiments of the present invention.

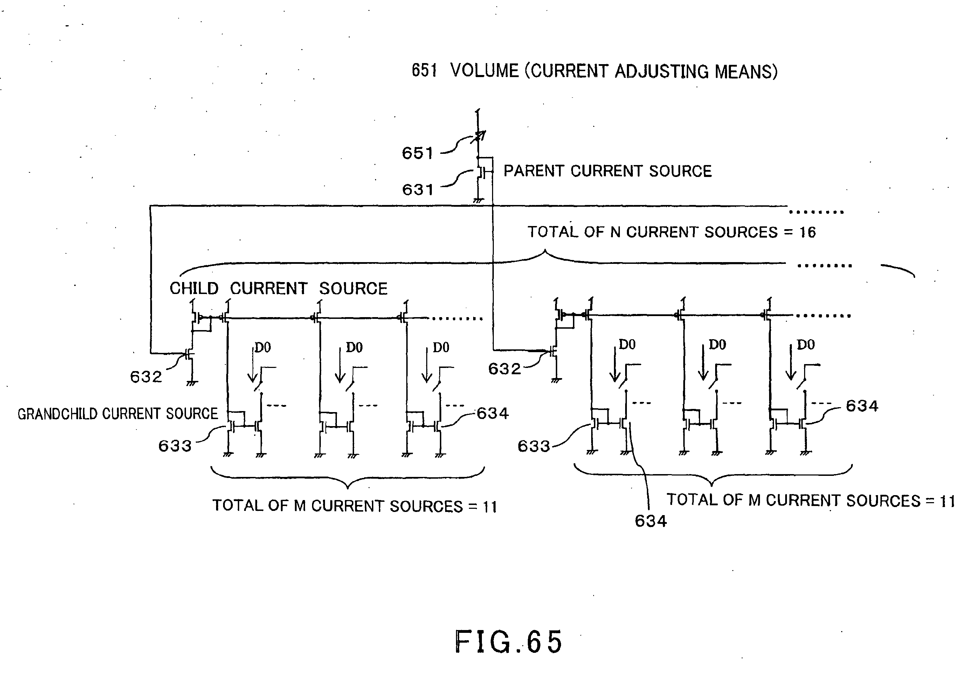

Referring to Figure 65, there is shown a diagram illustrating an example of a 176-output (N x M = 176) circuit which is a 3-stage current mirror circuit. In Figure 65, the current source 631 as a first-stage current mirror circuit is a "parent" current source, and the current source 632 as a second-stage current mirror circuit is a "child" current source, and the current source 633 as a third-stage current mirror circuit is a "grandchild" current mirror circuit. By virtue of the integral multiple configuration of the current sources formed by the third-stage current mirror circuits (i.e., the final-stage current mirror circuits), it becomes possible to reduce variation in the 176 outputs as much as possible, thereby making it possible to produce high-accuracy current outputs. Of course, it is important to remember that the current sources 631, 632, 633 are arranged densely.

Here, by "'arranged densely" is meant such an arrangement that the distance between the first-stage current source 631 and the second-stage current source 632 (the current (voltage) output side and the current (voltage) input side) does not exceed 8 mm at least. More preferably, the distance does not exceed 5 mm. According to the study, within such a distance range, the difference in characteristic (Vt, mobility ($\mu$)) between transistors arranged in the silicon chip hardly occurs. In addition, likewise, the second-stage current source 632 and the third-stage current source 633 (between the current output side and the current input side) are arranged such that the distance between the second-stage current source 632 and the third-stage current source 633 does not exceed 8 mm at least. More preferably, these transistors are arranged such that the distance between them does not exceed 5 mm. Needless to say, the above-described arrangement is applicable to other exemplary embodiments of the present invention.

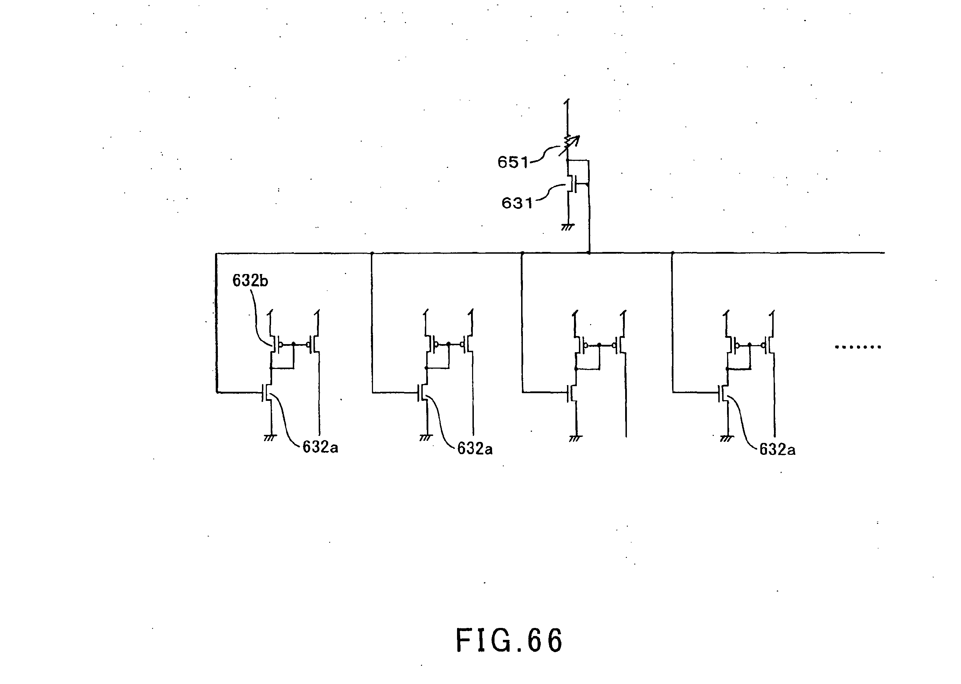

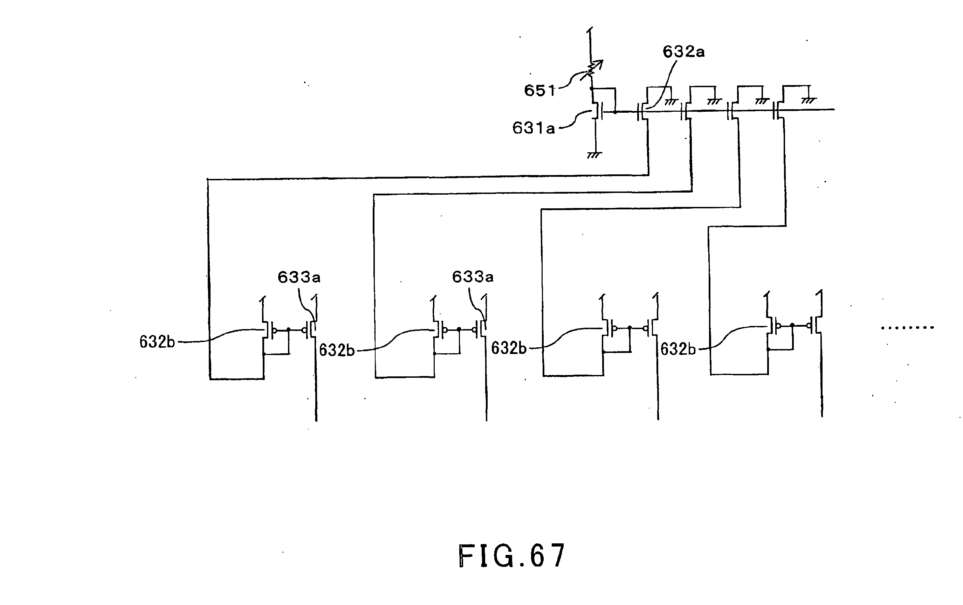

By "current (voltage) output side" and by "current (voltage) input side" are meant the following. The voltage transfer of Figure 66 relates to an arrangement in which the (I)th-stage current source transistor 631 (the output side) and the (I + 1)th-stage current source transistors 632a (the input side) are arrayed densely. The voltage transfer of Figure 67 relates to an arrangement in which the (I)th-stage current source transistor 631a (the output side) and the (I + 1)th-stage current source transistors 632b (the input side) are arrayed densely.

In Figures 65 and 66, the number of transistors 631 is one; however, this arrangement should not in any way be deemed restrictive. For example, it may be arranged such that, after forming a plurality of small transistors 631, they are connected, via their source or drain terminals, to the resistor 651. It is possible to reduce transistor variation by connecting a plurality of small transistors in parallel.

Likewise, the number of transistors 632a is one; however, this arrangement should not in any way be deemed restrictive. For example, it may be arranged such that, after forming a plurality of small transistors 631a, they are connected, via their gate terminals, to the gate terminal of the transistor 631. It is possible to reduce the difference between the transistors 632a by connecting a plurality of small transistors in parallel.

To sum up, as the configuration of the present invention, there are exemplarily shown the following arrangements, namely a first arrangement in which a single transistor 631 and a plurality of transistors 632a are connected; a second arrangement in which a plurality of transistors 631 and a single transistor 632a are connected; and a third arrangement in which a plurality of transistors 631 and a plurality of transistors 632a are connected.

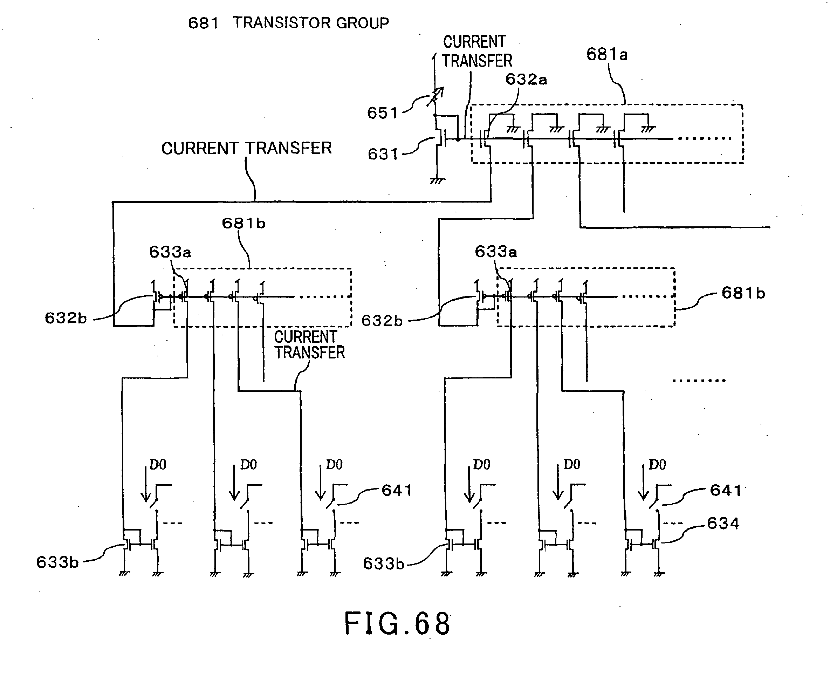

The above-described arrangement is applicable to the configuration of the transistors 633a and 633b (see Figure 68). There are exemplarily shown the following arrangements, namely a first arrangement in which a single transistor 633a and a plurality of transistors 633b are connected; a second arrangement in which a plurality of transistors 633a and a single transistor 633b are connected; and a third arrangement in which a plurality of transistors 633a and a plurality of transistors 633b are connected. This is because variation between the transistors 633 is reduced by connecting a plurality of small transistors 633 in parallel.

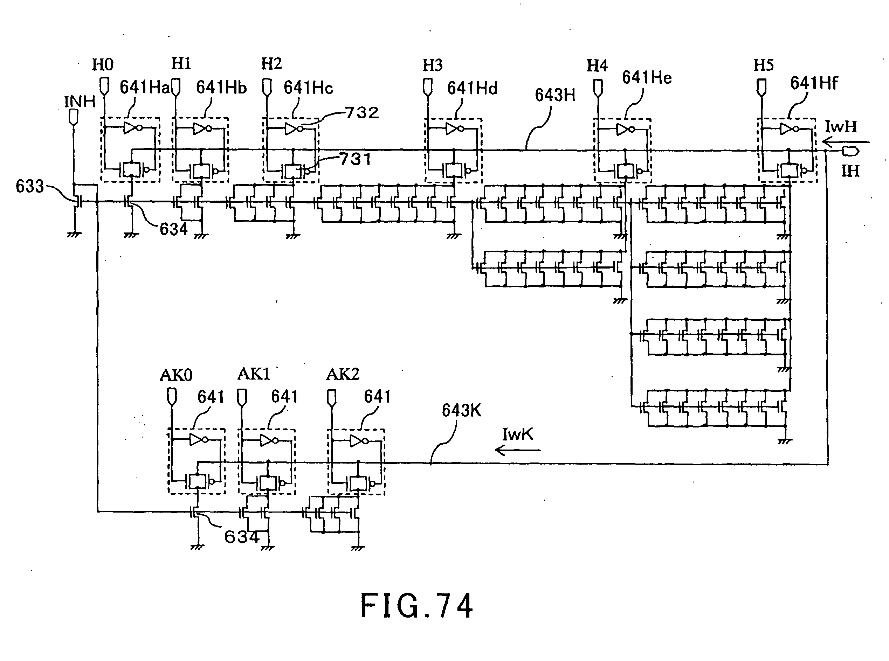

The above-described arrangement is applicable to the relationship between the transistor 632a and the transistor 632b (Figure 68). In addition, preferably the transistor 633b of Figure 64 is also formed by a plurality of transistors. Likewise, preferably the transistor 633 of Figure 74 is also formed by a plurality of transistors.

Here, by "silicon chip" is meant a semiconductor chip including a chip formed in a gallium substrate and other semiconductor chip formed in, for example, a germanium substrate.

Furthermore, it is applied to a source driver by means of low-temperature polysilicon, high-temperature polysilicon, semiconductor film (CGS) formed by solid-phase growth, or amorphous silicon technology. However, in this case, the panel size is relatively large in most cases. Even when there is some variation in output from the source signal line 18, such variation is unsusceptible to being recognized visually if the panel size is large. Accordingly, in a display panel in which pixel TFTs are formed in a glass substrate simultaneously with formation of the source driver 14, by "arranged densely" is meant such an arrangement that the distance between the first-stage current source 631 and the second-stage current source 632 (the current output side and the current input side) does not exceed 30 mm at least. More preferably, the distance does not exceed 5 mm. According to the study, the difference in characteristic (Vt, mobility ($\mu$)) between transistors arrayed within such a distance range hardly occurs. In addition, likewise, the distance between the second-stage current source 632 and the third-stage current source 633 (the current output side and the current input side) does not exceed 30 mm at least. More preferably, the distance does not exceed 5 mm.

In the foregoing description, for the sake of providing an easy understanding or for the sake of simplification, it is described such that signals are transferred between current mirror circuits in voltage form. However, by employing a current transfer configuration, it becomes possible to realize a drive driver circuit (IC) for a current driven type display panel with less variation.

Referring to Figure 67, there is shown an exemplary embodiment of the current transfer configuration. Figure 66 relates to an exemplary embodiment of the voltage transfer configuration. Figure 66 and Figure 67 are identical circuit diagrams but have different layout arrangements, in other words they differ from each other in interconnection line routing. In Figure 66, reference numeral 631 denotes an Nch transistor for the first-stage current source, and reference numeral 632a denotes an Nch transistor for the second-stage current source, and reference numeral 632b denotes a Pch transistor for the second-stage current source.

In Figure 67, reference numeral 631a denotes an Nch transistor for the first-stage current source, and reference numeral 632a denotes an Nch transistor for the second-stage current source, and reference numeral 632b denotes a Pch transistor for the second-stage current source.

Figure 66 shows a layout arrangement of the voltage transfer type in which the gate voltage of the first-stage current source made up of the variable resistor 651 (which is used for current variation) and the Nch transistor 631 is transferred to the gate of the Nch transistor 632a for the second-stage current source.

On the other hand, Figure 67 shows a layout arrangement of the current transfer type in which the gate voltage of the first-stage current source made up of the variable resistor 651 and the Nch transistor 631a is applied to the gate of the adjacent Nch transistor 632a of the second-stage current source, as a result of which the value of a current flowing through the transistor is transferred to the Pch transistor 632b of the second-stage current source.

In the exemplary embodiment of the present invention, the description has been made focusing attention on the relationship between the first current source and the second current source for the sake of simplification and for the sake of providing an easy understanding, which should not in any way be deemed restrictive. Needless to say, the present invention is applied (applicable) to the relationship between the second current source and the third current source or to the relationship between other different current sources.

In the layout arrangement of the current mirror circuit of the voltage transfer type (see Figure 66), the Nch transistor 631 of the first-stage current source constituting a current mirror circuit and the Nch transistor 632a of the second-stage current source are some distance from each other (or they are likely to separate from each other), as a result of which these transistors 631 and 632a are likely to differ from each other in their transistor characteristics. Consequently, the current value of the first-stage current source is not transferred exactly to the second-stage current source, and variations are likely to occur.

Contrary to the above, in the layout arrangement of the current mirror circuit of the current transfer type (see Figure 67), the Nch transistor 631a of the first-stage current source constituting a current mirror circuit and the Nch transistor 632a of the second-stage current source are next to each other (they are easily arranged next to each other), as a result of which these transistors 631a and 632a are unsusceptible to being differing from each other in their transistor characteristics. Consequently, the current value of the first-stage current source is transferred exactly to the second-stage current source, and variations are unlikely to occur.

In view of the above, preferably the multi-stage current mirror circuit of the present invention (the source driver (IC) 14 of the current driven type of the present invention) employs, as its circuitry, not a voltage transfer layout arrangement but a current transfer layout arrangement because the latter is able to reduce the variation. It is needless to say that the foregoing exemplary embodiment is applicable to other exemplary embodiments of the present invention.

For the sake of descriptive convenience, the "from the first-stage current source to the second-stage current source" case is discussed; however, it is needless to say that the same is applied to the "from the second-stage current source to the third-stage current source" case, the "from the third-stage current source to the fourth-stage current source" case, and so on.

Referring to Figure 68, there is shown an example in which a current mirror circuit having a 3-stage configuration (i.e., a current source having a 3-stage configuration) shown in Figure 65 is of the current transfer type. Figure 65 shows a circuit configuration of the voltage transfer type.

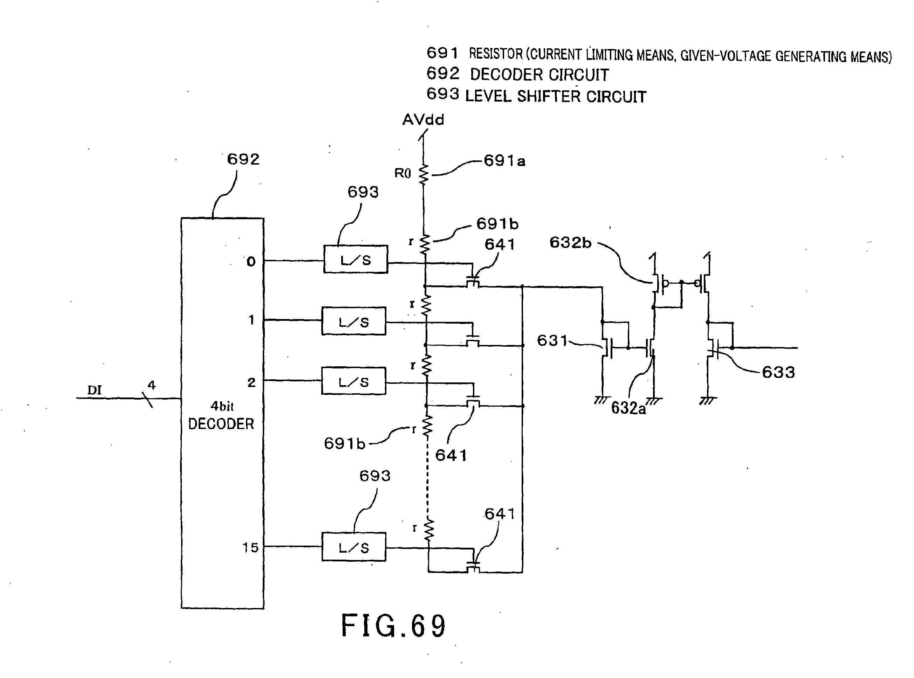

Referring to Figure 68, a reference current (a reference signal) is first generated by the variable resistor 651 and the Nch transistor 631. Although it is described such that the reference current is adjusted by the variable resistor 651, actually it is configured such that the source voltage of the transistor 631 is set and controlled by an electronic volume circuit formed (arranged) in the source driver (circuit) 14. Alternatively, adjustment of the reference current may be carried out by direct supply of a current, outputted from an electronic volume circuit of the current type made up of a large number of current sources (one unit) 634 as shown in Figure 64, to the source terminal of the transistor 631 (see Figure 69).

The gate voltage of the first-stage current source formed by the transistor 631 is applied to the gate of the Nch transistor 632a of the second-stage current source situated next to the transistor 631, as a result of which the value of a current flowing in the transistor is passed to the Pch transistor 632b of the second-stage current source. In addition, the gate voltage of the transistor 632b of the second-stage current source is applied to the gate of the Nch transistor 633a of third-stage current source situated next to the transistor 632b, as a result of which the value of a current flowing in the transistor is passed to the Nch transistor 633b of the third-stage current source. A large number of current sources 634 are formed (arranged) at the gate of the Nch transistor 633b of the third-stage current source according to the required number of bits.

Figure 69 is characterized in that the first-stage current source 631 of the aforesaid multi-stage current mirror circuit is provided with a current value adjusting element. As a result of such arrangement, it becomes possible to control output currents by varying the current value of the first-stage current source 631.

The Vt variation (characteristic variation) of the transistor is a variation of about 100 mV in a single wafer. However, the Vt variation between transistors which are formed in close proximity to each other (within 100 micrometers) does not exceed 10 mV (by actual measurement). Stated another way, the variation in output current of the current mirror circuit is reduced by forming transistors in close proximity to each other to constitute a current mirror circuit. Accordingly, it is possible to reduce variation in output current of each terminal of the source driver.

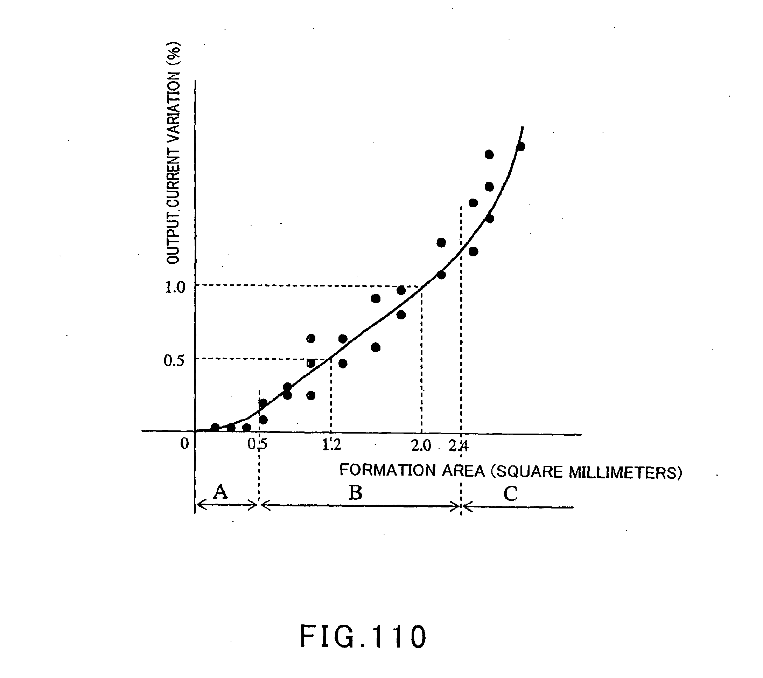

Referring to Figure 110, there are graphically shown measurement results for the transistor formation area (square mm) versus single transistor's output current variation (3σ) relationship. The output current variation is a current variation at a voltage of Vt. Black spot symbols represent transistor output current variations for evaluation samples (from 10 to 200 evaluation samples) fabricated within a predetermined formation area. There is almost no variation of the output current among the transistors formed within Region A (formation area: within 0.5 square mm), in other words there is only an output current variation within the error span, so that a constant output current is outputted. On the other hand, in Region C (formation area: not less than 2.4 square mm), the variation in output current with respect to the formation area tends to increase abruptly. In Region B (formation area: not less than 0.5 nor more than 2.4 square mm), the variation in output current with respect to the formation area is almost in a proportional relationship.

It should be noted that the output current absolute value differs from one wafer to another. However, such a problem can be dealt with by adjustment of the reference current or by maintaining the reference current at a predetermined value in the source driver (IC) 14 of the present invention. In addition, it is possible to solve or deal with the problem by the devising of a circuit (e.g., a current mirror circuit).

In the present invention, the number of currents flowing through the unit transistor 634 is switched by the input digital data (D), whereby the amount of current flowing through the source signal line 18 is varied (controlled). If the number of gray scales is 64 or more, then theoretically it is required that the variation in output current falls within the range from 1 to 2 % because 1/64 = 0.015. Output current variations within 1 % are difficult to recognize visually and output variations within 0.5 % are almost impossible to recognize (in other words, viewed evenly).

In order to hold the output current variation (%) within 1 %, it is required that a group of transistors (transistors to be variation-suppressed) be formed in an area within 2 square mm (see the results shown in Figure 110). More preferably, the output current variation (i.e., the transistor Vt variation) does not exceed 0.5 %. As shown by the results of Figure 110, it suffices if the formation area of the transistor group 681 does not exceed 1.2 square mm. The formation area is found by: a longitudinal length times a crosswise length. For example, 1. 2 square mm is: 1 mm times 1.2 mm.

The above is especially for the case of 8 bits (256 gray scales) or more. For the case of not more than 256 gray scales, e.g., for the case of 6 bits (64 gray scales), the output current variation may be about 2 % (there are no practical problems with image display). In this case, it suffices if the transistor group 681 is formed in an area within 5 square mm. In addition, there is no need for both the transistor groups 681 (in Figure 68, there are shown two transistor groups, i.e., transistor groups 681a and 681b) to satisfy this condition. The effects of the present invention are brought out when at least one of the two transistor groups (when the number of transistor groups 681 is three, at least one or more of the three transistor groups 681) is so configured as to satisfy the condition. It is particularly preferable that such a condition is satisfied by a low-order transistor group (the transistor group 681a is a high-order one while the transistor group 681b is a low-order one), thereby making image display unsusceptible to problems.

The above-described arrangements are applied to other exemplary embodiments of the present invention, and can be combined with a display panel, array, and display device of the present invention.

As shown in Figure 68, in the source driver (IC) 14 of the present invention, at least a plurality of current sources (parent, child, and grandchild current sources) are multi-stage connected so that they are arrayed densely (of course, 2-stage connection of parent and child current sources can be employed). In addition, currents are transferred between current sources (between the transistors groups 681). More specifically, the area surrounded by dotted line of Figure 68 (the transistor groups 681) is a transistor densely arranged area. The transistor groups 681 are in a voltage transfer relationship. In addition, the parent current source 631 and the child current source 632a are formed or arranged substantially centrally in the source driver (IC chip) 14. This is because the distance between the transistors arranged laterally in the chip, i.e., the transistor 632a constituting a child current source and the transistor 632b constituting a child current source, can be made relatively short. In other words, the highest-order transistor group 681a is arranged substantially centrally in the IC chip. And, the low-order transistor groups 681b are arranged laterally in the IC chip 14. More preferably, it is arranged, formed, or fabricated such that the number of low-order transistor groups 681b arranged on one side of the IC chip substantially equals the number of low-order transistor groups 681b arranged on the other side. The above arrangements are not limitedly applied to the IC chip 14. For example, they are applied to the source driver 14 that is formed directly in the substrate 71 by a low or high-temperature polysilicon technique. The same applies to other arrangements.

In accordance with the present invention, a single transistor group 681a is configured, arranged, formed or fabricated substantially centrally in the IC chip 14, and eight transistor groups 681b are formed laterally in the chip (N = 8 + 8, see Figure 63). It is preferable that the number of child transistor groups 681b on one side of the chip equals that of child transistor groups 681b on the other side, or that the difference between the number of child transistor groups 681b formed or arranged on the right side of the parent transistor group formed centrally in the chip and the number of child transistor groups 681b formed or arranged on the left side of the parent transistor group is within four. More preferably, the difference between the number of child transistor groups 681b formed or arranged on the right side of the chip and the number of child transistor groups 681b formed or arranged on the left side of the chip does not exceed one. The same is applied likewise to the grandchild transistor groups (not shown in Figure 68).

There is a voltage transfer (a voltage connection) between the parent current source 631 and the child current source 632a, therefore being susceptible to the transistor Vt variation. In order to cope with this, the area of the transistor group 681a is a transistor densely arranged area. Preferably, the formation area of the transistor group 681a is within 2 square mm, as shown in Figure 110. More preferably the formation area is within 1.2 square mm. Needless to say, in the case where the number of gray scales is not more than 64, it suffices if the area does not exceed 5 square mm.

Since the transfer of data between the transistor group 681a and the child transistor 632b is carried out by current (current transfer), it does not matter that there is some distance between the transistor group 681a and the child transistor 632b. As discussed above, the range of such a distance (e.g., the distance from an output terminal of the high-order transistor group 681a to an input terminal of the low-order transistor 681b) does not exceed 10 mm at least, in other words the transistor 632a constituting a second current source (child) and the transistor 632b constituting a second current source (child) are located not more than 10 mm apart. Preferably the transistors 632a and 632b are located not more than 8 mm apart. More preferably the transistors 632a and 632b are located not more than 5 mm apart. This is because the study shows that, within such a range, the characteristic difference (Vt, mobility ($\mu$)) among transistors arranged within the silicon chip has little influence on the current transfer. Especially, this relationship is established preferably in the low-order transistor groups. For example, if it is arranged such that the transistor group 681a is of the high order; the transistor group 681b is of the order lower than the transistor group 681a; and the transistor group 681c is of the order lower than the transistor group 681b, then the transfer of current between the transistor group 681b and the transistor group 681c satisfies the aforesaid relationship. This means that the present invention is not limited to such arrangement that all the transistor groups 681 satisfy the relationship, in other words, it suffices if at least a single transistor group 681 satisfies the relationship, because the number of transistor groups 681 increases as the order decreases.

The same is applied to the transistor 633a constituting a third current source (grandchild) as well as to the transistor 633b constituting a third current source, and is nearly applicable as for the voltage transfer.

The transistor group 681b is formed, fabricated, or arranged laterally in the chip (in the longitudinal direction, i.e., at a position opposing to the output terminal 761). The number (M) of transistor groups 681b is eleven in the present invention (see Figure 63).

Voltage transfer (voltage connection) is made between the child current source 632b and the grandchild current source 633a. Therefore, like the transistor group 681a, the section of the transistor group 681b is a transistor densely arranged area. The formation area of the transistor group 681b does not exceed 2 square mm, as shown in Figure 110, more preferably it does not exceed 1.2 square mm. If the Vt of this transistor group's 681b section varies even slightly, such Vt variation is susceptible to being recognized as an image. Therefore, it is preferable that the formation area does not exceed 0.5 square mm (Region A of Figure 110) so that there occurs little variation.

Since data transfer between the grandchild transistor 633a and the transistor 633b which constitute the transistor group 681b is established by means of current (current transfer), it is not objectionable that there is some distance between these transistors. The range of such a distance is the same as described above. The transistor 633a constituting a third current source (grandchild) and the transistor 633b constituting a second current source (grandchild) are located not more than 8 mm apart, more preferably not more than 5 mm apart.

Referring to Figure 69, there is shown an example in which the aforesaid current value control elemental device is implemented by an electronic volume circuit. The electronic volume circuit is made up of a resistor 691 (which generates a current limitation and each reference voltage and which is formed of polysilicon), a decoder 692, a level shifter 693, and other components. The electronic volume circuit outputs a current. The transistor 641 functions as an analog switch circuit.

In addition, the electronic volume circuit is formed or arranged according to the number of colors of the EL display panel For example, for the case of the three primary colors (R, G, and B), it is preferable that three electronic volume circuits associated with the colors R, G, and B respectively are formed or arranged, and that each color is controlled independently However, in the case where a single color is fixedly used as a reference, (the number of colors -1) electronic volume circuits are formed or arranged.

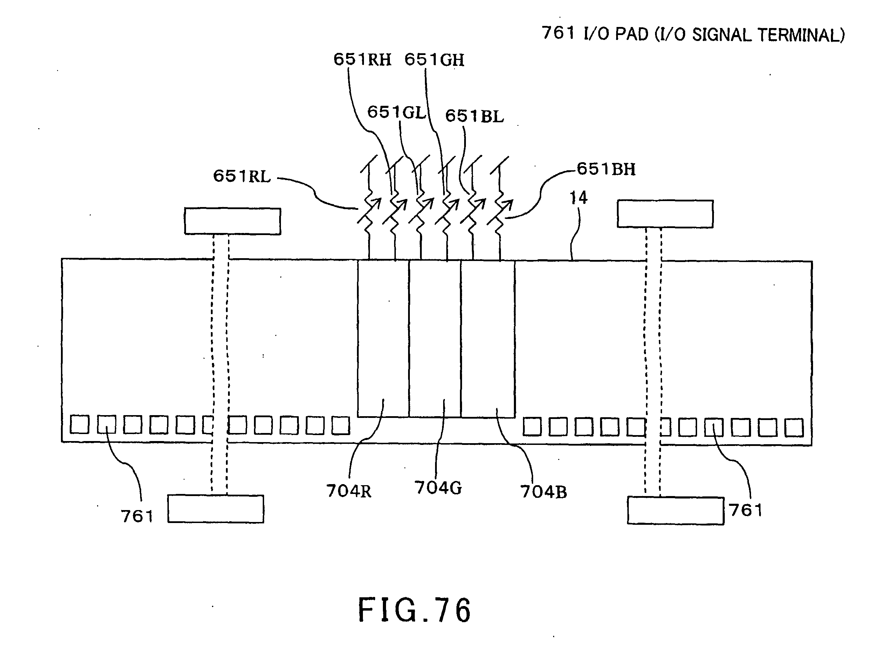

Referring to Figure 76, there is shown a constructional arrangement in which resistance elements 651 are formed or arranged for independent control of the reference current of the three primary colors R, G, and B. It is needless to say that the resistance element 651 is replaced by an electronic volume circuit. The basic current sources such as the parent and child current sources 631 and 632 are arrayed in a region shown in Figure 76 in close proximity with the current output circuits 704. Such dense arrangement reduces output variation between each source signal line 18. The arrangement that the current output circuit 704 is arranged centrally in the IC chip (circuit) 14 (see Figure 76) facilitates equal distribution of the current from the current sources 631 and 632 to either side of the IC chip (circuit) 14. Accordingly, lateral output variations are unlikely to occur.

However, the arrangement that the current output circuit 704 is situated in the middle should not in any way be deemed restrictive. For example, the current output circuit 704 may be formed at one end or both ends of the IC chip. In addition, the current output circuit 704 may be formed in parallel with an output-stage circuit.

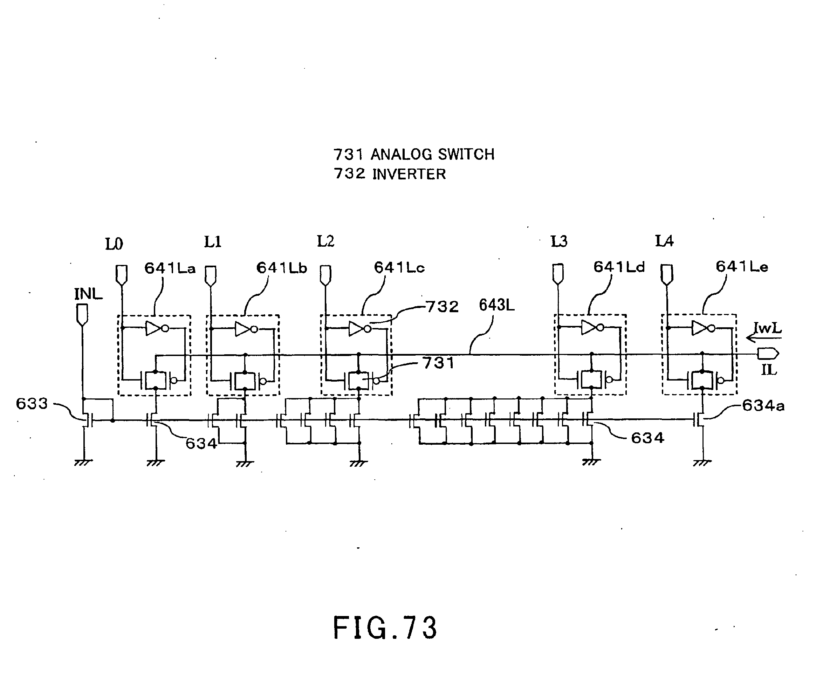

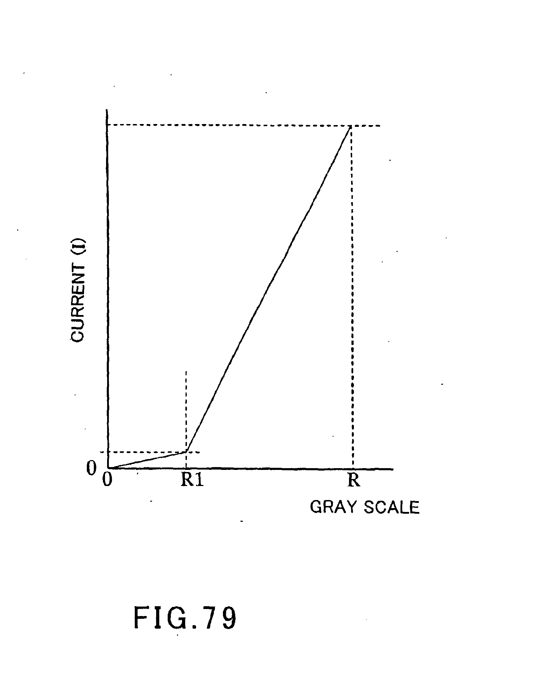

The current output circuit 704 is formed (arranged) for each of the colors R, G, and B and, in addition, these current output circuits 704R, 704G, 704B for the colors R, G, and B are also arranged in close proximity with each other. In addition, with respect to each color (R, G, and B), a reference current INL of the low current region shown in Figure 73 is adjusted and a reference current INH of the high current region shown in Figure 74 is adjusted (see also Figure 79). More specifically, a volume circuit (or an voltage or current output electronic volume circuit) 651RL for the adjustment of the reference current INL of the low current region, and a volume circuit (or an voltage or current output electronic volume circuit) 651RH for the adjustment of the reference current INH of the high current region are arranged in the current output circuit 704R for the color R. Likewise, a volume circuit (or an voltage or current output electronic volume circuit) 651GL for the adjustment of the reference current INL of the low current region, and a volume circuit (or an voltage or current output electronic volume circuit) 651GH for the adjustment of the reference current INH of the high current region are arranged in the current output circuit 704G for the color G. Furthermore, a volume circuit (or an voltage or current output electronic volume circuit) 651BL for the adjustment of the reference current INL of the low current region, and a volume circuit (or an voltage or current output electronic volume circuit) 651BH for the adjustment of the reference current INH of the high current region are arranged in the current output circuit 704B for the color B.

Preferably, the volume circuit 651 is so configured as to undergo a variation depending on temperature for compensation for the temperature characteristics of the EL elemental device 15. In addition, if there are two or more bending points in the gamma characteristic shown in Figure 79, three or more electronic volume circuits (or resistors) for the adjustment of the reference current of each of the colors R, G, and B, needless to say, may be provided.

An output pad 761 is either formed or arranged at the output terminal of the IC chip. This output pad and the source signal line 18 of the display panel are connected together. A bump (which is a projected portion) is formed in the output pad 761 by a plating technique or a nail head bonder technique. The bump has a height of not less than 10 nor more than 40 μm.

The aforesaid bump and each of the source signal lines 18 are connected together electrically through an electric conductive junction layer (not shown). The electric conductive junction layer is made of either a mixture of a base resin as an adhesive agent (e.g., an epoxy adhesive agent, a phenol adhesive agent et cetera) and flakes of silver (Ag), gold (Au), nickel (Ni), carbon (C), and tin oxide ($SnO_2$), or a UV cure resin. The electric conductive junction layer is formed on the bump by a transfer technique or other technique. In addition, the bump and the source signal line 18 are bonded together by thermo compression. The method of establishing connections between the bump or the output pad and the source signal line 18 is not limited to the above-described techniques. Film carrier technology may be used without mounting the IC 14 on the array substrate. In addition, connection with the source signal line 18 may be made by the use of a polyimide film.

Referring to Figure 69, the input 4-bit data (DI) for current value control is decoded in a 4-bit decoder circuit 692. If it is required that the division count be 64, then the input current value control data (DI) is, needless to say, comprised of 6 bits. Here, for the sake of simplification, a "4-bit" example will be described. Its output is pulled up from a voltage value of the logic level to a voltage value of the analog level by a level shifter circuit 693 and is fed to an analog switch 641.

A main constructional section of the electronic volume circuit is made up of a fixed resistor R0691a and 16 unit resistors r691b. The output of the decoder circuit 692 is connected to any one of the 16 analog switches 641, and it is configured such that the resistance value of the electronic volume circuit is determined by the output of the decoder circuit 692. Stated another way, for example, if the output of the decoder circuit 692 is 4, then the resistance value of the electronic volume circuit is: R0 + 5r. The resistance of the electronic volume circuit is a load to the first-stage current source 631 and is pulled up to the analog power supply AVdd. Therefore, when the resistance value of the electronic volume circuit undergoes a variation, the current value of the first-stage current source 631 varies. As a result, the current value of the second-stage current source 632 varies. Consequently, the current value of the third-stage current source 633 also varies. In this way, the output current of the driver IC is controlled.

For the sake of descriptive convenience, the current value control data is comprised of four bits; however, this arrangement should not in any way be deemed restrictive. Needless to say that, as the number of bits making up the current value control date increases, the number of variable current values increases. In addition, the description has been made in terms of the 3-stage current mirror circuitry as the multi-stage current mirror circuitry, which should not in any way be deemed restrictive. The number of stages may be selected at random.

Furthermore, to deal with the problem that the light emitting brightness of the EL elemental device varies when temperature varies, preferably an external resistor 691a whose resistance value varies with temperature is provided as an electronic volume circuit configuration. For example, a thermistor, posistor, or other thermally sensitive resistor may be used as the external resistor the resistance of which varies with temperature. Generally, an EL elemental device, whose brightness varies with current flowing therethrough, has temperature properties, and its light emitting brightness varies with temperature, even when a current of the same value flows. Tb deal with this, the resistor 691a whose resistance value varies with temperature is added to the electronic volume circuit, thereby making it possible to cause the current value of the constant current output to vary with temperature. As a result, even when temperature varies, it is possible to keep the light emitting brightness constant.

Preferably, the forgoing multi-stage current mirror circuit is divided into three systems for each of the colors red (R), for green (G), and for blue (B). Generally, a light emitting elemental device of the current driven type, such as an organic EL elemental device, has a respective luminescent characteristic for each of the colors R, G, and B. Therefore, in order for the colors R, G, and B to have the same brightness, it is necessary to perform separate control of the value of a current flowing through the light emitting elemental device with respect to each of the colors R, G, and B. In addition, in a light emitting elemental device of the current driven type such as an organic EL display panel, there is the difference in temperature characteristic among the colors R, G, and B. Accordingly, it is necessary to control the characteristics of an external auxiliary elemental device such as a thermistor which is formed or arranged for correction of the temperature characteristic of each of the colors R, G, and B.

In the present invention, since the multi-stage current mirror circuit is divided into three systems for each of the colors R, G, and B, this arrangement makes it possible to perform luminescent and temperature characteristic control for each of the colors R, G, and B to obtain an optimum white balance.

As previously described, in the current driven method, the current to be written into a pixel is small at the black display time. Because of this, if there exists a parasitic capacitance in the source signal line 18 or the like, this produces the problem that a sufficient current cannot be written into the pixel 16 for one horizontal scanning period (1H). In a typical light emitting elemental device of the current driven type, the black-level current value is weak (about several nA), so that it is difficult to drive a parasitic capacitance (wiring load capacitance) which seems to be about several tens of pF at its signal value. An effective way of solving this problem is as follows. That is, prior to the writing of image data to the source signal line 18, a pre-charge voltage is applied so that the level of potential of the source signal line 18 is at that of the black display current of the TFT 11a (basically, the TFT is in the OFF state). The outputting of a black-level constant voltage by decoding high-order bits of the image data is an effective way to form or produce such a pre-charge voltage.

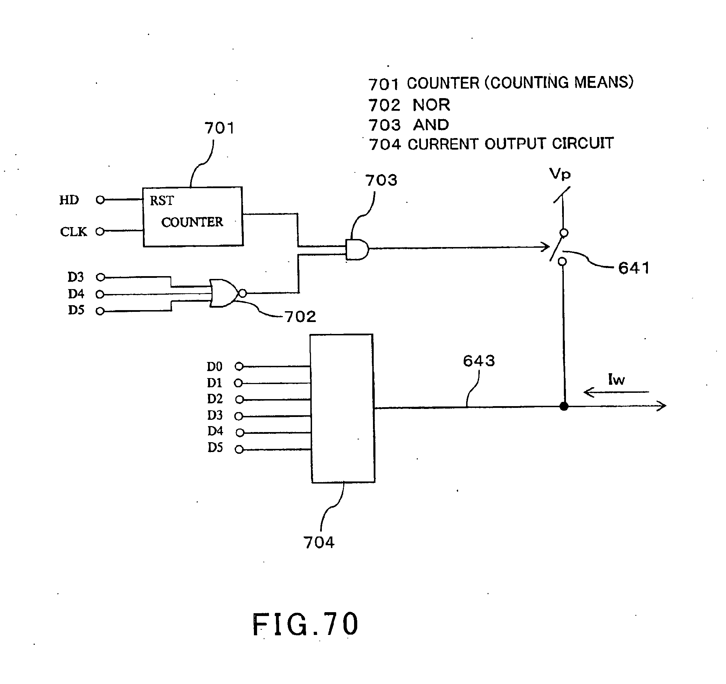

Referring to Figure 70; there is shown an example of the source driver (IC) 14 of the current output type of the present invention which has a pre-charge function. Figure 70 illustrates an example in which a 6-bit constant current output circuit is provided, at its output stage, with a pre-charge function. Referring to Figure 70, the precharge control signal is configured such that, in the case where three high-order bits D3, D4, D5 of the image data D0-D5 are all zero, the NOR circuit 702 decodes them and the AND circuit 703 ANDs an output from the NOR circuit 702 and an output from the counter circuit 701 of the dot clock CLK having a reset function by the horizontal synchronization signal HD, for outputting a black-level voltage Vp for a predetermined period of time. In other cases, a current outputted from the current output stage 704 (one described in Figure 68) is applied to the source signal line 18 (the program current Iw is absorbed from the source signal line 18). By virtue of such a configuration, when the image data is between the zeroth gray scale and the seventh gray scale, i.e., in proximity to the black level, a voltage corresponding to the black level is written only for a first certain period of the one horizontal period. As a result, the load of current driving is reduced, thereby making it possible to make compensation for lack of current writing. In addition, the complete black display is the zeroth gray scale while the complete white display is the sixty-third gray scale (for the 64-gray-scale display).

The gray scale for precharging should be limited to the black display region. In other words, write image data is judged, and a black region gray scale (low brightness, in other words a write current is small (very small) in the current driven method) is selected and precharging (selective precharging) is carried out. If precharging is performed on data of all the gray scales, this now causes the drop in brightness in the white display region, in other words it is impossible to attain a target brightness. Besides, vertical stripes will be displayed in the image.

Preferably, selective precharging is carried out at from the zeroth gray scale to the 1/8 region gray scale of the gray scale data (for example, for the case of 64 gray scales, precharging is carried out for image data of from the zeroth to the seventh gray scale before writing the image data). Furthermore, preferably selective precharging is carried out at from the zeroth gray scale to the 1/16 region gray scale of the gray scale data (for example, for the case of 64 gray scales, precharging is carried out for image data of from the zeroth to the third gray scale before writing the image data).

In order to increase contrast particularly during the black display time, a method, in which only the gray scale 0 is detected and precharging is carried out, is effective. This makes black display extremely excellent. However, the problem is that, when the entire screen looks like "black floating" for the gray scales 1 and 2. Accordingly, selective precharging is carried out for the gray scale 0 to the 1/8 region gray scale of the gray scale data in a given range.

It is effective that the colors R, G, and B differ from each other in precharge voltage and gray scale range. This is because the EL display elemental device 15 has a respective light emission start voltage and a respective light emission brightness for each of the colors R, G, and B. For example, for the case of the color R, at from the gray scale 0 to the 1/8 region gray scale of the gray scale data, selective precharging is carried out (for example, for the case of the 64-gray-scale display, precharging is carried out for image data of from the (01)th to the seventh gray scales before writing the image data. For the case of the other colors (i.e., the colors G and B), at from the gray scale 0 to the 1/16 region gray scale of the gray scale data, control such as selective precharging is carried out (for example, for the case of the 64-gray-scale display, precharging is carried out for image data of from the zeroth to the third gray scales before writing the image data). In addition, for the case of the color R, a precharge voltage of 7 (V) is written to the source signal line 18, while on the other hand for the case of each of the colors G and B, a precharge voltage of 7.5 (V) is written to the source signal line 18. Optimum precharge voltage varies from an EL display panel manufacture lot to another. Accordingly, it is preferable to employ such a configuration that the precharge voltage is adjustable by an external electronic volume circuit or the like. Such a type of adjustment circuit is easily realized by the use of an electronic volume circuit.

Preferably it is arranged such that five different modes (i.e., a zeroth mode in which no precharging is carried out at all, a first mode in which only the gray scale 0 is subjected to precharging, a second mode in which precharging is carried out in the range of from the gray scale 0 to the gray scale 3, a third mode in which precharging is carried out in the range of from the gray scale 0 to the gray scale 7, and a fourth mode in which precharging is carried out in the full gray scale range) are set, and that switching among these modes is established by a command. This can be realized easily by configuring (designing) a logic circuit in the source driver (IC) 14.

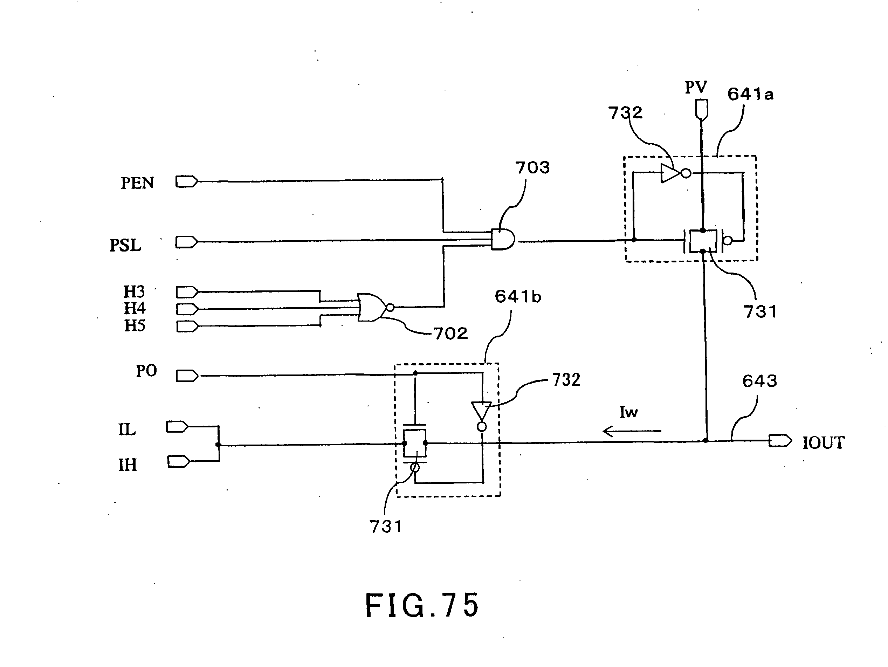

Referring to Figure 75, there is shown a constructional arrangement of an embodiment of a selective precharge circuit section. PV is an input terminal to which a precharge voltage is applied. A respective precharge voltage is set for each of the colors R, G, and B by an external input or by an electronic volume circuit; however, this arrangement should not in any way be deemed restrictive. The precharge voltage may be made common among the colors R, G, and B. This is because the precharge voltage correlates with the Vt of the drive TFT 11a of the pixel 16 and the pixel 16 is the same for each of the colors R, G, and B. On the contrary, in the case where the W/L ratio of the drive TFT 11a of the pixel 16 is made to vary with respect to each of the colors R, G, and B (designed differently), it is preferable that the precharge voltage is adjusted in association with a different design. For example, as the channel length (L) increases, the diode characteristics of the TFT 11a become worse, and the source-drain (SD) voltage increases. Consequently, it is required that the precharge voltage be set lower than the source potential (Vdd).

The precharge voltage PV is applied to the analog switch 731. It is required that the channel width (W) of the analog switch be not less than 10 µm for achieving a reduction in ON resistance. However, if the channel width (W) is excessively great, then a parasitic capacitance grows. Therefore, it should be arranged such that the channel width (W) does not exceed 100 µm, more preferably not less than 15 nor more than 60 µm. The above-described arrangements are applicable to the analog switch 731 of the switch 641b (Figure 75) and to the analog switch 731 of Figure 73.

The switch 641a is controlled by a precharge enable (PEN) signal, a selective precharge signal (PSL), and three high-order bits (H5, H4, H3) of the logic signal of Figure 74. The logic signal's three high-order bits (H5, H4, H3) are an example and it is arranged such that, when these three high-order bits are all "0", selective precharging is carried out. In other words, it is configured such that, when the three low-order bits are all "1", gray scales from the gray scale 0 to the gray scale 7 are selected and precharging is carried out.

It may be fixed such that only the gray scale 0 or a range from the gray scale 0 to the gray scale 7 is subjected to selective precharging. Alternatively, it may be arranged such that selective precharging is performed in conjunction with a low gray scale region. For example, selective precharging may be performed on a low gray scale region (a range from the gray scale 0 to the gray scale R1 or to the gray scale (R1-1)). Stated another way, when the low gray scale region is in a range from the gray scale 0 to the gray scale R1, selective precharging is performed within this range, while, when the low gray scale region is in a range from the gray scale 0 to the gray scale R2, selective precharging is performed in this range in conjunction therewith. This control method is able to provide a smaller hardware scale than other methods.

Depending on the application state of the signals, the switch 641a is subjected to ON/OFF control. When the switch 641a turns on, the precharge voltage PV is applied to the source signal line 18. The time, during which the precharge voltage PV is applied, is set by a separately-formed counter (not shown). This counter is so configured as to be set by a command. In addition, preferably the precharge voltage application time is set to be not less than 1/100 nor more than 1/5 of one horizontal scanning period (1H). For example, if 1H = 100 $\mu$ sec, then the precharge voltage application time is not less than 1 nor more than 20 $\mu$ sec. More preferably, the precharge voltage application time is not less than 2 nor more than 10 $\mu$ sec.

Furthermore, if the precharge voltage application time is varied with respect to each of the colors R, G, and B, this produces excellent results. For example, the precharge time for the color R is made longer than that of the colors G and B. This is because, in an organic EL elemental device or the like, materials for the colors R, G, and B differ in light emitting start time et cetera. In addition, if the precharge voltage PV application time is made variable by image data that is next applied to the source signal line 18, this also provides excellent results. For example, the application time is made longer at the gray scale 0 (the complete black display) while it is made shorter at the gray scale 4 than at the gray scale 0. In addition, setting of the application time in consideration of the difference between the image data applied 1H ahead and the image data that is applied next, also provides excellent results. For example, in the case where a current for pixel white display was written to the source signal line during the previous 1H period and a current for pixel black display will be written to the source signal line during the next 1H period, the precharge time is extended. This is because the black display current is very small. On the contrary, in the case where a current for pixel black display was written to the source signal line during a previous 1H period and a current for pixel white display will be written to the source signal line during the next 1H period, the precharge time is reduced or the operation of precharging itself is brought into a halt (not carried out). This is because the white display current is large.

Furthermore, it is effective that the precharge voltage is made to vary according to the image data that is applied. This is because the write current for black display is very small while the write current for white display is large. Accordingly, the precharge voltage is increased toward the low gray scale region (with respect to VDD when the pixel TFT 11a is formed by a P channel transistor) while the precharge voltage is decreased toward the high gray scale region (when the pixel TFT 11a is formed by a P channel transistor). When the program current open terminal (PO terminal) is at "0", the switch 641b is placed in the OFF state, and the IL and IH terminals are disconnected from the source signal line 18 (the Iout terminal is in connection with the source signal line 18). Consequently, the program current Iw does not flow through the source signal line 18. The PO terminal is "1" during the time in which the program current Iw is being applied to the source signal line 18, and the switch 641b is placed in the ON state so that the program current Iw flows through the source signal line 18.

When placing the switch 641b in the open state by application of "0" to the PO terminal, none of the pixel rows of a display region is selected. Based on the input data (D0-D5), the current source 634 draws in current at all the time from the source signal line 18. This current is a current that flows into the source signal line 18 from the Vdd terminal of a selected pixel 16 via the TFT 11a. Accordingly, when none of the pixel rows are selected, there is no current flow route between the pixel 16 and the source signal line 18. The time during which none of the pixel rows are selected takes place between the time a certain pixel row is selected and the time the next pixel row is selected. Such a state that none of the pixels (pixel rows) are selected and there is no route for a current to flow into or flow out of the source signal line 18 is called the "total non-selection period".

In this state, if the IOUT terminal is in connection with the source signal line 18, then a current flows through the unit current source 634 in the ON state. Actually, the switch 641, controlled by the data at the D0-D5 terminals, turns on. As a result, electric charges held in the parasitic capacitance of the source signal line 18 discharge electricity, and the potential of the source signal line 18 falls abruptly

As described above, if the potential of the source signal line 18 falls, this produces a problem that it will take time to bring back it to the original electric potential level by a current that is to be written originally to the source signal line 18.

In order to provide a solution to this problem, in the present invention the switch 641b is placed in the OFF state by application of "0" to the PO terminal during the total non-selection period and, as a result, the IOUT terminal and the source signal line 18 are disconnected. Because of this, no current will flow into the current source 643 from the source signal line 18. Therefore, the source signal line 18 does not undergo any variation in potential. As can be seen, the PO terminal is so controlled as to disconnect the source signal line 18 from the current source, thereby achieving excellent current writing.

In addition, it is effective to additionally provide a precharging stop function when there mixedly exist a white display region (i.e., a region having a constant brightness) and a black display region (i.e., a region having a brightness not more than a given value) in the screen, and the ratio of the area (white area) of the white display region and the area (black area) of the black display region falls in a certain range (adequate precharging), because generation of vertical stripes occurs in the image in the certain range. Of course, on the contrary, there are cases where precharging is carried out in a certain range. In addition to the above-described reason, another reason is that, when an image moves, noise occurs in the image. The operation of adequate precharging can be realized easily by the counting (calculation) of pixel data corresponding to the white and block areas by means of an arithmetic circuit. Furthermore, it is also effective that the operation of adequate precharging is made to vary with respect to each of the colors R, G, and B, because the EL display elemental device 15 has a respective light emission start voltage and a respective light emission brightness for each of the colors R, G, and B. For example, it is arranged such that, for the case of the color R, precharging is stopped or started when the ratio of a white area having a given brightness and a black area having a given brightness is not less than 1 : 20, while on the other hand it is arranged such that, for the case of the colors G and B, precharging is stopped or started when the ratio of a white area having a given brightness and a black area having a given brightness is not less than 1 : 16. In addition, according to the experimental tests and studies, it is preferable that the operation of precharging is stopped or started when the ratio of a white area having a given brightness and a black area having a given brightness is not less than 1:100 (i.e., the black area is not less than 100 times the white area), for the case of organic EL panels. Furthermore, preferably the operation of precharging is stopped or started when the ratio of a white area having a given brightness and a black area having a given brightness is not less than 1 : 200 (i.e., the black area is not less than 200 times the white area).

If the drive TFT 11a of the pixel 16 is formed by a P channel transistor, it is required that the precharge voltage PV close to Vdd (see Figure 1) be outputted from the source driver (IC) 14. However, as the precharge voltage PV comes to approximate to Vdd, it is required that the driver circuit (IC) 14 employs a high voltage resistance process semiconductor. Here, what is meant by "high voltage resistance" is the resistance to voltage (from 5 to 10 (V)), and if in excess of 5-V resistance, this produces the problem that the semiconductor process costs will increase. Accordingly, it becomes possible to employ a very fine, low cost process by employing a 5-V resistance process.

If the drive TFT 11a of the pixel 16 has an excellent diode characteristic and, in addition, the ON current for white display is secured, no problem will arise because the source driver 14 is also able to use such a 5-V process if below 5 (V). However, problems will arise when the diode characteristic exceeds 5 (V). Especially, since the operation of precharging requires application of the precharge voltage PV close to the source voltage Vdd of the TFT 11a, this produces a problem that the IC 14 becomes unable to give an output.

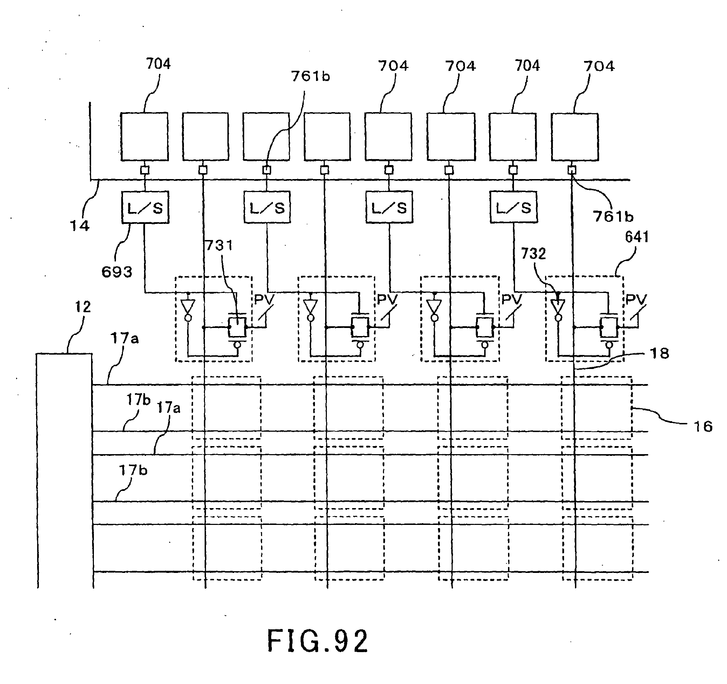

Figure 92 depicts a panel configuration capable of providing a solution to the above-described problem. Referring to Figure 92, the switch circuit 641 is formed on the side of an array 71. The source driver 14 outputs an ON/OFF signal to the switch 641. The ON/OFF signal is pulled up by the level shifter circuit 693 formed in the array 71 and turns the switch 641 on or off. The switch 641 and the level shifter circuit 693 are formed at the same time or one after another in a process of forming pixel TFTs. Of course, they may be formed separately, implemented by external circuits (ICs), and mounted on the array 71.

The ON/OFF signal is outputted from a terminal 761a of the IC 14 on the basis of the previously described precharge conditions (see for example Figure 75). Accordingly, both the precharge voltage application method and the drive method are, of course, applicable to the exemplary embodiment of Figure 92. A voltage (signal) that is outputted from the terminal 761a is low (not more than 5 (V)). The vibration amplitude of the voltage (signal) is increased up to the ON/OFF logic level of the switch 641 by the level shifter circuit 693.

As the result of the above-described arrangement, the source driver (IC) 14 becomes operationally sufficient by a power supply voltage in an operational voltage range capable of driving the program current Iw. The precharge voltage PV is no longer the problem with respect to the array substrate 71 whose operational voltage is high. Therefore, the precharge voltage PV at the level of the Vdd voltage can be applied in satisfactory manner.

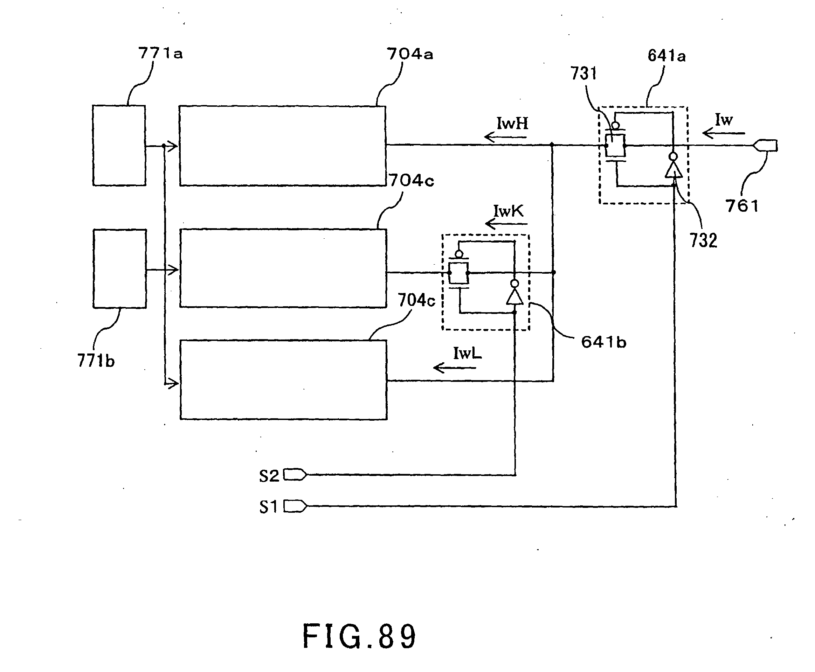

If the switch circuit 641 of Figure 89 is formed (arranged) in the source driver (IC) 14, the resistance to voltage becomes a problem. For example, if the Vdd voltage of the pixel 16 is higher than the power supply voltage of the IC 14, there is a danger that a voltage that breaks down the IC 14 is applied to the terminal 761 of the IC 14.

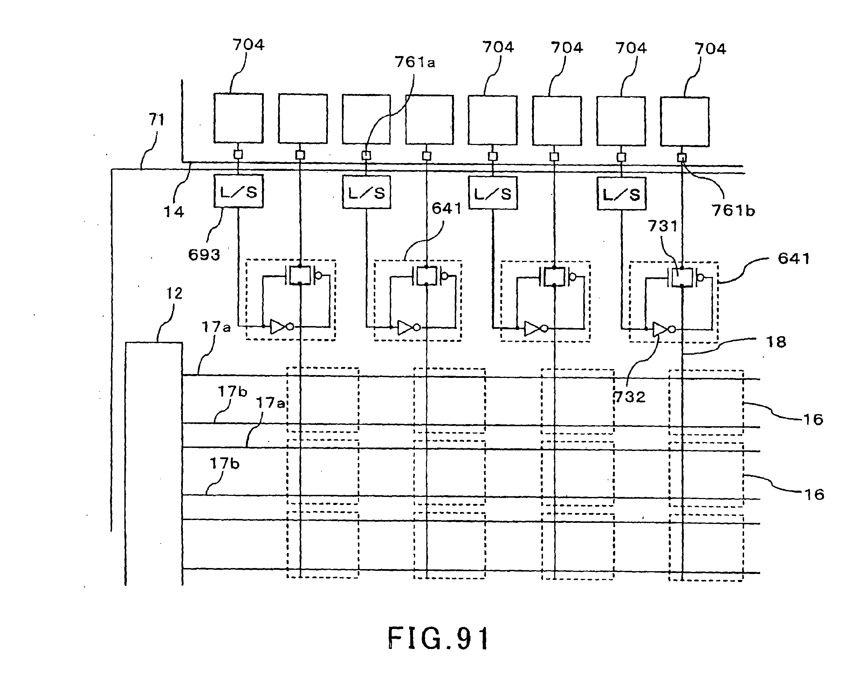

An exemplary embodiment capable of solving such a problem is a configuration shown in Figure 91. The switch circuit 641 is formed (arranged) in the array substrate 71. The configuration of the switch circuit 641 is the same as or similar to the configuration and specifications of the one described with reference to Figure 92.

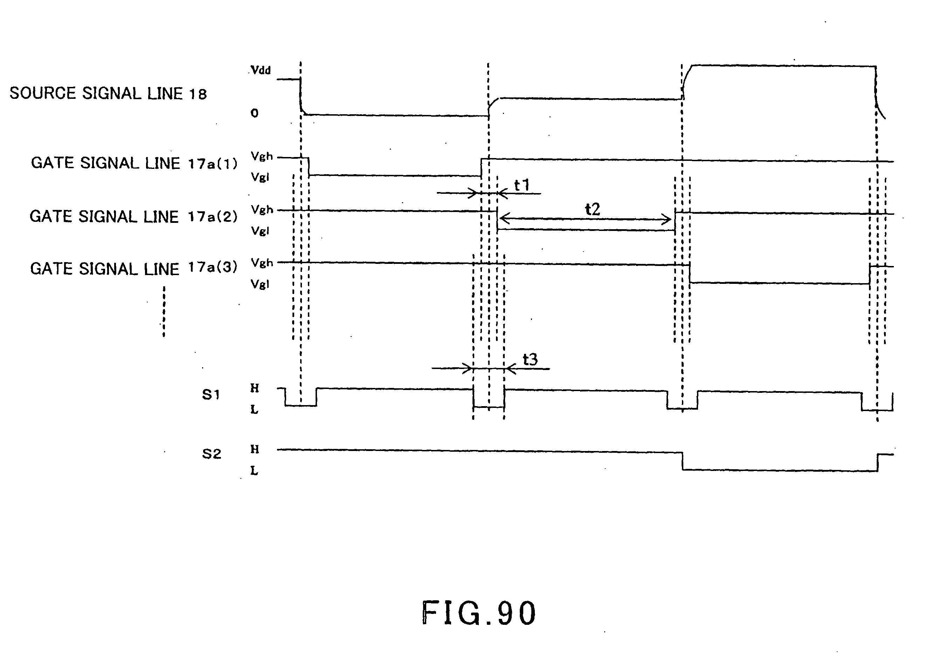

The switch 641 is arranged ahead of the output of the IC 14 and midway along the source signal line 18. When the switch 641 turns on, the current Iw for programming the pixel 16 flows into the source driver (IC) 14. On the other hand, when the switch 641 turns off, the source driver (IC) 14 is disconnected from the source signal line 18. The drive method shown in Figure 90 is executed by controlling the switch 641.

Like Figure 92, a voltage (signal) that is outputted from the terminal 761a is low, (not more than 5 (V)). The vibration amplitude of the voltage (signal) is increased up to the ON/OFF logic level of the switch 641 by the level shifter circuit 693.

As the result of the above-described arrangement, the source driver (IC) 14 becomes operationally sufficient by a power supply voltage in an operational voltage range capable of driving the program current Iw. In addition, since the switch 641 is also operated by the power supply voltage of the array 71, the switch 641 will not undergo breakdown even when the Vdd voltage is applied to the source signal line 18 from the pixel 16. In addition, the source driver (IC) is not destroyed.

Needless to say, both the switch 641 arranged (formed ) midway along the source signal line 18 (Figure 91) and the switch 641 for the application of the precharge voltage PV are formed (arranged) in the array substrate 71 (a combination of the Figure 91 configuration and the Figure 92 configuration).

As previously described, if the drive TFT 11a and the selective TFTs (11b, 11c) of the pixel 16 (Figure 1) are formed by P channel TFTs, this results in generation of a punch-through voltage, because a variation in potential of the gate signal line 17a punches through the terminal of the capacitor 19 via the G-S capacitance (parasitic capacitance) of the selective TFTs (11b, 11c). The voltage Vgh is used to turn the P channel transistor 11b off. Because of this, the terminal voltage of the capacitor 19 is shifted slightly toward the Vdd voltage. And, the gate (G) terminal voltage of the transistor 11a increases, thereby providing a blacker representation.

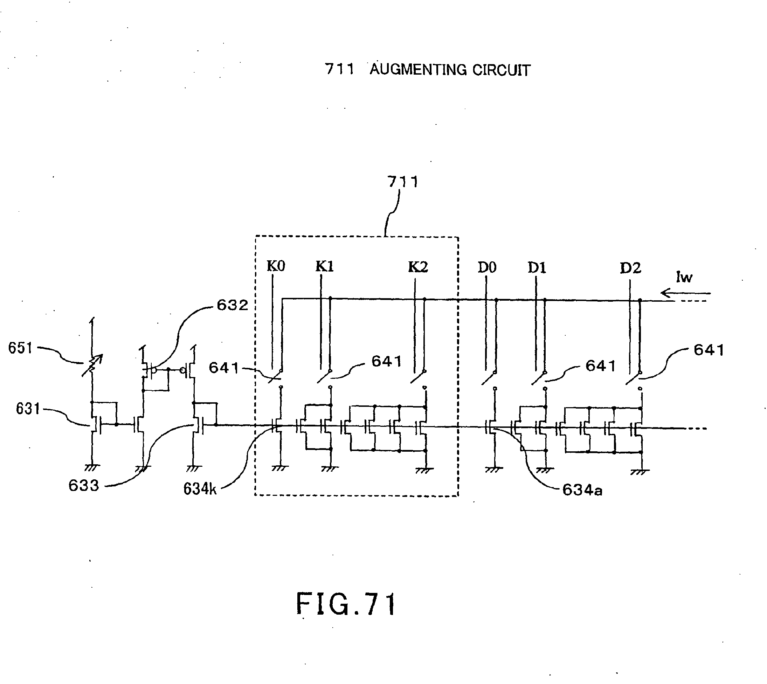

However, although it is possible to realize a completely black representation of the first gray scale, the second gray scale or other scale becomes difficult to display, or there occurs a gray scale jump from the first to the second gray scale and a "blackened state" occurs over a given gray scale range. Figure 71 shows a configuration capable of solving such problems. This configuration is characterized in that it has a function of augmenting the value of output current. The main purpose of providing the augmenting circuit 711 is to make compensation for the punch-through current. In addition, even when the image data is at a black level 0, it is arranged such that some current (several tens of nA) flows and is used for black level adjustment.

Basically, Figure 71 results from addition of an augmenting circuit (indicated by broken line of Figure 71) to the output stage of Figure 64. Figure 71 shows a diagram in which three bits (K0, K1, K2) are supposed as a current value augmentation control signal, and by virtue of this 3-bit control signal it becomes possible to add a current value zero to seven times the current value of a grandchild current source, to an output current.

The above is a basic general outline of the source driver (IC) 14 according to the present invention. Hereinafter, the source driver (IC) 14 of the present invention will be discussed in more detail.

An current I(A) that flows through the EL elemental device 15 and a light emission brightness B(nt) are in a linear relationship. In other words, there is a proportional relationship between the current I(A) that flows in the EL elemental device 15 and the light emission brightness B(nt). In the current driven method, one step (gray scale) is the current (the current source 634 (one unit)).

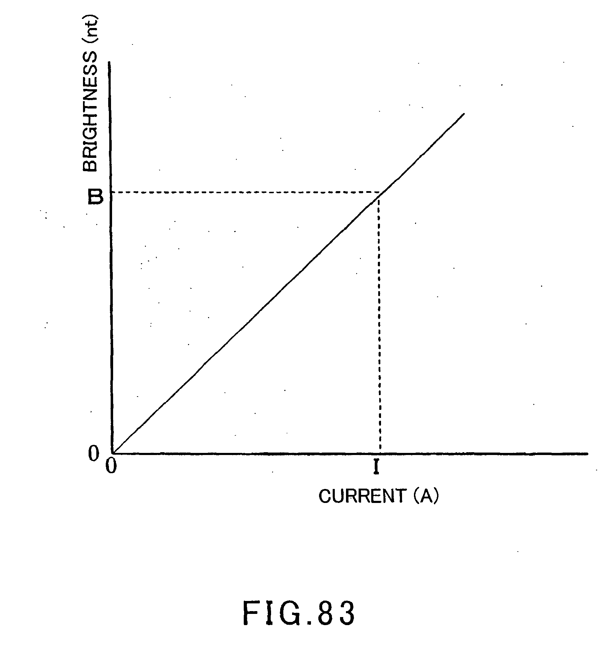

The human vision system to brightness has a square property. Stated another way, when varying along a square curved line, it is recognized that brightness seems to vary linearly. However, in the relationship of Figure 83, the current I(A) that flows through the EL elemental device 15 and the light emission brightness B(nt) are in proportion to each other not only in the low brightness region but also in the high brightness region.

Accordingly; when varied by step, the variation in brightness for one step is great in the low gray scale area (black region) (there occurs a so-called "blackening"). Since the high gray scale area (white region) substantially corresponds to a linear region of the square curve, it is recognized that the brightness variation for one step seems to vary at equal intervals. As can be seen from the above, in the current driven method (in the case one step is a current step), i.e., in the source driver (IC) 14 of the current driven type, the black display region becomes a problem.

To cope with this problem, in accordance with the present invention, the slope of the current output of the low gray scale region (from the gray scale 0 (complete black display) to the gray scale (R1)) is made gentle, whereas the slope of the current output of the high gray scale region (from the gray scale (R1) to the maximum gray scale (R)) is made sharp. In other words, in the low gray scale region, the amount of current that is increased per gray scale (one step) is diminished. On the other hand, in the high gray scale region, the amount of current that is increased per gray scale (one step) is increased. By making the amount of current that is varied per step in one of the two gray scale regions of Figure 79 different from the amount of current that is varied per step in the other gray scale region, the gray scale characteristic approximates to the square curve and no "blackening" occurs in the low gray scale region. The aforesaid gray scale-current characteristic curve, as shown in Figure 79, is called the "gamma curve".

The above-described exemplary embodiment uses a 2-stage current output slope (one stage for the low gray scale region and the other for the high gray scale region); however, this arrangement should not in any way be deemed restrictive. Needles to say, the number of stages for the current output slope can be three or more. However, the 2-stage current output slope is preferable because it can provide simple circuitry.

The technical idea of the present invention is that, in a source driver (IC) of the current driven type or the like, there are plural current amounts which are increased per gray scale step. Basically, it is a circuit that performs gray scale representation by current output and therefore the display panel is not limited to the active matrix type. The display panel includes those of the simple matrix type.

The display brightness of a display panel of the current driven type such as an EL display panel varies in proportion to the amount of current applied. Accordingly, in the source driver (IC) 14 of the present invention, the brightness of the display panel is controlled easily by adjusting a reference current based on a current flowing in a single current source (one unit).

In the EL display panel, the efficiency of light emission varies with respect to each of the colors R, G, and B and, in addition, there is a deviation in color purity with respect to the NTS Standards. Accordingly, in order to make the white balance optimum, it is required for adequately adjusting the RGB ratio. Such adjustment is carried out by adjustment of the reference current of each of the colors R, G, and B. For example, the R reference current is 2 µA, the G reference current is 1.5 µA, and the B reference current is 3.5 µA. In addition, in the driver of the present invention, it is configured such that: the current mirror multiplying ratio of the first-stage current source 631 of Figure 67 is made small (for example, if the reference current is 1 µA, then the current flowing in the transistor 632b is 1/100 of 1 µA, i.e., 10 nA) so that the accuracy of the reference current that is externally controlled can be adjusted in rough manner; and the accuracy of microcurrent within the chip can be adjusted effectively.

In order to realize the gamma curve of Figure 79, the source driver of the present invention is provided with an adjustment circuit for the reference current of the low gray scale region and an adjustment circuit for the reference current of the high gray scale region. In addition, in order to achieve independent adjustment with respect to each of the colors R, G, and B, an adjustment circuit for the reference current of the low gray scale region and an adjustment circuit for the reference current of the high gray scale region are provided for each of the colors R, G, and B. Of course, in the case where one of the colors R, G, and B is fixed and the white balance is adjusted by controlling of the reference current of the other colors, it suffices if an adjustment circuit for the reference current of the low gray scale region and an adjustment circuit for the reference current of the high gray scale region are provided for controlling two colors (for example, the colors R and B when the color G is fixed).

As illustrated in Figure 83, in the current driven method the current I flowing through the EL elemental device and the brightness are in a linear relationship. Therefore, in the white balance adjustment by RGB mixing, it suffices if the RGB reference current is controlled at a single given brightness point. In other words, the white balance can be established basically over all the gray scales if the white balance is adjusted by adjustment of the RGB reference current at a single given brightness point.

However, some attention should be paid to the gamma curve shown in Figure 79. In the first place, in order to achieve the white balance of the colors R, G, and B, it is required that the position, at which the gamma curve bends (gray scale R1), be substantially the same for each of the colors R, G, B. In other word, the relative relationship of the gamma curve can be made identical for each of the colors R, G, and B in the current driven method. In addition, it is further required that the ratio between the low gray scale region's slope and the high gray scale region's slope for the colors R, G, and B be constant. In other words, the relative relationship of the gamma curve can be made identical for each of the colors R, G, and B in the current driven method. For example, in the low gray scale region an increment of 10 nA (the gamma curve slope in the low gray scale region) is made per gray scale, whereas in the high gray scale region an increment of 50 nA (the gamma curve slope in the high gray scale region) is made per gray scale. The current increment amount per gray scale in the high gray scale region/the current increment amount per gray scale in the low gray scale region, is called the "gamma current ratio". In the present exemplary embodiment the gamma current ratio: 50 nA/10 nA = 5. The gamma current ratio is made identical for each of the colors R, G, B. Stated another way, in the state in which the current flowing in the EL elemental device 15 is adjusted, with the gamma current ratio made identical for each of the colors R, G, and B.

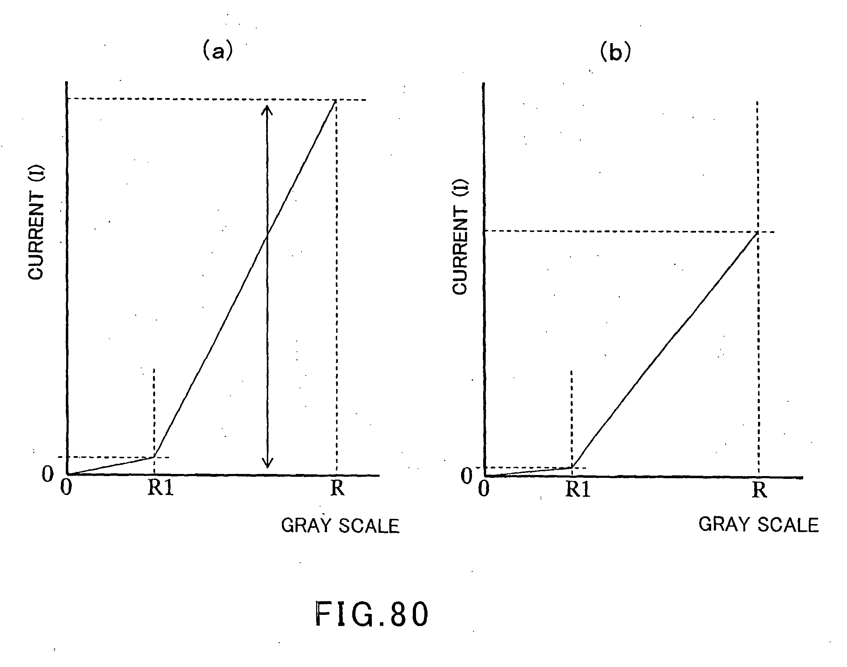

Referring to Figure 80, there is shown an example of the gamma curve. In Figure 80(a), the increase in current per gray scale is great both in the low gray scale area and in the high gray scale area. In Figure 80 (b), the increase in current per gray scale is less both in the low gray scale area and in the high gray scale area, in comparison with Figure 80(a). But in Figures 80(a) and (b), the gamma current ratio is the same. The gamma current ratio is adjusted while it is maintained identical for each of the colors R, G, B, so that it suffices if a constant current circuit for generating a reference current which is supplied to the low gray scale area and a constant current circuit for generating a reference current which is supplied to the high gray scale are formed for each color, and if a current adjusting volume circuit for causing these currents to flow is fabricated (arranged).

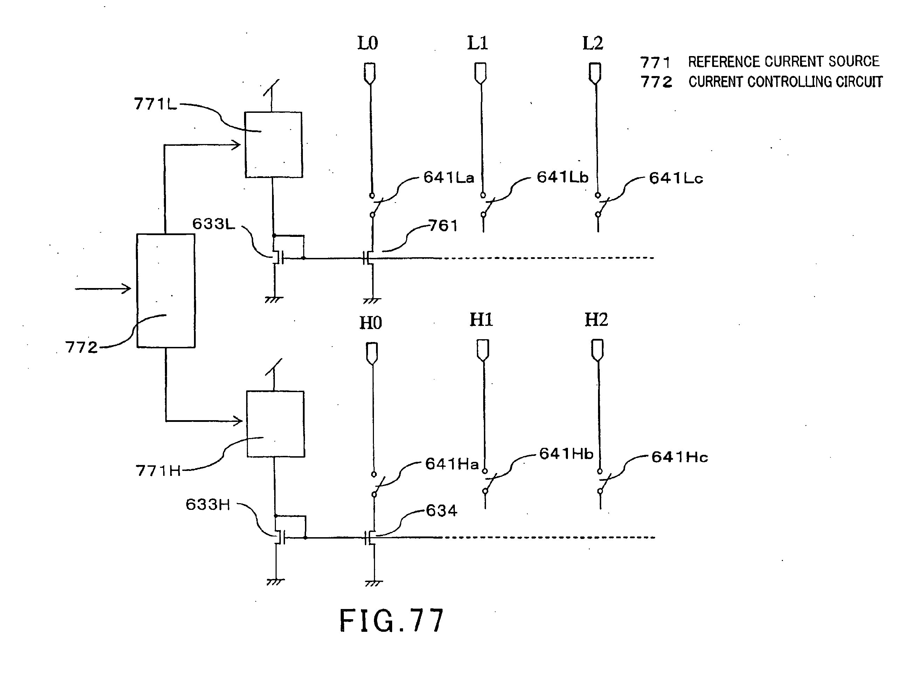

Referring to Figure 77, there is shown a circuit configuration capable of making the output current variable while at the same time maintaining the gamma current ratio. While maintaining the gamma current ratio between a reference current source 771L of the low current region and a reference current source 771H of the high current region by means of a current control circuit 772, the current flowing through a current source 633L and the current flowing through a current source 633H are made to vary.

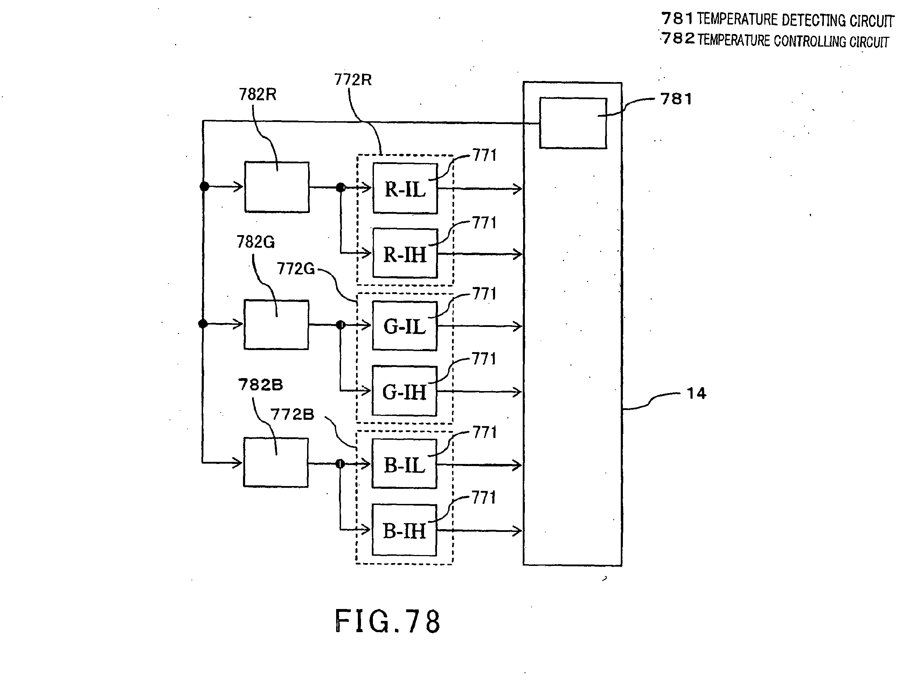

In addition, as shown in Figure 78, it is preferable that the relative temperature of the display panel is detected by a temperature detecting circuit 781 formed in the IC chip (circuit) 14. This is because the EL elemental device exhibits a respective temperature property for each of the RGB constituting materials. This temperature detection makes utilization of the fact that the junction state of a bipolar transistor varies with temperature and the output current varies with temperature. Temperatures detected are fed back to temperature control circuits 782 arranged (formed) for each color, for temperature compensation by associated current control circuits 772.

Based on the review by the inventors of the present invention, preferably the gamma ratio is not less than 3 nor more than 10. More preferably, the gamma ratio is not less than 4 nor more than 8. It is particularly preferable that the gamma current ratio is not less than 5 nor more than 7. This is called a "first relationship".

Furthermore, it is preferable that the point of change between the low gray scale area and the high gray scale area (the gray scale R1 of Figure 79) is set not less than 1/32 nor more than 1/4 of the maximum gray scale number K (for example, if the maximum gray scale number K is 6-bit 64 gray scales, not less than (64/32 = the second gray scale) nor more than (64/4 = the sixteenth gray scale)). More preferably, it is preferable that the point of change between the low gray scale area and the high gray scale area (the gray scale R1 of Figure 79) is set not less than 1/16 nor more than 1/4 of the maximum gray scale number K (for example, if the maximum gray scale number K is 6-bit 64 gray scales, not less than (64/14 = the fourth gray scale) nor more than (64/4 = the sixteenth gray scale)). Much more preferably, it is preferable that the point of change is set not less than 1/10 nor more than 1/5 of the maximum gray scale number K (if a calculation includes fractions below decimal point, they are subjected to round-off). For example, if the maximum gray scale number K is 6-bit 64 gray scales, the change point is set not less than (64/10 = the sixth gray scale) nor more than (64/5 = the twelfth gray scale)). The above-described relationship is called a "second relationship". The forgoing description is a gamma current ratio relationship between the two current regions. However, the second relationship is applied also to the case where there is a gamma current ratio relationship among three or more current regions (in other words, there are two or more bending points). Stated another way, it suffices if a relationship for any two slopes is applied to three or more slopes.

Excellent image representation free from "blackening" is realized by satisfying the first relationship simultaneously with the second relationship.

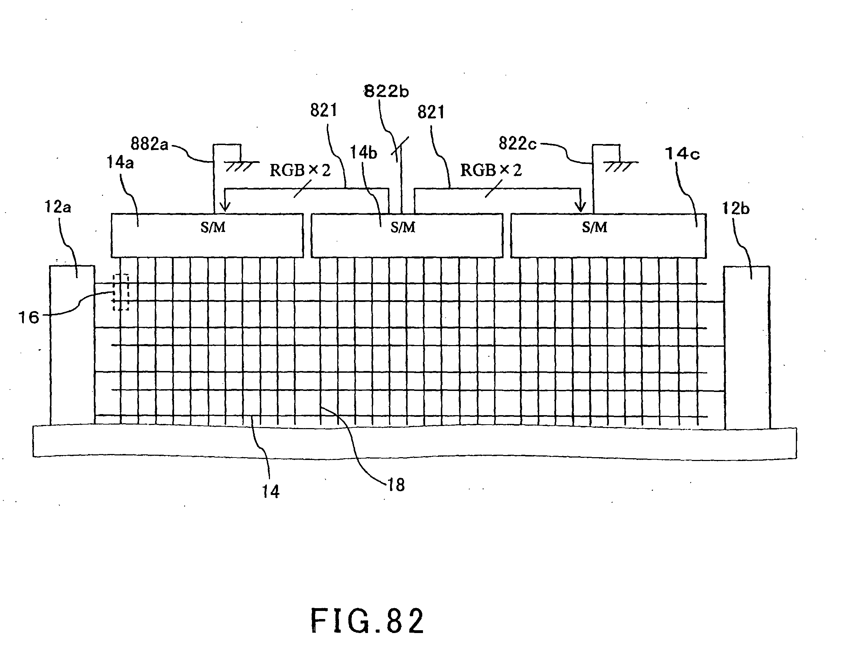

Referring to Figure 82, there is shown an exemplary embodiment making use of a plurality of source drivers (IC) 14 of the current driven type of the present invention in a single display panel. The source driver 14 of the present invention is provided with a slave/master (S/M) terminal on the assumption that a plurality of driver ICs 14 are used. When the S/M terminal is brought to HIGH level, the IC 14 operates as a master chip and outputs a reference current from a reference current output terminal (not shown). This current becomes a current that flows through INL and INH terminals (Figures 73 and 74) of the slave ICs 14 (14a, 14c). By bringing the S/M terminal to LOW level, the IC 14 operates as a slave chip and receives a master chip reference current from a reference current input terminal (not shown). This current becomes a current that flows through the INL and INH terminals (Figures 73 and 74).

With respect to the reference current which is transferred between the reference current input terminal and the reference current output terminal, there are two systems for the low and high gray scale regions for each of the colors. Accordingly, for the three colors (R, G, and B), there are 6 (3 x 2) systems. In the exemplary embodiment each color is assigned two systems; however, this arrangement should not in any way be deemed restrictive. For example, each color may be assigned three or more systems.

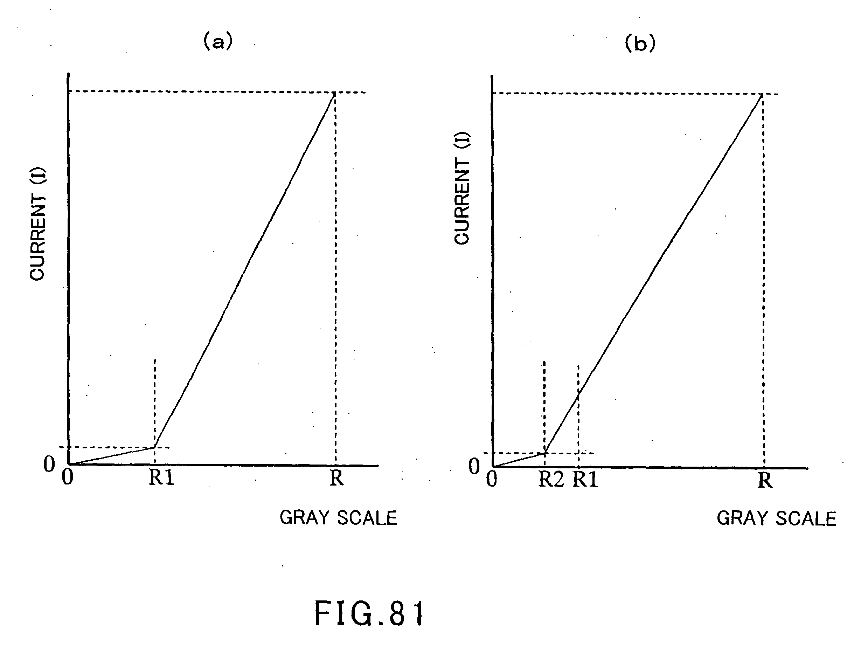

In the current driven method of the present invention, it is configured such that the bending point (for example the gray scale R1) can be changed, as shown in Figure 81. In Figure 81(a), the low gray scale area and the high gray scale area are changed at the gray scale R1, and switching between the low gray scale area and the high gray scale area is made at the gray scale R2 in Figure 81(b). As can be seen, it is arranged such that the bending point can be varied at a plurality of points.

More specifically, the present invention is able to realize display of 64 gray scales. The bending point (R1) is nonexistent, or it is the second gray scale, the fourth gray scale, the eighth gray scale, and the sixteenth gray scale. Since the complete black representation is the gray scale 0, the bending point is: 2, 4, 8, and 16. If the complete dark representation is the gray scale 1, the bending point is: 3, 5, 9, 17, and 33. As can be seen, the configuration that the bending point exists at a position represented by a multiple of the number 2 (alternatively, at a position represented by a value (i.e., (a multiple of the number 2) + 1 when the complete black representation is the gray scale 1), provides the effect of making the circuitry simple.

Referring to Figure 73, there is shown a diagram depicting a constructional arrangement of a current source circuit section of the low current region. In addition, Figure 74 is a constructional diagram depicting a current source section and an augmentation current circuit section in the high current region. As shown in Figure 73, the low current source circuit section is supplied a reference current INL, and basically this current becomes a unit current. By the input data L0-L4, a required number of current sources 634 are operated, whereby a program current IwL of the low current section flows as a sum of currents outputted from the operated current sources 634.

Furthermore, as shown in Figure 74, the high current source circuit section is supplied a reference current INH, and basically this current becomes a unit current. By the input data H0-L5, a required number of current sources 634 are operated, whereby a program current IwH of the low current section flows as a sum of currents outputted from the operated current sources 634.

Likewise, as shown in Figure 74, the augmentation current circuit section is supplied a reference current INH, and basically this current becomes a unit current. By the input data AK0-AK2, a required number of current sources 634 are operated, whereby a current IwK corresponding to an augmented current flows as a sum of currents outputted from the operated current sources 634.

The program current Iw flowing through the source signal line 18 is: Iw = IwH + IwL + IwK. The ratio of the current IwH and the current IwL, i.e., the gamma current ratio, is so set as to satisfy the previously-described first relationship.

Referring to Figures 73 and 74, the ON/OFF switch 641 is composed of an analog switch 731 which is made up of an inverter 732, a P channel transistor, and an N channel transistor. By this configuration that the ON/OFF switch 641 is composed of the analog switch 731 which is made up of the inverter 732, the P channel transistor, and the N channel transistor, it becomes possible to achieve a reduction in ON resistance, thereby making it possible to extremely reduce the drop in voltage between the current source 634 and the source signal line 18.

The operation of the low current circuit section of Figure 73 and the operation of the high current circuit section of Figure 74 will be described. The source driver (IC) 14 of the present invention is composed of low current circuit five bits L0-L4 and high current circuit six bits H0-H5. Six bits, i.e., data D0-D5, are inputted from outside the circuit (64 gray scales for each color). This 6-bit data is converted into five bits (the low current circuit sections L0-L4) and into six bits (the high current circuit sections H0-H5) so that the source signal line is supplied a program current Iw corresponding to the image data. Stated another way, the 6-bit input data is converted into the data composed of 5 + 6 = 11 bits. Accordingly, it is possible to form a high-accuracy gamma curve.

As described above, the 6-bit input data is converted into the data of 5 + 6 = 11 bits. In accordance with the present invention, the number of bits of the high current region circuit (H) equals the number of bits of the input data (D), while on the other hand the number of bits of the low current region circuit (L) is: (the number of bits of the input data (D))-1. It may be arranged such that the number of bits of the circuit in the low current region is: (the number of bits of the input data (D)) - 2. As a result of such arrangement, both a low current region's gamma curve and a high current region's gamma curve become optimum for the display of an image on the EL display panel.

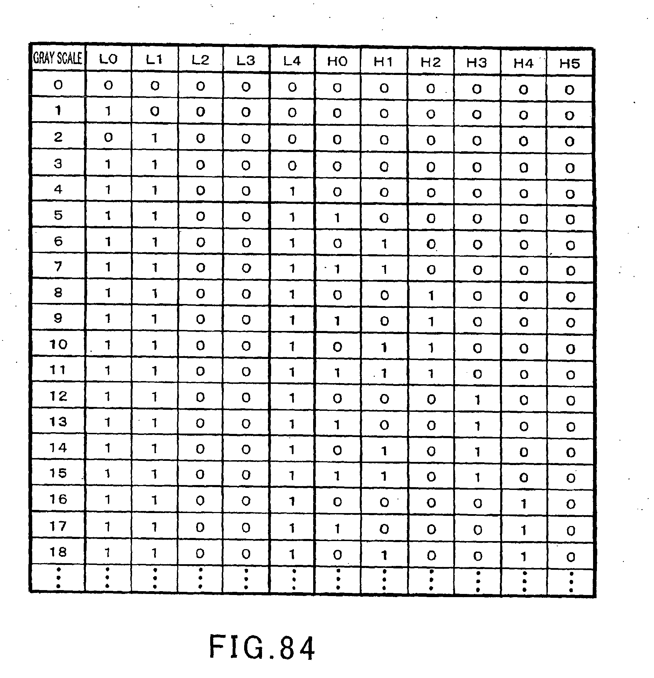

Hereinafter, by making reference to Figures 84-86, a control method of controlling the circuit control data (L0-L4) of the low current region and the circuit control data (H0-H4) of the high current region will be described.

The present invention is characterized by the operation of a current source 634a in connection with an L4 terminal of Figure 73. The current source 634a is made up of a single transistor which serves as a current source (one unit). It becomes easy to control (on/off control) the program current Iw by causing the transistor to turn on and off.

Referring to Figure 84, there are shown applied signals to a low current side signal line (L) and applied signals to a high current side signal line (H) when switching between the low current region and the high current region is made at the gray scale 4. Figures 84 through 86 each show only gray scales from 0 to 18; however, in fact there are 64 gray scales (from 0 to 63). Accordingly; in each figure, representation of the gray scales (beyond the gray scale 18) is omitted. In addition, the switch 641 turns on at "1" of the table and its associated current source 634 and the source signal line 18 are brought into connection with each other. On the other hand, at "0" of the table, the switch 641 turns off.

In Figure 84, at the gray scale 0 (complete black representation), (L0-L4) = (0, 0, 0, 0, 0) and (H0-H5) = (0, 0, 0, 0, 0). Consequently, all the switches 641 are placed in the OFF state. In the source signal line 18, the program current Iw = 0.

At the gray scale 1, (L0-L4) = (1, 0, 0, 0, 0) and (H0-H5) = (0, 0, 0, 0, 0). Consequently, a single unit current source 634 in the low current region is brought into connection with the source signal line 18. None of the unit current sources in the high current region are brought into connection with the source signal line 18.

At the gray scale 2, (L0-L4) = (0, 1, 0, 0, 0) and (H0-H5) = (0, 0, 0, 0, 0). Consequently, two single unit current sources 634 in the low current region are brought into connection with the source signal line 18. None of the unit current sources in the high current region are brought into connection with the source signal line 18.

At the gray scale 3, (L0-L4) = (1, 1, 0, 0, 0) and (H0-H5) = (0, 0, 0, 0, 0). Consequently, two switches in the low current region, i.e., the switches 641La and 641Lb, turn on and three unit current sources 634 in the low current region are brought into connection with the source signal line 18. None of the unit current sources in the high current region are brought into connection with the source signal line 18.

At the gray scale 4, (L0-L4) = (1, 1, 0, 0, 1) and (H0-H5)= (0, 0, 0, 0, 0). Consequently, three switches in the low current region, i.e., the switches 641La, 641Lb, 641Le, turns on and four unit current sources 634 in the low current region are brought into connection with the source signal line 18. None of the unit current sources in the high current region are brought into connection with the source signal line 18.

At gray scales above the gray scale 5, there are no variations in the low current region, i.e., (L0-L4) = (1, 1, 0, 0, 1). However, in the high current region, (H0-H5) = (1, 0, 0, 0, 0). Consequently, the switch 641Ha turns on. A single unit current source 641 in the high current region is brought into connection with the source signal line 18. In addition, at the gray scale 6, (H0-H5) = (0, 1, 0, 0, 0). Consequently, the switch 641Hb is turned on and two unit current sources 641 in the high current region are brought into connection with the source signal line 18. Likewise, at the gray scale 7, (H0-H5) = (1, 1, 0, 0, 0). Consequently, two switches, i.e., the switch 641Ha and the switch 641Hb, are turned on and three unit current sources 641 in the high current region are brought into connection with the source signal line 18. In addition, at the gray scale 8, (H0-H5) = (0, 0, 1, 0, 0). Consequently, a single switch, i.e., the switch 641Hc, is turned on and four unit current sources 641 in the high current region are brought into connection with the source signal line 18. After that, the switches 641 are turned on and off one after another, as shown in Figure 84, and the program current Iw is supplied to the source signal line 18.

The above-described operation is characterized in that the control bit (L) of the low current region does not undergo a variation beyond the bending point. The bending point is a point of switching between the low current region and the high current region. However, to be more accurate, the term "switching point" is not adequate because a low current IwL is added as the program current Iw for the case of high current region gray scales. In addition, an augmentation current IwK is also added. In other words, in a gray scale of the high gray scale part an addition to a current of the low gray scale part is made, and a current according to a step (gray scale) of the high gray scale part becomes the program current Iw. Tb sum up, the bending point should be defined as either a point or a position at which the current undergoes a variation (one step gray scale). The operation is further characterized in that, at that time, the L4 terminal of Figure 73 becomes "1", and the switch 641e is turned on, and there is flow of a current in the transistor 634a.

Accordingly, at the gray scale 4 of Figure 84, four unit transistors (current sources) 634 of the low gray scale part are operated. And, at the gray scale 5, four unit transistors (current sources) 634 of the low gray scale part are operated while at the same time a single transistor (current source) 634 of the high gray scale part is operated. In the same manner as above, at the gray scale 6, four unit transistors (current sources) of the low gray scale part are operated while at the same time two transistors (current sources) 634 of the high gray scale part are operated. To sum up, at gray scales above the gray scale 5 which is a bending point, a corresponding number of unit transistors (current sources) 634 of the low gray scale part to the gray scale (in this case, four unit transistors of the low gray scale part) are turned on and, in addition, a corresponding number of transistors (current sources) 634 of the high gray scale part to the gray scale are turned on one after another.

It is accordingly understandable that a transistor 634a of the L4 terminal of Figure 73 operates effectively. In absence of this transistor 643a, a single transistor 634 of the high gray scale part is turned on after the gray scale 3. Because of this, the switching point is not multipliers (for example, 4, 8, 6, ...) of the number 2. The multiplier of the number 2 is a state in which only a single signal becomes "1". This facilitates determination of the condition that the signal line assigned a weight of 2 becomes "1". This accordingly makes it possible to reduce the scale of hardware for condition judgment. In other words, IC chip logic circuitry can be simplified, as a result of which it becomes possible to design ICs having smaller chip areas (it is possible to reduce costs).

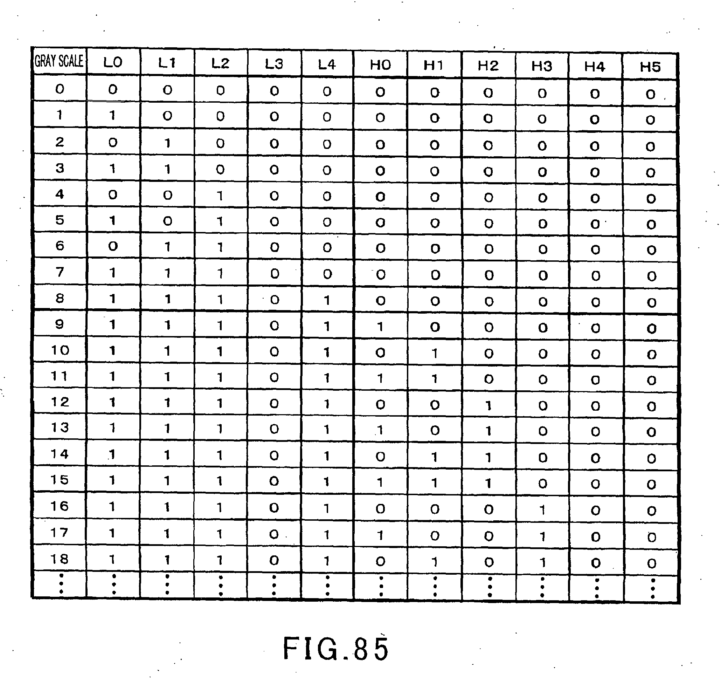

Figure 85 is an explanatory diagram of applied signals to a low current side signal line (L) and applied signals to a high current side signal line (H) when switching between the low current region and the high current region is made at the gray scale 8.

Like Figure 84, at the gray scale 0 (complete black representation), (L0-L4) = (0, 0, 0, 0, 0) and (H0-H5) = (0, 0, 0, 0, 0) in Figure 85. Consequently, all the switches 641 are placed in the OFF state. In the source signal line 18, the program current Iw = 0.

At the gray scale 1, (L0-L4) = (1, 0, 0, 0, 0) and (H0-H5) = (0, 0, 0, 0, 0). Consequently, a single unit current source 634 of the low current region is in connection with the source signal line 18. None of the unit current sources in the high current region are brought into connection with the source signal line 18.

At the gray scale 2, (L0-L4) = (0, 1, 0, 0, 0) and (H0-H5) = (0, 0, 0, 0, 0). Consequently, two unit current sources 634 of the low current region are in connection with the source signal line 18. None of the unit current sources in the high current region are brought into connection with the source signal line 18.

At the gray scale 3, (L0-L4) = (1, 1, 0, 0, 0) and (H0-H5) = (0, 0, 0, 0, 0). Consequently, two switches of the low current region, i.e., the switches 641La and 641Lb, are turned on and three unit current sources 634 of the low current region are in connection with the source signal line 18. None of the unit current sources of the high current region are brought into connection with the source signal line 18.

At the gray scale 4, (L0-L4) = (0, 0, 1, 0, 0) and (H0-H5) = (0, 0, 0, 0, 0). At the gray scale 5, (L0-L4) = (1, 0, 1, 0, 0) and (H0-H5) = (0, 0, 0, 0, 0). At the gray scale 6, (L0-L4) _ (0, 1, 1, 0, 0) and (H0-H5 (0, 0, 0, 0, 0). Furthermore, at the gray scale 7, (L0-L4)= (1, 1, 1, 0, 0) and (H0-H5 (0, 0, 0, 0, 0).

The gray scale 8 is a switching point (i.e., a bending point). At the gray scale 8, (L0-L4) = (1, 1, 1, 0, 1) and (H0-H5) = (0, 0, 0, 0, 0). Consequently, four switches of the low current region, i.e., the switches 641La, 641Lb, 641Lc, 641Le, are turned on while at the same time eight unit current sources 634 are in connection with the source signal line 18. None of the unit current sources of the high current region are brought into connection with the source signal line 18.

At gray scales above the gray scale 8, there are no variations in the low current region, i.e., (L0-L4) = (1, 1, 1, 0, 1). However, in the high current region, (H0-H5= (1, 0, 0, 0, 0) at the gray scale 9. Consequently, the switch 641Ha is turned on and a single unit current source 641 of the high current region is in connection with the source signal line 18.

According to the gray scale step, the number of transistors 634 of the high current region increases in increments of one transistor. More specifically, at the gray scale 10, (H0-H5) = (0, 1, 0, 0, 0). Consequently, the switch 641Hb is turned on and two unit current sources 641 of the high current region are brought into connection with the source signal line 18. At the gray scale 11, (H0-H5) = (1, 1, 0, 0, 0). Consequently, two switches, i.e., the switch 641Ha and the switch 641Hb, are turned on and three unit current sources 641 of the high current region are brought into connection with the source signal line 18. Furthermore, at the gray scale 12, (H0-H5) = (0, 0, 1, 0, 0). Consequently, a single switch, i.e., the switch 641Hc, is turned on and four unit current sources 641 of the high current region are brought into connection with the source signal line 18. Thereafter, the switches 641 are turned on and off one after another as shown in Figure 84, and the program current Iw is supplied to the source signal line 18.

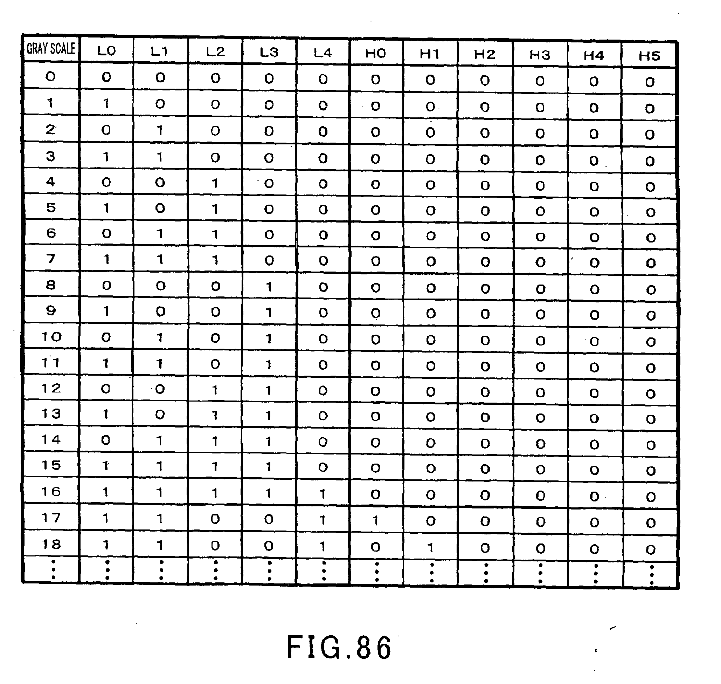

Figure 86 is an explanatory diagram serving to explain applied signals to a low current side signal line (L) and applied signals to a high current side signal line (H) when switching between the low current region and the high current region is made at the gray scale 16. This case is also identical in basic operation with Figures 84 and 85.

At the gray scale 0 (complete black representation), (L0-L4) = (0, 0, 0, 0, 0) and (H0-H5) = (0, 0, 0, 0, 0), as shown in Figure 86. Consequently, all the switches 641 are placed in the OFF state. In the source signal line 18, the program current Iw = 0. Likewise, from the gray scale 1 through the gray scale 16, in the high current region, (H0-H5= (0, 0, 0, 0, 0). Accordingly, a single unit current source 634 of the low current region is in connection with the source signal line 18. None of the unit current sources of the high current region are in connection with the source signal line 18. Stated another way, only the (L0-L4) of the low current region will undergo a variation.

At the gray scale 1, (L0-L4) = (1, 0, 0, 0, 0). At the gray scale 2, (L0-L4) = (0, 1, 0, 0, 0). At the gray scale 3, (L0-L4) = (1, 1, 0, 0, 0). At the gray scale 2, (L0-L4) = (0, 0, 1, 0, 0). Thereafter, counting is made sequentially up to the gray scale 16. More specifically, at the gray scale 15, (L0-L4) = (1, 1,1,1, 0). At the gray scale 16, (L0-L4) = (1, 1, 1, 1, 1). At the gray scale 16, of the bits (D0-D5 rendering a gray scale, only a single signal line, i.e., the fifth bit (D4), turns on, and it is possible to decide, by judging a single data signal line (D4), that the data D0-D5 represent 16. Accordingly, it is possible to reduce the scale of logical circuit hardware.

The gray scale 16 is a switching point (a bending position), or probably it should be said that the gray scale 17 is a switching point. At the gray scale 16, (L0-L4) = (1, 1, 1, 1, 1) and (H0-H5) = (0, 0, 0, 0, 0). Consequently, four switches of the low current region, i. e., the switches 641La, 641Lb, 641Lc, 641Ld, 641Le, are turned on, and sixteen unit current sources 634 are in connection with the source signal line 18. None of the unit current sources of the high current region are connected to the source signal line 18.

At gray scales above the gray scale 16, there is no variation in the low current region, i.e., (L0-L4) = (1, 1, 1, 0, 1). However, in the high current region, (H0-H5) = (1, 0, 0, 0, 0). Consequently, the switch 641Ha is turned on. A single unit current source 641 of the high current region is in connection with the source signal line 18. Thereafter, in the same way as above, the number of transistors 634 of the high current region increases in increments of one transistor according to the gray scale step. Stated another way, at the gray scale 18, (H0-H5) = (0, 1, 0, 0, 0), and the switch 641Hb is turned on and two unit current sources 641 of the high current region are brought into connection with the source signal line 18. In the same way, at the gray scale 19, (H0-H5) = (1, 1, 0, 0, 0). Consequently, two switches, i. e., the switches 641Ha and 641Hb, are turned on, and three unit current sources 641 of the high current sources are brought into connection with the source signal line 18. Further, at the gray scale 20, (H0-H5 = (0, 0, 1, 0, 0). Consequently, a single switch, i.e., the switch 641Hc, is turned on, and four unit current sources 641 of the high current sources are brought into connection with the source signal line 18.

As has been described above, logic processing, by which a certain number of current sources (one unit) 634 which is a multiplier of the number 2 are turned on (or turned off) or connected to the source signal line 18 at the switching point (bending point), becomes easy to perform. For example, as shown in Figure 84, it is arranged such that four current sources (one unit) 634 are brought into operation if the bending position is the gray scale 4 (the number 4 is a multiplier of the number 2). And, at gray scales above the gray scale 4, it is arranged such that addition of a current source (one unit) 634 of the high current source is made. Furthermore, as shown in Figure 85, it is arranged such that eight current sources (one unit) 634 are brought into operation if the bending position is the gray scale 8 (the number 8 is a multiplier of the number 2). And, at gray scales above the gray scale 8, it is arranged such that addition of a current source (one unit) 634 of the high current source is made. The use of the configuration of the present invention makes it possible to constitute a gamma control circuit with a small hardware structure for every gray scale representation in addition to the 64-gray-scale display (16-gray-scale display: 4096 colors; 256-gray-scale display: 16700000 colors).

In the exemplary embodiments as described with reference to Figures 84, 85, and 86 it is designed such that the gray scale, at which the switching point lies, is a multiplier of the number 2, which is the case where the gray scale for complete black representation is 0. In the case where the gray scale for complete dark representation is 1, addition of 1 (+1) is required. However, these are merely matters of convenience. What is important in the present invention is to provide a configuration in which a plurality of current regions (high and low current regions et cetera) are provided and the switching point is determined (processed) with less signal input. The present invention adopts a technical idea that, if the gray scale at which the switching point lies is a multiplier of the number 2, this requires detection of only one signal line. Accordingly, the scale of hardware becomes extremely small. In addition, in order to facilitate such processing, the current source 634a is additionally provided.

Accordingly, for the case of negative logic, the switching point lies not at the gray scales 2, 4, 8, and so on but at the gray scale 1, 3, 7, 15, and so on. Furthermore, it is arranged such that the gray scale 0 is a complete black representation state; however, this arrangement should not in any way be deemed restrictive. For example, for the case of the 64 gray scale display, the gray scale 63 is a complete black representation state and the gray scale 0 is a maximum white representation state. In this case, the switching point may be dealt with by opposite consideration to the above. Accordingly, processing from the multiplier of the number 2 becomes a different configuration from the foregoing configuration.

Furthermore, the present invention is not limited to a gamma curve with a single switching point (bending position). The circuit of the present invention can be constructed even when there exist a plurality of bending positions. Accordingly, it may be arranged such that there are provided two bending positions (for example, the gray scale 4 and the gray scale 16). Furthermore, it may be arranged such that there are provided three or more bending positions (for example, the gray scale 4, the gray scale 16, and the gray scale 32).

In the above-described exemplary embodiments, it is set such that the gray scale is a multiplier of the number 2; however, this arrangement should not in any way be deemed restrictive. The bending point may be set by for example the numbers 2 and 8 which are multipliers of the number 2 (2 + 8 = the tenth gray scale, in other words the number of signal lines required for judgment is two). Alternatively, the bending point may be set by the numbers 2, 8, and 16 which are multipliers of the number 2 (2 + 8 + 16 = the twenty-sixth gray scale, in other words the number of signal lines required for judgment is three). In this case, the scale of hardware necessary for judgment and processing is somewhat increased; however, such increase can be dealt with satisfactorily in circuitry. Besides, the above-explained arrangements are, needless to say, included in the technical scope of the present invention.

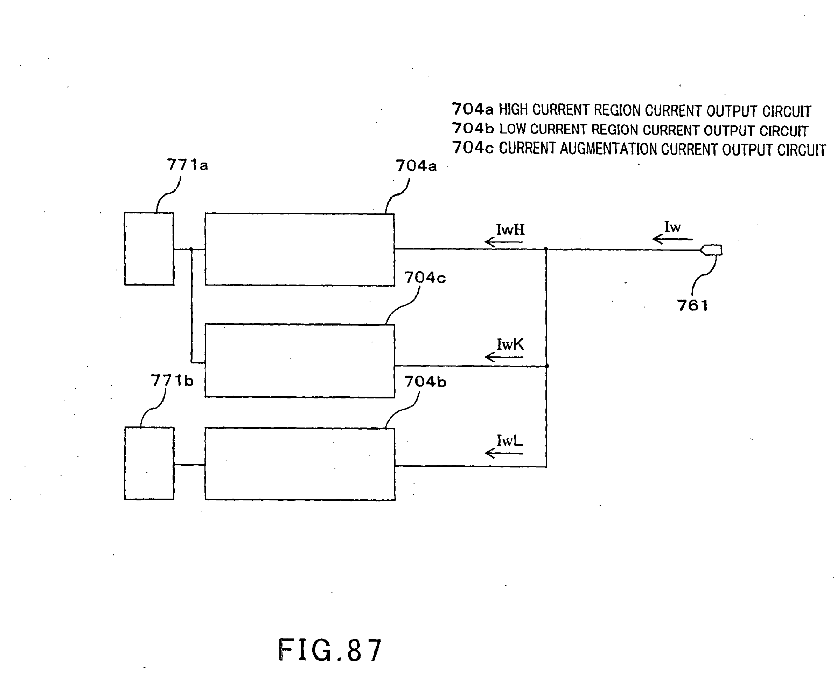

Referring to Figure 87, the source driver (IC) 14 of the present invention comprises the current output circuit 704 which is made up of three sections, i.e., sections 704a, 704b, and 704c. More specifically, the high current region current output circuit 704a operates in the high gray scale region. The low current region current output circuit 704b operates both in the low gray scale region and in the high gray scale region. The current augmenting current output circuit 704b outputs an augmented current.

The high current region current output circuit 704a and the current augmenting current output circuit 704c operate on the basis of a reference current which is a high current generated by a reference current source 771a. On the other hand, the low current region current output circuit 704b operates on the basis of a reference current which is a low current generated by a reference current source 771b.

As described above, the current output circuit 704 is composed of three circuits (i.e., the high current region current output circuit 704a, the low current region current output circuit 704b, and the current augmenting current output circuit 704c); however, such arrangement should not in any way be deemed restrictive. Alternatively the current output circuit 704 may be made up of two circuits (for example the high current region output circuit 704a and the low current region current output circuit 704b) or may be made up of three or more circuits. In addition, the reference current source 771 may be either arranged or formed in association with the current region current output circuit 704. Alternatively, the reference current source 771 may be made common to all the current region current output circuits 704.

The current output circuit 704 responds to the gray scale data and the internal transistor 634 is brought into operation and absorbs a current from the source signal line 18. The transistor 634 operates in sync with the 1-horizontal scan period (1H) signal. In other words, during the period of 1H, a current based on the associated gray scale data is inputted (when the transistor 634 is formed by an N channel transistor).

On the other hand, the gate driver 12 basically makes sequential selection of a single gate signal line 17a in synch with the 1H signal. Stated another way, in synch with the 1H signal, the gate driver 12 selects: a gate signal line 17a(1) during the first 1H period, a gate signal line 17a(2) during the second 1H period, a gate signal line 17a(3) during the third 1H period, and a gate signal line 17a(4) during the fourth 1H period.

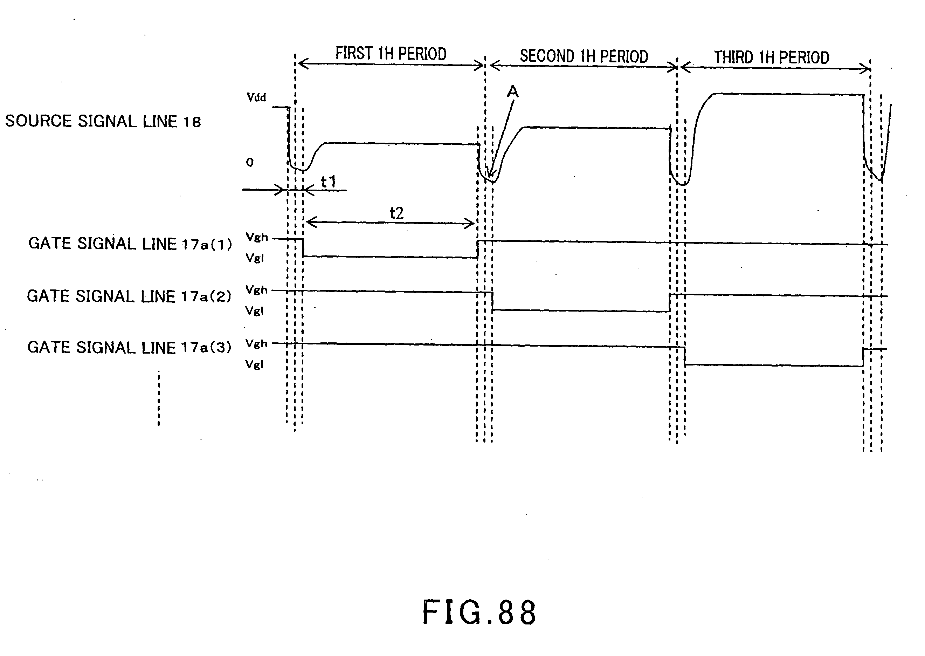

However, a period, during which none of the gate signal lines 17a are selected, is set between the time the first gate signal line 17a is selected and the time the second gate signal line 17a is selected (a non-selection period; see t1 of Figure 88). The non-selection period is provided because the gate signal line 17a requires a rising period and a falling period and is provided to secure an ON/OFF control period for the TFT 11d.

If any one of the gate signal lines 17a is applied an ON voltage and, in addition, if the TFTs 11b and 11c are turned on, then the program current Iw flows from the Vdd power supply (the anode voltage) to the source signal line 18 via the drive TFT 11a. This program current Iw flows through the transistor 634 (period t2 of Figure 88). The parasitic capacitance C is generated in the source signal line 18. Such parasitic capacitance is generated by a capacitance at a cross point between the gate signal line and the source signal line.

However, during the period in which none of the gate signal lines 17a are selected (during the non-selection period (the period t1 of Figure 88)), there is no current pathway through the TFT 11a. The transistor 634 flows a current, therefore absorbing a charge of electricity from the parasitic capacitance generated in the source signal line 18. Because of this, the potential of the source signal line 18 falls (part A of Figure 88). If the potential of the source signal line 18 drops, it will take a long time to write a current corresponding to the next image data.

In order to provide a solution to this problem, a switch 641a is formed at an output end of a source terminal 761, as shown in Figure 89. In addition, a switch 641b is formed or arranged at an output stage of the augmenting current output circuit 704c.

During the non-selection period t1, a control signal is applied to a control terminal S1 to cause the switch 641a to turn off. During the selection period t2, the switch 641a is placed in the ON state (conducting state). In the ON state, the program current Iw (= IwH + IwL + IwK) flows. When the switch 641a is turned off, the current Iw no longer flows. Therefore, the potential will not fall (vary) down to the level (part A of Figure 88), as shown in Figure 90. The channel width (W) of the analog switch 731 of the switch 641 is not less than 10 nor more than 100 μm. In order to achieve a reduction in the ON resistance, it is required that the analog switch channel width (W) be in excess of 10 μm. However, if the channel width (W) becomes excessively great, the parasitic capacitance likewise increases. Therefore, preferably the channel width should not be more than 100 μm. More preferably, the channel width (W) is not less than 15 nor more than 60 μm.

The switch 641b is a device for controlling only low gray scale representations. For the case of the low gray scale representation (black representation), approximation of the gate potential of the TFT 11a of the pixel 16 to the voltage Vdd is required to carry out (accordingly, in the black representation, approximation of the potential of the source signal line 18 to the voltage Vdd is required to perform). In addition, the program current Iw is low in the black representation, and once the potential falls (see part A of Figure 88), it will take a long time for the dropped potential to return to the normal potential level.

Accordingly, for the case of the low gray scale representation, it is necessary to prevent the occurrence of the non-selection period t1. On the other hand, for the case of the high gray scale representation, the occurrence of the non-selection period t1 is not a problem in most cases, because the program current Iw is great. Therefore, in the present invention, during the writing of a high gray scale representation image, both the switch 641a and the switch 641b are made to remain in the ON state, even during the non-selection period. In addition, it is required that the augmented current IwK is also disconnected. This is to realize black representation as much as possible. On the other hand, during the writing of a low gray scale representation image, it is driven such that, during the non-selection period, the switch 641a is turned on while the switch 641b is turned off. The switch 641b is controlled by a control terminal S2.

Needless to say, it may be driven such that, during both the writing of a low gray scale representation image and the writing of a high gray scale representation image, the switch 641a remains in the OFF state (non-conducting state) while the switch 641b remains in the ON state (conducting state) during the non-selection period t1. In addition, it may be driven such that, during both the writing of a low gray scale representation image and the writing of a high gray scale representation image, both the switch 641a and the switch 641b remain in the OFF state (non-conducting state) during the non-selection period t1.

In both of the above cases, the switches 641 are controlled by the control terminals S1 and S2. These control terminals S1 and S2 are command-controlled.

For example, by virtue of the control terminal S2, it is controlled such that the period t3 is a "0" logic level, overlapping the non-selection period t1. By such control, the state, indicated by A of Figure 88, will not occur. Furthermore, the control terminal S1 is held at "0" logic level when the gray scale is above a certain black representation level, upon which the augmented current IwK is stopped, thereby achieving more darker representation.

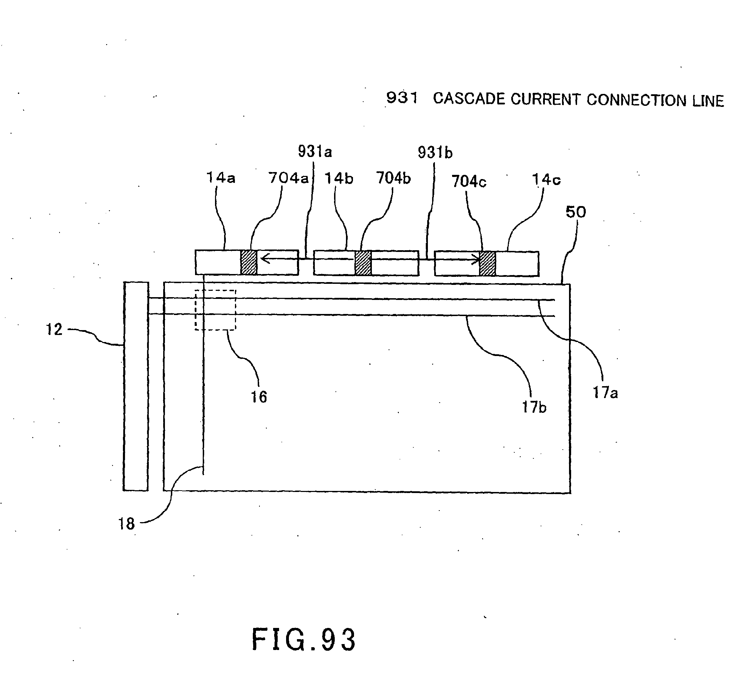

The aforesaid exemplary embodiment has been described on the condition that the display panel is provided with a single source driver 14. However, the present invention is not limited to that arrangement. It may be arranged such that a plurality of source drivers 14 are mounted in a single display panel. For example, Figure 93 shows an exemplary embodiment of a display panel which is provided with three source drivers 14.

The source driver 14 of the present invention is provide with at least two current systems, i.e., a low gray scale region reference current and a high gray scale region reference current, which has already been described in conjunction with Figure 82.

As has already been described in conjunction with Figure 82, the source driver 14 of the current driven type in accordance with the present invention is provided with a slave/master (S/M) terminal on the assumption that a plurality of driver ICs 14 are used. When the S/M terminal is brought to HIGH level, the IC 14 operates as a master chip and outputs a reference current from a reference current output terminal (not shown). Needless to say, the logic of the S/M terminal may be of the reverse polarity. In addition, it may be switched by a command to the source driver 14. The reference current is transferred along a cascade current connection line 931. By bringing the S/M terminal to LOW level, the IC 14 operates as a slave chip and receives a master chip reference current from a reference current input terminal (not shown). This current becomes a current that flows through the INL terminal (Figure 73) and through the INH terminal (Figure 74).

The reference current is generated by the current output circuit 704 in the middle of the IC chip 14. The master chip reference current is controlled externally by an external resistor or an electronic volume circuit of the current division method disposed or constructed in the inside of the IC, and is applied.

In addition, a control circuit such as a command decoder is formed or disposed in the middle of the IC chip 14. The reference current source is formed centrally in the chip with a view to making the distance between the reference current generating circuit and the program current output terminal 761 as short as possible.

In the configuration of Figure 93, a reference current is transferred to two slave chips (14a, 14c) from the master chip 14b. Each slave chip receives the reference current and, based on this current, causes parent, child, and grandchild currents to be generated. The reference current is transferred from the master chip 14b to the slave chip by means of current mirror circuit transfer (see Figure 67). By such current transfer, there is no reference current deviation between a plurality of chips, and no screen divisional line is displayed.

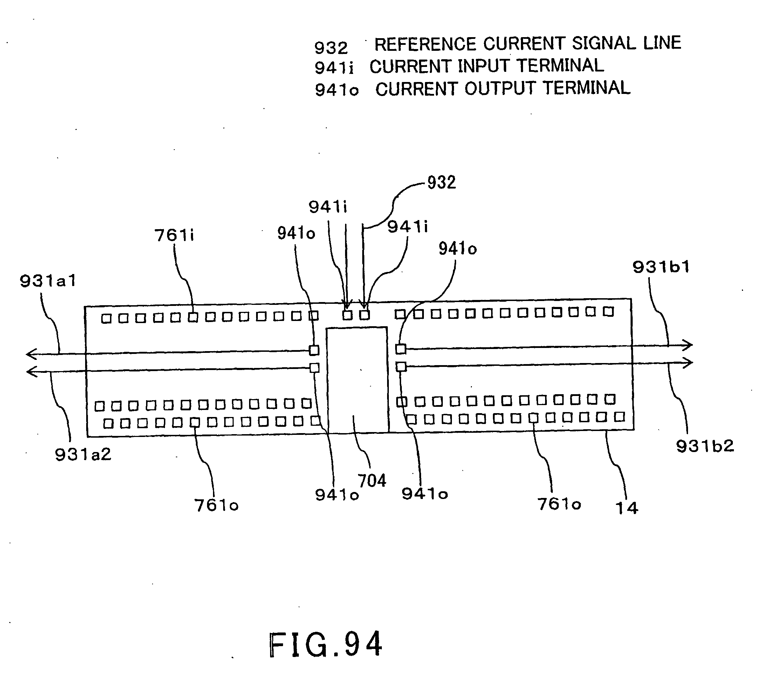

Figure 94 is a diagram which conceptually shows the position of reference current transfer terminals. A reference current signal line 932 is connected to a signal input terminal 941i disposed centrally in the IC chip. A current (or a voltage; see Figure 76) which is supplied to the reference current signal line 932 is EL-material temperature compensated. In addition, compensation for the EL-material life duration deterioration is made.

Each current source (631, 632, 633, 634) is driven in the chip 14, on the basis of the current (voltage) supplied to the reference current signal line 932. This reference current is outputted as a reference current to the slave chip, via the current mirror circuit. The reference current to the slave chip is outputted from a terminal 941o. At least one or more terminals 941o are either disposed or formed on each side of the reference current generating circuit 704. Referring to Figure 94, two terminals 941o are disposed (formed) on each side of the circuit 704. This reference current is transferred to the slave chip 14 through the cascade signal lines 931a1, 931a2, 931b1, 931b2. The circuit may be configured such that a reference current supplied to the slave chip 14a is fed back to the master chip 14b for deviation amount correction:

The problem arising when modularizing an organic EL display panel is the value of the resistance of the routing (arrangement) of the anode interconnection line 951 and cathode interconnection line. The organic EL display panel is characterized in that, although the drive voltage of the EL elemental device 15 is relatively low, a large current flows through the EL elemental device 15. Because of this, it is required for thickening the anode and cathode interconnection lines by which a current is supplied to the EL elemental device 15. For example, for the case of a polymer EL material, it is required, even for the case of EL panels of the 2-inch class, for supplying a current of not less than 200 mA to the anode interconnection line 951. Accordingly, in order to prevent the anode interconnection line 951 from undergoing a voltage drop, the resistance of the anode interconnection line should be reduced down to not more than 10 Ω. However, such resistance reduction is difficult to achieve, because in the array substrate 71 formation of interconnection lines is carried out by means of thin-film vapor deposition. Consequently, it is necessary to increase the pattern width. This however produces another problem that the width of the interconnection line exceeds 2 mm if a current of 200 mA is required to be transferred almost without a voltage drop.

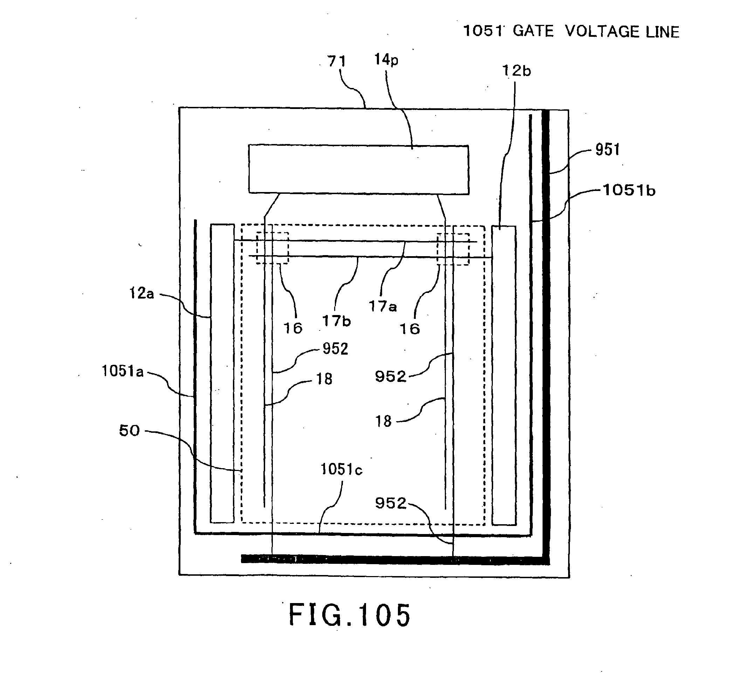

Referring now to Figure 105, there is shown a constructional arrangement of a conventional EL display panel. Internal gate drivers 12a and 12b are formed (arranged) on either side of a display region 50. In addition, a source driver 14p is also formed in the same process that the pixel's 16 TFT is formed. The source driver 14p is an internal source driver.

Disposed on the right side of the panel is an anode interconnection line 951. A voltage (Vdd) is applied to the anode interconnection line 951. The width of the anode interconnection line 951 is, for example, not less than 2 mm. The anode interconnection line 951 is branched off from a lower end portion to an upper end portion of the screen. The branch line count is the number of pixel lows. For example, in the QCIF panel, 176 rows x RGB = 528 branch lines. On the other hand, the source signal line 18 extends from the internal source driver 14p. The source signal line 18 is arranged (formed) extending from an upper end portion to a lower end portion of the screen. In addition, power supply interconnection lines 1051 of the internal gate driver 12 are arranged on either side of the display.

The picture frame on the right side of the display panel cannot be slimmed. At present, it is important for display panels for use in cellular phones to have slimmed picture frames. Further, it is important that picture frame portions on the right and left sides of the screen are made equal in size. However, it is too much for the Figure 10 configuration to achieve slim picture frames.

In order to provide a solution to the above-described problem, in the display panel of the present invention, the anode interconnection line 951 is arranged (formed) in an underside surface area of the source driver 14 and on a surface area of the array. The source driver (IC) 14 is formed (fabricated) of a semiconductor chip and is mounted on the substrate 71 by a COG (chip on glass) technique. The anode interconnection line 951 is allowed to be arranged (formed) under the source driver 14 because there is a space of from 10 to 30 μm

in the underside surface of the chip 14 extending in a direction perpendicular to the substrate. If, as shown in Figure 105, the source driver 14p is formed directly to the array substrate 71, this causes several problems about the number of masks, yield ratio, noise et cetera, thereby making it difficult to form the anode interconnection lines 951 (including a base-anode voltage line, an anode voltage line, a basic anode line) in a lower or upper layer of the source driver 14p.

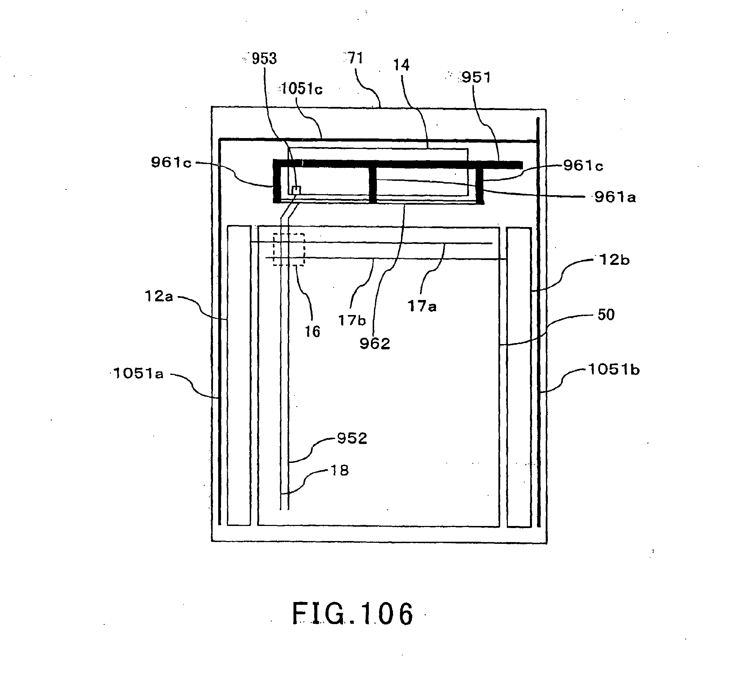

Furthermore, as shown in Figure 106, a common anode line 962 is formed, and the base anode line 951 and the common anode line 962 are short-circuited by a connection anode line 961. Particularly, the point is that the connection anode line 961 is formed centrally in the IC chip. The formation of the connection anode line 961 eliminates the difference in electric potential between the base anode line 951 and the common anode line 962. In addition, another point is that the anode interconnection line 952 branches off from the common anode line 962. By virtue of the employment of the above-described configuration, routing of the anode interconnection line 951, such as shown in Figure 105, is no longer required, thereby making it possible to provide slimmed picture frames.

If: the common anode line 962 is 20 mm in length; the interconnection line width is 150 $\mu$m; and the interconnection line sheet resistance is 0.05 $\Omega/\mu$m, then the resistance value is: 20000 ($\mu$m)/150 ($\mu$m) x 0.05 $\Omega$ = about 7 $\Omega$. If both ends of the common anode line 962 are connected to the base anode line 951 by a connection anode line 961c, the common anode line 962 is power supplied at the both ends thereof. Accordingly, the apparent resistance value is: 7 $\Omega$/2 = 3.5 $\Omega$. In addition, when substituted with a concentrating distribution multiplier, the apparent resistance value of the common anode line 962 is reduced to half (at least not more than 2 $\Omega$). Even when the anode current is 100 mA, the drop in voltage in the common anode line 962 is 0.2 V or less. Furthermore, it is possible to almost prevent the occurrence of a drop in voltage if short-circuited by a connection anode line 961b provided in the middle.

In accordance with the present invention, the base anode line 951 is formed underlying the IC 14, and the common anode line 962 is formed and the common anode line 962 is brought into electrical connection with the base anode line 951 (the connection anode line 961), and the common anode line 962 branches off from the anode interconnection line 952. The anode line can be replaced with an anode line.

Furthermore, in order that the resistance of the anode lines (the base anode line 951, the common anode line 962, the connection anode line 961, the anode interconnection line 952 et cetera) may be reduced, electric conductive materials are placed one upon the other by an electroless plating, electrolytic plating or other technique after formation of thin-film interconnection lines or prior to patterning, for achieving film thickening. By such film thickening, the cross sectional area of an interconnection line is broadened and, therefore, the interconnection line resistance is reduced. The above is likewise applied to the cathode lines as well as to the gate signal line 17 and the source signal line 18.

Accordingly, the effect of the configuration in which the common anode line 962 is formed and the common anode line 962 is power supplied at its both ends by the connection anode line 961 is excellent and, in addition, the effect is enhanced to a further extent by forming a connection anode line 961b in the middle. Furthermore, since the base anode line 951, the common anode line 962, and the connection anode line 961 together form a loop, this makes it possible to suppress an electric field that is inputted to the IC 14.

Preferably, the common anode line 962 and the base anode line 951 are formed of the same metal material. In addition, preferably the common anode line 962, the base anode line 951, and the connection anode line 961 are formed of the same metal material. These anode lines are realized by the use of an array-forming metal material or a configuration with a minimum resistance. Generally, they are realized by the metal material and the configuration (SD layer) of the source signal line 18. An area, at which the common anode line 962 and the source signal line 18 intersect with each other, cannot be formed with the same material as above. Accordingly, such an area is formed of a different material (the same material and the same configuration as the gate signal line 17 (GE layer)), and is electrically insulated by a dielectric layer. Of course, such an anode line may be formed by lamination of a thin film composed of the constructional material of the source signal line 18 and a thin film composed of the constructional material of the gate signal line 17.

In the above description, the interconnection lines (the anode and cathode interconnection lines) for the supplying of current to the EL elemental device are laid (arranged or formed) in the underside surface of the source driver 14; however, this arrangement should not in any way be deemed restrictive. For example, it may be arranged such that the gate driver 12 is formed by an IC chip and the IC chip is COG-mounted. And, anode interconnection lines and cathode interconnection lines are arranged (formed) on an underside surface of the gate driver IC 12. As described above, in the EL display device of the present invention, a drive IC is formed (fabricated) of a semiconductor chip. The IC is mounted directly onto a substrate such as the anode substrate 71. And, a power supply (e.g., an anode or cathode interconnection line) or a ground pattern is formed (fabricated) in a space of the underside surface of the IC.

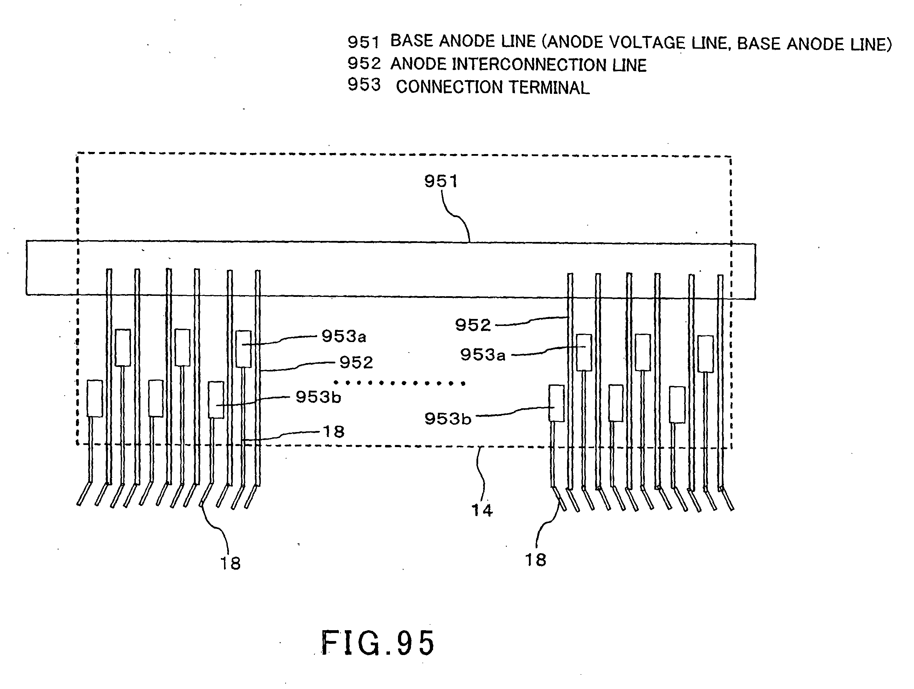

The above arrangements will be described in more detail by making reference to other drawing figures. Figure 95 is an explanatory diagram of a part of the display panel according to the present invention. In Figure 95, the position, at which the IC chip 14 is laid, is indicated by dotted line. More specifically, a base anode line (an anode voltage line, i.e., an anode interconnection line prior to branching) is formed (arranged) on the underside surface of the IC chip 14 as well as on the array substrate 71. In the exemplary embodiment of the present invention, for the sake of simplicity, it will be described such that the anode interconnection line 951 is formed on the underside surface of the IC chip (12, 14). For example, instead of forming (arranging) the anode interconnection line 951 prior to branching, either a cathode interconnection line or a cathode film may be formed (arranged). In addition, the power supply interconnection line 1051 of the gate source driver 12 may be arranged or formed.

A current output (current input) terminal 741 and a connection terminal 953 formed by COG in the array 71 are connected to the IC chip 14. The connection terminal 953 is formed at one end of the source signal line 18. In addition, the connection terminals 953 are in a zigzag arrangement (953a, 953b). The connection terminal 953 is formed on the one end of the source signal line and a terminal electrode for checking is formed at the other end.

In the present invention, the IC chip is a driver IC of the current driven type (a type in which pixels are programmed by current); however, this arrangement should not in any way be deemed restrictive. For example, the present invention is also applicable to an EL display panel (device) on which is mounted a driver IC of the voltage driven type which drives a pixel of the voltage program (Figures 43 and 53).

Arranged between the connection terminals 953a and 953b is the anode interconnection line 952 (the anode interconnection line after branching). Stated another way, the anode interconnection line 952, branched off from the thick, low-resistance base anode line 951, is formed between the connection terminals 953 and is arranged along a row of pixels 16. Accordingly, the anode interconnection line 952 and the source signal line 18 are formed (arranged) in parallel with each other. By virtue of employing the above-described configuration (formation), it becomes possible to supply the Vdd voltage to each pixel without laterally routing the base anode line 951 in the screen (Figure 105).

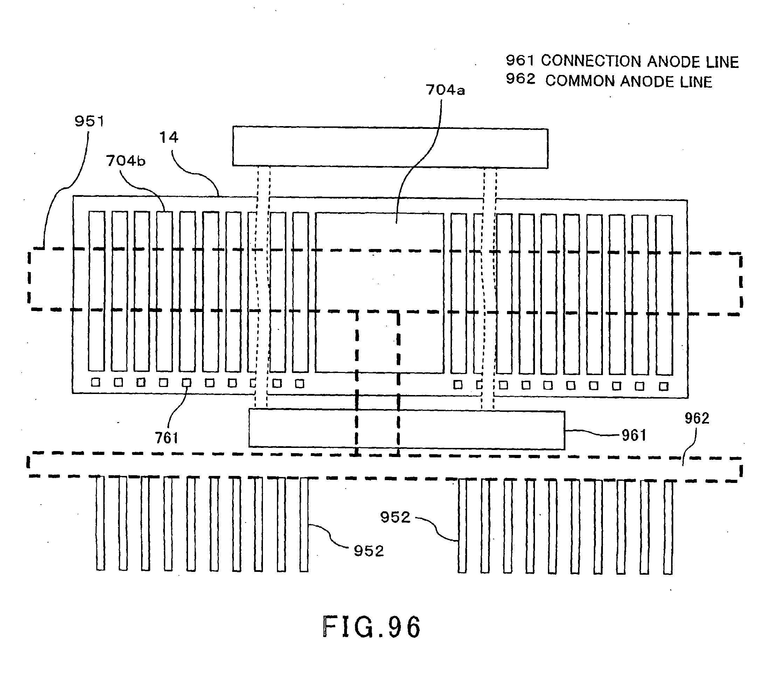

Figure 96 provides a further description. The difference between Figure 96 and Figure 95 is that in the former the anode interconnection line is not arranged between the connection terminals 953 but is branched off from a separately-formed common anode line 962. The common anode line 962 and the base anode line 951 are connected together by the connection anode line 961.

Figure 96 is a see-through diagram of the IC chip 14, illustrating an underside arrangement thereof. In the IC chip 14, the current output circuit 704 which outputs the program current Iw to the output terminal 761 is arranged. Basically, the output terminals 761 and the current output circuits 704 are arranged with regularity. Formed centrally in the IC chip 14 is a circuit as a control circuit for generating a parent current source basic current. Because of this, no output terminal 761 is formed in the middle of the IC chip, the reason for which is that the current output circuit 704 cannot be formed centrally in the IC chip.

In the present invention, the output terminal 761 is not fabricated in a central part 704a (Figure 96) of the IC chip because there is no output circuit. There are many case examples in which a control circuit is formed centrally in an IC chip such as a source driver and no output circuit is formed. Taking this point into consideration, the IC chip of the present invention was made. More specifically, no output terminal 761 is formed (arranged) in the middle of the IC chip (even in the case where a control circuit and so on are formed centrally in the IC chip such as a source driver and no output circuits are formed, it is a general practice that an output terminal (pad) is formed in the middle as a dummy pad) and the common anode line 961 is formed at this position (however, the common anode line 961 is formed in the array substrate's 71 surface). The width of the connection anode line 961 is not less than 50 nor more than 1000 μm. In addition, it is set such that the resistance value (the maximum resistance value) with respect to the length is 100 Ω or less.

The occurrence of the drop in voltage due to the flow of a current through the common anode line 962 is suppressed as low as possible by causing the base anode line 951 and the common anode line 962 to be short-circuited by the connection anode line 961. In other words, the connection anode line 961 which is a constructional component of the present invention makes effective utilization of the point that there is provided no output circuit in the middle of the IC chip. In addition, the need for the provision of the output terminal 761 which is conventionally formed in the middle of the IC chip as a dummy pad, is eliminated. This prevents the IC chip from electrically exerting an influence when the dummy pad and the connection anode line 961 come to contact with each other. However, when the dummy pad is electrically insulated from the base substrate (chip ground) of the IC chip and from the other configurations, there is no trouble even when the dummy pad comes to contact with the connection anode line 961. Therefore, it is needless to say that the dummy pad may be formed and remain in the middle of the IC chip.

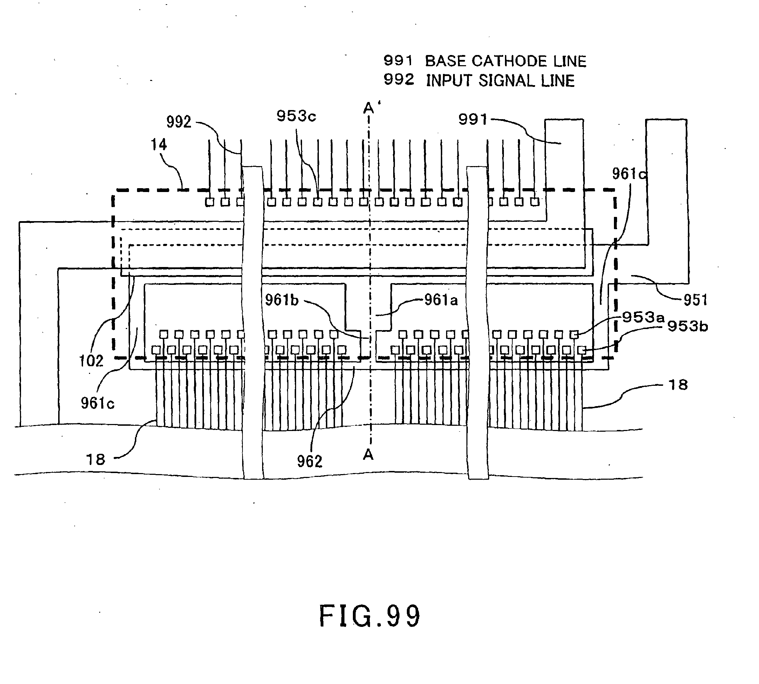

More specifically, the connection anode line 961 and the common anode line 962 are formed (arranged) in a manner as shown in Figure 99. In the first place, the connection anode line 961 is made up of a thicker portion (961a) and a thinner portion (961b). The thicker portion (961a) serves to reduce resistance. On the other hand, the thinner portion (961b) serves to form the connection anode line 961b between the output terminals 963 for establishing connection with the common anode line 962.

Furthermore, the connection of the base anode line 951 and the common anode line 962 is short-circuited not only by the connection anode line 961b but also by the connection anode lines 961c on either side. Therefore, the common anode line 962 and the base anode line 951 are short-circuited by these three connection anode lines 961. As a result of such arrangement, even when a heavy electric current flows through the common anode line 962, the drop in voltage is unlikely to occur in the common anode line 962. This is because the IC chip 14 usually has a width of 2 mm or more so that the line width of the base anode line 951 formed under the IC 14 is made greater (low impedance). Since the low-impedance base anode line 951 and the common anode line 962 are short-circuited at a plurality of points by the connection anode lines 961, this reduces the voltage drop of the common anode line 962.

The voltage drop of the common anode line 962 is reduced because: the base anode line 951 is arranged (formed) under the IC chip 14; the connection anode line 961 is arranged (formed) by making utilization of right and left positions of the IC chip 14; and the connection anode line 961b is arranged (formed) centrally in the IC chip 14.

In addition, the base anode line 951 and the cathode power supply line 991 (which is a base cathode line) are placed one upon the other through an insulating film 102, as shown in Figure 99. This laminated area constitutes a capacitor. Such a structure is called the "anode capacitor structure". This capacitor functions as a power supply path capacitor. Accordingly, it is possible to absorb an abrupt variation in current of the base anode line 951. It is advisable that the capacity of the capacitor satisfies a relation of: not more than (M/200 $\leq$ C $\leq$ M/10) where the EL display device has an S square mm display area and C indicates the capacity of the capacitor (pF). Further, it is advisable that the capacity of the capacitor satisfies a relation of: not more than (M/100 $\leq$ C $\leq$ M/20). If C is small, then it becomes difficult to absorb a variation in current. On the other hand, if C is great, then the capacitor formation area becomes too great, therefore being impractical.

In the exemplary embodiments (for example Figure 99), the base anode line 951 is arranged (formed) underlying the IC chip 14. Needless to say, the anode line may be replaced with a cathode line. In addition, in Figure 99, the base cathode line 991 may be replaced with the base anode line 951. The technical idea of the present invention is characterized in that: the driver is formed of a semiconductor chip; the semiconductor chip is mounted onto the array substrate 71 or onto a flexible substrate; and a power supply for the EL elemental device 15 or an interconnection line for the supply of ground potential (current) is arranged (formed) on an underside surface area of the semiconductor chip.

Accordingly, the semiconductor chip is not limited to the source driver 14. For example, the semiconductor chip may be the gate driver 12 or a power supply IC. Furthermore, there is included a configuration in which a semiconductor chip is mounted onto a flexible substrate and a power supply for the EL elemental device 15 or a ground pattern is arranged (formed) on a surface of the flexible substrate as well as on an underside surface of the semiconductor chip. Of course, it may be arranged such that both the source driver 14 and the gate driver 12 are formed by semiconductor chips and are mounted onto the substrate 71 by COG. And, a power supply or a ground pattern may be formed on an underside surface of the semiconductor chip. The interconnection line is formed, serving as a power supply line or a ground pattern to the EL elemental device 15; however, this arrangement should not in any way be deemed restrictive. For example, the interconnection line may serve as a power supply line to the source driver 14 or as a power supply line to the gate driver 12. In addition, the present exemplary embodiment is not limited to EL display devices. For example, the present exemplary embodiment is applicable to liquid crystal display devices and to other types of display panels such as FED and PDP. The above-described arrangement are applicable in the same way to the other exemplary embodiments of the present invention.

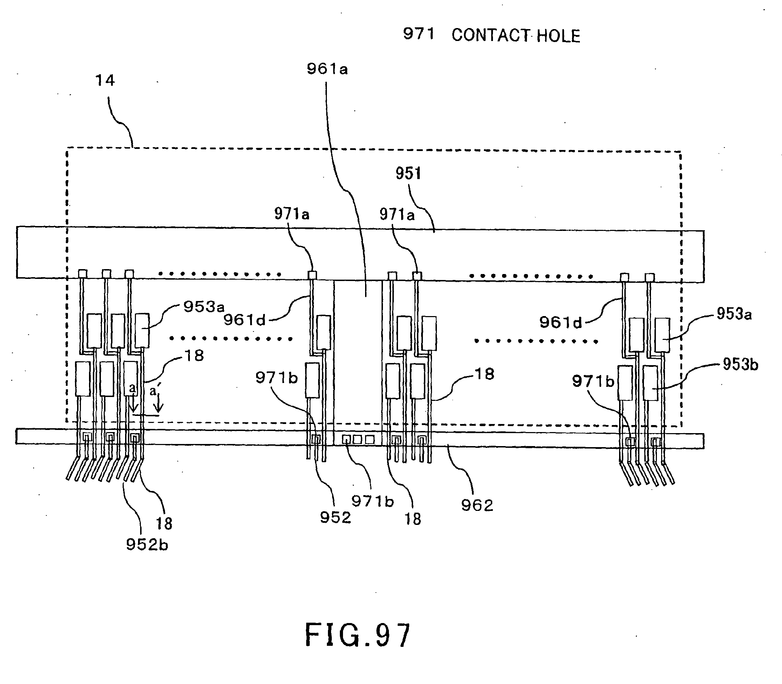

Referring now to Figure 97, there is illustrated another exemplary embodiment of the present invention. The main differences between Figure 97 and Figures 95, 96, and 99 are as follows. Contrary to the configuration of Figure 95 in which the anode interconnection line 952 is interposed between the output terminals 953, in the configuration of Figure 97 many thin connection anode lines 961d are branched off from the base anode interconnection line 951 and the connection anode line 961d and the common anode line 962 are short-circuited. Furthermore, the thin connection anode line 961 and the source signal line 18 connected to the connection terminal 953 are laminated together through the insulating film 102.

Connection between the anode line 961d and the base anode line 951 is established by a contact hole 971a, while connection between the anode interconnection line 952 and the common anode line 962 is established by a contact hole 971b. The description of the other arrangements (the connection anode lines 961a, 961b, 961c and anode capacitor configuration) is omitted here since they are the same as those shown in Figures 96 and 99.

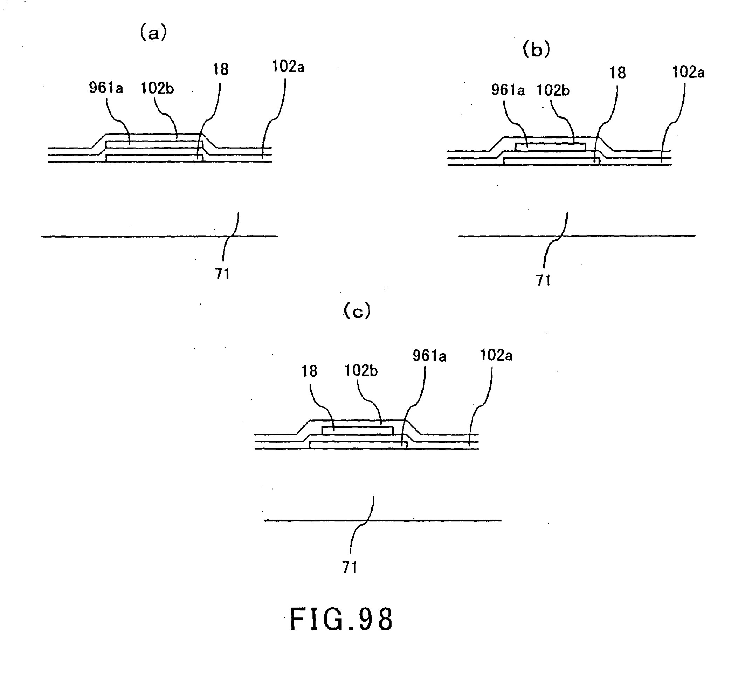

Figure 98 is a cross sectional view taken along the line A-A' of Figure 99. Referring to Figure 98(a), the source signal line 18 of substantially the same width and the connection anode line 961d are laminated together through an insulating film 102a.

The film thickness of the insulating film 102a is so set as to be not less than 500 nor more than 3000 Å. More preferably, the film thickness of the insulating film 102a is not less than 800 nor more than 2000 Å. If the film thickness is small, this produces unfavorable conditions, in other words the parasitic capacitance of the connection anode line 961d and the source signal line increases and short-circuiting of the connection anode line 961d and the source signal line 18 is likely to occur. On the other hand, if the film thickness is great, it takes a long period of time to form an insulating film. The manufacturing time increases, thereby increasing costs. Besides, it becomes difficult to form upper interconnection lines. As the material used to form the insulating film 102, an organic material, such as polyvinyl alcohol resin (PVA), epoxy resin, polypropylene resin, phenol resin, acrylic resin, polyimide resin et cetera, is exemplified. Other than that, inorganic materials such as $SiO_2$ and $SiN_x$ are exemplified. Needless to say, $Al_2O_3$ or $Ta_2O_3$ may be available. In addition, as illustrated in Figure 98 (a), the insulating film 102b is formed on the outermost surface for preventing the interconnection line 961 from undergoing corrosion and mechanical damage.

Referring to Figure 98(b), the connection anode line 961d having a narrower line width than that of the source signal line 18 is placed on the source signal line 18 through the insulating film 102. As a result of such arrangement, it becomes possible to suppress short-circuiting of the source signal line 18 and the connection anode line 961d due to a step created by the source signal line 18. In the configuration of Figure 98(b), preferably the line width of the connection anode line 961d is made narrower by 0.5 $\mu$m or more than the line width of the source signal line 18. More preferably, the line width of the connection anode line 961d is made narrower by 0.8 $\mu$m or more than the line width of the source signal line 18.

In Figure 98(b), the connection anode line 961d having a narrower line width than that of the source signal line 18 is placed on the source signal line 18 through the insulating film 102. Alternatively, it may be arranged such that the source signal line 18 having a narrower line width than that of the connection anode signal line 961d is placed on the connection anode line 961d through the insulating film 102a, as shown in Figure 98(c). Other matters are the same as the other exemplary embodiments and their description will be omitted accordingly.

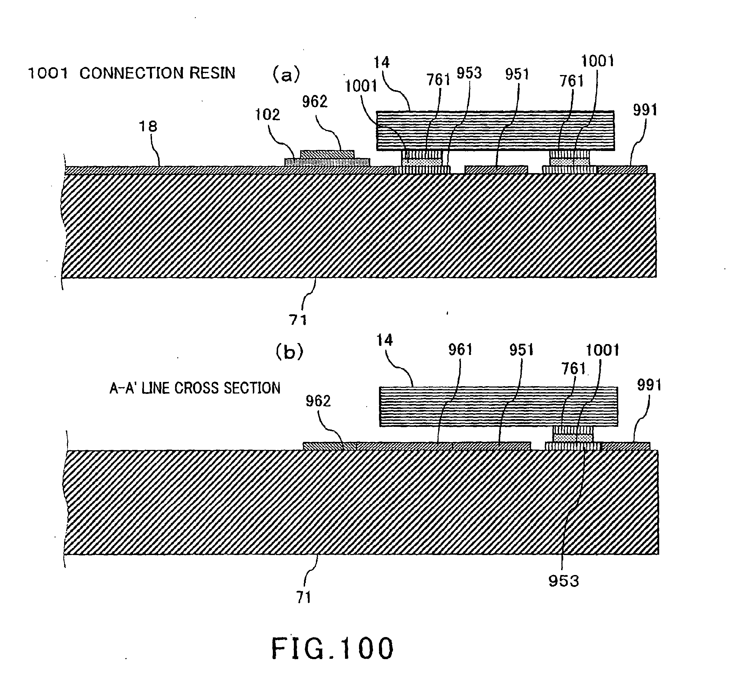

Figure 100 is a cross sectional view of a section of the IC chip 14. Although based basically on the configuration of Figure 99, the configuration of Figure 100 can be applied in the same manner or in a similar manner to, for example, Figures 96 and 97.

Figure 100(b) is a cross sectional view taken along the line A-A' of Figure 99. As can clearly be seen from Figure 100(b), the output pad 761 is not formed (arranged) centrally in the IC chip 14. The output pad is brought into connection with the source signal line 18 of the display panel. The output pad 761 is provided with a bump (projected portion) formed by means of a plating technique or nail head bonder technique. It is so set for the bump as to have a height of not less than 10 nor more than 40 $\mu$m. Needless to say, the projected portion may be formed by means of a gold plating technique (electrolytic plating, electroless plating).

The aforesaid projected portion and each of the source signal lines 18 are connected together electrically through an electric conductive junction layer (not shown). The electric conductive junction layer is made of either a mixture of a base resin as an adhesive agent (e.g., an epoxy adhesive agent, a phenol adhesive agent et cetera) and flakes of silver (Ag), gold (Au), nickel (Ni), carbon (C), tin oxide ($SnO_2$) et cetera, or a UV cure resin. The electric conductive junction layer (connection resin) 1001 is formed on the bump by a transfer technique or other technique. Alternatively, the bump and the source signal line 18 are bonded together by thermo compression with the ACF resin 1001. The method of establishing connections between the bump or the output pad 761 and the source signal line 18 is not limited to the above-described techniques. In addition, a film carrier technique may be used without mounting the IC 14 on the array substrate. In addition, connection with the source signal line 18 may be established by the use of a polyimide film or the like. Figure 100(a) is a cross sectional view of a portion at which the source signal line 18 and the common anode line 962 overlap each other(see Figure 98).

The anode interconnection line 952 is branched off from the common anode line 962. For the case of the QCIF panel, the number of anode interconnection lines 952 is: 176 x RGB = 528. The Vdd voltage (anode voltage), as shown in Figure 1, is supplied via the anode interconnection line 952. An electric current of about 200 $\mu$A at most flows through a single anode interconnection line, when the EL elemental device 15 is composed of low molecular material. Consequently, an electric current of about 100 mA (200 $\mu$A x 528) combined flows through the common anode interconnection line 962.

Therefore, in order that the voltage drop in the common anode interconnection line 962 may be held within 0.2 (V), it is required that the resistance value of a maximum route through which current flows be so held as not to exceed 2 Q (on the condition that a electric current of 100 mA flows). In the present invention, as shown in Figure 99, connection anode lines 961 are formed in three areas. When substituted by a concentrating distribution circuit, it becomes possible to easily design for the resistance value of the common anode line 962 to be extremely small. In addition, if a large number of connection anode lines 961d are formed (see Figure 97), the common anode line 962 will undergo nearly no voltage drop.

The problem is the influence exerted by a parasitic capacitance (hereinafter called the "common anode parasitic capacitance) present at an overlapped portion of the common anode line 962 and the source signal line 18. Basically, in the current driven method, if there exists a parasitic capacitance in the source signal line 18 to which a current is written, this makes it difficult to write a black representation current. Accordingly, it is required that the parasitic capacitance be made as small as possible.

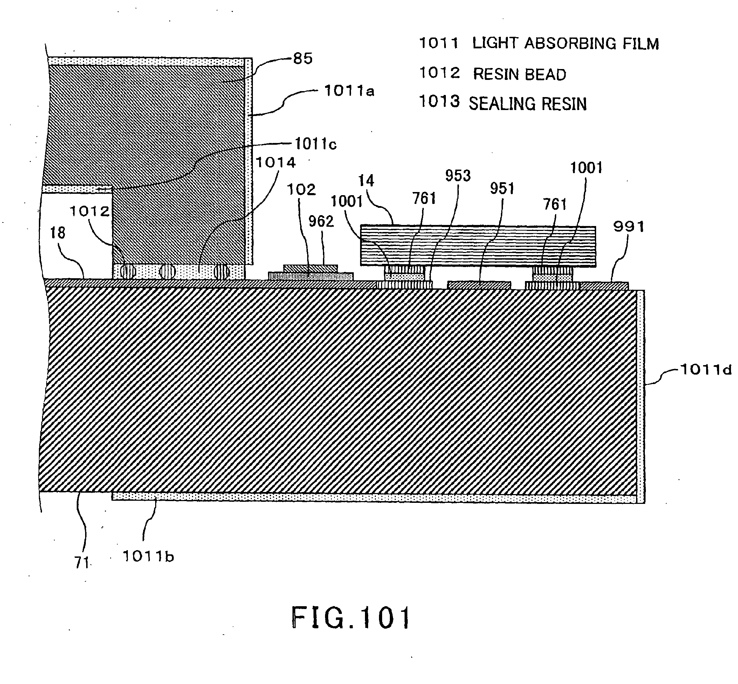

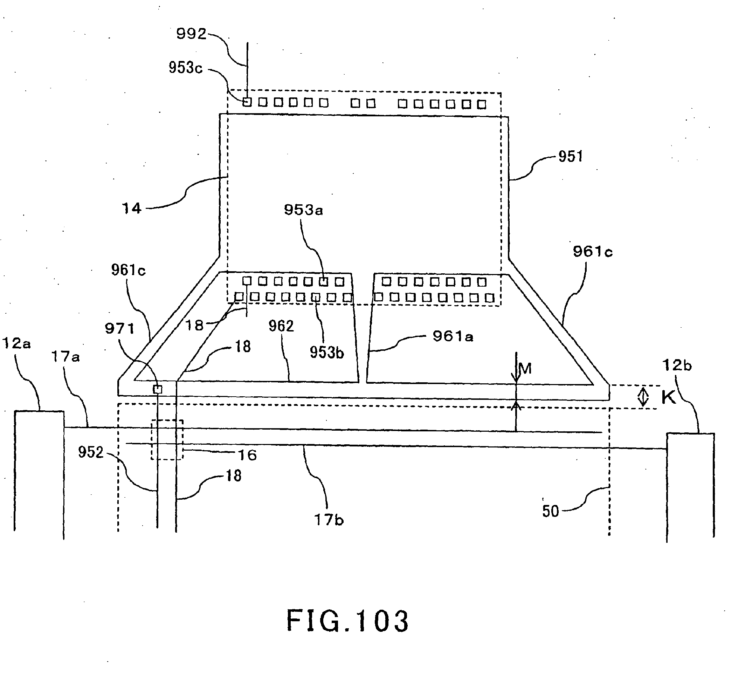

It is required that the common anode parasitic capacitance be so held as not to exceed at least 1/10 of a parasitic capacitance generated in the display region by a single source signal line 18 (hereinafter called the "display parasitic capacitance"). For example, if the display parasitic capacitance is 10 (pF), then it is required for the common anode parasitic capacitance not to exceed 1 (pF). More preferably, it is required for the common anode parasitic capacitance not to exceed 1/20 of the display parasitic capacitance. In other words, if the display parasitic capacitance is 10 (pF), then it is required for the common anode parasitic capacitance not to exceed 0.5 (pF). In the light of this point, the line width of the common anode line 962 (indicated by M'in Figure 103) and the film thickness of the insulating film 102 (see Figure 101) are determined.

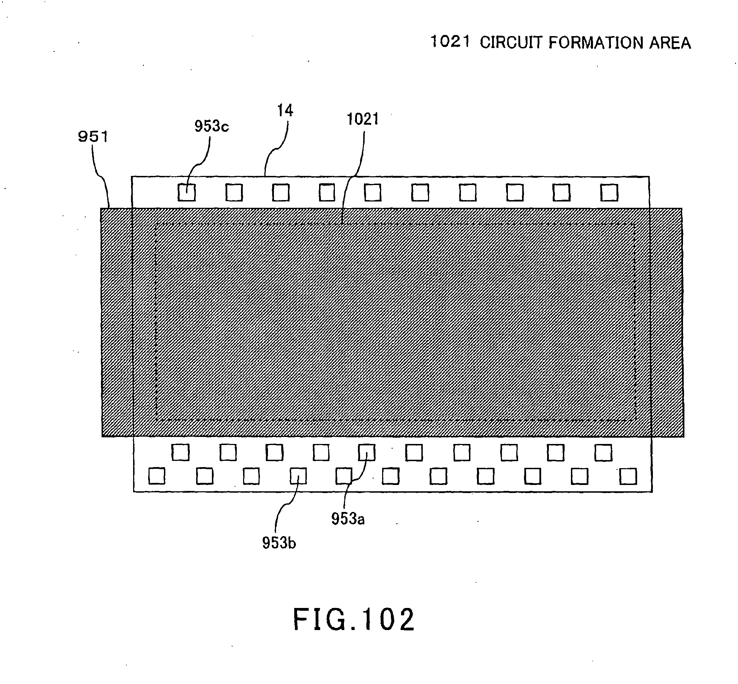

The base anode line 951 is formed (arranged) under the IC chip 14. Needless to say, it is advisable that the line width of the base anode line 951 is made as thick as possible, in the light of the lowering of resistance. Besides, it is preferable that the base anode interconnection line 951 has a light shielding function, which is explained in Figure 102. If the base anode interconnection line 951 of a metal material is formed to a given film thickness, this, of course, provides a light shielding effect. If the base anode line 951 cannot be made thicker or if the base anode line 951 is formed of transparent material such as ITO, either a light absorbing film or a light reflecting film is formed under the IC chip 14 (basically on the surface of the array 71), being layered or multi-layered on the base anode line 951. In addition, the light shielding film (the base anode line 951) of Figure 102 is not necessarily a perfect light shielding film. The light shielding film may have an opening portion therethrough. Alternatively, the light shielding film may exhibit a diffractive or scattering effect. By lamination on the base anode line 951, a light shielding composed of an optical interference multilayer is formed or arranged.

Needless to say, a light reflective plate (sheet) or a light absorbing plate (sheet) formed of a metal foil, plate, or sheet may be disposed or inserted in a space defined between the array substrate 71 and the IC chip 14. The material is not limited to the metal foil. That is to say, a light reflective plate (sheet) or a light absorbing plate (sheet) formed of a foil, plate, or sheet composed of organic or inorganic material may be disposed, inserted, or formed. Furthermore, a light absorbing material or light reflective material composed of gel substance or liquid may be filled or disposed in a space defined between the array substrate 71 and the IC chip 14. Preferably, the light absorbing material (light reflective material) made of gel substance or liquid is hardened by application of heat or light illumination. Here, for the sake of descriptive simplicity, the base anode line 951 is described as a light shielding film (light reflecting film).

As shown in Figure 102, the base anode line 951 is so formed or arranged on a surface of the array substrate 71 as to function as a light shielding film. The formation area is not limited to the surface. It suffices if no light strikes on the under surface of the IC chip 14, in order to satisfy the idea that the base anode line 951 serves as a light shielding film (light absorbing film). Therefore, it is needless to say that the base anode line 951 can be formed in an interior surface or layer of the array substrate 71. Besides, the base anode line 951 (which has a configuration or construction capable of functioning either as a light shielding film or as a light absorbing film) can be formed on an underside surface of the array substrate 71 as long as such formation (i. e., formation of the base anode line 951 on the underside surface of the array substrate 71) prevents rays of light from striking upon the IC chip 14.

For example, in Figure 102, the light shielding film is formed on the array substrate 71; however, this arrangement should not in any way be deemed restrictive. It may be arranged such that the light shielding film is formed directly on the underside surface of the IC chip 14. In this case, the insulating layer 102 (not shown) is formed on the underside surface of the IC chip 14 and either a light shielding film or a light reflecting film is formed on the insulating layer 102. For the case of a configuration in which the source driver 14 is formed directly on the array substrate 71 (i.e., a driver construction by low-temperature polysilicon technology, high-temperature polysilicon technology, solid-phase growth technology, or amorphous silicon technology), it suffices that a light shielding film, light absorbing film, or a light reflecting film is formed on the substrate 71 and the driver circuit 14 is formed (arranged) thereon.

A large number of transistor elemental devices (the current sources 634 et cetera) through which microcurrent flows are formed in the IC chip 14 (a circuit formation section 1021 of Figure 102). When rays of light strike upon such a transistor elemental device through which microcurrent flows, the photoconductor phenomenon occurs. As a result, the output current (the program current Iw), the parent current amount, and the child current amount each undergo a variation, thereby assuming abnormal values, in other words variations occur. Especially, for the case of a self-luminous elemental device such as an organic EL elemental device, strong light is emitted from areas other than the display region 50 because rays of light generated from the EL elemental device 15 are reflected diffusely in the inside of the substrate 71. When the light thus reflected strikes upon the circuit formation section 1021 of the IC chip 14, the photoconductor phenomenon occurs. Accordingly, measures to deal with the photoconductor phenomenon are those proper to the EL display devices.

In order to deal with such a problem, in accordance with the present invention the base anode line 951 is formed on the substrate 71, which serves as a light shielding film. It is designed such that the region, in which the base anode line 951 is formed, covers the circuit formation section 1021, as shown in Figure 102. As described above, by virtue of the formation of the light shielding film (the base anode line 951), the photoconductor phenomenon is completely prevented from occurring. Particularly, the EL power supply line such as the base anode interconnection line 951 undergoes some variation in potential due to a flow of current accompanied with a screen rewrite. Since the amount of potential variation varies little by little at the timing of 1H, it may be taken almost as the ground potential (which means that the potential does not vary). Consequently, the base anode line 951 (or the base cathode line) performs not only a light shielding function but also a shield effect.

For the case of a self-luminous elemental device such as an organic EL elemental device, strong light is emitted from the areas other than the display region 50 because rays of light generated from the EL elemental device 15 are reflected diffusely in the inside of the substrate 71. In order to avoid or suppress diffuse reflection of the light rays, a light absorbing film 1011 is formed in an area capable of blocking the passage of light effective to the display of an image (invalid region). The valid region includes the display region 50 and its neighboring areas. A light absorbing film 1011a is formed on an external surface of a sealing lid 85. A light absorbing film 1011c is formed on an internal surface of the sealing lid 85. A light absorbing film 1011d is formed on a side surface of the substrate 70. A light absorbing film 1011b is formed in an area other than the substrate image display region. The use of the light absorbing film should not in any way be deemed restrictive. For example, a light absorbing sheet may be attached. Alternatively, a light absorbing wall may be provided. In addition, the concept of "light absorption" includes a method or structure for diffusing rays of light by light scarring and further includes, in the broad sense, a method or structure for sealing in light.

As the material of the light absorbing film, a substance formed of carbon-contained organic material (for example, carbon-contained acrylic resin), a substance prepared by dispersing in an organic resin a black dye or pigment, and a substance prepared by dyeing a gelatine or casein with a block acid colorant (like a color filter) may be used. In addition to these substances, a substance prepared by subjecting a fluoran-based coloring mater which becomes black by itself to color development and a colored black prepared by mixing of a dye of the green color family with a dye of the red color family may be used as the material of the light absorbing film. In addition, a film of $PrMnO_3$ formed by means of sputtering and a film of phthalocyanine formed by plasma polymerization may be used as the light absorbing film.

All of the above-mentioned materials are black; however, as the material of the light absorbing film, a material which is in a complementary color relationship with the color of light generated by a display elemental device may be used. For example, it suffices to use a color filter light absorbing material, which has been so improved as to exhibit desired light absorbing properties. Basically, like the above-described black light absorbing materials, a substance obtained by dyeing a natural resin with a dye may be used. In addition, a material prepared by dispersing in a synthetic resin a dye may be available. The range of dye selection is rather wider in comparison with the black dye, and an adequate one may be selected from the group consisting of an azo dye, an anthraquinone dye, a phthalocyanine dye, and a triphenyl dye, or a combination of two or more thereof may be used.

Furthermore, metal materials may be used as the material of the light absorbing film. For example, sexivalent chrome is an example. Sexivalent chrome is black and is able to function as a light absorbing film. In addition, light scattering materials such as opal glass and titanium oxide are suitable. To sum up, light scattering is, in the outcome, equivalent to light absorption.

The sealing lid 85 is adhered to the substrate 71 with a sealing resin 1031 containing therein resin beads 1012 having a size of not less than 4 nor more than 15 μm. The lid 85 is arranged and fixed without application of pressure.

In the exemplary embodiment of Figure 99, the common anode line 962 is formed (arranged) in the vicinity of the IC chip 14; however, this arrangement should not in any way be deemed restrictive. For example, as shown in Figure 103, the common anode line 962 may be formed near the display region 50. Preferably, the common anode line 962 is formed in proximity to the display region 50, because the distance between the source signal line 18 and the anode interconnection line 952 is short and the area, in which they are arranged (formed) in parallel with each other, is reduced. If the distance between the source signal line 18 and the anode interconnection line 952 is short and, in addition, they are arranged in parallel, this generates a parasitic capacitance between the source signal line 18 and the anode interconnection line 952. Such a problem is eliminated if, as shown in Figure 103, the common anode line 962 is placed in the vicinity of the display region 50. Preferably, the distance (K) from the screen display region 50 to the common anode line 962 does not exceed 1 mm (see Figure 103).

It is preferable that the common anode line 962 is formed of a metal material of which the source signal line 18 is formed, in order to make the resistance of the common anode line 962 as low as possible. In the present invention, the common anode line 962 is formed of a thin film of Cu, a thin film of Al, a laminated structure of Ti/Al/Ti, or a metal material (SD metal) formed of alloy or amalgam. Therefore, in order to avoid the occurrence of short-circuiting, the area, at which the source signal line 18 and the common anode line 962 intersect with each other, is replaced with a metal material (GE metal) of which the gate signal line 17 is formed. The gate signal line comprises a metal material having an Mo/W laminated structure.

In general, the sheet resistance of the gate signal line 17 is higher than the sheet resistance of the source signal line 18. This is typically practiced in the field of liquid crystal display devices. However, in the organic EL display panel of the current driven type, the current flowing through the source signal line 18 is very small (from 1 to 5 μA). Accordingly, even when the wiring resistance of the source signal line 18 is high, there occurs substantially no voltage drop, thereby realizing excellent image display. In the liquid crystal display device, image data is written to the source signal line 18 by voltage. Therefore, if the resistance value of the source signal line 18 is high, the image data cannot be written to the source signal line 18 in a single horizontal scanning period.

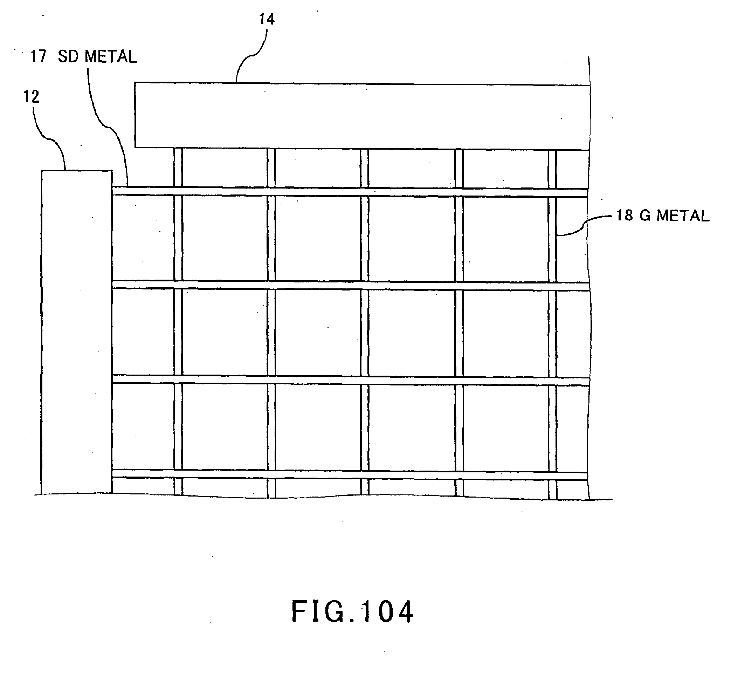

However, in the current driven method of the present invention, the fact that the resistance value of the source signal line 18 is high (in other words, the sheet resistance thereof is high) does not make any difference. Accordingly, the sheet resistance of the source signal line 18 can be higher than the sheet resistance of the gate signal line 17. Accordingly, in the EL display panel of the present invention (conceptually, in the display panel or display device of the current driven type), it may be arranged such that the source signal line 18 is fabricated (formed) of a GE metal while the gate signal line 17 is fabricated (formed) of an SD metal (in contrast to the liquid crystal display panel), as shown in Figure 104.

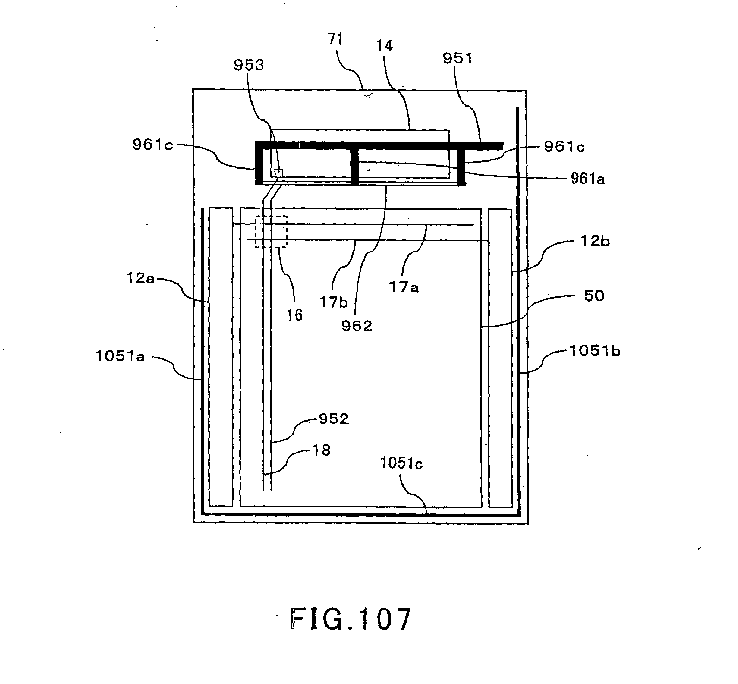

Figure 107 shows a constructional arrangement in which, in addition to the arrangement shown in Figures 99 and 103, a power supply interconnection line 1051 for driving the gate driver 12 is laid. This power supply interconnection line 1051 is routed, in the panel display region 50, to the right-hand end, to the lower side, and to the left-hand end. Stated another way, the gate driver 12a and the gate driver 12b use the same power supply.

However, preferably the gate driver 12a which selects a gate signal line 17a which controls the TFTs 11b and 11c, and the gate driver 12b which selects a gate signal line 17b which controls the TFT 11d and the current flowing through the EL elemental device 15 differ in power supply voltage from each other. Particularly, it is preferable that the amplitude of vibration of the gate signal line 17a (ON voltage - OFF voltage) is made as small as possible, because, as the amplitude of vibration of the gate signal line 17a decreases, the punch-through voltage to the capacitor 19 of the pixel 16 likewise decreases (see for example Figure 1). On the other hand, since the gate signal line 17b has to control the EL elemental device 15, its vibration amplitude cannot be reduced.

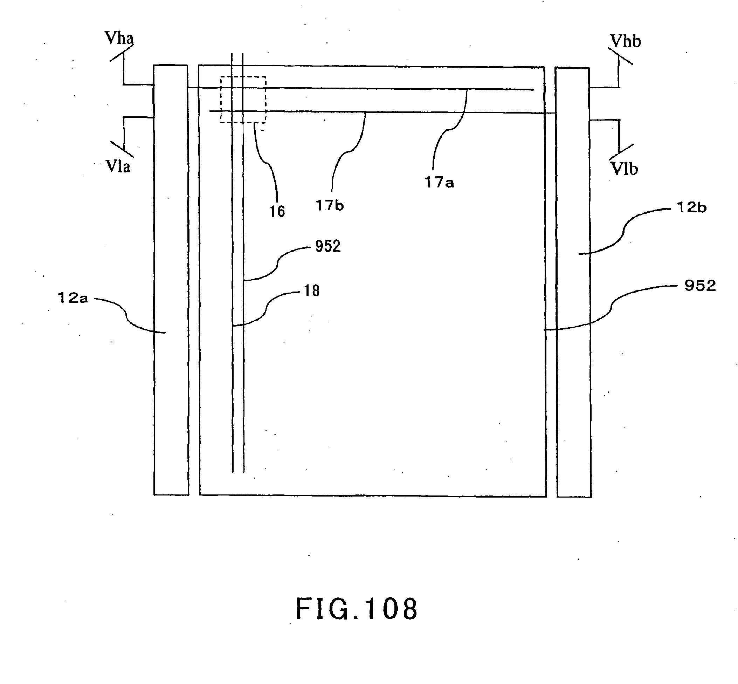

Accordingly, as shown in Figure 108, voltages that are applied to the gate driver 12a are Vha (the OFF voltage of the gate signal line 17a) and Vla (the ON voltage of the gate signal line 17a), while voltages that are applied the gate driver 12a are Vhb (the OFF voltage of the gate signal line 17b) and Vla (the ON voltage of the gate signal line 17b). Here, there is a relation of Vla < Vlb. It may be arranged such that Vha substantially equals Vhb.

The gate driver 12 is usually made up of an N channel transistor and a P channel transistor. However, preferably the gate driver 12 is formed using only P channel transistors, because the number of masks required for preparing an array is decreased and improvements in manufacture yield ratio and throughput are expected. Therefore, as shown in Figures 1 and 2, the TFT constituting the pixel 16 is a P channel transistor and the gate driver 12 is also formed or constructed of a P channel transistor. When the gate driver is formed by N and P channel transistors, the number of masks required is ten, while on the other hand, if formed using only P channel transistors, the number of masks required can be reduced to five.

However, if the gate driver 12 is formed using only P channel transistors, this makes it impossible to form a level shifter circuit in the array substrate 71, because the level shifter circuit is made up of N and P channel transistors.

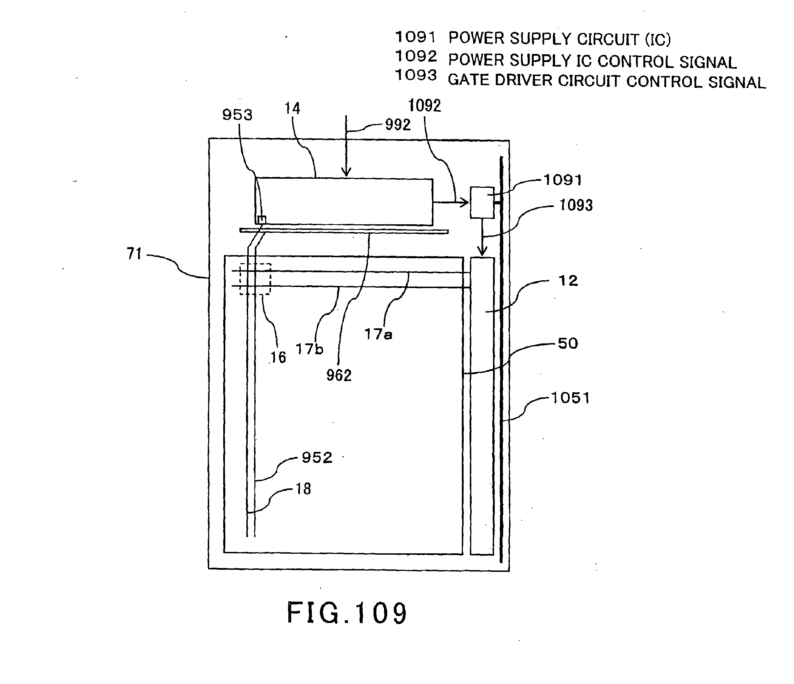

To deal with this problem, in the present invention, a power supply IC 1091 contains therein a level shifter circuit function, an example of which is illustrated in Figure 109. The power supply IC 1091 generates the drive voltage of the gate driver 12, the anode and cathode voltages of the EL elemental device 15, and the drive voltage of the source driver 14.

In order for the power supply IC 1091 to generate the anode and cathode voltages of the EL elemental device 15 of the gate driver 12, it is required that a semiconductor process capable of withstanding high pressure be used. When withstanding such high pressure, a level shift to the voltage of a signal driven by the gate driver 12 can be made.

Accordingly, level shifting and driving of the gate driver 12 are executed by the constructional arrangement of Figure 109. Input data (image data, command, control data) 992 is fed to the source driver 14. The input data includes control data for the gate driver 12. The withstanding voltage (operational voltage) of the source driver 14 is 5 (V). On the other hand, the operational voltage of the gate driver 12 is 5 (V). The signal which is outputted from the source driver 14 to the gate driver 12 has to be level shifted from 5 to 15 (V). This level shifting operation is carried out by the power supply circuit (IC) 1091. In Figure 109, the data signal for controlling the gate driver 12 is a power supply IC control signal 1092.

The input data signal 1092 for controlling the gate driver 12 is level shifted by a level shifter circuit built in the power supply circuit 1091, and the signal thus level shifted is outputted as a gate driver control signal 1093 for controlling the gate driver 12.

Hereinafter, the gate driver 12 of the present invention contained in the substrate 71 and comprising only P channel transistors will be described. As previously described, it becomes possible to reduce the number of masks required for array formation, to achieve improvements in manufacture yield ratio, and to achieve improvements in throughput by forming the pixel 16 and the gate driver 12 by the use of only P channel transistors, in other words, transistors that are formed in the substrate 71 are all P channel transistors (no N channel transistors). In addition, it is possible to work only on the improvement in performance of the P channel transistor, thereby facilitating the improvement in characteristics. More specifically, it is possible to more easily reduce the Vt voltage (approximated to near 0 (V)) and the Vt variation, in comparison with the CMOS structure which uses both P and N channel transistors.

As shown in Figure 106, in the present invention the gate driver 12 is arranged, formed, or fabricated on each side of the display region 50 by phase (shift register). In the description, the gate driver 12 and the other components including the pixel's 16 transistor are formed or constructed by means of low-temperature polysilicon technology in which the process temperature does not exceed 450 degrees Centigrade; however, this arrangement should not in any way be deemed restrictive. For example, high-temperature polysilicon technology (process temperature: above 450 degrees Centigrade) may be used to construct the gate driver 12. Alternatively, a TFT formed of a solid-phase grown semiconductor film may be used to form the gate driver 12. The gate driver 12 is formed of an organic TFT. TFTs formed or constructed by amorphous silicon technology may be available.

One of the gate drivers 12 is the gate driver 12a on the selection side. The gate driver 12a applies an ON/OFF voltage to the gate signal line 17a and controls the pixel TFT 11. The other gate driver 12 is the gate driver 12b which controls or ON/OFF controls an electric current that flows through the EL elemental device 15. In the exemplary embodiment of the present invention, the description has been made mainly focusing on the pixel structure of Figure 1. However, the Figure 1 pixel structure should not in any way be deemed restrictive. Needless to say, the exemplary embodiment of the present invention is applicable to the other pixel structures shown in Figures 50, 51, 54 and so on. In addition, the configuration of the gate driver 12 of the present invention and its drive method are able to bring out more characteristic effects when combined with the display panel, display device, or information display device formed in accordance with the present invention. However, such effects can of course be brought out in different configurations.

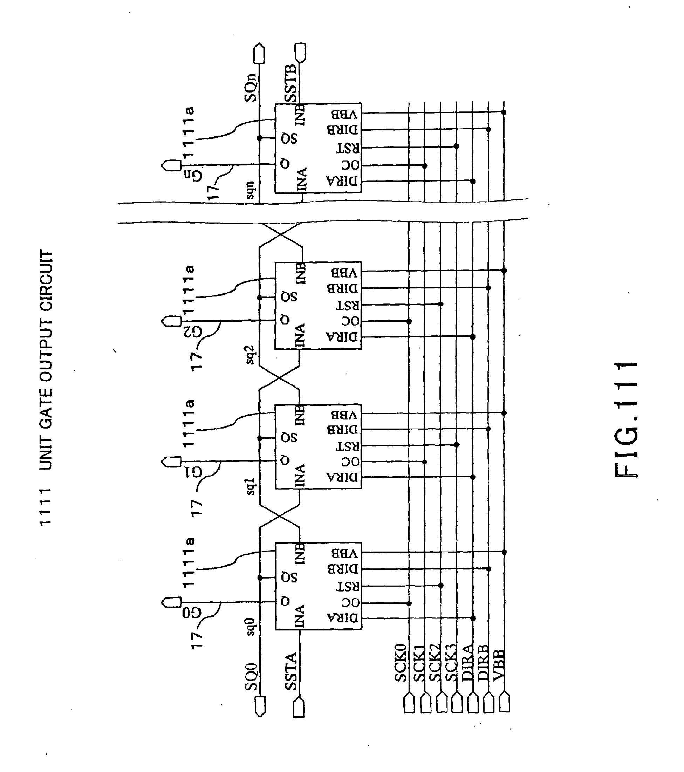

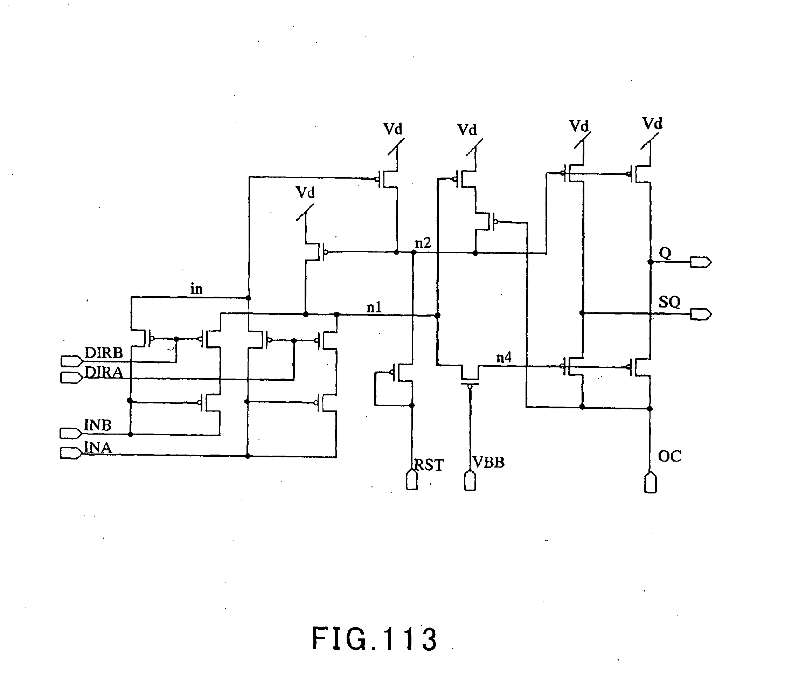

The following configuration/arrangement manner of the gate driver 12 is not limitedly applicable to organic EL display panels and self-luminous devices and may find its application in liquid crystal display panels and electromagnetic induction display panels. For example, in the liquid display panel the configuration or method of the gate driver 12 of the present invention may be employed as a pixel selecting switching device controller. In addition, in the case where two phases of gate drivers 12 are used, it may be arranged such that one phase is employed for pixel switching elemental device selection while the other phase is brought into connection to one terminal of a retention capacitor in the pixel. This method is called the "independent CC drive" (capacitance coupling drive method). Furthermore, needless to say, the configuration, described in conjunction with Figures 111, 113 and so on, can be applicable not only to the gate driver 12 but also to the shift register circuit of the source driver 14.

Preferably, the gate driver 12 of the present invention is embodied or employed as the gate driver 12 of each of Figures 6, 13, 16, 20, 22, 24, 26, 27, 28, 29, 34, 37, 40, 41, 48, 82, 51, 92, 93, 103, 104, 105, 106, 107, 108, 109 and so on.

Referring to Figure 111, there is shown a block diagram of the gate driver 12 of the present invention. For the sake of descriptive simplicity, unit gate output circuits 111 of four stages are shown. However, basically a corresponding number of unit gate output circuits 111 to the number of gate signal lines 17 are formed or arranged.

As shown in Figure 111, the gate driver 12 (12a, 12b) is provided with signal terminals, namely four clock terminals (SCK0, SCK1, SCK2, and SCK3), a single start terminal (data signal (SSTA)), and two inverting terminals (DIRA and DIRB for application of a reverse-phase signal). In addition, it further comprises an L power supply terminal (VBB) and an H power supply terminal (Vd) which are power supply terminals.

Since the gate driver 12 of the present invention is formed using only P channel TFTs (transistors), this makes it impossible for a level shifter circuit (which is a circuit operable to convert a logic signal of low voltage level into a logic signal of high voltage level) to be built in the gate driver. To cope with this, the level shifter circuit is arranged or formed in the power supply circuit (IC) 1091 as shown in for example Figure 109. The power supply circuit (IC) 1091 is operable to generate voltages at potentials necessary for the ON voltage (selection voltage) of the pixel's 16 TFT and the OFF voltage (non-selection voltage) of the pixel's 16 TFT, the generated voltages being outputted from the gate driver 12 to the gate signal line 17. Accordingly, the voltage resistance process of a semiconductor of which the power supply IC (circuit) 1091 is formed has resistance to high voltage. Therefore, it is convenient that logic signals are level shifted (LSed) in the power supply IC 1091. Accordingly, a control signal for the gate driver 12 outputted from a controller (not shown) is fed to the power supply IC 1091, is level shifted, and is delivered to the gate driver 12 of the present invention. A control signal for the source driver circuit 14 outputted from a controller (not shown) is fed directly to the source driver 14 of the present invention, because no level shifting is required.

The present invention is not limited to such an arrangement that all transistors which are formed in the array substrate 71 are P channel transistors. If the gate driver 12 is made up of P channel transistors as will be described later (see Figures 111 and 113), this makes it possible to make picture frames slim. For the case of a 2.2-inch QCIF panel, the width of the gate driver 12 is 600 µm when employing a 6-µm design rule. Even when counting in the routing of power supply interconnection lines of the gate driver 12, the width is 700 µm. If the same circuitry is fabricated by CMOS (N and P channel transistors), the width is 1.2 mm. Therefore, if the gate driver 12 is formed of P channel transistors, this provides a characteristic effect such as picture-frame sliming.

In addition, if the pixel 16 is made up of a P channel transistor, this provides excellent matching with the gate driver 12 formed by a P channel transistor. The P channel transistors (TFT 11b, TFT 11c, TFT 11d in the pixel configuration of Figure 1) are turned on by an L voltage. On the other hand, the selection voltage of the gate driver 12 is also the L voltage. As can be seen from the configuration shown in Figure 113, the P channel gate driver provides excellent matching if the selection level is the L level. This is because the L level cannot be held for a long period of time. On the other hand, the H voltage can be held for a long period of time.

In addition, if the drive TFT (the TFT 11a in Figure 1) operable to supply an electric current to the EL elemental device 15 is also formed by a P channel transistor, this makes it possible to form a cathode of the EL elemental device 15 into a solid electrode made of a metal thin film. Besides, it is possible to cause an electric current to flow from the anode potential Vdd toward the EL elemental device 15 in the forward direction. In view of the above, it is advisable that the transistor of the pixel 16 is a P channel transistor and the transistor of the gate driver 12 is also a P channel transistor. As can be seen, the arrangement, in which the transistor constituting the pixel 16 of the present invention (such as a drive TFT and a switching TFT) is implemented by a P channel transistor and the transistor of the gate driver 12 is implemented by a P channel transistor, is not just a matter of design.

In view of this point, the level shifter (LS) circuit may be formed directly in the substrate 71. In other words, the level shifter (LS) circuit is formed by N and P channel transistors. A logic signal from the controller (not shown) is so pulled up as to conform to the logic level of the gate driver 12 formed of P channel transistors by the level shifter directly formed in the substrate 71. The logic voltage thus pulled up is applied to the gate driver 12.

It may be arranged such that the level shifter circuit is formed by a semiconductor chip and is COG-mounted onto the substrate 71. In addition, the source driver 14 is basically formed of a semiconductor chip and is COG-mounted onto the substrate 71, as shown in Figure 109. However, the arrangement that the source driver 14 is formed of a semiconductor chip should not in any way be deemed restrictive. For example, the source driver 14 is formed directly in the substrate 71 by a polysilicon technique. If the transistor 11 constituting the pixel 16 is formed of a P channel transistor, a program current flows from the pixel 16 to the source signal line 18. Accordingly, it is required that the unit current circuit 634 of the source driver (see for example Figures 73 and 74) be formed of an N channel transistor. In other words, the source driver 14 is so circuit-configured as to draw in the program current Iw.

Accordingly, in the case where the drive TFT 11a of the pixel 16 (Figure 1) is implemented by a P channel transistor, the unit current source 634 is formed by an N channel transistor so that the source driver 14 draws in the program current Iw. When forming the source driver 14 in the array substrate 71, it is required for using both an N channel mask (process) and a P channel mask (process). Conceptually speaking, the pixel 16 and the gate driver 12 are each formed by a P channel transistor and the transistor of the drawing-in current source of the source driver is formed by an N channel transistor, in the display panel (display device) of the present invention.

For the sake of descriptive simplicity, in the exemplary embodiment of the present invention the description has been made using the pixel configuration of Figure 1 by way of example. However, the technical idea of the present invention that the selection transistor of the pixel 16 (the TFT 11c in Figure 1) is formed by a P channel transistor and the gate driver 12 is formed by a P channel transistor, is not limited to the pixel configuration of Figure 1. For example, it is needless to say that the technical idea of the present invention is applicable to a current mirror pixel configuration of the current driven type as shown in Figure 42. Besides, the technical idea of the present invention is applicable to the two TFTs as shown in Figure 62 (the TFT 11b (selection transistor) and the TFT 11a (drive transistor) ) in the pixel configuration of the current driven type. It is of course applicable to the configuration of the gate driver 12 (Figures 111 and 113) and it is possible to form a device by combination. Accordingly, the above-described arrangement and the following arrangements that will be described below are not limited to the pixel configuration.

Furthermore, the arrangement, in which the selection transistor of the pixel 16 is formed by a P channel transistor and the gate driver is formed of a P channel transistor, is not limited to self-luminous devices (display panels or display apparatus) such as organic EL elemental devices. For example, such arrangement is applicable to liquid crystal display devices.

The inverting terminals (DIRA, DIRB) are supplied a signal common for all the unit gate output circuits 1111. As can be seen from the equivalent circuit diagram of Figure 113, the inverting terminals (DIRA, DIRB) are fed voltage values that are of opposite polarity. In addition, when inverting the direction of scanning of the shift register, the polarity of the voltages applied to the inverting terminals (DIRA, DIRB) is inverted.

In the circuit configuration of Figure 111, the number of clock signal lines is four. The arrangement that the number of clock signal lines is four is optimal for the present invention; however, this arrangement should not in any way be deemed restrictive. The number of clock signal lines may be not more than four or not less than four.

The inputting of the clock signals (SCK0, SCK1, SCK2, SCK3) differs among the neighboring unit gate output circuits 1111. For example, in the unit gate output circuit 1111a, the clock signal SCK0 is inputted to the terminal OC and the clock signal SCK2 is inputted to the terminal RST This state is the same as in the unit gate output circuit 1111c. In the unit gate output circuit 1111b (the next-stage unit gate output circuit) next to the unit gate output circuit 1111a, the clock signal SCK1 is inputted to the terminal OC and the clock signal SCK3 is inputted to the terminal RST. To sum up, the inputting of the clock signals is made different alternately from one unit gate output circuit to another. More specifically, in the first stage unit gate output circuit 1111a, the clock signal SCK0 is inputted to the terminal OC and the clock signal SCK2 is inputted to the terminal RST. In the second stage unit gate output circuit 1111b, the clock signal SCK1 is inputted to the terminal OC and the clock signal SCK3 is inputted to the terminal RST. In the third stage unit gate output circuit 1111c, the clock signal SCK0 is inputted to the terminal OC and the clock signal SCK2 is inputted to the terminal RST.

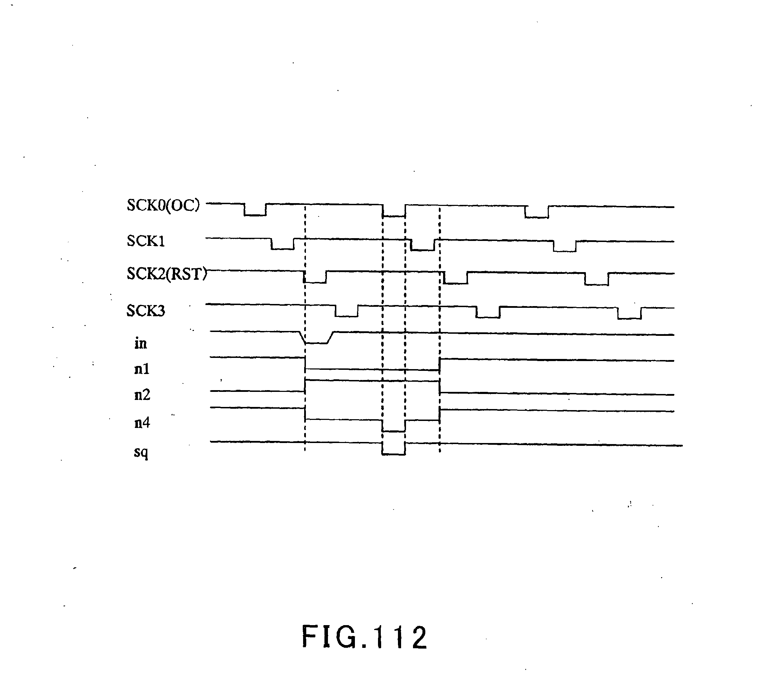

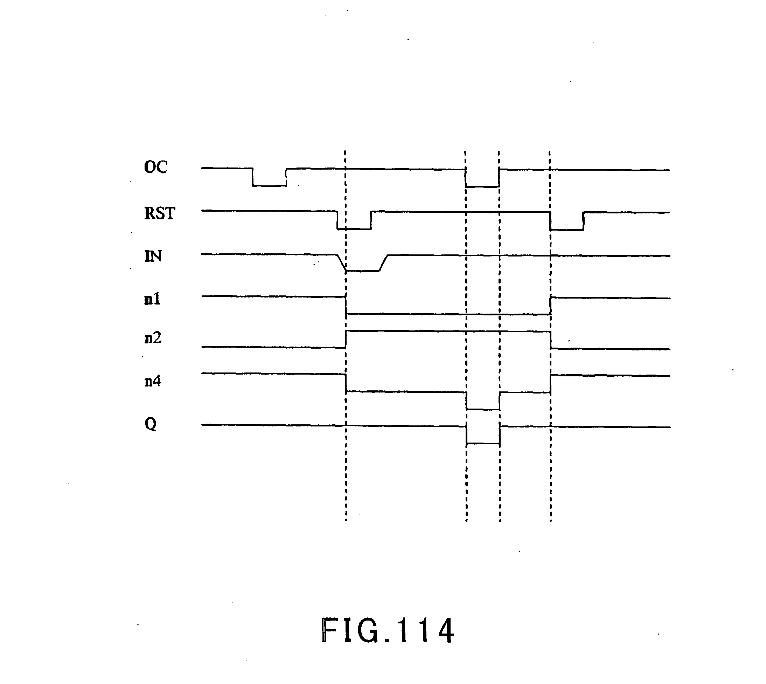

Referring to Figure 113, there is shown a circuit configuration of the unit gate output circuit 1111, which is composed of only P channel transistors. Figure 114 is a timing chart serving to provide a description of the circuit configuration of Figure 113. Figure 112 shows a timing chart for a plurality of stages of Figure 113. Accordingly, the entire operation can be understood by understanding Figure 113. The timing chart of Figure 114 provides a better understanding of the operation than written description (see the equivalent circuit diagram of Figure 113). Therefore, detailed description of the operation of each transistor is omitted accordingly.

If only P channel transistors are used to form a driver circuit configuration, it is basically possible to maintain the gate signal line 17 at HIGH level (the voltage Vd in Figure 113). However, it is difficult to maintain, for a long period of time, the gate signal line 17 at LOW level (the voltage VBB in Figure 113). But the gate signal line 17 can sufficiently be held at LOW level for a short period of time during, for example, pixel row selection. By the signal inputted to the IN terminal and the SCK clock signal inputted to the RST terminal, n1 is varied and n2 is placed in the inverted signal state of n1. Although the potential of n2 and the potential of n4 are identical in polarity with each other, the level of potential of n4 is reduced to a further extent by the SCK clock signal inputted to the OC terminal. The Q terminal is held at LOW level during the period in response to the reduced level and the ON voltage is outputted from the gate signal line 17. The signal outputted to the SQ or Q terminal is transferred to the next-stage unit gate output circuit 1111.

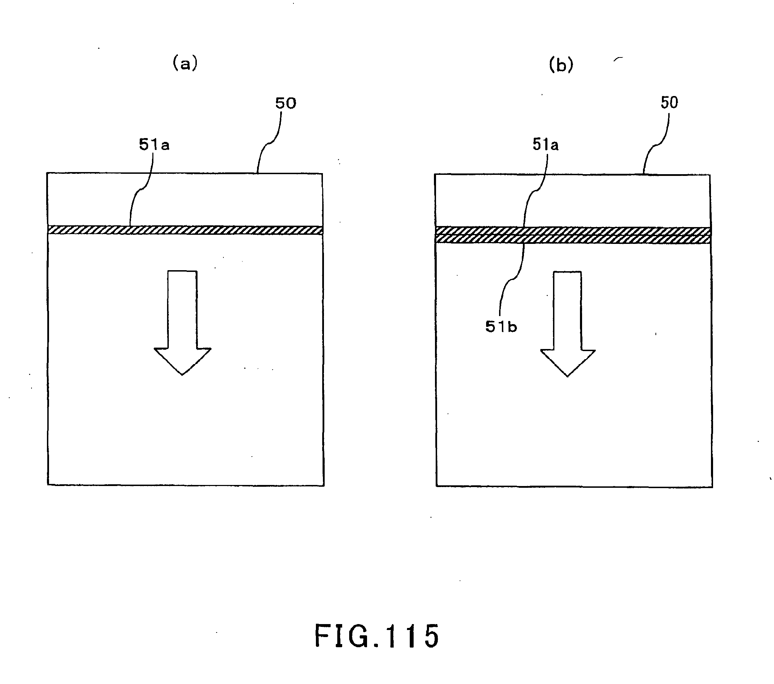

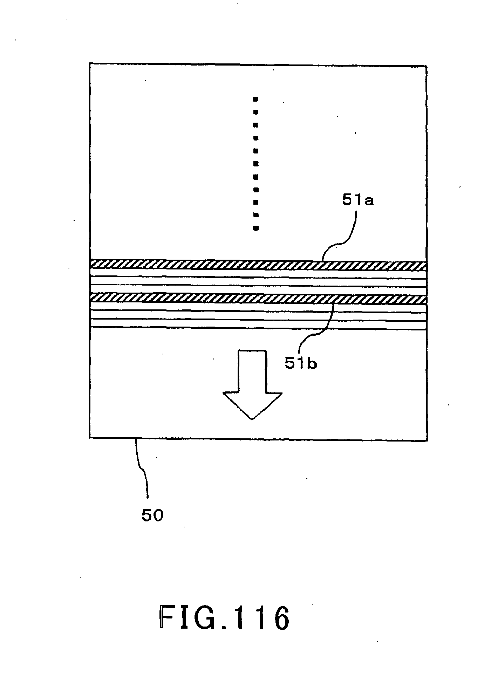

By controlling the timing of signals applied at the IN (INA, INb) terminals and at the clock terminals in the circuit configurations shown in Figures 111 and 113, it is possible to realize both a state in which a single gate signal line 17 is selected as shown in Figure 115(a) and a state in which two gate signal lines 17 are selected as shown in Figure 115(b) with the same circuit configuration. In the gate driver 12a on the selection side, the method, shown in Figure 115(a), is a drive method in which a single pixel row (51a) is selected at the same time (normal drive). The selection pixel row is shifted by row. Figure 115(b) shows a configuration for selecting two pixel rows. This drive method is a drive method (which has been described with reference to Figures 27 and 28) for simultaneously selecting a plurality of pixel rows (51a, 51b) (dummy pixel row configuration method). The selection pixel row is shifted by pixel row and, in addition, two pixel rows next to each other are selected at the same time. Particularly, in the drive method of Figure 115(b), the pixel row 51b is pre-charged with respect to a pixel row (51a) that holds a final video image. Accordingly, the pixel 16 is easily written. In other words, in accordance with the present invention, switching between the two drive methods is realized by the signals applied to the terminals. Figure 115(b) shows a method in which pixel rows 16 that are next to each other are selected. Alternatively, it may be arranged such that, as shown in Figure 116, pixel rows 16 that are not next each other are selected. Figure 116 shows an exemplary embodiment in which a pixel row and another situated three rows away are selected. In the Figure 13 configuration, control is performed by a group of four pixel rows. It is possible to perform control so that either one of the four pixel rows is selected or two consecutive pixel rows are selected. This is a constraint by the arrangement that the number of clock signal (SCK) lines that are used is four. When the number of clock signal (SCK) is eight, this makes it possible to perform control by a group of eight pixel rows.

The operation of the gate driver 12a on the selection side is the operation of Figure 115. As shown in Figure 115(a), a single pixel row is selected. Then, the selection position is shifted by one pixel row in synch with the horizontal synchronization signal. In addition, as shown in Figure 115(b), two single pixel rows are selected. Then, the selection position is shifted by one pixel row in synch with the horizontal synchronization signal.

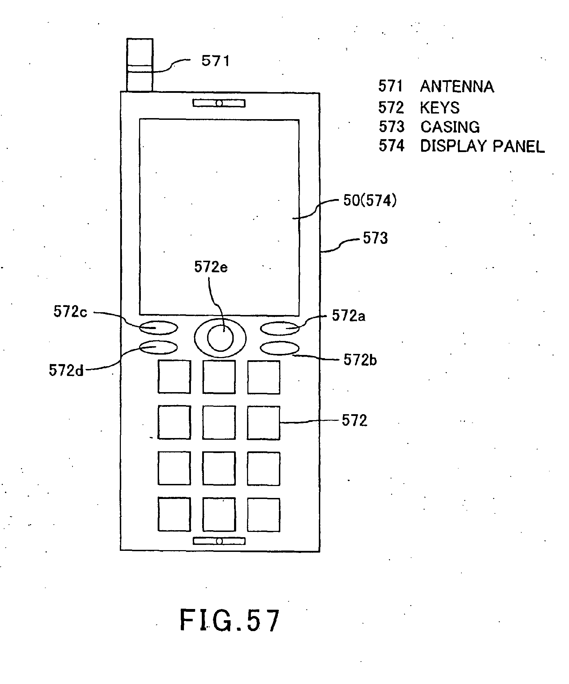

Next, description will be made of an embodiment of an electronic apparatus incorporating the EL display panel of the present invention. Figure 57 is a plan view of a mobile phone as an example of a personal digital assistant. The mobile phone shown includes a receiver and a speaker. Casing 573 is provided with an antenna 571, a numeric key pad 572 and the like. Keys 572a to 572e include a display color switching key, a power on-off key and a frame rate changing key.

A sequence may be formed such that depressing the display color switching key once will turn the display into a 8-color mode, depressing the same key again subsequently will turn the display into a 256-color mode, and further depressing the same key will turn the display into a 4096-color mode. The key is a toggle switch operative to change the display color mode upon every depression. Change keys corresponding to display colors may be provided separately. In this case, there are three (or more) display color switching keys.

The display color switching key may be another mechanical switch, such as a slide switch, instead of a push switch. Alternatively, it is possible to employ an arrangement for switching the display color based on voice recognition. Such an arrangement is possible that the display color on the display screen 50 of a display panel is changed in response to a voice inputting of, for example, "4096-color display", "high-definition display", "256-color mode" or "low display color mode" to the receiver. This arrangement can be realized easily by utilizing the current voice recognition technology.

The switching of display color may be made using an electrical switch or a touch panel for the user to select a desired item from a menu displayed in the display section 21 of the display panel by touching. Alternatively, it is possible to employ such an arrangement that the display color is changed as the number of depressions on the switch varies or as the rotation and the direction vary like a click ball.

Instead of the aforementioned display color switching key, a key for changing the frame rate or the like may be used. A key for switching between motion picture display and stationary image display may be used. It is possible to employ such an arrangement as to change plural conditions such as the frame rates of motion picture display and stationary image display. Also, it is possible to employ such an arrangement as to gradually vary the frame rate by being continuously depressed. This arrangement can be realized by using a variable resistor or an electronic volume for resistor R of an oscillator comprising capacitor C and the resistor R, or by using a trimmer capacitor for the capacitor C. Such an arrangement may be realized using a circuit in which one or more capacitors selected from plural capacitors formed on a semiconductor chip are connected in parallel.

The technical concept of varying the frame rate based on the display color is applicable not only to mobile phones but also to various apparatus of the type having a display screen such as palm-top computers, notebook PCs, desk-top PCs and portable clocks. This concept is applicable not only to organic EL display panels but also to liquid crystal display panels, transistor panels, PLZT panels, CRTs and the like.

Though not shown in Figure 57, the mobile phone according to the present invention has a CCD camera on the rear side of the casing 573. An image taken by this CCD camera can be immediately displayed on display screen 50 of the display panel. The data on the image taken by the CCD camera can be displayed on display screen 50. The image data taken by the CCD camera can be displayed in different display color modes such as 24-bit mode (16,700,000 colors), 18-bit mode (260,000 colors), 16-bit mode (65,000 colors), 12-bit mode (4,096 colors), and 8-bit mode (256 colors), which can be switched one from another by inputting through the key 572.

When the display data is data of 12 bits or more, the error diffusion process is performed before it is display. That is, when image data from the CCD camera exceeds the capacity of internal memory, image processing including the error diffusion process and the like is performed so that the number of colors to be displayed will correspond to a capacity lower than the capacity of the internal image memory.

Now, reference is made to the case where source driver 14 is provided with internal RAM adapted for 4,096 colors (4 bits for each of R, G and B) per screen. In the case where image data fed from outside of the module is 4,096-color data, the data is stored directly into the internal image RAM and then read out of the internal image RAM for the image to be displayed on display screen 50.

In the case where image data is 260,000-color data (16-bit data comprising 6 bits for G and 5 bits for each of R and B), the image data is temporarily stored into the operational memory of an error diffusion controller while, at the same time, being subjected to the error diffusion process or dither process performed by an operational circuit. Such an error diffusion process or the like converts the 16-bit image data into 12-bit data, the number of bits of which is equal to that of the internal image RAM. The data thus converted is transferred to source driver 14, which in turn outputs image data having 4 bits for each of R, G and B (4,096 colors) to display the image on display screen 50.

An embodiment employing the EL display panel or EL display apparatus or the driving method according to the present invention will be described with reference to the drawings.

Figure 58 is a sectional view of a view finder according to the embodiment of the present invention. Figure 58 illustrates the view finder schematically for easy explanation. In this figure there are portions enlarged or reduced in scale, or omitted. For example, an eyepiece cover is omitted from Figure 58. This holds true for other figures.

Body 573 has a reverse surface in a dark or black color. This is for preventing stray light emitted from EL display panel (display apparatus) 574 from diffuse reflection at an internal surface of body 573. On the light-emitting side of the display panel are located phase plate ($\lambda$/4 plate or the like) 108, sheet polarizer 109 and the like. These components have been described with reference to Figs. 10 and 11.

Magnifying lens 582 is fitted to eyepiece ring 581. The observer adjusts the position of the eyepiece ring 581 inserted in the body 573 so that image 50 displayed by the display panel 574 may be brought into focus.

If convex lens 583 is disposed on the light-emitting side of the display panel 574 when need arises, a principal ray incident on the magnifying lens 582 can be converged. Therefore, it is possible to reduce the diameter of the magnifying lens 582, hence, downsize the view finder.

Figure 59 is a perspective view of a digital video camera. The video camera includes shooting (image pickup) lens section 592 and a digital video camera body 573, the shooting lens section 592 and the view finder section 573 being positioned back to back. The view finder 573 (see Figure 58 also) is fitted with an eyepiece cover. The observer (user) observes display section 50 of the display panel 574 from the eyepiece cover section.

The display section 50, which is the EL display panel of the present invention, is also used as a display monitor. The angle of the display section 50 can be adjusted about a fulcrum 591 as desired. When not in use, the display section 50 is put in a storage section 593.

A switch 594 is a change-over switch or a control switch for implementing the following functions. The switch 594 is a display mode change-over switch. It is preferable to provide a mobile phone or the like with switch 594. Description will be made of this display mode change-over switch 594.

One of the driving methods according to the present invention includes feeding EL device 15 with an N-fold current for 1/M of a 1F period thereby causing EL device 15 to light for a 1/M period. The brightness of EL device 15 can be varied digitally by varying this lighting period. If N = 4 for example, EL device 15 is fed with a 4-fold current. If the 1/M lighting period is varied by varying the value of M from 1 up to 4, the brightness can be varied from 1-fold brightness up to 4-fold brightness. It is possible to employ an arrangement capable of varying the value of M in such a manner as M = 1, 1.5, 2, 3, 4, 5, 6.

The above-described change-over operation is utilized for an arrangement such as to make display screen 50 very bright when the mobile phone is powered on and, after lapse of a fixed time, lower the display luminance to save the power. The change-over operation may also be utilized as a function which allows the user to set his or her desired brightness. For example, when in use outdoors, the screen is made very bright, otherwise the screen is difficult to view due to the surrounding which is bright outdoors. However, if such a high-luminance display is continued, EL device will deteriorate rapidly. For this reason, if such a very bright display is provided, an arrangement is employed such as to resume the normal luminance in a short time. Further, if a high-luminance display is needed, an arrangement is employed which allows the user to raise the display luminance by his or her depressing a button.

Thus, it is preferable to employ an arrangement which allows the user to vary the brightness of the screen by button 594, an arrangement which is capable of automatically varying the brightness of the screen according to preset modes, or an arrangement which is capable of detecting the brightness of extraneous light and automatically varying the brightness of the screen depending on the result of detection. Also, it is preferable to employ an arrangement which allows the user or the like to set the display luminance to any value, for example, 50%, 60% or 80%.

Preferably, display screen 50 provides a Gaussian distribution display. The Gaussian distribution display is a display having a central portion made to exhibit a higher luminance and a peripheral portion made relatively dark. Visually, a display having a bright central portion appears to be wholly bright even when the peripheral portion is dark. According to subjective evaluation, the peripheral portion appears not to be visually inferior to the central portion as far as the peripheral portion maintains 70% of the luminance of the central portion. Not so serious a problem arises even when the luminance of the peripheral portion is further lowered to 50% of the luminance of the central portion. In the display panel of the self-luminescence type according to the present invention, a Gaussian distribution is provided vertically of the screen from the upper side to the lower side thereof by utilizing the N-fold pulse driving method (which includes feeding EL device 15 with an N-fold current for 1/M of a 1F period.)

Specifically, the value of M is increased for the upper and lower portions of the screen and decreased for the central portion. This can be realized by modulating the operation speed of the shift register of gate driver 12. The modulation of the brightness of the screen in the lateral direction is made based on multiplication of table data and image data by each other. When the peripheral luminance is lowered to 50% (with an angle of view of 0.9), the operation described above makes it possible to attain about 20% reduction in power consumption as compared to the case of 100% display luminance. When the peripheral luminance is lowered to 70% (with an angle of view of 0.9), the above-described operation makes it possible to attain about 15% reduction in power consumption as compared to the case of 100% display luminance.

It is preferable to provide a change-over switch or the like for turning on/off such a Gaussian distribution display. This is because the peripheral portion of the screen giving the Gaussian distribution display becomes invisible when the apparatus is used outdoors for example. For this reason, it is preferable to employ an arrangement which allows the user to turn on/off the Gaussian distribution display by a button, an arrangement which is capable of automatically switching between on and off according to preset modes, or an arrangement which is capable of detecting the brightness of extraneous light and automatically switching between on and off depending on the result of detection. It is also preferable to employ an arrangement which allows the user to set the luminance of the peripheral portion to any value, for example, 50%, 60% or 80%.

Liquid crystal display panels, in general, use a back light to cause a fixed Gaussian distribution to occur. Therefore, such a Gaussian distribution cannot be turned on/off. The ability to turn on/off a Gassian distribution is the advantage characteristic of self-luminescence type display devices.

In the case where the frame rate is predetermined, it is possible that flicker occurs due to interference between the panel and a lighting state of a fluorescent lamp located indoors or the like. When EL display device 15 operates at a frame rate of 60 Hz while a fluorescent lamp is lighting with an alternating current of 60 Hz, there occurs slight interference, which might make the viewer feel the screen blinking slowly. To avoid this inconvenience, varying the frame rate is sufficient. According to the present invention, the function of varying the frame rate is additionally provided. Further, the N-fold pulse driving method (which includes feeding EL device 15 with an N-fold current for 1/M of a 1F period) according to the present invention is capable of varying the value of N or M.

The above-described functions can be implemented by switch 594. When depressed plural times, switch 594 realizes switching between the above-described functions according to a menu provided on display screen 50.

It is needless to say that the feature described above is applicable not only to mobile phones but also to television sets, monitors and the like. It is preferable that the display screen is provided with icons for the user to be capable of immediately recognizing what display state the current display state is. The matters described above hold true for the matters to be described below.

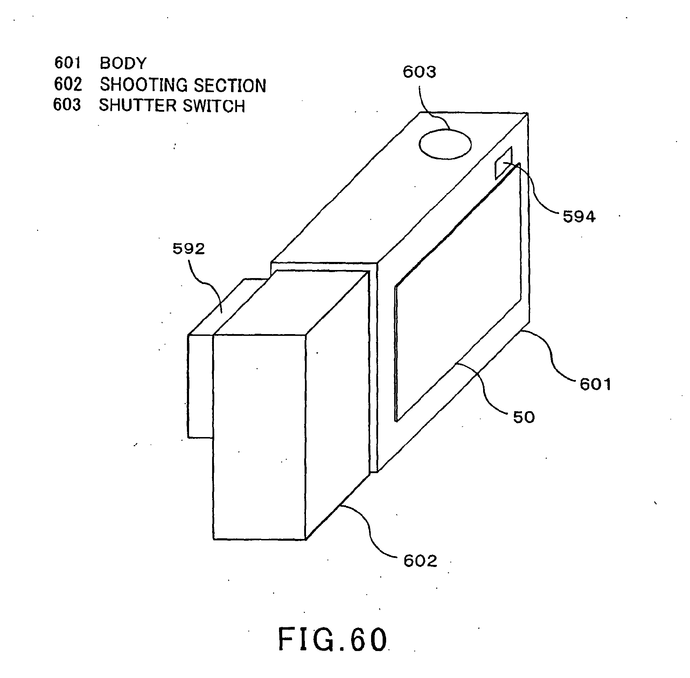

The EL display apparatus and the like according to this embodiment are applicable not only to a digital video camera but also to a digital still camera as shown in Figure 60. The display apparatus is used as a monitor 50 attached to a camera body 601. The camera body 601 is fitted with a shutter 603 as well as switch 594.

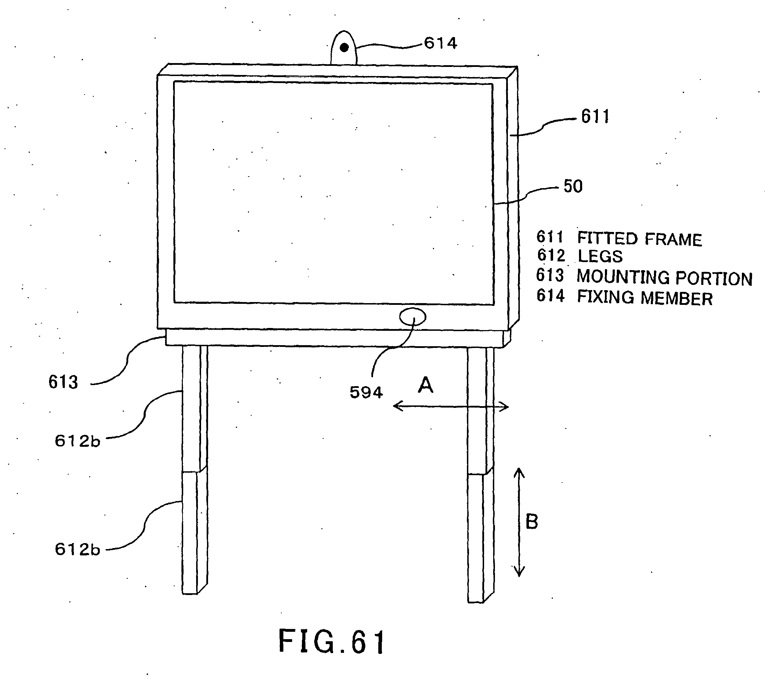

Though the foregoing description is directed to cases where the display region of a display panel is relatively small, display screen 50 as large as 30 inches or more is likely to warp. To deal with this inconvenience, the present invention provides the display panel with an outer frame 611 fitted therearound and a fixing member 614 for hanging the outer frame 611, as shown in Figure 61. The display panel is fitted on wall or the like by means of this fixing member 614.

However, the weight of the display panel increases with increasing screen size. For this reason, a leg-mounting portion 613 is provided under the display panel so that plural legs mounted thereon can support the weight of the display panel.

The legs 612 are movable laterally as indicated by arrow A and are expandable/contractible in directions indicated by arrow B. For this reason, the display apparatus can be easily installed even in a narrow place.

A television set shown in Figure 61 has a screen covered with a protective film (which may be a protective plate.) One object of such coverage is to prevent damage to the surface of the display panel due to a body hitting the surface. The protective film has an obverse surface formed with an AIR coat and embossed to inhibit unwanted reflection of external scene (extraneous light) by the display panel.

A fixed space is provided between the protective film and the display panel by dispersing beads or the like therebetween. Further, the protective film has a reverse surface formed with fine projections for retaining the space between the display panel and the protective film. By thus retaining the space, an impact is inhibited to transfer from the protective film to the display panel.

It is also effective to dispose or inject a light coupling agent such as alcohol or ethylene glycol in a liquid state, an acrylic resin in a gel state, or an epoxy resin which is a solid resin between the protective film and the display panel. This is because interfacial reflection can be prevented and because the light coupling agent functions also as a shock absorber.

Examples of such protective films include polycarbonate film (plate), polypropylene film (plate), acrylic film (plate), polyester film (plate), and PVA film (plate). It is needless to say that besides these films, engineering resin films (such as ABS) can be used. The protective film may be formed from an inorganic material such as strengthened glass. A similar effect will be produced if the surface of the display panel is coated with epoxy resin, phenolic resin, acrylic resin or the like to a thickness of not less than 0.5 mm and not more than 2.0 mm instead of the provision of the protective film. Embossing the surface of such a resin coat or a like process is also effective.

It is also effective that the surface of the protective film or coating layer is coated with fluorine. This is because such a fluorine coat allows stain thereon to be removed easily with a detergent. The protective film may be formed thicker so that a front light may share the protective film.

It is needless to say that combining the display panel according to the embodiment of the present invention with the three-side-free arrangement. The three-side-free arrangement is effective particularly when the pixels are manufactured utilizing the amorphous silicon technology. With the panel formed utilizing the amorphous silicon technology, process control for controlling variations in the characteristics of transistors is impossible. Hence, it is preferable to apply the N-fold pulse driving method, reset driving method, dummy pixel driving method or the like according to the present invention to such a panel. Thus, the transistors used in the present invention may be formed by the amorphous silicon technology without limitation to those formed by the polysilicon technology.

The N-fold pulse driving methods (see Figs. 13, 16, 19, 20, 22, 24 and 30 and the like) and like methods according to the present invention are effective for display panels of the type having transistors 11 formed by the amorphous silicon technology as well as for display panels of the type having transistors 11 formed by the low temperature polysilicon technology. This is because adjacent transistors 11 formed using amorphous silicon substantially agree to each other in characteristics. Accordingly, driving currents for individual transistors are each substantially equalized to the target value even when the panel is driven with the sum of currents. (The N-fold pulse driving methods illustrated in Figs. 22, 24 and 30 are particularly effective for pixel configurations of the type having transistors formed utilizing amorphous silicon.) The technical concept described by way of the embodiments of the present invention is applicable to digital video cameras, projectors, stereoscopic television, projection television, and the like. The concept is also applicable to view finders, mobile phone monitors, PHSs, personal digital assistants and their monitors, and digital still cameras and their monitors.

Also, the technical concept is applicable to electrophotographic systems, head-mounted displays, direct viewing monitors, notebook PCs and desktop PCs. Further, the concept is applicable to monitors for cash dispensers, and public telephones, video phones and watches and their displays.

It is needless to say that the technical concept of the present invention can be utilized in or applied to development of display monitors for household appliances, pocket-size game machines and their monitors, back lights for display panels, lighting instruments for home use or industrial use, and the like. A lighting instrument is preferably configured to be capable of varying the color temperature. The color temperature can be varied by adjustment of currents to be fed to R, G and B pixels if these pixels are arranged in a striped pattern or a dot-matrix pattern. The technical concept is also applicable to display apparatus for displaying advertisements or posters, RGB signals, warning display lights, and the like.

The organic EL display panel is effective as a light source of a scanner. In this case, a dot matrix comprising R, G and B pixels is used as the light source to illuminate a subject with light in reading the image of the subject. Of course, it is needless to say that such a light source may be designed to emit monochromatic light. Such a light source may be of a simple matrix configuration without limitation to an active matrix configuration. The image reading precision will improve if the color temperature can be controlled.

Also, the organic EL display apparatus is effective as the back light of a liquid crystal display device. The color temperature can be varied by adjustment of currents to be fed to R, G and B pixels of the EL display apparatus (back light) if these pixels are arranged in a striped pattern or a dot-matrix pattern. In this case, the brightness can also be controlled easily. Moreover, since the EL display apparatus is a surface-emitting light source, it can easily realize a Gaussian distribution in which a central portion of the screen is made relatively bright whereas a peripheral portion of the screen made relatively dark. The EL display apparatus is also effective as the back light of a liquid crystal display panel of the field sequential type which performs scanning with R, G and B rays alternately. The EL display apparatus can also be used as the back light of a liquid crystal display panel or the like adapted for motion picture display if black is inserted even when the back light blinks.

It should be noted that EL device 15 is regarded as an OLED in the present invention and represented using the symbol of diode in the drawings such as Figure 1. However, EL device 15 according to the present invention is not limited to the OLED but may be of any type which controls its luminance based on the amount of current passing through EL device 15. An example of such a device is an inorganic EL device. Other examples include a white light emitting diode comprising a semiconductor, and a common light-emitting diode. A light-emitting transistor can serve the purpose. Device 15 does not necessarily call for rectification. Therefore, device 15 may be a bidirectional diode.

It will be apparent from the foregoing description that many improvements and other embodiments of the present invention occur to those skilled in the art. Therefore, the foregoing description should be construed as an illustration only and is provided for the purpose of teaching the best mode for carrying out the present invention to those skilled in the art. The details of the structure and/or the function of the present invention can be modified substantially without departing from the spirit of the present invention.

Industrial Applicability

The EL display apparatus according to the present invention is useful as the display section of a thin television set, digital video camera, digital still camera, mobile phone or the like.

**Claims**

**1.** An electroluminescent (EL) display device comprising: a plurality of source signal lines; a plurality of EL elemental devices, each capable of the emission of light at a brightness corresponding to a current supplied via said source signal line; and a source driver which supplies a current corresponding to a gray scale of an image to said EL elemental device via said source signal line,

said source driver comprising:

reference signal generating means which generates reference signals,
a first current source which outputs a reference signal generated by said reference signal generating means in electric current form, and
a plurality of second current sources provided in association with said source signal lines, each of said plurality of second current sources being configured such that a reference signal outputted by said first current source is transferred in voltage form,

wherein a current according to said image gray scale is generated by the use of a reference signal held by each of said second current sources.

2. The EL display device as set forth in claim 1,
wherein a plurality of unit transistors, each of said unit transistors being so configured as to output said reference signal in electric current form when selected, are connected to each of said second current sources,
wherein said source driver is so configured as to select one or more of said unit transistors according to said image gray scale, and
wherein said EL display device is configured such that both a relational expression of $40 \leq K/(St)^{1/2}$ and a relational expression of $St \leq 300$, where K indicates the number of representable gray scales and St (square micrometers) indicates the size of said unit transistor, are satisfied.

3. The EL display device as set forth in claim 1, wherein said plural second current sources are formed in a region the area of which does not exceed 2 square millimeters.

4. The EL display device as set forth in claim 1, wherein said source driver is provided with a light shielding film for preventing said first and second current sources from being illuminated with rays of light emitted from said EL elemental device.

5. An electroluminescent (EL) display device comprising: a plurality of source signal lines; a plurality of EL elemental devices, each capable of the emission of light at a brightness corresponding to a current supplied via said source signal line; and a source driver which supplies a current corresponding to a gray scale of an image to said EL elemental device via said source signal line,

said source driver comprising:

a first current output circuit, made up of a plurality of unit transistors each operable to output a first unit current, for outputting to said EL elemental device a desired current by the combination of said first unit currents, and
a second current output circuit, made up of a plurality of unit transistors each operable to output a second unit current greater than said first unit current, for outputting to said EL elemental device a desired current by the combination of said second unit currents,

wherein, when a gray scale to be displayed is lower than a predetermined gray scale, said first current output circuit is so operated as to output a corresponding current for said gray scale to be displayed, while, when a gray scale to be displayed is higher than said predetermined gray scale, said second current output circuit is so operated as to output a corresponding current for said gray scale to be displayed, and wherein said EL display device is configured such that said first current output circuit outputs a given current.

6. The EL display device as set forth in claim 5, wherein the magnitude of said second current is not less than four times nor more than eight times the magnitude of said first current.

7. The EL display device as set forth in claim 5, wherein said source driver is provided with a light shielding film for preventing said first and second current output circuits from being illuminated with rays of light emitted from said EL elemental device.

8. Electronic equipment which is provided with an EL display device as set forth in claim 2 and which is so configured as to output an image signal to said EL display device.

9. An electroluminescent (EL) display device comprising:

a display region in which EL elemental devices are arranged in a matrix, and
a source driver which supplies in electric current form a video signal to said EL elemental device,

said source driver comprising:

reference current generating means which generates a reference current,
a first current source which is fed a reference current from said reference current generating means and which outputs a first current corresponding to said reference current,
a second current source which is fed a first current outputted from said first current source and which outputs a second current corresponding to said first current,
a third current source which is fed a second current outputted from said second current source and which outputs a third current corresponding to said second current, and
a plurality of unit current sources each of which is fed a third current outputted from said third current source, and outputs to said EL elemental device a unit current corresponding to said third current in response to input image data.

10. An electroluminescent (EL) display device comprising:

a display region in which EL elemental devices are arranged in a matrix, and
a source driver which supplies in electric current form a video signal to said EL elemental device,

wherein said source driver has a plurality of unit transistors,
wherein said unit transistor is so configured as to output, when selected, a unit current corresponding to the magnitude of an input video signal, and
wherein said EL display device is configured such that both a relational expression of $40 \leq K/(St)^{1/2}$ and a relational expression of $St \leq 300$, where K indicates the number of representable gray scales and St (square micrometers) indicates the size of said unit transistor, are satisfied.

11. An electroluminescent (EL) display device comprising:

a display region in which EL elemental devices are arranged in a matrix, and
a source driver which supplies in electric current form a video signal to said EL elemental device,

wherein said source driver has a transistor group made up of a first transistor and a plurality of second transistors in current-mirror connection with said first transistor, and
wherein said transistor group is formed in a region the area of which does not exceed 2 square millimeters.

12. The EL display device as set forth in claim 11,
wherein said first transistor is made up of a plurality of unit transistors, and
wherein said plural unit transistors are formed in a region the area of which does not exceed 2 square millimeters.

13. An electroluminescent (EL) display device comprising:

a display region in which pixels each having a respective EL elemental device are arranged in a matrix, and
a transistor elemental device formed in said pixel,
a gate driver for the ON/OFF control of said transistor elemental device, and
a source driver for supplying a video signal to said transistor elemental device,

wherein said gate driver is formed by a P channel transistor,
wherein said transistor formed in said pixel is a P channel transistor, and
wherein said source driver is formed by a semiconductor chip.

14. An electroluminescent (EL) display device comprising:

a display region in which an EL elemental device, a drive transistor, a first switching elemental device which establishes a path between said drive transistor and said EL elemental device, and a second switching elemental device which establishes a path between said drive transistor and a source signal line,
a first gate driver for the ON/OFF control of said first switching elemental device,
a second gate driver for the ON/OFF control of said second switching elemental device, and
a source driver which applies a video signal to said transistor elemental device,

wherein said gate driver is formed by a P channel transistor,
wherein a transistor formed in a pixel and said switching elemental devices are P channel transistor elemental devices, and
wherein said source driver is formed by a semiconductor chip.

15. The EL display device as set forth in either claim 13 or claim 14, wherein said source driver outputs a video signal in electric current form.

16. The EL display device as set forth in either claim 13 or claim 14, wherein said gate driver performs shifting operations by four clock signals.

FIG. 1

11 TFT
12 GATE DRIVER (CIRCUIT)
14 SOURCE DRIVER (CIRCUIT)
15 EL (DEVICE)
16 PIXEL
17 GATE SIGNAL LINE
18 SOURCE SIGNAL LINE
19 STORAGE CAPACITOR
   (ADDITIONAL CAPACITOR)

EP 1 450 341 A1

FIG. 2

FIG. 3

FIG. 4

50 DISPLAY SCREEN

51 WRITTEN PIXEL (ROW)

52 NON-DISPLAY PIXEL (NON-DISPLAY REGION, NON-LIGHTING REGION)

53 DISPLAY PIXEL (DISPLAY REGION, LIGHTING REGION)

(a)

(b)

FIG. 5

EP 1 450 341 A1

FIG. 6

61 SHIFT REGISTER
62 INVERTER
63 OUTPUT GATE

FIG. 7

71 ARRAY SUBSTRATE (PANEL)
72 LASER IRRADIATION RANGE
73 POSITIONING MARKER
74 GLASS SUBSTRATE

EP 1 450 341 A1

FIG. 8

81 CONTROL IC (CIRCUIT)

82 POWER SUPPLY IC (CIRCUIT)

83 PRINTED CIRCUIT BOARD

84 FLEXIBLE BOARD

85 ENCAPSULATING COVER

86 CATHODE WIRING

87 ANODE WIRING (Vdd)

88 DATA SIGNAL LINE

89 GATE CONTROL SIGNAL LINE

EP 1 450 341 A1

FIG. 9

101 RIB

102 INTERLAYER INSULATOR

104 CONTACT PORTION

105 PIXEL ELECTRODE

106 CATHODE ELECTRODE

107 DESICANT

108 $\lambda/4$ PLATE

109 SHEET POLARIZER

85   15

104   105   15R   101   15G   105   101 15B

107

106

11

109   108   102   71

# FIG.10

EP 1 450 341 A1

EP 1 450 341 A1

108  105  15R  101  109  15G  105  101  15B  111  106

t

11

71  102

FIG.11

FIG.12

FIG.13

EP 1 450 341 A1

(a) GATE SIGNAL LINE 17a

(b) GATE SIGNAL LINE 17b

(c) LUMINANCE OF EMISSION

FIG.14

EP 1 450 341 A1

FIG.15

EP 1 450 341 A1

EP 1 450 341 A1

(a)

(b)

14

51a

12

18

52d

53a

52a

53b

52b

53c

52c

17

50

50

FIG.16

(a) GATE SIGNAL LINE 17a

1H

1F

Vgh

Vgl

TIME t

(b) GATE SIGNAL LINE 17b

1F/(N·K)

1F/(N·K)

Vgh

Vgl

TIME t

(c) LUMINANCE OF EMISSION

N

0

TIME t

FIG.17

EP 1 450 341 A1

104

FIG.18

EP 1 450 341 A1

FIG.19

EP 1 450 341 A1

(a)                                    (b)

EP 1 450 341 A1

FIG.20

FIG.21

EP 1 450 341 A1

(a)                                    (b)

FIG.22

EP 1 450 341 A1

FIG.23

(a)

(b)

FIG.24

EP 1 450 341 A1

FIG.25

EP 1 450 341 A1

FIG.26

281   DUMMY PIXEL (ROW)

(a)

(b)

14

51a

12

17

51b

50

18

14

12

51a

17

18

281(51b)

FIG.27

EP 1 450 341 A1

EP 1 450 341 A1

FIG.28

(a)                                                (b)

14                                                 14

12                                                 12          281(51b)

51b

51a                                                51a

17    51a    50    18                              17                18

50

FIG. 29

EP 1 450 341 A1

(a1)

51a

51b

50

(a2)      53a

52

50

53b

(b1)

51a

51b

50

(b2)   53a
53b

52

50

53b

# FIG.30

FIG.31

FIG.32

FIG.33

EP 1 450 341 A1

341 CIRCUIT OF OUTPUT SECTION

FIG.34

EP 1 450 341 A1

FIG.35

EP 1 450 341 A1

FIG.36

FIG.37

FIG.38

FIG.39

FIG.40

EP 1 450 341 A1

FIG.41

(a)     (b)

FIG. 42

FIG.43

EP 1 450 341 A1

(a)  (b)  (c)

FIG.44

FIG.45

FIG.46

471  REVERSE BIAS LINE
473  GATE POTENTIAL CONTROL LINE

FIG. 47

FIG.48

FIG.49

EP 1 450 341 A1

FIG.50

EP 1 450 341 A1

FIG.51

Vdd — 19a — 11b — b — a — 19b — 11c — 16 — 17a — 17c — 16 — 11a — 11e — 15 — 11g — Vsg — 17b — 471 — Vk

FIG.52

EP 1 450 341 A1

FIG.53

FIG.54

FIG.55

561 ELECTRONIC VOLUME CIRCUIT

562 SD (SOURCE-DRAIN) OF TFT SHORTCIRCUITED

(a)

(b)

EP 1 450 341 A1

FIG.56

571 ANTENNA
572 KEYS
573 CASING
574 DISPLAY PANEL

FIG.57

EP 1 450 341 A1

EP 1 450 341 A1

581 EYEPIECE RING
582 MAGNIFYING LENS
583 CONVEX LENS

108

109 583

573

581

582

581

574

FIG.58

591 FULCRUM
592 SHOOTING LENS
593 STORAGE SECTION
594 SWITCH

FIG.59

EP 1 450 341 A1

601 BODY
602 SHOOTING SECTION
603 SHUTTER SWITCH

603

594

592

601

50

602

FIG.60

EP 1 450 341 A1

611 FITTED FRAME
612 LEGS
613 MOUNTING PORTION
614 FIXING MEMBER

FIG.61

FIG.62

EP 1 450 341 A1

631, 632, 633 CURRENT SOURCES

631

N CURRENT
SOURCES

632b

632a

632n

633

633

633a

633

633

633

M CURRENT
SOURCES

M CURRENT
SOURCES

M CURRENT
SOURCES

TOTAL OF N x M CURRENT SOURCES

FIG.63

641 SWITCH (ON/OFF MEANS)
634 CURRENT SOURCE (ONE UNIT)
643 INTERNAL INTERCONNECTION LINE

FIG.64

EP 1 450 341 A1

651  VOLUME (CURRENT ADJUSTING MEANS)

651 ─

631 ─  PARENT CURRENT SOURCE

TOTAL OF N CURRENT SOURCES = 16

CHILD  CURRENT  SOURCE

632 ─

632 ─

GRANDCHILD CURRENT SOURCE

633 ─

633 ─

634

634

634

TOTAL OF M CURRENT SOURCES = 11

TOTAL OF M CURRENT SOURCES = 11

FIG.65

FIG.66

FIG.67

681 TRANSISTOR GROUP

681a

632a

CURRENT TRANSFER

651

631

CURRENT TRANSFER

681b

633a

632b

681b

633a

CURRENT TRANSFER

632b

633b

681b

D0

641

634

D0

D0

D0

641

D0

D0

633b

FIG.68

691 RESISTOR (CURRENT LIMITING MEANS, GIVEN-VOLTAGE GENERATING MEANS)
692 DECODER CIRCUIT
693 LEVEL SHIFTER CIRCUIT

FIG.69

EP 1 450 341 A1

701 COUNTER (COUNTING MEANS)
702 NOR
703 AND
704 CURRENT OUTPUT CIRCUIT

FIG.70

FIG.71

EP 1 450 341 A1

721  D/A CONVERTER
722  OPERATIONAL AMPLIFIER

631p1    631p2    O1   O2   O3   O4   O5 ···

721    722

$D_1 \sim D_n$    D/A    +    633n

633n    633n    633n

631a    633n    633n

691    R

FIG.72

EP 1 450 341 A1

731 ANALOG SWITCH
732 INVERTER

L0    L1    L2                    L3    L4

641La   641Lb   641Lc    732   643L    641Ld   641Le

INL

732

731

IwL

IL

633

634a

634

634

FIG.73

**FIG.74**

FIG.75

EP 1 450 341 A1

EP 1 450 341 A1

761 I/O PAD (I/O SIGNAL TERMINAL)

651RH  651GH

651GL    651BL

651RL

651BH

14

704R    704G    704B

761

761

## FIG.76

EP 1 450 341 A1

771  REFERENCE CURRENT SOURCE
772  CURRENT CONTROLLING CIRCUIT

L0    L1    L2

771L

633L    761

641La    641Lb    641Lc

772

H0    H1    H2

771H

633H    634

641Ha    641Hb    641Hc

FIG.77

781 TEMPERATURE DETECTING CIRCUIT
782 TEMPERATURE CONTROLLING CIRCUIT

FIG.78

EP 1 450 341 A1

FIG.79

FIG.80

FIG.81

FIG.82

FIG.83

| GRAY SCALE | L0 | L1 | L2 | L3 | L4 | H0 | H1 | H2 | H3 | H4 | H5 |
|---|---|---|---|---|---|---|---|---|---|---|---|
| 0 | 0 | 0 | 0 | 0 | 0 | 0 | 0 | 0 | 0 | 0 | 0 |
| 1 | 1 | 0 | 0 | 0 | 0 | 0 | 0 | 0 | 0 | 0 | 0 |
| 2 | 0 | 1 | 0 | 0 | 0 | 0 | 0 | 0 | 0 | 0 | 0 |
| 3 | 1 | 1 | 0 | 0 | 0 | 0 | 0 | 0 | 0 | 0 | 0 |
| 4 | 1 | 1 | 0 | 0 | 1 | 0 | 0 | 0 | 0 | 0 | 0 |
| 5 | 1 | 1 | 0 | 0 | 1 | 1 | 0 | 0 | 0 | 0 | 0 |
| 6 | 1 | 1 | 0 | 0 | 1 | 0 | 1 | 0 | 0 | 0 | 0 |
| 7 | 1 | 1 | 0 | 0 | 1 | 1 | 1 | 0 | 0 | 0 | 0 |
| 8 | 1 | 1 | 0 | 0 | 1 | 0 | 0 | 1 | 0 | 0 | 0 |
| 9 | 1 | 1 | 0 | 0 | 1 | 1 | 0 | 1 | 0 | 0 | 0 |
| 10 | 1 | 1 | 0 | 0 | 1 | 0 | 1 | 1 | 0 | 0 | 0 |
| 11 | 1 | 1 | 0 | 0 | 1 | 1 | 1 | 1 | 0 | 0 | 0 |
| 12 | 1 | 1 | 0 | 0 | 1 | 0 | 0 | 0 | 1 | 0 | 0 |
| 13 | 1 | 1 | 0 | 0 | 1 | 1 | 0 | 0 | 1 | 0 | 0 |
| 14 | 1 | 1 | 0 | 0 | 1 | 0 | 1 | 0 | 1 | 0 | 0 |
| 15 | 1 | 1 | 0 | 0 | 1 | 1 | 1 | 0 | 1 | 0 | 0 |
| 16 | 1 | 1 | 0 | 0 | 1 | 0 | 0 | 0 | 0 | 1 | 0 |
| 17 | 1 | 1 | 0 | 0 | 1 | 1 | 0 | 0 | 0 | 1 | 0 |
| 18 | 1 | 1 | 0 | 0 | 1 | 0 | 1 | 0 | 0 | 1 | 0 |
| ... | ... | ... | ... | ... | ... | ... | ... | ... | ... | ... | ... |

FIG.84

171

| GRAY SCALE | L0 | L1 | L2 | L3 | L4 | H0 | H1 | H2 | H3 | H4 | H5 |
|---|---|---|---|---|---|---|---|---|---|---|---|
| 0 | 0 | 0 | 0 | 0 | 0 | 0 | 0 | 0 | 0 | 0 | 0 |
| 1 | 1 | 0 | 0 | 0 | 0 | 0 | 0 | 0 | 0 | 0 | 0 |
| 2 | 0 | 1 | 0 | 0 | 0 | 0 | 0 | 0 | 0 | 0 | 0 |
| 3 | 1 | 1 | 0 | 0 | 0 | 0 | 0 | 0 | 0 | 0 | 0 |
| 4 | 0 | 0 | 1 | 0 | 0 | 0 | 0 | 0 | 0 | 0 | 0 |
| 5 | 1 | 0 | 1 | 0 | 0 | 0 | 0 | 0 | 0 | 0 | 0 |
| 6 | 0 | 1 | 1 | 0 | 0 | 0 | 0 | 0 | 0 | 0 | 0 |
| 7 | 1 | 1 | 1 | 0 | 0 | 0 | 0 | 0 | 0 | 0 | 0 |
| 8 | 1 | 1 | 1 | 0 | 1 | 0 | 0 | 0 | 0 | 0 | 0 |
| 9 | 1 | 1 | 1 | 0 | 1 | 1 | 0 | 0 | 0 | 0 | 0 |
| 10 | 1 | 1 | 1 | 0 | 1 | 0 | 1 | 0 | 0 | 0 | 0 |
| 11 | 1 | 1 | 1 | 0 | 1 | 1 | 1 | 0 | 0 | 0 | 0 |
| 12 | 1 | 1 | 1 | 0 | 1 | 0 | 0 | 1 | 0 | 0 | 0 |
| 13 | 1 | 1 | 1 | 0 | 1 | 1 | 0 | 1 | 0 | 0 | 0 |
| 14 | 1 | 1 | 1 | 0 | 1 | 0 | 1 | 1 | 0 | 0 | 0 |
| 15 | 1 | 1 | 1 | 0 | 1 | 1 | 1 | 1 | 0 | 0 | 0 |
| 16 | 1 | 1 | 1 | 0 | 1 | 0 | 0 | 0 | 1 | 0 | 0 |
| 17 | 1 | 1 | 1 | 0 | 1 | 1 | 0 | 0 | 1 | 0 | 0 |
| 18 | 1 | 1 | 1 | 0 | 1 | 0 | 1 | 0 | 1 | 0 | 0 |
| ⋮ | ⋮ | ⋮ | ⋮ | ⋮ | ⋮ | ⋮ | ⋮ | ⋮ | ⋮ | ⋮ | ⋮ |

FIG.85

| GRAY SCALE | LO | L1 | L2 | L3 | L4 | HO | H1 | H2 | H3 | H4 | H5 |
|---|---|---|---|---|---|---|---|---|---|---|---|
| 0 | 0 | 0 | 0 | 0 | 0 | 0 | 0 | 0 | 0 | 0 | 0 |
| 1 | 1 | 0 | 0 | 0 | 0 | 0 | 0 | 0 | 0 | 0 | 0 |
| 2 | 0 | 1 | 0 | 0 | 0 | 0 | 0 | 0 | 0 | 0 | 0 |
| 3 | 1 | 1 | 0 | 0 | 0 | 0 | 0 | 0 | 0 | 0 | 0 |
| 4 | 0 | 0 | 1 | 0 | 0 | 0 | 0 | 0 | 0 | 0 | 0 |
| 5 | 1 | 0 | 1 | 0 | 0 | 0 | 0 | 0 | 0 | 0 | 0 |
| 6 | 0 | 1 | 1 | 0 | 0 | 0 | 0 | 0 | 0 | 0 | 0 |
| 7 | 1 | 1 | 1 | 0 | 0 | 0 | 0 | 0 | 0 | 0 | 0 |
| 8 | 0 | 0 | 0 | 1 | 0 | 0 | 0 | 0 | 0 | 0 | 0 |
| 9 | 1 | 0 | 0 | 1 | 0 | 0 | 0 | 0 | 0 | 0 | 0 |
| 10 | 0 | 1 | 0 | 1 | 0 | 0 | 0 | 0 | 0 | 0 | 0 |
| 11 | 1 | 1 | 0 | 1 | 0 | 0 | 0 | 0 | 0 | 0 | 0 |
| 12 | 0 | 0 | 1 | 1 | 0 | 0 | 0 | 0 | 0 | 0 | 0 |
| 13 | 1 | 0 | 1 | 1 | 0 | 0 | 0 | 0 | 0 | 0 | 0 |
| 14 | 0 | 1 | 1 | 1 | 0 | 0 | 0 | 0 | 0 | 0 | 0 |
| 15 | 1 | 1 | 1 | 1 | 0 | 0 | 0 | 0 | 0 | 0 | 0 |
| 16 | 1 | 1 | 1 | 1 | 1 | 0 | 0 | 0 | 0 | 0 | 0 |
| 17 | 1 | 1 | 0 | 0 | 1 | 1 | 0 | 0 | 0 | 0 | 0 |
| 18 | 1 | 1 | 0 | 0 | 1 | 0 | 1 | 0 | 0 | 0 | 0 |
| ⋮ | ⋮ | ⋮ | ⋮ | ⋮ | ⋮ | ⋮ | ⋮ | ⋮ | ⋮ | ⋮ | ⋮ |

FIG.86

EP 1 450 341 A1

704a HIGH CURRENT REGION CURRENT OUTPUT CIRCUIT
704b LOW CURRENT REGION CURRENT OUTPUT CIRCUIT
704c CURRENT AUGMENTATION CURRENT OUTPUT CIRCUIT

771a    704a

IwH    Iw

704c

761

771b    704b

IwK

IwL

FIG.87

FIG.88

FIG.89

FIG.90

FIG.91

FIG.92

931a    931b

14a    704a    14b    704b    704c    14c

50

12

16

18

17b    17a

EP 1 450 341 A1

FIG.93

932   REFERENCE CURRENT SIGNAL LINE
941i  CURRENT INPUT TERMINAL
941o  CURRENT OUTPUT TERMINAL

FIG.94

951 BASE ANODE LINE (ANODE VOLTAGE LINE, BASE ANODE LINE)
952 ANODE INTERCONNECTION LINE
953 CONNECTION TERMINAL

**FIG.95**

EP 1 450 341 A1

FIG.96

FIG.97

EP 1 450 341 A1

FIG.98

991 BASE CATHODE LINE
992 INPUT SIGNAL LINE

FIG.99

EP 1 450 341 A1

EP 1 450 341 A1

1001  CONNECTION RESIN    (a)

14  761  953  951  761  1001

102  962  1001  18  991

71

(b)

14  961  951  1001

A-A' LINE CROSS SECTION  962  761  991

71  953

# FIG.100

EP 1 450 341 A1

1011 LIGHT ABSORBING FILM

1012 RESIN BEAD

1013 SEALING RESIN

FIG.101

EP 1 450 341 A1

951    953c    14    1021

953a

953b

# FIG.102

FIG.103

18 G METAL

14

17 SD METAL

12

FIG.104

FIG.105

EP 1 450 341 A1

EP 1 450 341 A1

FIG.106

FIG.107

FIG.108

1091 POWER SUPPLY CIRCUIT (IC)
1092 POWER SUPPLY IC CONTROL SIGNAL
1093 GATE DRIVER CIRCUIT CONTROL SIGNAL

FIG.109

EP 1 450 341 A1

FIG.110

1111 UNIT GATE OUTPUT CIRCUIT

FIG.111

FIG.112

FIG.113

FIG.114

EP 1 450 341 A1

(a)

(b)

50

51a

50

51a

51b

FIG.115

FIG.116

FIG.117

## INTERNATIONAL SEARCH REPORT

| International application No. |
|---|
| PCT/JP02/09668 |

A. CLASSIFICATION OF SUBJECT MATTER
   Int.Cl⁷ G09G3/30, 3/20, H03M1/74

According to International Patent Classification (IPC) or to both national classification and IPC

B. FIELDS SEARCHED

Minimum documentation searched (classification system followed by classification symbols)
   Int.Cl⁷ G09G3/30, 3/20, H03M1/74

Documentation searched other than minimum documentation to the extent that such documents are included in the fields searched

| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | US 6091203 A (NEC corp.), 18 Jury, 2000(18.07.00), | 1-4,9-12, 14-16 |
| A | Full text; all drawings & JP 11-282419 A | 5-8 |
| Y | WO 99/65011 A2 (KONINKLIJKE PHILIPS ELECTRONICS N.V.), 16 December, 1999 (16.12.99), Full text; all drawings & JP 2002-517806 A | 1-4,9-12, 14-16 |
| Y | JP 8-340243 A (Canon Inc.), 24 December, 1996 (24.12.96), Column 2, line 16 to column 4, line 19 (Family: none) | 1-4,9-12, 14-16 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 19 November, 2002 (19.11.02) | 03 December, 2002 (03.12.02) |

| Name and mailing address of the ISA/ Japanese Patent Office | Authorized officer |
|---|---|
| Facsimile No. | Telephone No. |

Form PCT/ISA/210 (second sheet) (July 1998)

### INTERNATIONAL SEARCH REPORT

| | International application No. |
|---|---|
| | PCT/JP02/09668 |

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 4-42619 A (Fujitsu Ltd.), 13 February, 1992 (13.02.92), Page 2, upper right column, line 10 to page 4, upper right column, line 17; Figs. 1, 2, 4 to 6 (Family: none) | 1-4,9-12, 14-16 |
| Y | JP 6-314977 A (NEC IC Miconsystem Kabushiki Kaisha), 08 November, 1994 (08.11.94), Column 1, line 30 to column 2, line 32 (Family: none) | 1-4,9-12, 14-16 |
| X Y | JP 11-202295 A (Seiko Epson Corp.), 30 July, 1999 (30.07.99), Column 19, line 2 to column 21, line 16; column 23, lines 16 to 43; column 27, lines 24 to 29; Figs. 17 to 20 (Family: none) | 13 14-16 |
| X Y | JP 2001-134217 A (TDK Kabushiki Kaisha), 18 May, 2001 (18.05.01), Column 1, line 1 to column 6, line 41; Figs. 1 to 3, 14 (Family: none) | 13 14-16 |
| A | JP 2001-195014 A (TDK Kabushiki Kaisha), 19 Jury, 2001 (19.07.01), Full text; all drawings (Family: none) | 13-16 |

Form PCT/ISA/210 (continuation of second sheet) (July 1998)

## INTERNATIONAL SEARCH REPORT

| International application No. |
|---|
| PCT/JP02/09668 |

**Box I  Observations where certain claims were found unsearchable (Continuation of item 1 of first sheet)**

This international search report has not been established in respect of certain claims under Article 17(2)(a) for the following reasons:

1. ☐ Claims Nos.:

because they relate to subject matter not required to be searched by this Authority, namely:

2. ☐ Claims Nos.:

because they relate to parts of the international application that do not comply with the prescribed requirements to such an extent that no meaningful international search can be carried out, specifically:

3. ☐ Claims Nos.:

because they are dependent claims and are not drafted in accordance with the second and third sentences of Rule 6.4(a).

**Box II  Observations where unity of invention is lacking (Continuation of item 3 of first sheet)**

This International Searching Authority found multiple inventions in this international application, as follows:
An EL display apparatus having a source driver is not novel (see JP 11- 282419 A (NEC Corp.) 1999. 10. 15). This subject matter does not overcome the prior art and is therefore not a special technical feature in the meaning of the second sentence of PCT Rule 13. 2. Claims 1-4, 9 define the invention "a source driver comprising a first current source for outputting a reference signal generated by a reference signal generating means in the form of current and a second current source so constituted as to deliver the reference signal outputted by the first power source". Claims 5-8 define the invention " a device comprising a first current output circuit which includes unit transistors (continued to extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**  ☐ The additional search fees were accompanied by the applicant's protest.

☒ No protest accompanied the payment of additional search fees.

Form PCT/ISA/210 (continuation of first sheet (1)) (July 1998)

**INTERNATIONAL SEARCH REPORT**

International application No.

PCT/JP02/09668

Continuation of Box No.II of continuation of first sheet(1)

each for outputting a first unit current and outputs a desired current to an EL device by combining the first unit currents and a second current output circuit which includes unit transistors each for outputting a second unit current larger than the first unit current and outputs a desired current to the EL device by combining the second unit currents". Claim 10 defines the invention "a source driver having unit transistors for outputting unit currents when selected according to an inputted video signal. Claims 11, 12 define the invention "a source driver having a group of transistors comprising a first transistor and a second transistor current-mirror-connected to the first transistor". Claims 13-16 define the invention "comprising a display area with a matrix of pixels having EL devices, transistor devices formed in the pixels, gate drivers for on-off control of the transistor devices, and source drivers for supplying video signals to the transistor devices". These five groups of inventions are not so linked as to form a single general inventive concept.

Form PCT/ISA/210 (extra sheet) (July 1998)